(19) Europäisches Patentamt
European Patent Office
Office européen des brevets

(11) EP 4 572 587 A1

(12) EUROPEAN PATENT APPLICATION

(43) Date of publication:
**18.06.2025 Bulletin 2025/25**

(21) Application number: **23215922.8**

(22) Date of filing: **12.12.2023**

(51) International Patent Classification (IPC):
***H10K 85/60*** *(2023.01)*

(52) Cooperative Patent Classification (CPC):
**H10K 85/633; H10K 85/626; H10K 85/631; H10K 85/636; H10K 85/654; H10K 85/657; H10K 85/6572; H10K 85/6574;** H10K 50/17; H10K 2101/30

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Novaled GmbH**
**01099 Dresden (DE)**

(72) Inventors:
- **HELLMANN, Christoph**
  **01099, Dresden (DE)**
- **ROSENOW, Thomas**
  **01099, Dresden (DE)**

(74) Representative: **Michalski Hüttermann & Partner Patentanwälte mbB**
**Kaistraße 16A**
**40221 Düsseldorf (DE)**

# (54) ORGANIC ELECTROLUMINESCENT DEVICE AND DISPLAY DEVICE

(57) The present invention relates to an organic electroluminescent device comprising a p-doped hole injection layer and a display device comprising the organic electroluminescent device.

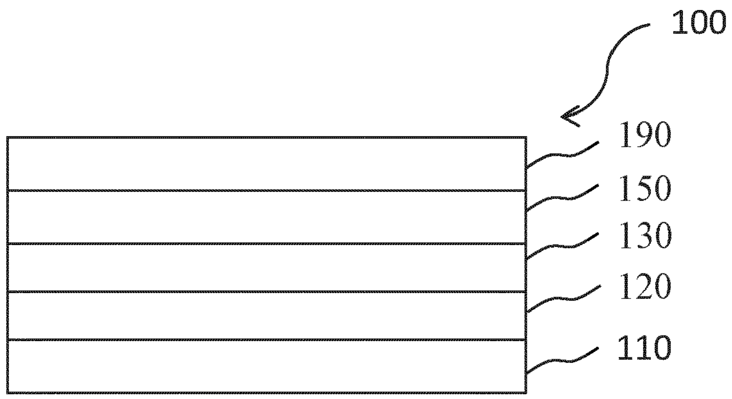


FIG. 1

EP 4 572 587 A1

## Description

### Technical Field

The present invention relates to an organic electroluminescent device comprising a p-doped hole injection layer and a display device comprising the organic electroluminescent device.

### Background Art

Organic electroluminescent devices, also named organic light-emitting diodes (OLEDs), which are self-emitting devices, have a wide viewing angle, excellent contrast, quick response, high brightness, excellent operating voltage characteristics, and color reproduction. A typical OLED comprises an anode layer, a hole injection layer HIL, a hole transport layer HTL, a first emission layer EML, an electron transport layer ETL, and a cathode layer, which are sequentially stacked on a substrate. In this regard, the HIL, the HTL, the EML, and the ETL are thin films formed from organic compounds.

When a voltage is applied to the anode and the cathode, holes injected from the anode move to the EML, via the HIL and HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency and/or a long lifetime.

Performance of an organic electroluminescent device may be affected by characteristics of the hole injection layer, and among them, may be affected by characteristics of the composition of the hole injection layer (HIL).

There remains a need to improve performance of organic electroluminescent devices as well as display devices comprising the organic electroluminescent devices, in particular to achieve improved operating voltage, improved efficiency and/or improved sheet resistance through improving the characteristics of the compounds comprised therein, in particular compounds in the hole injection layer. In addition, there remains a need to improved the HOMO energy level, LUMO energy level, dipole moment and/or spontaneous orientation polarization of the compounds comprised in the hole injection layer, in particular of the second organic compound.

### DISCLOSURE

An aspect of the present invention provides an organic electroluminescent device comprising an anode layer, a cathode layer, a first emission layer, and a hole injection layer, the hole injection layer comprises a composition comprising:

- a first organic compound comprising ≥ 7 to ≤ 14 aromatic rings and at least one triarylamine moiety; and
- a second organic compound comprising ≥ 7 to ≤ 14 aromatic rings;
  wherein the HOMO energy level of the second organic compound is in the range of ≤ -5 eV to ≥ -6.5 eV; and
- a first organic p-dopant comprising at least three CN groups, and wherein the first organic p-dopant has a molecular weight of ≥ 400 g/mol, and

wherein
the following equations (a) and (b) are fulfilled:

(a) 0.2 eV < Δ [LUMO energy level of the first organic compound - LUMO energy level of the second organic compound] < 3.5 eV; and
(b) 0 eV < Δ [HOMO energy level of the first organic compound - LUMO energy level of the first organic p-dopant] < 1.5eV;

wherein
the hole injection layer is in direct contact with the anode layer.

According to one embodiment, wherein the composition of the hole injection layer consists of said first organic compound, of said second organic compound and said first organic p-dopant.

According to one embodiment, wherein the composition of the hole injection layer consists of:

- a first organic compound comprising ≥ 7 to ≤ 14 aromatic rings and at least one triarylamine moiety; and
- a second organic compound comprising ≥ 7 to ≤ 14 aromatic rings; and
- a first organic p-dopant comprising at least three CN groups, and wherein the first organic p-dopant has a molecular weight of ≥ 400 g/mol and ≤ 2000 g/mol.

It should be noted that throughout the application and the claims any $Ar^1$, $Ar^2$, $Ar^3$, $Ar^4$ and $Ar^5$, $Ar^{21}$, $Ar^{22}$ and $Ar^{23}$, $T^1$, $T^2$, $T^3$, $T^4$, $T^5$ and $T^6$, $T^{21}$ and $T^{22}$, $Z^1$, $Z^2$ and $Z^3$, $Ar^{31}$ and $Ar^{32}$, $R^{11}$, $R^{22}$, $R^{31}$, $R^{32}$ and $R^{33}$, $r^{31}$, $r^{32}$ and $r^{33}$, $Ar^{41}$, $Ar^{42}$, $L^{41}$, $L^{42}$, $R^{41}$ to $R^{48}$, etc. always refer to the same moieties, unless otherwise noted.

In the present specification, when a definition is not otherwise provided, "partially fluorinated" refers to a $C_1$ to $C_6$ alkyl group in which only part of the hydrogen atoms are replaced by fluorine atoms.

In the present specification, when a definition is not otherwise provided, "perfluorinated" refers to a $C_1$ to $C_6$ alkyl group in which all hydrogen atoms are replaced by fluorine atoms.

In the present specification, when a definition is not otherwise provided, "substituted" refers to one substituted with a partially fluorinated or perfluorinated $C_1$ to $C_6$ alkyl, $CF_3$, partially fluorinated or perfluorinated $C_1$ to $C_4$ alkoxy, $OCF_3$, partially fluorinated or perfluorinated $C_1$ to $C_4$ alkylsulfonyl, $SO_2CF_3$, F, CN, $NO_2$, $SF_5$, D and H.

In the present specification, when a definition is not otherwise provided, an "alkyl group" refers to a saturated aliphatic hydrocarbyl group. The alkyl group may be a $C_1$ to $C_6$ alkyl group. For example, a $C_1$ to $C_4$ alkyl group includes 1 to 4 carbons in alkyl chain, and may be selected from methyl, ethyl, propyl, iso-propyl, n-butyl, iso-butyl, sec-butyl, and tert-butyl.

Specific examples of the alkyl group may be a methyl group, an ethyl group, a propyl group, an isopropyl group, a butyl group, an iso-butyl group, a sec-butyl group, a tert-butyl group, a pentyl group, a hexyl group.

The term "fused aryl rings" or "condensed aryl rings" is understood the way that two aryl rings are considered fused or condensed when they share at least two common $sp^2$-hybridized carbon atoms.

The term "azine group" or "azine" is understood the way that the "azine group" or "azine" can contain more than one ring.

The term "six-member ring" is understood to mean a ring formed by 6 atoms. The ring-forming atoms of the "six-member ring" may be bonded to further atoms outside the ring, for example hydrogen atoms.

The term "five-member ring" is understood to mean a ring formed by 5 atoms. The ring-forming atoms of the "five-member ring "may be bonded to further atoms outside the ring, for example hydrogen atoms.

In the present specification, the single bond refers to a direct bond.

The term "aromatic rings" is understood to mean aromatic rings which adhere to the Hückel rule of aromaticity. The aromatic rings may comprise heteroatoms, such as N, O, S, Se, Si, P, or may be free of heteroatoms. In the first organic compound and the second organic compound, every aromatic ring is counted. For example, a carbazolyl moiety counts as three aromatic rings.

The term "free of', "does not contain", "does not comprise" does not exclude impurities which may be present in the compounds prior to deposition. Impurities have no technical effect with respect to the object achieved by the present invention.

The term "contacting sandwiched" refers to an arrangement of three layers whereby the layer in the middle is in direct contact with the two adjacent layers.

The terms "light-absorbing layer" and "light absorption layer" are used synonymously.

The terms "light-emitting layer", "light emission layer" and "emission layer" are used synonymously.

The terms "p-type charge generation layer" and "p-CGL" are used synonymously.

The terms "n-type charge generation layer" and "n-CGL" are used synonymously.

The terms "OLED", "organic light-emitting diode", "organic light-emitting device" and "organic electroluminescent device" are used synonymously.

The terms "anode", "anode layer" and "anode electrode" are used synonymously.

The terms "cathode", "cathode layer" and "cathode electrode" are used synonymously.

The terms "voltage" and "operating voltage" are used synonymously.

In the specification, hole characteristics refer to an ability to donate an electron to form a hole when an electric field is applied and that a hole formed in the anode may be easily injected into the emission layer and transported in the emission layer due to conductive characteristics according to a highest occupied molecular orbital (HOMO) energy level.

In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) energy level.

## Disclaimer

According to one embodiment wherein the hole injection layer does not contain at least one or all of compounds DIS-1 to DIS-6:

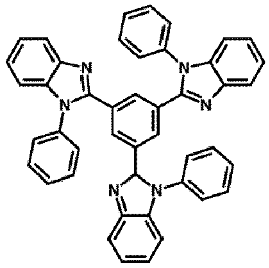

DIS-1, 1,3,5-Tris(1-phenyl-1H-benzimidazol-2-yl)benzene) (TPBi);

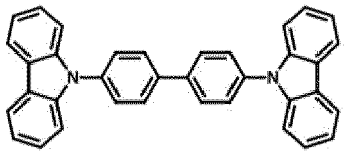

DIS-2, 4,4'-Bis(N-carbazolyl)-1,1'-biphenyl (CBP);

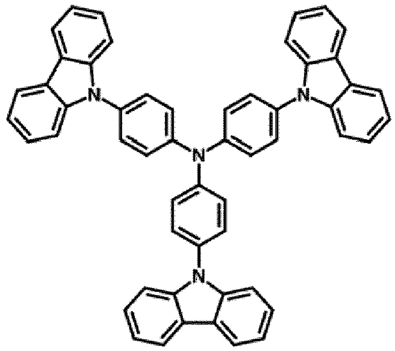

DIS-3, tris(4-carbazoyl-9-ylphenyl)amine (TCTA);

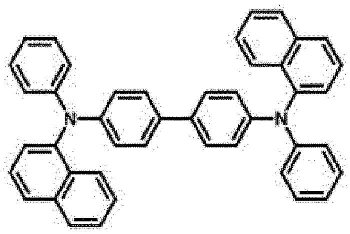

DIS-4, N,N'-Di(1-naphthyl)-N,N'-diphenyl-(1,1 '-biphenyl)-4,4'-diamine (NPB);

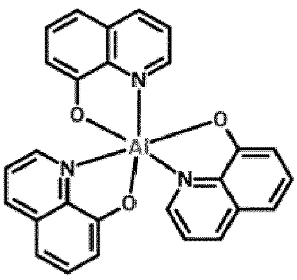

DIS-5, Tris(8-hydroxyquinoline)aluminum ($Alq_3$) and/or

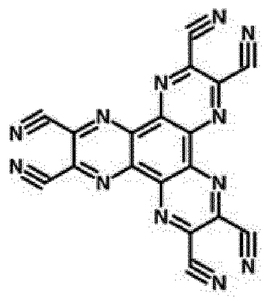

DIS-6, 1,4,5,8,9,11-Hexaazatriphenylenehexacarbonitrile (HAT-CN).

According to one embodiment wherein the hole injection layer is free of HAT-CN.

According to one embodiment wherein the hole injection layer is free of TPBi (CAS Registry number 192198-85-9).

According to one embodiment wherein the hole injection layer is free of TPBi, CBP, NPB, TCTA and/or $Alq_3$.

According to one embodiment wherein the first organic compound and/or second organic compound are free of metal and/or metal cation.

According to one embodiment wherein the hole injection layer is:

- free of HAT-CN; and
- free of TPBi (CAS Registry number 192198-85-9); and
- free of TPBi, CBP, NPB, TCTA and $Alq_3$.

According to one embodiment wherein the hole injection layer is:

- free of HAT-CN; and
- free of TPBi (CAS Registry number 192198-85-9); and
- free of TPBi, CBP, NPB, TCTA and $Alq_3$; and
- wherein the first organic compound and/or second organic compound and/or first organic p-dopant are free of metal and/or metal cation.

According to one embodiment wherein the first organic compound and/or second organic compound and/or first organic p-dopant of the hole injection layer are free of metal and/or metal cation.

## Advantageous Effects

Surprisingly, it was found that the organic compounds, such as the first organic compound, second organic compound and first organic p-dopant of the present invention, for example according to (Ia) and (Ib) as well as of formula (II) and formula (III) may solve the problem underlying the present invention by enabling organic electroluminescent devices in various aspects superior over the organic electroluminescent devices known in the art, with respect to operating voltage, efficiency and/or sheet resistance of a layer comprising the compounds.

Further, it was surprisingly found that compounds of formula (Ia) and (Ib) as well as of formula (II) and (III) may have improved HOMO and LUMO energy levels, improved dipole moment and/or improved spontaneous orientation polarization.

In particular, it was found that the HOMO and LUMO energy levels, dipole moment and/or spontaneous orientation polarization of the second organic compound may be in the range required for increased sheet resistance and reduced pixel crosstalk.

## Organic electroluminescent device

According to one embodiment, wherein the organic electroluminescent device comprising an anode layer, a cathode layer, a first emission layer, and a hole injection layer, and the hole injection layer comprises a composition of a first organic compound, a second organic compound and a first organic p-dopant, wherein the hole injection layer is free of metal and/or metal cations.

According to one embodiment, wherein the organic electroluminescent device comprising an anode layer, a cathode layer, a first emission layer, and a hole injection layer, and the hole injection layer comprises a composition of a first organic compound, a second organic compound and a first organic p-dopant, wherein the second organic compound

comprises an azine group, preferably a triazine group, a pyrimidine group, a pyridine group, an acridine group, a dibenzoacridine group, a dibenzo[c,h]acridine group, a benzo[h]quinazoline group and/or a 3,8a-dihydroimidazo[1,5-a]pyridine group, more preferred a pyrimidine group, a pyridine group and/or an acridine group.

According to one embodiment, wherein the organic electroluminescent device comprising an anode layer, a cathode layer, a first emission layer, and a hole injection layer, and the hole injection layer comprises a composition of a first organic compound, a second organic compound and a first organic p-dopant, wherein the hole injection layer is free of metal and/or metal cations; and wherein the second organic compound comprises an azine group, preferably a triazine group, a pyrimidine group, a pyridine group, an acridine group, a dibenzoacridine group, a dibenzo[c,h]acridine group, a benzo[h]quinazoline group and/or a 3,8a-dihydroimidazo[1,5-a]pyridine group, more preferred a pyrimidine group, a pyridine group and/or an acridine group.

According to one embodiment, wherein the organic electroluminescent device comprising an anode layer, a cathode layer, a first emission layer, and a hole injection layer,

the hole injection layer comprises a composition comprising:

- a first organic compound comprising ≥ 7 to ≤ 14 aromatic rings and at least one triarylamine moiety; and
- a second organic compound comprising ≥ 7 to ≤ 14 aromatic rings;
  wherein the HOMO energy level of the second organic compound is in the range of ≤ -5 eV to ≥ -6.5 eV; and
- a first organic p-dopant comprising at least three CN groups, and wherein the first organic p-dopant has a molecular weight of ≥ 400 g/mol, and

wherein
the following equations (a) and (b) are fulfilled:

(a) 0.2 eV < Δ [LUMO energy level of the first organic compound - LUMO energy level of the second organic compound] < 3.5 eV; and
(b) 0 eV < Δ [HOMO energy level of the first organic compound - LUMO energy level of the first organic p-dopant] < 1.5eV;

wherein
the second organic compound comprising ≥ 7 and ≤ 14 aromatic rings, if formed as a separated organic semiconductor layer, said separated organic semiconductor layer consisting of the second organic compound has a spontaneous orientation polarization in the range of ≥ 0 mV/nm to ≤ 150 mV/nm, preferably a spontaneous orientation polarization of ≥ 5 mV/nm, more preferred ≥ 10 mV/nm, most preferred ≥ 15 mV/nm, or a spontaneous orientation polarization of ≥ 8 mV/nm and ≤ 100 mV/nm, preferably ≥ 9 mV/nm and ≤ 80 mV/nm, more preferred ≥ 10 mV/nm and ≤ 70 mV/nm; and wherein the hole injection layer is in direct contact with the anode layer.

According to one embodiment, wherein the organic electroluminescent device comprising an anode layer, a cathode layer, a first emission layer, and a hole injection layer,

the hole injection layer comprises a composition comprising:

- a first organic compound comprising ≥ 7 to ≤ 14 aromatic rings and at least one triarylamine moiety; and
- a second organic compound comprising ≥ 7 to ≤ 14 aromatic rings;
  wherein the HOMO energy level of the second organic compound is in the range of ≤ -5 eV to ≥ -6.5 eV; and
- a first organic p-dopant comprising at least three CN groups, and wherein the first organic p-dopant has a molecular weight of ≥ 400 g/mol, and

wherein
the following equations (a) and (b) are fulfilled:

(a) 0.2 eV < Δ [LUMO energy level of the first organic compound - LUMO energy level of the second organic compound] < 3.5 eV; and
(b) 0 eV < Δ [HOMO energy level of the first organic compound - LUMO energy level of the first organic p-dopant] < 1.5eV;

wherein

the first organic p-dopant comprises independently of each other at least two groups selected from $C_6$ to $C_{19}$ aryl group or $C_3$ to $C_{12}$ heteroaryl group, wherein each of the $C_6$ to $C_{19}$ aryl group or $C_3$ to $C_{12}$ heteroaryl group is substituted,
wherein the one or more substituents are independently selected from halogen, F, CN, partially perfluorinated $C_1$ to $C_{12}$ alkyl, perfluorinated $C_1$ to $C_{12}$ alkyl, $CF_3$; and

wherein the hole injection layer is in direct contact with the anode layer.

According to one embodiment, wherein the organic electroluminescent device comprising an anode layer, a cathode layer, a first emission layer, and a hole injection layer,

the hole injection layer comprises a composition comprising:

- a first organic compound comprising ≥ 7 to ≤ 14 aromatic rings and at least one triarylamine moiety; and
- a second organic compound comprising ≥ 7 to ≤ 14 aromatic rings;
  wherein the HOMO energy level of the second organic compound is in the range of ≤ -5 eV to ≥ -6.5 eV; and
- a first organic p-dopant comprising at least three CN groups, and wherein the first organic p-dopant has a molecular weight of ≥ 400 g/mol, and

wherein
the following equations (a) and (b) are fulfilled:

(a) 0.2 eV < Δ [LUMO energy level of the first organic compound - LUMO energy level of the second organic compound] < 3.5 eV; and
(b) 0 eV < Δ [HOMO energy level of the first organic compound - LUMO energy level of the first organic p-dopant] < 1.5 eV;

wherein
the second organic compound comprises azine group, preferably a triazine group, a pyrimidine group, a pyridine group, an acridine group, a dibenzoacridine group, a dibenzo[c,h]acridine group, a benzo[h]quinazoline group and/or a 3,8a-dihydroimidazo[1,5-a]pyridine group, more preferred a pyrimidine group, a pyridine group and/or an acridine group; and
wherein the hole injection layer is in direct contact with the anode layer.

According to one embodiment, wherein the organic electroluminescent device comprising an anode layer, a cathode layer, a first emission layer, and a hole injection layer,

the hole injection layer comprises a composition comprising:

- a first organic compound comprising ≥ 7 to ≤ 14 aromatic rings and at least one triarylamine moiety; and
- a second organic compound comprising ≥ 7 to ≤ 14 aromatic rings;
  wherein the HOMO energy level of the second organic compound is in the range of ≤ -5 eV to ≥ -6.5 eV; and
- a first organic p-dopant comprising at least three CN groups, and wherein the first organic p-dopant has a molecular weight of ≥ 400 g/mol, and

wherein
the following equations (a) and (b) are fulfilled:

(a) 0.2 eV < Δ [LUMO energy level of the first organic compound - LUMO energy level of the second organic compound] < 3.5 eV; and
(b) 0 eV < Δ [HOMO energy level of the first organic compound - LUMO energy level of the first organic p-dopant] < 1.5 eV;

wherein
the second organic compound comprising ≥ 7 and ≤ 14 aromatic rings, if formed as a separated organic semiconductor layer, said separated organic semiconductor layer consisting of the second organic compound has a spontaneous orientation polarization in the range of ≥ 0 mV/nm to ≤ 150 mV/nm, preferably a spontaneous orientation polarization of ≥ 5 mV/nm, more preferred ≥ 10 mV/nm, most preferred ≥ 15 mV/nm, or a spontaneous orientation polarization of ≥ 8

mV/nm and ≤ 100 mV/nm, preferably ≥ 9 mV/nm and ≤ 80 mV/nm, more preferred ≥ 10 mV/nm and ≤ 70 mV/nm; and wherein
the second organic compound comprises an azine group, preferably a triazine group, a pyrimidine group, a pyridine group, an acridine group, a dibenzoacridine group, a dibenzo[c,h]acridine group, a benzo[h]quinazoline group and/or a 3,8a-dihydroimidazo[1,5-a]pyridine group, more preferred a pyrimidine group, a pyridine group and/or an acridine group; and
wherein the hole injection layer is in direct contact with the anode layer.

According to one embodiment, wherein the organic electroluminescent device comprising an anode layer, a cathode layer, a first emission layer, and a hole injection layer,

the hole injection layer comprises a composition comprising:

- a first organic compound comprising ≥ 7 to ≤ 14 aromatic rings and at least one triarylamine moiety; and
- a second organic compound comprising ≥ 7 to ≤ 14 aromatic rings;
  wherein the HOMO energy level of the second organic compound is in the range of ≤ -5 eV to ≥ -6.5 eV; and
- a first organic p-dopant comprising at least three CN groups, and wherein the first organic p-dopant has a molecular weight of ≥ 400 g/mol, and

wherein
the following equations (a) and (b) are fulfilled:

(a) 0.2 eV < Δ [LUMO energy level of the first organic compound - LUMO energy level of the second organic compound] < 3.5 eV; and
(b) 0 eV < Δ [HOMO energy level of the first organic compound - LUMO energy level of the first organic p-dopant] < 1.5 eV;

wherein

the second organic compound comprises at least one substituted or unsubstituted $C_3$ to $C_{24}$ heteroaryl group, azine group, 5-membered N-heteroaryl group, 6-membered N-heteroaryl group, or 6-membered heteroaryl group comprising between 1 and 3 N atoms,
wherein the substituents of the at least one substituted or unsubstituted $C_3$ to $C_{24}$ heteroaryl group are selected from the group comprising H, D, F, C(-O)$R^{22}$, CN, Si($R^{22}$)$_3$, P(-O)($R^{22}$)$_2$, O$R^{22}$, S(-O)$R^{22}$, S(-O)$_2$$R^{22}$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted substituted or unsubstituted aromatic ring systems having 6 to 40 aromatic ring atoms, and substituted or unsubstituted heteroaromatic ring systems having 5 to 40 aromatic ring atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,

wherein $R^{22}$ is selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl; and
wherein

the first organic p-dopant comprises independently of each other at least two groups selected from $C_6$ to $C_{19}$ aryl group or $C_3$ to $C_{12}$ heteroaryl group, wherein each of the $C_6$ to $C_{19}$ aryl group or $C_3$ to $C_{12}$ heteroaryl group is substituted,
wherein the one or more substituents are independently selected from halogen, F, CN, partially perfluorinated $C_1$ to $C_{12}$ alkyl, perfluorinated $C_1$ to $C_{12}$ alkyl, $CF_3$; and
wherein the hole injection layer is in direct contact with the anode layer.

According to one embodiment, wherein the organic electroluminescent device comprising an anode layer, a cathode layer, a first emission layer, and a hole injection layer,

the hole injection layer comprises a composition comprising:

- a first organic compound comprising ≥ 7 to ≤ 14 aromatic rings and at least one triarylamine moiety; and
- a second organic compound comprising ≥ 7 to ≤ 14 aromatic rings;
  wherein the HOMO energy level of the second organic compound is in the range of ≤ -5 eV to ≥ -6.5 eV; and
- a first organic p-dopant comprising at least three CN groups, and wherein the first organic p-dopant has a molecular weight of ≥ 400 g/mol, and

wherein
the following equations (a) and (b) are fulfilled:

(a) 0.2 eV < Δ [LUMO energy level of the first organic compound - LUMO energy level of the second organic compound] < 3.5 eV; and
(b) 0 eV < Δ [HOMO energy level of the first organic compound - LUMO energy level of the first organic p-dopant] < 1.5 eV;

wherein

the second organic compound comprises at least one substituted or unsubstituted $C_3$ to $C_{24}$ heteroaryl group, azine group, 5-membered N-heteroaryl group, 6-membered N-heteroaryl group, or 6-membered heteroaryl group comprising between 1 and 3 N atoms,
wherein the substituents of the at least one substituted or unsubstituted $C_3$ to $C_{24}$ heteroaryl group are selected from the group comprising H, D, F, C(-O)$R^{22}$, CN, Si$(R^{22})_3$, P(-O)$(R^{22})_2$, O$R^{22}$, S(-O)$R^{22}$, S$(-O)_2R^{22}$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted substituted or unsubstituted aromatic ring systems having 6 to 40 aromatic ring atoms, and substituted or unsubstituted heteroaromatic ring systems having 5 to 40 aromatic ring atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,

wherein $R^{22}$ is selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl; and
wherein
the first organic p-dopant comprises independently of each other at least two groups selected from $C_6$ to $C_{19}$ aryl group or $C_3$ to $C_{12}$ heteroaryl group, wherein each of the $C_6$ to $C_{19}$ aryl group or $C_3$ to $C_{12}$ heteroaryl group is substituted, wherein the one or more substituents are independently selected from halogen, F, CN, partially perfluorinated $C_1$ to $C_{12}$ alkyl, perfluorinated $C_1$ to $C_{12}$ alkyl, $CF_3$; and
wherein
the second organic compound comprising ≥ 7 and ≤ 14 aromatic rings, if formed as a separated organic semiconductor layer, said separated organic semiconductor layer consisting of the second organic compound has a spontaneous orientation polarization in the range of ≥ 0 mV/nm to ≤ 150 mV/nm; and
wherein the hole injection layer is in direct contact with the anode layer.

According to one embodiment, wherein the organic electroluminescent device comprising an anode layer, a cathode layer, a first emission layer, and a hole injection layer,

the hole injection layer comprises a composition comprising:

- a first organic compound comprising ≥ 7 to ≤ 14 aromatic rings and at least one triarylamine moiety; and
- a second organic compound comprising ≥ 7 to ≤ 14 aromatic rings;
  wherein the HOMO energy level of the second organic compound is in the range of ≤ -5 eV to ≥ -6.5 eV; and
- a first organic p-dopant comprising at least three CN groups, and wherein the first organic p-dopant has a molecular weight of ≥ 400 g/mol, and

wherein
the following equations (a) and (b) are fulfilled:

(a) 0.2 eV < Δ [LUMO energy level of the first organic compound - LUMO energy level of the second organic compound] < 3.5 eV; and
(b) 0 eV < Δ [HOMO energy level of the first organic compound - LUMO energy level of the first organic p-dopant] < 1.5 eV;

wherein

the first organic p-dopant comprises independently of each other at least two groups selected from $C_6$ to $C_{19}$ aryl group or $C_3$ to $C_{12}$ heteroaryl group, wherein each of the $C_6$ to $C_{19}$ aryl group or $C_3$ to $C_{12}$ heteroaryl group is substituted,
wherein the one or more substituents are independently selected from halogen, F, CN, partially perfluorinated $C_1$ to $C_{12}$ alkyl, perfluorinated $C_1$ to $C_{12}$ alkyl, $CF_3$; and

wherein
the dipole moment of the second organic compound is selected in the range ≥ 0.5 Debye to ≤ 5 Debye; and
wherein the hole injection layer is in direct contact with the anode layer.

According to one embodiment, wherein the organic electroluminescent device comprising an anode layer, a cathode layer, a first emission layer, and a hole injection layer,

the hole injection layer comprises a composition comprising:

- a first organic compound comprising ≥ 7 to ≤ 14 aromatic rings and at least one triarylamine moiety; and
- a second organic compound comprising ≥ 7 to ≤ 14 aromatic rings;
  wherein the HOMO energy level of the second organic compound is in the range of ≤ -5 eV to ≥ -6.5 eV; and
- a first organic p-dopant comprising at least three CN groups, and wherein the first organic p-dopant has a molecular weight of ≥ 400 g/mol, and

wherein
the following equations (a) and (b) are fulfilled:

(a) 0.2 eV < Δ [LUMO energy level of the first organic compound - LUMO energy level of the second organic compound] < 3.5 eV; and
(b) 0 eV < Δ [HOMO energy level of the first organic compound - LUMO energy level of the first organic p-dopant] < 1.5 eV;

wherein

the first organic p-dopant comprises independently of each other at least two groups selected from $C_6$ to $C_{19}$ aryl group or $C_3$ to $C_{12}$ heteroaryl group, wherein each of the $C_6$ to $C_{19}$ aryl group or $C_3$ to $C_{12}$ heteroaryl group is substituted,
wherein the one or more substituents are independently selected from halogen, F, CN, partially perfluorinated $C_1$ to $C_{12}$ alkyl, perfluorinated $C_1$ to $C_{12}$ alkyl, $CF_3$; and

wherein
the dipole moment of the second organic compound is selected in the range ≥ 0.5 Debye to ≤ 5 Debye; and
wherein
the second organic compound comprises an azine group, preferably a triazine group, a pyrimidine group, a pyridine group, an acridine group, a dibenzoacridine group, a dibenzo[c,h]acridine group, a benzo[h]quinazoline group and/or a 3,8a-dihydroimidazo[1,5-a]pyridine group, more preferred a pyrimidine group, a pyridine group and/or an acridine group; and
wherein the hole injection layer is in direct contact with the anode layer.

According to one embodiment, wherein the organic electroluminescent device comprising an anode layer, a cathode layer, a first emission layer, and a hole injection layer,

the hole injection layer comprises a composition comprising:

- a first organic compound comprising ≥ 7 to ≤ 14 aromatic rings and at least one triarylamine moiety; and
- a second organic compound comprising ≥ 7 to ≤ 14 aromatic rings;
  wherein the HOMO energy level of the second organic compound is in the range of ≤ -5 eV to ≥ -6.5 eV; and
- a first organic p-dopant comprising at least three CN groups, and wherein the first organic p-dopant has a molecular weight of ≥ 400 g/mol, and

wherein
the following equations (a) and (b) are fulfilled:

(a) 0.2 eV < Δ [LUMO energy level of the first organic compound - LUMO energy level of the second organic compound] < 3.5 eV; and
(b) 0 eV < Δ [HOMO energy level of the first organic compound - LUMO energy level of the first organic p-dopant] < 1.5eV;

wherein

the first organic p-dopant comprises independently of each other at least two groups selected from $C_6$ to $C_{19}$ aryl group or $C_3$ to $C_{12}$ heteroaryl group, wherein each of the $C_6$ to $C_{19}$ aryl group or $C_3$ to $C_{12}$ heteroaryl group is substituted,
wherein the one or more substituents are independently selected from halogen, F, CN, partially perfluorinated $C_1$ to $C_{12}$ alkyl, perfluorinated $C_1$ to $C_{12}$ alkyl, $CF_3$; and

wherein the hole injection layer is:

- free of HAT-CN; and
- free of TPBi (CAS Registry number 192198-85-9); and
- free of TPBi, CBP, NPB, TCTA and $Alq_3$; and
- free of metal and/or metal cation; and

wherein the hole injection layer is in direct contact with the anode layer.

According to one embodiment, wherein the second organic compound comprising ≥ 7 to ≤ 14 aromatic rings, if formed as a separated organic semiconductor layer, said separated organic semiconductor layer consisting of the second organic compound has a spontaneous orientation polarization in the range of ≥ 0 mV/nm to ≤ 150 mV/nm, preferably a spontaneous orientation polarization of ≥ 5 mV/nm, more preferred ≥ 10 mV/nm, most preferred ≥ 15 mV/nm, or a spontaneous orientation polarization of ≥ 8 mV/nm to ≤ 100 mV/nm, preferably ≥ 9 mV/nm and ≤ 80 mV/nm, more preferred ≥ 10 mV/nm to ≤ 70 mV/nm.

According to one embodiment, wherein the hole injection layer comprises a composition comprising

- a first organic compound comprising ≥ 7 to ≤ 14 aromatic rings and at least one triarylamine moiety; and
- a second organic compound comprising ≥ 7 to ≤ 14 aromatic rings, wherein the second organic compound comprises at least one substituted or unsubstituted $C_3$ to $C_{24}$ heteroaryl group, azine group, 5-membered N-heteroaryl group, 6-membered N-heteroaryl group, or 6-membered heteroaryl group comprising between 1 and 3 N atoms,

wherein the substituents of the at least one substituted or unsubstituted $C_3$ to $C_{24}$ heteroaryl group are selected from the group comprising H, D, F, C(-O)$R^{22}$, CN, Si$(R^{22})_3$, P(-O)$(R^{22})_2$, O$R^{22}$, S(-O)$R^{22}$, S$(-O)_2R^{22}$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted substituted or unsubstituted aromatic ring systems having 6 to 40 aromatic ring atoms, and substituted or unsubstituted heteroaromatic ring systems having 5 to 40 aromatic ring atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein $R^{22}$ is selected from H, D, straight-chain alkyl having 1 to 6 carbon atoms, branched alkyl having 1 to 6

carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl; and

- a first organic p-dopant comprises at least three CN groups, wherein the first organic p-dopant comprises independently of each other at least two groups selected from $C_6$ to $C_{19}$ aryl group or $C_3$ to $C_{12}$ heteroaryl group, wherein each of the $C_6$ to $C_{19}$ aryl group or $C_3$ to $C_{12}$ heteroaryl group is substituted,

wherein the one or more substituents are independently selected from halogen, F, CN, partially perfluorinated $C_1$ to $C_{12}$ alkyl, perfluorinated $C_1$ to $C_{12}$ alkyl, $CF_3$;
wherein
optionally the second organic compound comprising ≥ 7 to ≤ 14 aromatic rings, if formed as a separated organic semiconductor layer, said separated organic semiconductor layer consisting of the second organic compound has a spontaneous orientation polarization in the range of ≥ 0 mV/nm to ≤ 150 mV/nm.

According to one embodiment, wherein the composition of the hole injection layer consists of:

- a first organic compound comprising ≥ 7 to ≤ 14 aromatic rings and at least one triarylamine moiety; and
- a second organic compound comprising ≥ 7 to ≤ 14 aromatic rings; and
- a first organic p-dopant comprising at least three CN groups, and wherein the first organic p-dopant has a molecular weight of ≥ 400 g/mol and ≤ 2000 g/mol.

**Spontaneous orientation polarization of a separated organic semiconductor layer**

The spontaneous orientation polarization is a physical property of a layer consisting of the compound or composition.

The spontaneous orientation polarization cannot be determined for a layer comprised in an organic electroluminescent device, as the other layers in the organic electroluminescent device would interfere with the measurement method.

Instead, a separated organic electronic device has to be prepared which comprises a layer consisting of the compound or composition.

In this context, the term "separated organic semiconductor layer" means a layer consisting of compound or composition in an organic electronic device which has been prepared for the purpose of determining the spontaneous orientation polarization of a layer.

The spontaneous orientation polarization of a layer may be determined by methods known in the art.

**Method of determining the spontaneous orientation polarization via impedance measurement**

The spontaneous orientation polarization for a separated organic semiconductor layer may be determined via impedance measurement of a separated organic electronic device (200), see Figure 5.

The measurement is conducted by determining the capacitance at varied bias voltage and a fixed frequency of 1kHz at 20 °C of a separated organic electronic device, also named "device".

The spontaneous orientation polarization of an organic semiconductor layer may be determined by performing the following steps:

- In a first step, four devices d1 to d4 are prepared as described below;
- In a second step, the impedance at a fixed frequency of 1kHz and environment temperature of 20°C is measured in Rp-Cp mode in the dark by applying a swept bias voltage from -20 V to 20 V in 0.1 V increments and using an AC-amplitude of 50mV for each of the four devices d1 to d4, wherein the thickness t of the organic semiconductor layer consisting of the second organic compound or composition is varied between 50 and 200 nm in 50 nm increments;
- In a third step, the parallel capacitance Cp in nano farad (nF) is plotted against the voltage in V;
- In a fourth step, the transition voltage v1 to v4 is determined for four different thickness t1 to t4 by determining the lowest applied bias voltage at which the capacitance increases;
- In a fifth step, the transition voltage v1 to v4 is plotted against the layer thickness t1 to t4 and the spontaneous orientation polarization in mV/nm is determined by determining the slope of a linear fit of the data points.

**Method of preparing four devices d1 to d4**

The layer arrangement of the four devices d1 to d4 can be seen in Figure 5.

The four devices d1 to d4 are prepared by performing the following steps:

- In a first step, a glass substrate with an anode layer comprising a first anode sub-layer of 120 nm Ag, a second anode sub-layer of 8 nm ITO and a third anode sub-layer of 10 nm ITO was cut to a size of 25 mm x 25 mm x 0.7 mm, ultrasonically washed with water for 60 minutes and then with isopropanol for 20 minutes. The liquid film was removed in a nitrogen stream, followed by plasma treatment to prepare the anode layer. The plasma treatment was performed in an atmosphere comprising 97.6 vol.-% nitrogen and 2.4 vol.-% oxygen to prepare the anode;
- In a second step, the substrate was transferred to an evaporation chamber and biphenyl-4-yl(9,9-diphenyl-9H-fluoren-2-yl)-[4-(9-phenyl-9H-carbazol-3-yl)phenyl]-amine (CAS 1242056-42-3) was vacuum deposited on the anode, to form a HTL (230) having a thickness of 50 nm;
- In a third step, the second organic compound or comparative compound is vacuum deposited at a rate of 1 Å/s at $10^{-7}$ to $8.10^{-7}$ mbar on the HTL to form an organic semiconductor layer (240) with a thickness of 50 nm (device d1 with thickness t1), 100 nm (device d2 with thickness t2), 150 nm (device d3 with thickness t3) or 200 nm (device d4 with thickness t4), wherein the process pressure was derminted at a distance to the substrate of ≥ 60 cm using a pressure gauge (BPG400 BA Pirani Gauge);
- In a fourth step, the cathode layer (250) is vacuum deposited on the organic semiconductor layer by depositing AgMg alloy (90 vol.-%/ 10 vol.-%);
- In a fifth step, the device stack is protected from ambient conditions by encapsulation of the device with a glass lid. The glass lid comprises a cavity, which may include a getter material for further protection.

**First organic compound**

The first organic compound may be an organic compound, consisting of or consisting substantially of a covalently bound C, H, O, N, S, which may optionally comprise also covalently bound B, P or Si. The first organic compound may be an organic aromatic covalent bonded compound, which is free of metal atoms, and the majority of its skeletal atoms may be selected from C, O, S, N and preferably from C, O and N, wherein the majority of atoms are C-atoms. Alternatively, the first organic compound is free of metal atoms and majority of its skeletal atoms may be selected from C and N, preferably the first organic compound is free of metal atoms and majority of its skeletal atoms may be selected from C and the minority of its skeletal atoms may be N.

According to one embodiment, the first organic compound of the hole injection layer may have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol, also preferred a molecular weight Mw of ≥ 600 and ≤ 800 g/mol.

In one embodiment, the HOMO energy level of the first organic compound may be more negative than the HOMO energy level of N2,N2,N2',N2',N7,N7,N7',N7'-octakis(4-methoxyphenyl)-9,9'-spirobi[fluorene]-2,2',7,7'-tetraamine (CAS 207739-72-8) when determined under the same conditions.

In one embodiment, the HOMO energy level of the first organic compound, when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, may be more negative than -4.27 eV, preferably more negative than -4.3 eV, alternatively more negative than -4.5 eV, alternatively more negative than -4.6 eV, alternatively more negative than -4.65 eV.

In one embodiment, the HOMO energy level of the first organic compound may be more negative than the HOMO energy level of N2,N2,N2',N2',N7,N7,N7',N7'-octakis(4-methoxyphenyl)-9,9'-spirobi[fluorene]-2,2',7,7'-tetraamine (CAS 207739-72-8) and more positive than the HOMO level of N-([1,1'-biphenyl]-2-yl)-N-(9,9-dimethyl-9H-fluoren-2-yl)-9,9'-spirobi[fluoren]-4-amine when determined under the same conditions.

In one embodiment, the HOMO energy level of the first organic compound, when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, may be selected in the range of ≤ -4.27 eV and ≥ -4.95 eV, alternatively in the range of ≤ -4.3 eV and ≥ -4.95 eV, alternatively in the range of ≤ -4.5 eV and ≥ -4.95 eV, alternatively in the range of ≤ -4.6 eV and ≥ -4.95 eV, alternatively in the range of ≤ -4.65 eV and ≥ -4.95 eV; alternatively in the range of < -4.65 eV and ≥ -4.93 eV.

In one embodiment, the LUMO energy level of the first organic compound of the hole injection layer is the range of ≥ -1.5 eV to ≤ -0.7 eV, preferably ≥ -1.3 eV to ≤ -0.8 eV, more preferably ≥ -1.2 eV to ≤ -0.85 eV.

In one embodiment, the dipole moment of the first organic compound of the hole injection layer is in the range of ≥ 0.2 Debye and ≤ 3 Debye, and preferably ≥ 0.25 Debye and ≤ 2.5 Debye.

In one embodiment, the dipole moment of the first organic compound of the hole injection layer, when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, may be selected in the range of ≥ 0.2 Debye and ≤ 3 Debye, preferably ≥ 0.25 Debye and ≤ 2.5 Debye.

Preferably, the first organic compound of the hole injection layer is free of metals and/or ionic bonds.

In one embodiment of the present invention, the first organic compound may be free of alkoxy groups.

Preferably, the first organic compound comprises at least one arylamine moiety, alternatively a diarylamine moiety, alternatively a triarylamine moiety.

Preferably, the first organic compound is free of TPD or NPB.

The first organic compound is not a p-dopant compound.

**Compound of formula (Ia) or a compound of formula (Ib)**

According to another aspect of the present invention, the first organic compound is selected from a compound of formula (Ia) or a compound of formula (Ib):

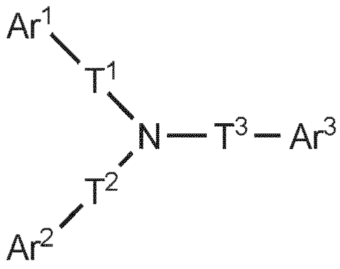 (Ia), 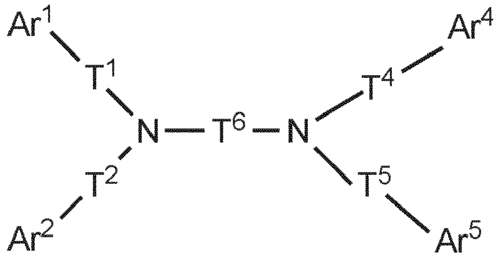 (Ib),

wherein:

$T^1$, $T^2$, $T^3$, $T^4$ and $T^5$ are independently selected from a single bond, phenylene, biphenylene, terphenylene or naphthenylene, preferably a single bond or phenylene;

$T^6$ is phenylene, biphenylene, terphenylene or naphthenylene;

$Ar^1$, $Ar^2$, $Ar^3$, $Ar^4$ and $Ar^5$ are independently selected from substituted or unsubstituted $C_6$ to $C_{20}$ aryl, or substituted or unsubstituted $C_3$ to $C_{20}$ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;

wherein

the substituents of $Ar^1$, $Ar^2$, $Ar^3$, $Ar^4$ and $Ar^3$ are selected the same or different from the group comprising H, D, F, C(-O) $R^{11}$, CN, $Si(R^{11})_3$, $P(-O)(R^{11})_2$, $OR^{11}$, $S(-O)R^{11}$, $S(-O)_2R^{11}$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted substituted or unsubstituted aromatic ring systems having 6 to 40 aromatic ring atoms, and substituted or unsubstituted heteroaromatic ring systems having 5 to 40 aromatic ring atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,

wherein $R^{11}$ may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl.

Preferably, the substituents of $Ar^1$, $Ar^2$, $Ar^3$, $Ar^4$ and $Ar^5$ are selected the same or different from the group comprising H, straight-chain alkyl having 1 to 6 carbon atoms, branched alkyl having 1 to 6 carbon atoms, cyclic alkyl

having 3 to 6 carbon atoms, alkenyl or alkynyl groups having 2 to 6 carbon atoms, $C_6$ to $C_{18}$ aryl, $C_3$ to $C_{18}$ heteroaryl, a fused ring system comprising 2 to 4 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle; more preferred the substituents are selected the same or different from the group consisting of H, straight-chain alkyl having 1 to 4 carbon atoms, branched alkyl having 1 to 4 carbon atoms, cyclic alkyl having 3 to 4 carbon atoms and/or phenyl.

Thereby, the compound of formula (Ia) or (Ib) may have a rate onset temperature suitable for mass production.

According to an embodiment of the hole injection layer, wherein the first organic compound is selected from a compound of formula (Ia) or formula (Ib):

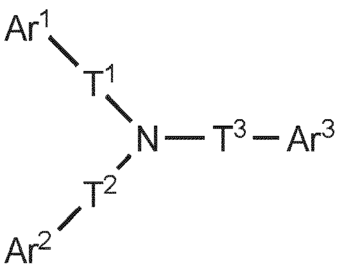 (Ia), 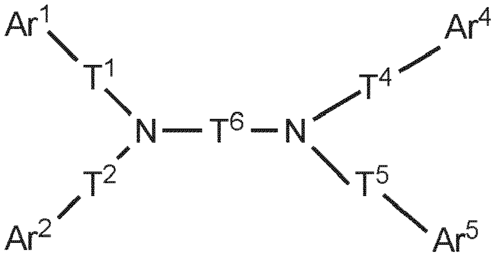 (Ib),

wherein

$T^1$, $T^2$, $T^3$, $T^4$ and $T^5$ may be independently selected from a single bond, phenylene, biphenylene, terphenylene or naphthenylene, preferably a single bond or phenylene;
$T^6$ is phenylene, biphenylene, terphenylene or naphthenylene;
$Ar^1$, $Ar^2$, $Ar^3$, $Ar^4$ and $Ar^5$ may be independently selected from unsubstituted $C_6$ to $C_{20}$ aryl, or unsubstituted $C_3$ to $C_{20}$ heteroarylene, unsubstituted biphenylene, unsubstituted fluorene, substituted 9-fluorene, substituted 9,9-fluorene, unsubstituted naphthalene, unsubstituted anthracene, unsubstituted phenanthrene, unsubstituted pyrene, unsubstituted perylene, unsubstituted triphenylene, unsubstituted tetracene, unsubstituted tetraphene, unsubstituted dibenzofurane, unsubstituted dibenzothiophene, unsubstituted xanthene, unsubstituted carbazole, substituted 9-phenylcarbazole, unsubstituted azepine, unsubstituted dibenzo[b,f]azepine, unsubstituted 9,9'-spirobi[fluorene], unsubstituted spiro[fluorene-9,9'-xanthene], or a unsubstituted aromatic fused ring system comprising at least three unsubstituted aromatic rings selected from the group comprising unsubstituted non-hetero, unsubstituted hetero 5-member rings, unsubstituted 6-member rings and/or unsubstituted 7-member rings, unsubstituted fluorene, or a fused ring system comprising 2 to 6 unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle.

According to an embodiment of the hole injection layer, wherein the first organic compound is selected from a compound of formula (Ia) or formula (Ib):

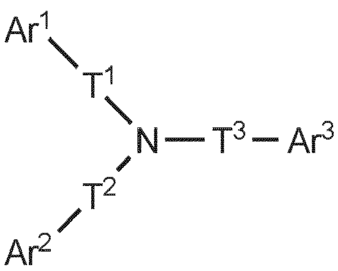 (Ia), 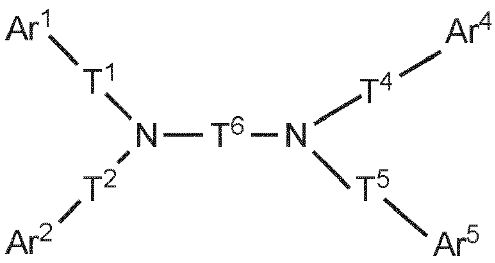 (Ib),

wherein

$T^1$, $T^2$, $T^3$, $T^4$ and $T^5$ may be independently selected from a single bond, phenylene, biphenylene, terphenylene or naphthenylene, preferably a single bond or phenylene;
$T^6$ is phenylene, biphenylene, terphenylene or naphthenylene;
$Ar^1$, $Ar^2$, $Ar^3$, $Ar^4$ and $Ar^5$ may be independently selected from unsubstituted $C_6$ to $C_{20}$ aryl, or unsubstituted $C_3$ to $C_{20}$ heteroarylene, unsubstituted biphenylene, unsubstituted fluorene, substituted 9-fluorene, substituted 9,9-fluorene,

unsubstituted naphthalene, unsubstituted anthracene, unsubstituted phenanthrene, unsubstituted pyrene, unsubstituted perylene, unsubstituted triphenylene, unsubstituted tetracene, unsubstituted tetraphene, unsubstituted dibenzofurane, unsubstituted dibenzothiophene, unsubstituted xanthene, unsubstituted carbazole, substituted 9-phenylcarbazole, unsubstituted azepine, unsubstituted dibenzo[b,f]azepine, unsubstituted 9,9'-spirobi[fluorene], unsubstituted spiro[fluorene-9,9'-xanthene].

Thereby, the compound of formula (Ia) or (Ib) may have a rate onset temperature suitable for mass production.

According to an embodiment wherein $T^1$, $T^2$, $T^3$, $T^4$ and $T^5$ may be independently selected from a single bond, phenylene, biphenylene or terphenylene.

According to an embodiment wherein $T^1$, $T^2$, $T^3$, $T^4$ and $T^5$ may be independently selected from phenylene, biphenylene or terphenylene and one of $T^1$, $T^2$, $T^3$, $T^4$ and $T^5$ are a single bond. According to an embodiment wherein $T^1$, $T^2$, $T^3$, $T^4$ and $T^5$ may be independently selected from phenylene or biphenylene and one of $T^1$, $T^2$, $T^3$, $T^4$ and $T^5$ are a single bond.

According to an embodiment wherein $T^1$, $T^2$, $T^3$, $T^4$ and $T^5$ may be independently selected from phenylene or biphenylene and two of $T^1$, $T^2$, $T^3$, $T^4$ and $T^5$ are a single bond.

According to an embodiment wherein $T^1$, $T^2$ and $T^3$ may be independently selected from phenylene and one of $T^1$, $T^2$ and $T^3$ are a single bond.

According to an embodiment wherein $T^1$, $T^2$ and $T^3$ may be independently selected from phenylene and two of $T^1$, $T^2$ and $T^3$ are a single bond.

According to an embodiment wherein $T^6$ may be phenylene, biphenylene, terphenylene. According to an embodiment wherein $T^6$ may be phenylene.

According to an embodiment wherein $T^6$ may be biphenylene. According to an embodiment wherein $T^6$ may be terphenylene.

According to an embodiment wherein $Ar^1$, $Ar^2$, $Ar^3$, $Ar^4$ and $Ar^5$ may be independently selected from formulae (A1) to (A16):

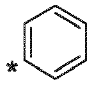 (A1), 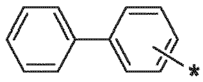 (A2), 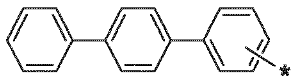 (A3), 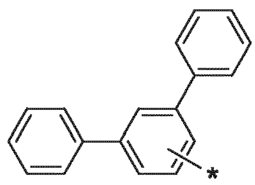 (A4),

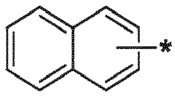 (A5), 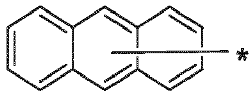 (A6), 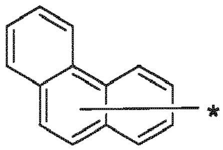 (A7),

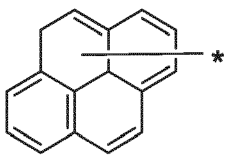 (A8), 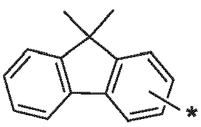 (A9), 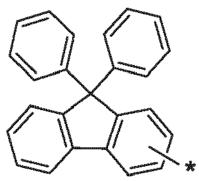 (A10), 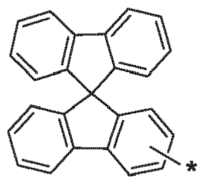 (A11),

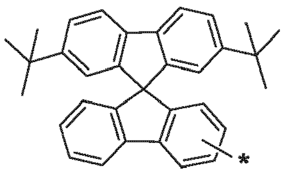 (A12), 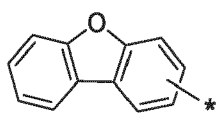 (A13), 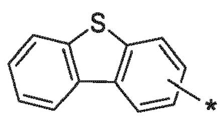 (A14),

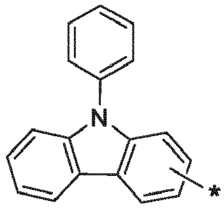 (A15), 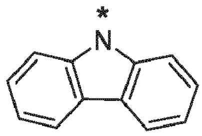 (A16),

wherein the asterix "*" denotes the binding position.

According to an embodiment, wherein $Ar^1$, $Ar^2$, $Ar^3$, $Ar^4$ and $Ar^5$ may be independently selected from (A1) to (A15); alternatively selected from (A1) to (A10) and (A13) to (A15).

According to an embodiment, wherein $Ar^1$, $Ar^2$, $Ar^3$, $Ar^4$ and $Ar^3$ may be independently selected from the group consisting of (A1), (A2), (A5), (A7), (A9), (A10), (A13) to (A16).

The rate onset temperature may be in a range particularly suited to mass production, when $Ar^1$, $Ar^2$, $Ar^3$, $Ar^4$ and $Ar^5$ are selected in this range.

The "first organic compound" and "compound of formula (Ia) or formula (Ib) " may be also referred to as "hole transport compound".

According to one embodiment the compound of formula (Ia) or formula (Ib) may comprises at least ≥ 1 to < 6 substituted or unsubstituted aromatic fused ring systems comprising heteroaromatic rings.

According to one embodiment the compound of formula (Ia) or formula (Ib) may comprises at least ≥ 1 to ≤ 6 substituted or unsubstituted aromatic fused ring systems comprising heteroaromatic rings and at least ≥ 1 to ≤ 3 substituted or unsubstituted unsaturated 5- to 7-member ring of a heterocycle, preferably ≥ 2 to ≤ 5 substituted or unsubstituted aromatic fused ring systems comprising heteroaromatic rings.

According to one embodiment the compound of formula (Ia) or formula (Ib) may comprises at least ≥ 1 to ≤ 6 substituted or unsubstituted aromatic fused ring systems comprising heteroaromatic rings and at least ≥ 1 to ≤ 3 substituted or unsubstituted unsaturated 5- to 7-member ring of a heterocycle, preferably ≥ 2 to ≤ 5 substituted or unsubstituted aromatic fused ring systems comprising heteroaromatic rings, and at least ≥ 1 to ≤ 3 substituted or unsubstituted unsaturated 5- to 7-member ring of a heterocycle, further preferred 3 or 4 substituted or unsubstituted aromatic fused ring systems comprising heteroaromatic rings and optional at least ≥ 1 to ≤ 3 substituted or unsubstituted unsaturated 5- to 7-member ring of a heterocycle, and additional preferred wherein the aromatic fused ring systems comprising heteroaromatic rings are unsubstituted and optional at least ≥ 1 to ≤ 3 unsubstituted unsaturated 5- to 7-member ring of a heterocycle.

According to one embodiment the compound of formula (Ia) or formula (Ib) may comprises:

- a substituted or unsubstituted aromatic fused ring systems with at least ≥ 2 to ≤ 6, preferably ≥ 3 to ≤ 5, or 4 fused aromatic rings selected from the group comprising substituted or unsubstituted non-hetero aromatic rings, substituted or unsubstituted hetero 5-member rings, substituted or unsubstituted 6-member rings and/or substituted or unsubstituted unsaturated 5-to 7- member ring of a heterocycle; or
- an unsubstituted aromatic fused ring systems with at least ≥ 2 to ≤ 6, preferably ≥ 3 to ≤ 5, or 4 fused aromatic rings selected from the group comprising unsubstituted non-hetero aromatic rings, unsubstituted hetero 5-member rings, unsubstituted 6-member rings and/or unsubstituted unsaturated 5- to 7-member ring of a heterocycle.

It should be noted here that the wording "aromatic fused ring system" may include at least one aromatic ring and at least one substituted or unsubstituted unsaturated 5- to 7- member ring. It should be noted here that the substituted or unsubstituted unsaturated 5- to 7- member ring may not be an aromatic ring.

According to one embodiment, the substantially first organic compound comprises at least one naphthyl group, carbazole group, dibenzofurane group, dibenzothiophene group and/or substituted fluorenyl group, wherein the substituents are independently selected from methyl, phenyl or fluorenyl.

According to an embodiment, the first organic compound is a compound of formula (Ia). Thereby, the HOMO energy level, LUMO energy level and dipole moment of the first organic compound may be in the particularly preferred range. The thermal properties of the first organic compound may be particularly suitable for mass production of organic electroluminescent devices via vacuum thermal evaporation.

According to an embodiment of the present invention, wherein the first organic compound, compound of formula (Ia) or formula (Ib) are selected from formulae (F 1) to (F23):

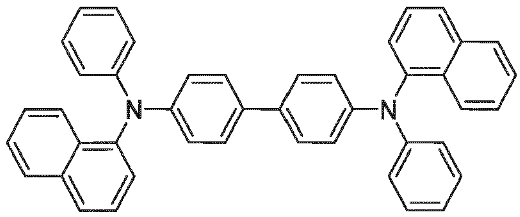
(F1),
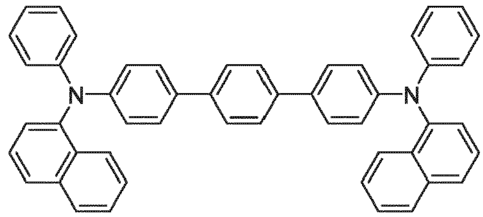
(F2),

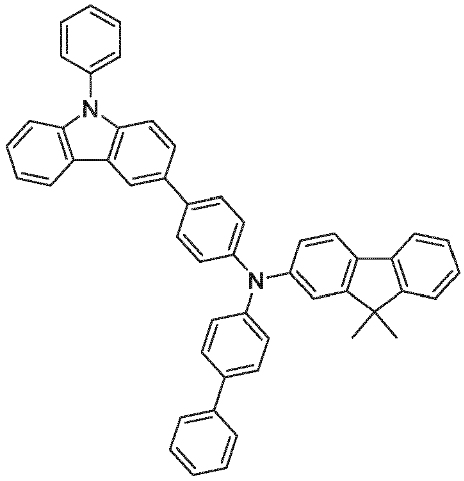
(F3),
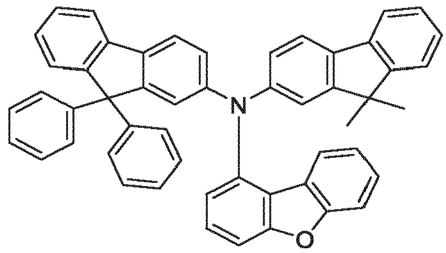
(F4),

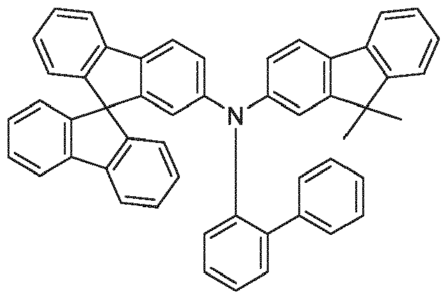
(F5),
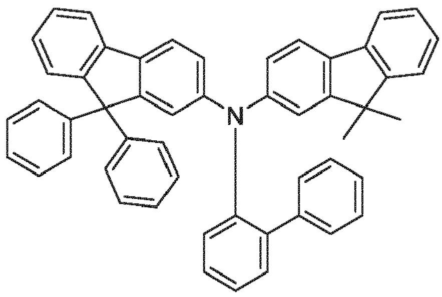
(F6),

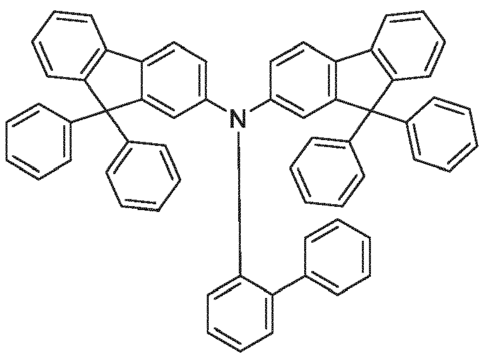
(F7),
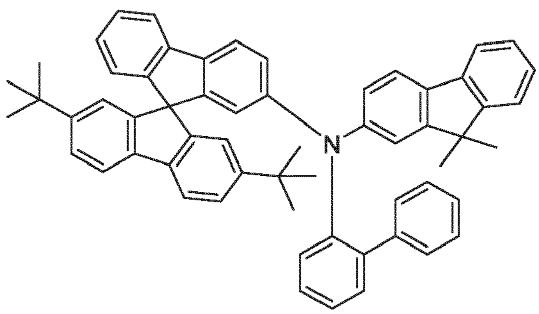
(F8),

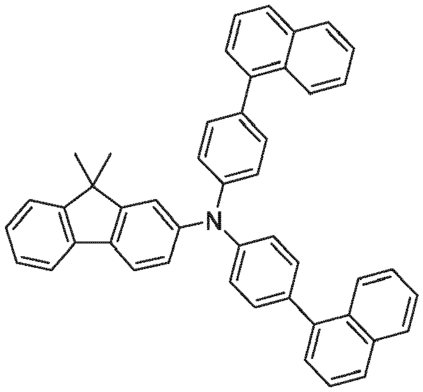 (F9),

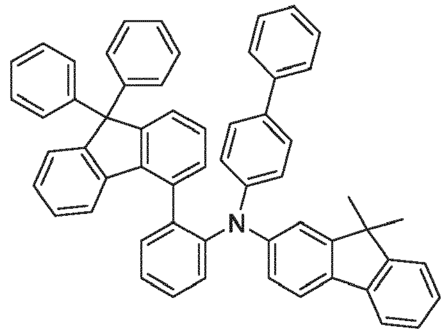 (F10),

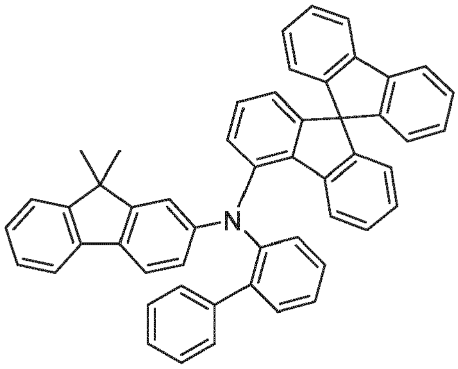 (F11),

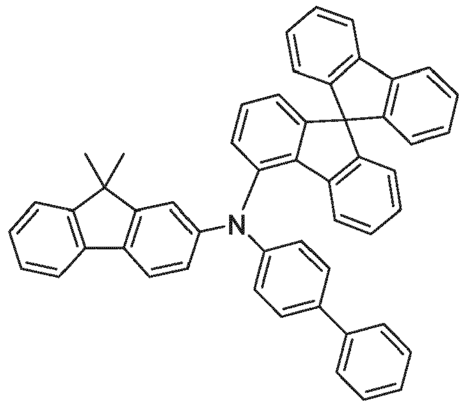 (F12),

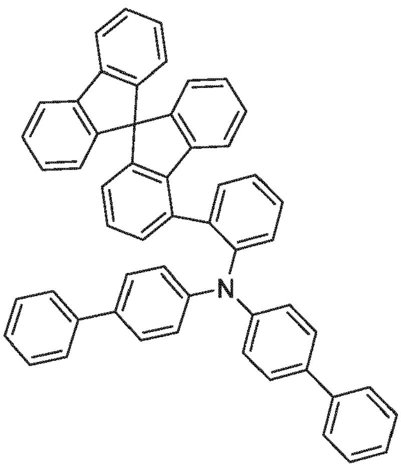 (F13),

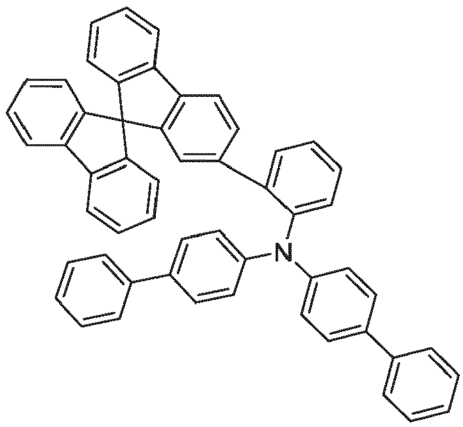 (F14),

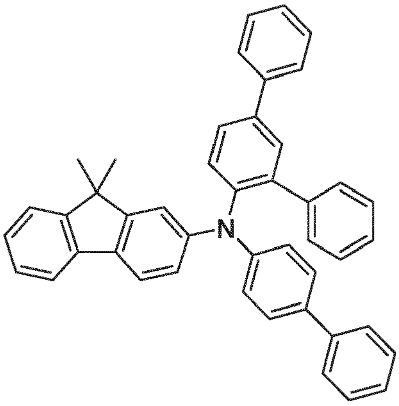 (F15), 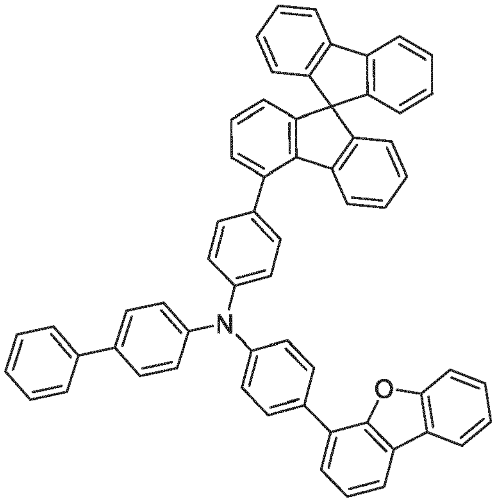 (F16),

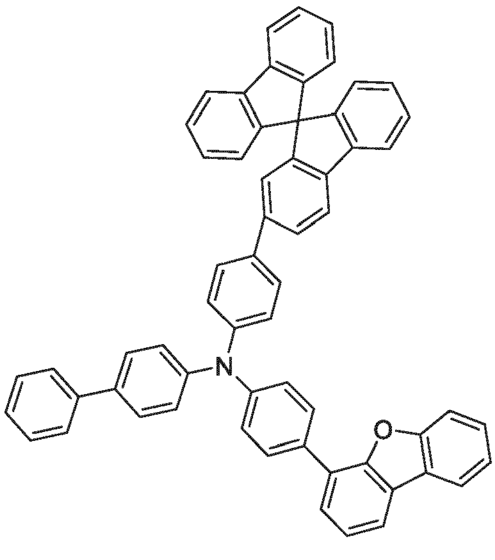 (F17), 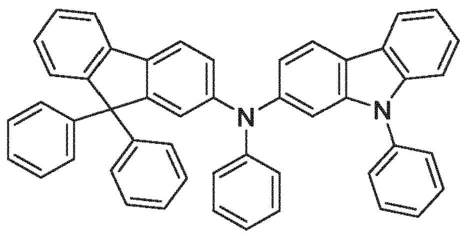 (F18),

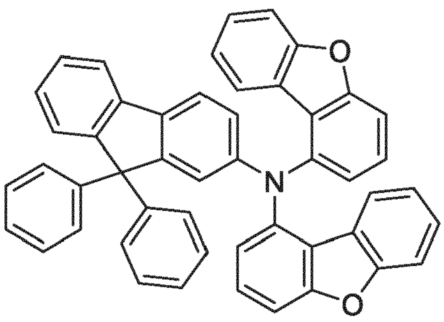 (F19), 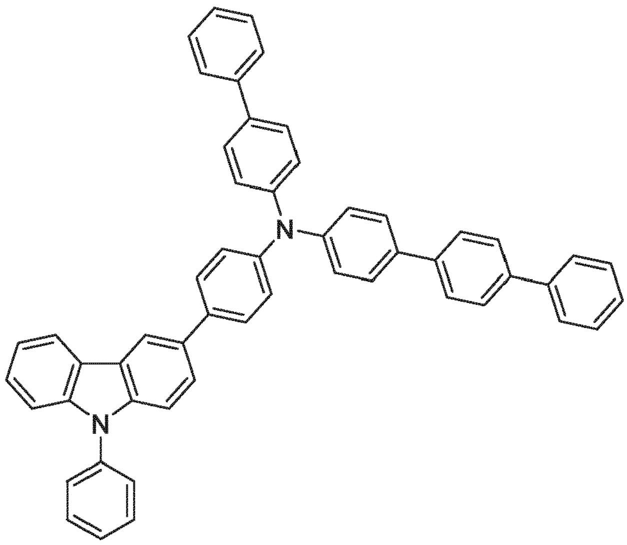 (F20),

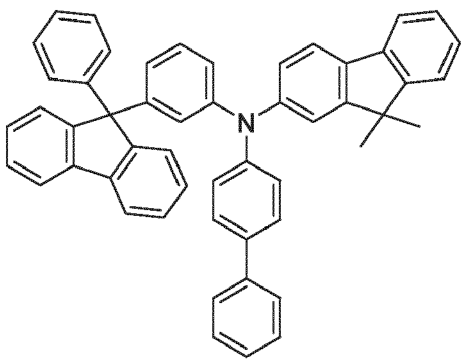
(F21),

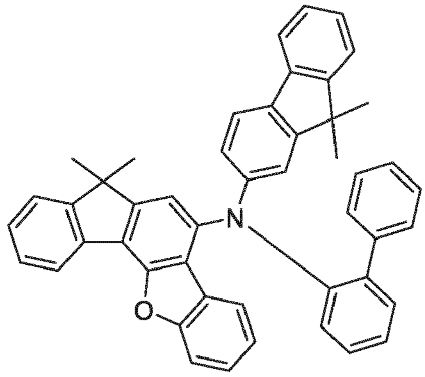
(F22),

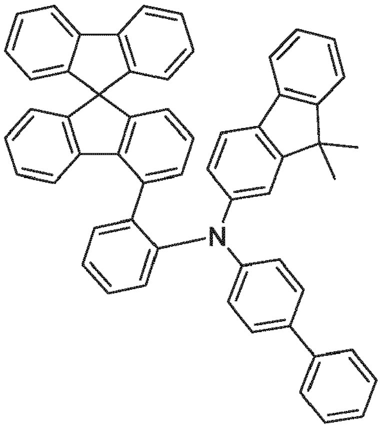
(F23).

Preferably, the first organic compound of the hole injection layer or compound of formula (Ia) is selected from formulae (F3) to (F23), more preferred from (F4) to (F23), most preferred from (F4), (F10), (F18), (F22) and (F23).

Second organic compound

The second organic compound consists or may consist substantially of covalently bound C, H, O, N, S, which optionally comprise in addition covalently bound B, P, As and/or Se.

According to an embodiment of the present invention, the second organic compound compound preferably comprises at least one $C_2$ to $C_{24}$ N-heteroaryl or P=X group, with X being O, S or Se, with O being especially preferred.

According to an embodiment of the present invention, the second organic compound of the hole injection layer may comprises an azine group, preferably a triazine group, a pyrimidine group, a pyridine group, an acridine group, a dibenzoacridine group, a dibenzo[c,h]acridine group, a benzo[h]quinazoline group and/or a 3,8a-dihydroimidazo[1,5-a] pyridine group, more preferred a pyrimidine group, a pyridine group and/or an acridine group.

According to an embodiment of the present invention, the at least one $C_2$ to $C_{24}$ N-heteroaryl may be selected from a compound comprising at least one azine group, preferably at least two azine groups, also preferred three azine groups.

According to an embodiment of the present invention, the second organic compound compound comprises at least one group selected from the list consisting of pyridine, pyrimidine, triazine, imidazole, benzimidazole, benzooxazole, quinoline, quinoxaline, benzoquinoxaline, acridine, phenanthroline, benzoacridine, dibenzoacridine, imidazopyridine.

According to one embodiment, the second organic compound compound comprises at least 15 covalently bound atoms, preferably at least 20 covalently bound atoms, more preferably at least 25 covalently bound atoms, and most preferably at least 30 covalently bound atoms.

According to one embodiment, the organic substantially covalent additive compound comprises at least 15 covalently bound atoms, preferably at least 20 covalently bound atoms, more preferably at least 25 covalently bound atoms, and most preferably at least 30 covalently bound atoms.

According to one embodiment, the second organic compound compound may have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, further preferred a molecular weight Mw of ≥ 550 and ≤ 900 g/mol, in addition preferred a molecular weight Mw of ≥ 580 and ≤ 800 g/mol, also preferred a molecular weight Mw of ≥ 600 and ≤ 800 g/mol.

According to one embodiment, the second organic of the hole injection layer comprises

- at least one $C_2$ to $C_{24}$ N-heteroaryl or P=X group, with X being O, S or Se, with O being especially preferred; wherein the at least one $C_2$ to $C_{24}$ N-heteroaryl optional be selected from a compound comprising at least one azine group, preferably at least two azine groups, also preferred three azine groups; and/or
- at least one group selected from the list consisting of pyridine, pyrimidine, triazine, imidazole, benzimidazole, benzooxazole, quinoline, quinoxaline, benzoquinoxaline, acridine, phenanthroline, benzoacridine, dibenzoacridine, imidazopyridine; and/or
- at least 15 covalently bound atoms, preferably at least 20 covalently bound atoms, more preferably at least 25 covalently bound atoms, and most preferably at least 30 covalently bound atoms; and/or
- a molecular weight Mw of ≥ 400 to ≤ 2000 g/mol, preferably a molecular weight Mw of ≥ 450 to ≤ 1500 g/mol, further preferred a molecular weight Mw of ≥ 500 to ≤ 1000 g/mol, further preferred a molecular weight Mw of ≥ 550 to ≤ 900 g/mol, in addition preferred a molecular weight Mw of ≥ 580 to ≤ 800 g/mol, also preferred a molecular weight Mw of ≥ 600 to ≤ 800 g/mol.

According to one embodiment, the second organic compound is a substantially covalent second organic compound.

According to one embodiment, the second organic compound is free of a metal complex, metal cation and/or metal-organic compound.

According to one embodiment, the second organic compound is not a metal complex or metal cation.

Preferably, the substantially covalent second organic compound is free of metals and/or ionic bonds.

According to one embodiment, the second organic compound is free of triarylamine groups.

According to one embodiment, an organic semiconductor layer comprising the second organic compound comprising ≥ 7 and ≤ 14 aromatic rings, if formed as a separated organic semiconductor layer, said separated organic semiconductor layer consisting of the second organic compound has a spontaneous orientation polarization in the range of ≥ 0 mV/nm to ≤ 150 mV/nm, preferably a spontaneous orientation polarization of ≥ 5 mV/nm, more preferred ≥ 10 mV/nm, most preferred ≥ 15 mV/nm, or a spontaneous orientation polarization of ≥ 8 mV/nm to ≤ 100 mV/nm, preferably ≥ 9 mV/nm and ≤ 80 mV/nm, more preferred ≥ 10 mV/nm to ≤ 70 mV/nm.

According to one embodiment of the present invention, an organic semiconductor layer comprising the second organic compound has a spontaneous orientation polarization of ≥ 5 mV/nm, preferably ≥ 10 mV/nm, more preferably ≥ 15 mV/nm.

According to one embodiment of the present invention, an organic semiconductor layer comprising the second organic compound has a spontaneous orientation polarization of ≥ 8 mV/nm and ≤ 100 mV/nm, preferably ≥ 9 mV/nm and ≤ 80 mV/nm, more preferred ≥ 10 mV/nm and ≤ 70 mV/nm.

Particularly improved performance may be obtained when the spontaneous orientation polarization of an organic semiconductor layer comprising comprising the second organic compound is selected in this range.

According to one embodiment, wherein the HOMO energy level of the second organic compound of the hole injection layer is in the range of ≤ -5 eV to ≥ -6.3 eV, preferably ≤ -5 eV to ≥ -6.2 eV, and more preferably ≤ -5 eV to ≥ -6 eV.

According to one embodiment, the HOMO energy level of the second organic compound is in the range of ≤ -5 eV to ≥ -6.3 eV, preferably ≤ -5 eV to ≥ -6.2 eV, more preferably ≤ -5 eV to ≥ -6 eV; wherein the HOMO energy level is calculated using the hybrid functional B3LYP with a Gaussian 6-31G* basis set as implemented in the program package TURBOMOLE V6.5; and the values are expressed in the absolute scale referring to vacuum energy level being zero.

According to one embodiment, wherein the LUMO energy level of the second organic compound of the hole injection layer is the range of ≥ -3 eV to ≤ -0.8 eV, preferably ≥ -3 eV to ≤ - 1 eV, more preferably ≥ -2.5 eV to ≤ -1 eV, and most preferably ≥ -2 eV to ≤ -1.5 eV.

According to one embodiment, the second organic compound has a LUMO energy level in the range of ≥ -3 eV to ≤ -0.8 eV, preferably ≥ -3 eV to ≤ -1 eV, more preferably ≥ -2.5 eV to ≤ -1 eV, most preferably ≥ -2 eV to ≤ -1.5 eV; wherein the LUMO energy level is calculated using the hybrid functional B3LYP with a Gaussian 6-31G* basis set as implemented in the program package TURBOMOLE V6.5; and the values are expressed in the absolute scale referring to vacuum energy level being zero.

According to one embodiment, wherein the second organic compound of the hole injection layer comprises ≥ 7 to ≤ 14 aromatic rings;
wherein

the HOMO energy level of the second organic compound is in the range of ≤ -5 eV to ≥ -6.5 eV; and
the LUMO energy level of the second organic compound is in the range of ≤ -1.3 eV to ≥ -3.5 eV.

Particularly improved performance may be obtained when the HOMO and/or LUMO energy level of the second

organic compound is selected in this range.

According to one embodiment, wherein the dipole moment of the second organic compound of the hole injection layer is in the range of ≥ 0.2 Debye and ≤ 7 Debye, preferably ≥ 0.3 Debye and ≤ 6 Debye; more preferred ≥ 0.5 Debye and ≤ 5 Debye, and alternatively ≥ 0.5 Debye and ≤ 4.8 Debye.

In one embodiment, the dipole moment of the second organic compound, when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase, may be selected in the range of ≥ 0.5 Debye and ≤ 7 Debye, preferably ≥ 0.5 Debye and ≤ 6 Debye; more preferred ≥ 0.5 Debye and ≤ 5 Debye; alternatively ≥ 0.5 Debye and < 4.8 Debye.

According to an embodiment of the present invention, the second organic compound of the hole injection layer is a compound of formula (II)

$$\left(Ar^{21}\right)_n T^{21} - Ar^{22} - T^{22} \left(Ar^{23}\right)_m \quad (II),$$

$T^{21}$ and $T^{22}$ are independently selected from a single bond, phenylene, biphenylene, terphenylene or naphthenylene, preferably a single bond or phenylene;

n and m is an integer independently selected from 1, 2 or 3, preferably 1 or 2;

$Ar^{21}$ is selected from substituted or unsubstituted $C_6$ to $C_{42}$ aryl, or substituted or unsubstituted $C_3$ to $C_{41}$ heteroarylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (Ia) 6-member ring of an aromatic non-heterocycle;

$Ar^{22}$ is selected from substituted or unsubstituted $C_6$ to $C_{20}$ aryl, or substituted or unsubstituted $C_3$ to $C_{20}$ heteroarylene, a single bond, phenylene, biphenylene, terphenylene or naphthenylene, preferably a single bond, phenylene or naphthalene,

$Ar^{23}$ is selected from a substituted or unsubstituted $C_3$ to $C_{41}$ heteroarylene, a substituted or unsubstituted 5-membered or 6-membered heteroarylene comprising 2 or 3 N atoms, subsituted or unsubstituted azine, pyridine, pyrimidine, triazine, imidazole, benzimidazole, benzooxazole, quinoline, quinoxaline, benzoquinoxaline, acridine, phenanthroline, benzoacridine, dibenzoacridine, imadzopyridine;

wherein
the substituents of $Ar^{21}$, $Ar^{22}$, $Ar^{23}$ are selected the same or different from the group comprising H, D, F, $C(-O)R^{22}$, CN, $Si(R^{22})_3$, $P(-O)(R^{22})_2$, $OR^{22}$, $S(-O)R^{22}$, $S(-O)_2R^{22}$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted substituted or unsubstituted aromatic ring systems having 6 to 40 aromatic ring atoms, and substituted or unsubstituted heteroaromatic ring systems having 5 to 40 aromatic ring atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle, wherein $R^{22}$ may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl.

Preferably, n and m are 1.

According to an embodiment wherein $Ar^{21}$ may be selected from phenyl, naphthyl, biphenyl, phenanthrenyl or formulae (C1) to (C58):

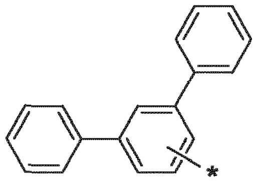 (C1), 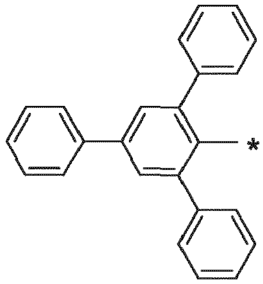 (C2), 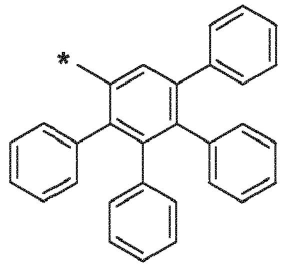 (C3),

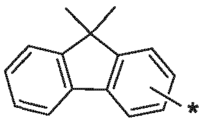 (C4), 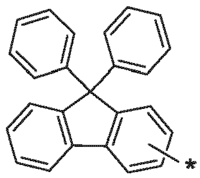 (C5), 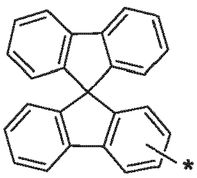 (C6), 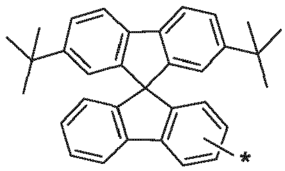 (C7),

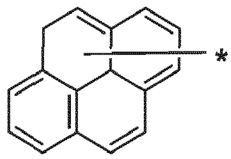 (C8), 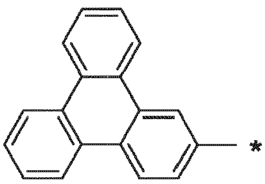 (C9), 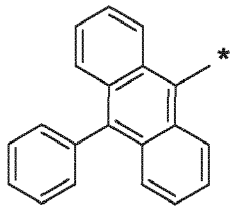 (C10),

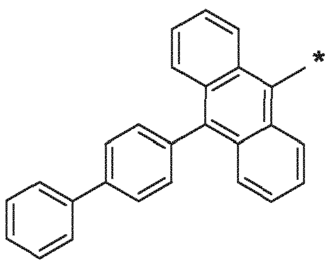 (C11), 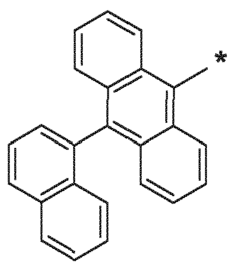 (C12), 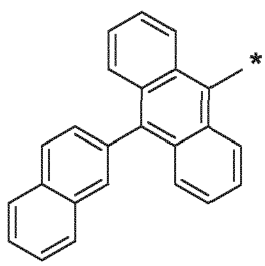 (C13),

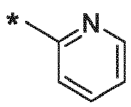 (C14), 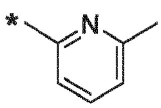 (C15), 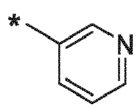 (C16), 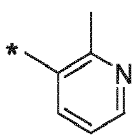 (C17),

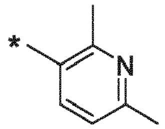 (C18), 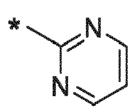 (C19), 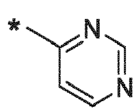 (C20), 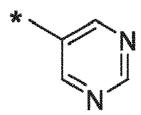 (C21),

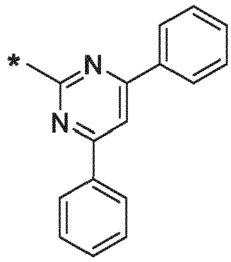 (C22), 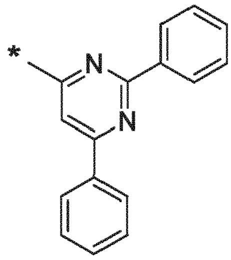 (C23), 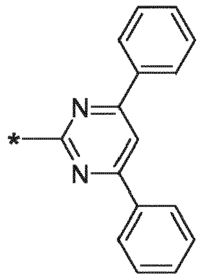 (C24),

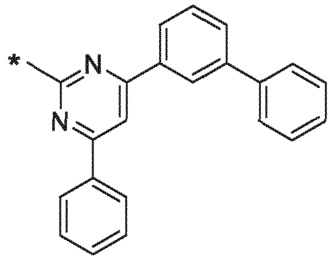 (C25), 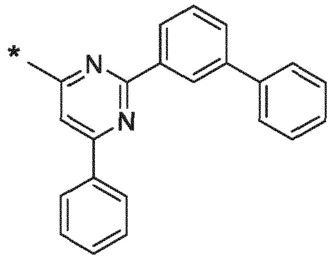 (C26), 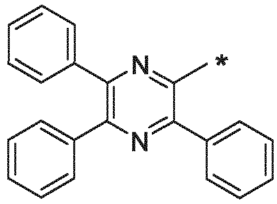 (C27),

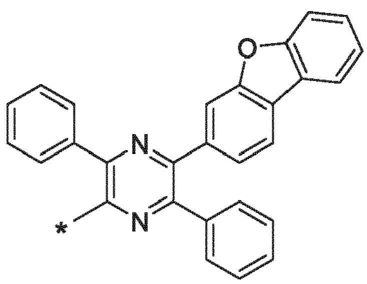 (C28), 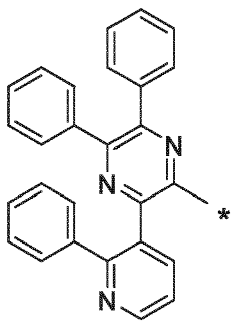 (C29), 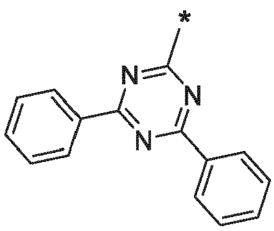 (C30),

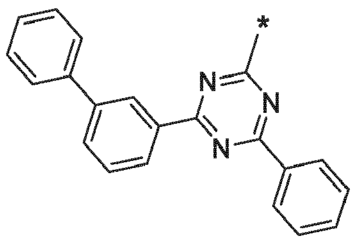 (C31), 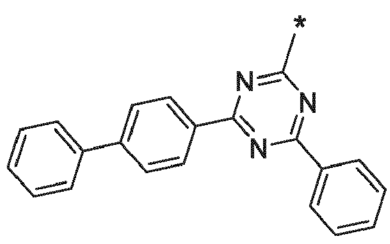 (C32),

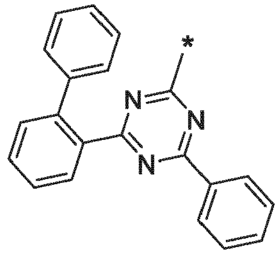 (C33), 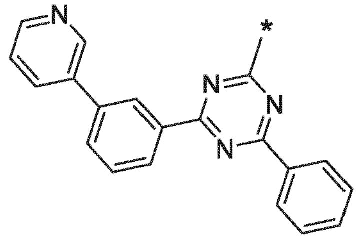 (C34), 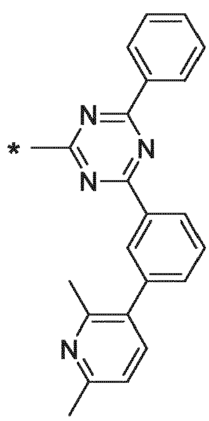 (C35),

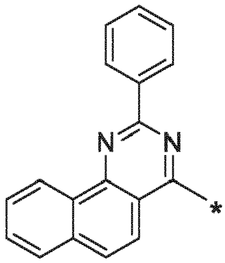 (C36), 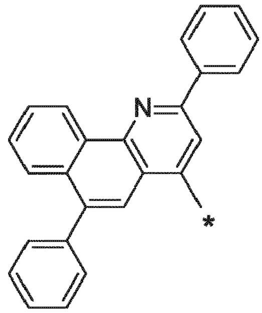 (C37), 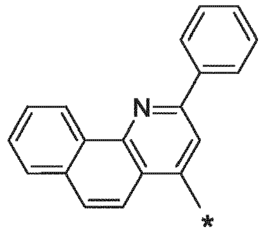 (C38),

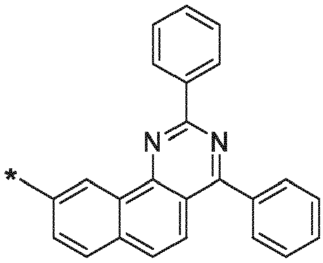 (C39), 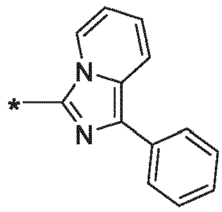 (C40), 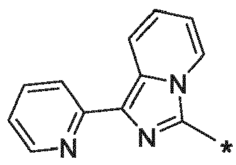 (C41),

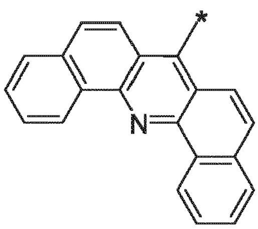 (C42), 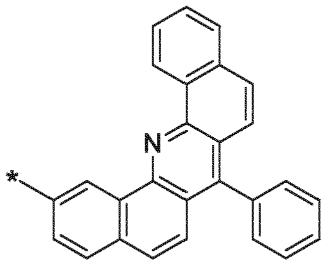 (C43), 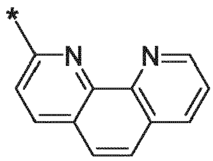 (C44),

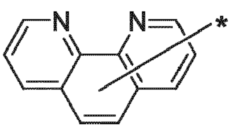 (C45), 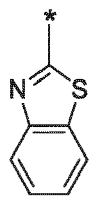 (C46), 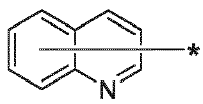 (C47), 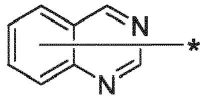 (C48),

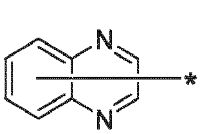 (C49), 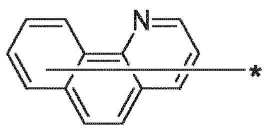 (C50), 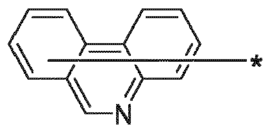 (C51),

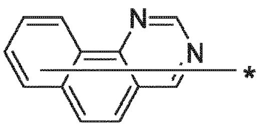 (C52), 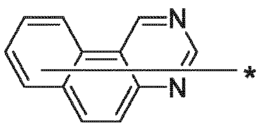 (C53), 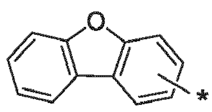 (C54),

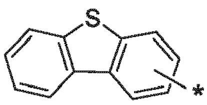 (C55), 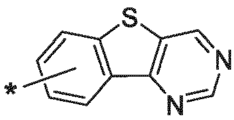 (C56), 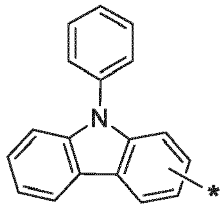 (C57),

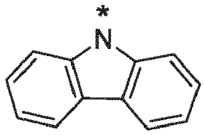 (C58);

wherein the asterix "*" denotes the binding position.

Preferably, $Ar^{21}$ is selected from (C2) to (C56), more preferred from (C2) to (C6) and (C14) to (C45) and (C47) to (C56).

According to an embodiment, $Ar^{23}$ may be selected from formulae (D1) to (D43)

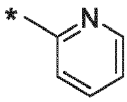 (D1), 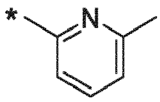 (D2), 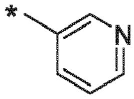 (D3), 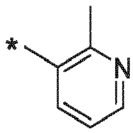 (D4), 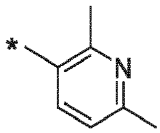 (D5),

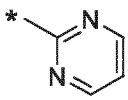 (D6), 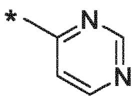 (D7), 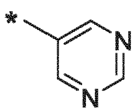 (D8), 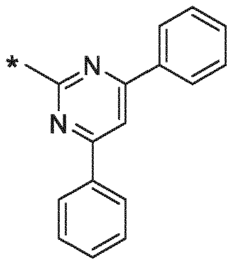 (D9),

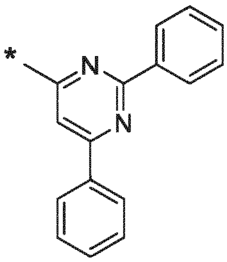 (D10), 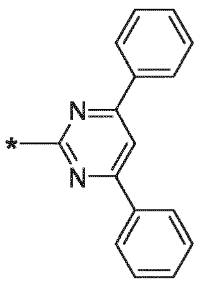 (D11), 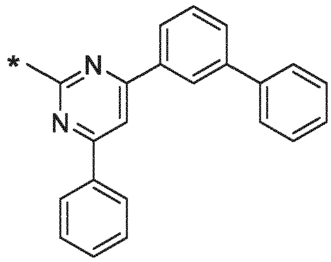 (D12),

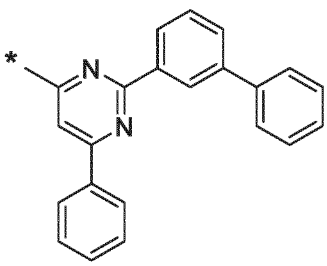 (D13), 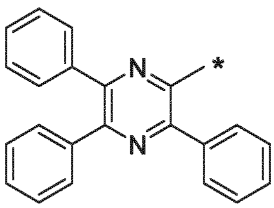 (D14), 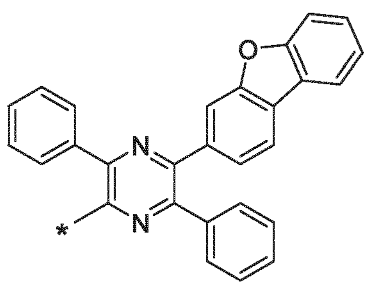 (D15),

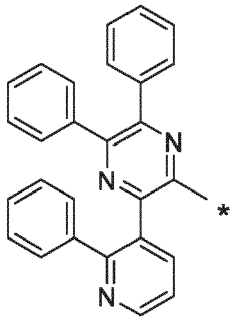 (D16), 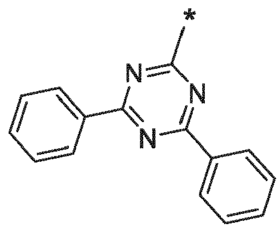 (D17), 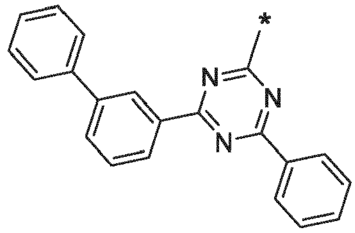 (D18),

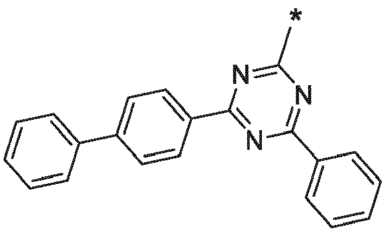 (D19), 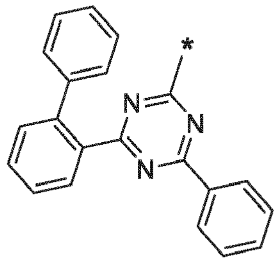 (D20),

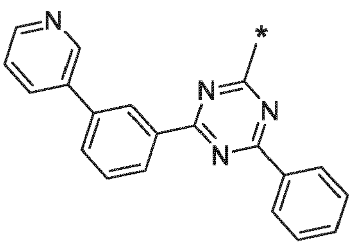 (D21), 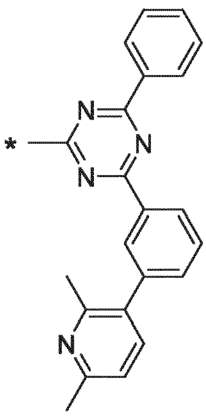 (D22),

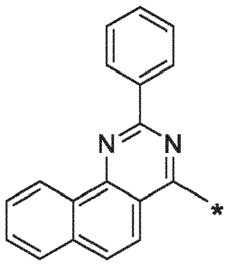 (D23), 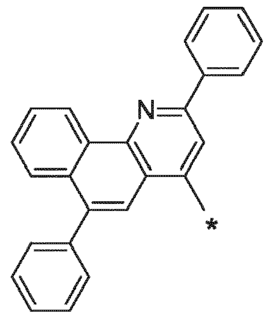 (D24), 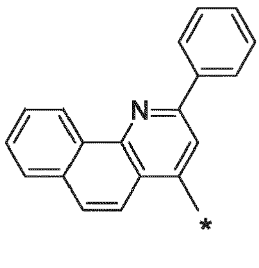 (D25),

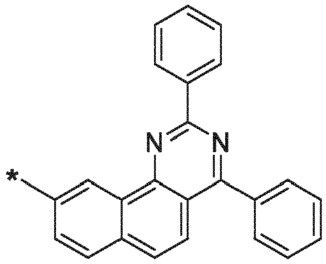 (D26), 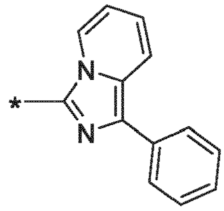 (D27), 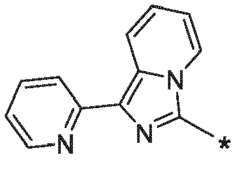 (D28),

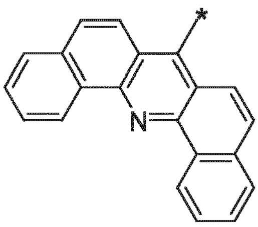 (D29), 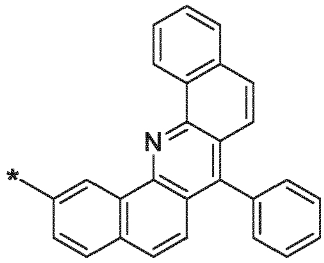 (D30), 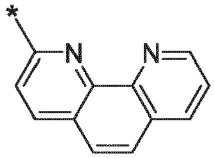 (D31),

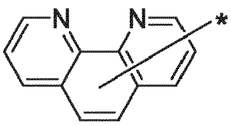 (D32), 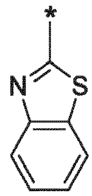 (D33), 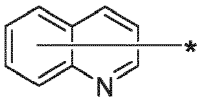 (D34), 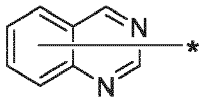 (D35),

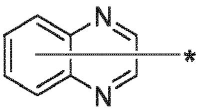 (D36), 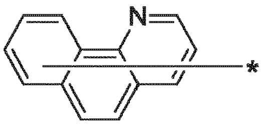 (D37), 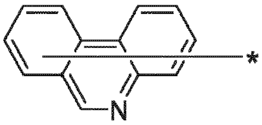 (D38),

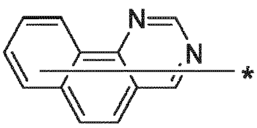 (D39), 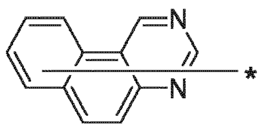 (D40), 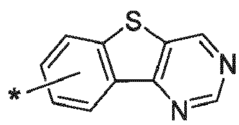 (D41),

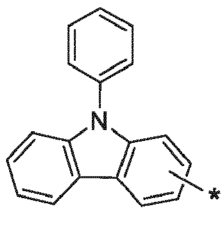 (D42), 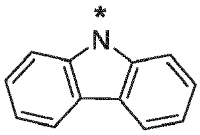 (D43);

wherein the asterix "*" denotes the binding position.

Preferably, $A^{23}$ is selected from formulae (D1) to (D40), more preferred (D1) to (D32).

- $Ar^{21}$ is selected from phenyl, naphthyl, biphenyl, phenanthrenyl and formulae (C1) to (C58);
- $Ar^{22}$ is selected from a single bond, phenylene or naphthalene; and
- $Ar^{23}$ may be selected from formulae (D1) to (D43);
  preferably,
- $Ar^{21}$ is selected from (C2) to (C56), more preferred from (C2) to (C6) and (C14) to (C45) and (C47) to (C56);
- $Ar^{22}$ is selected from a single bond, phenylene or naphthalene; and
- $A^{23}$ is selected from formulae (D1) to (D40), more preferred (D1) to (D32).

Preferably, $Ar^{21}$ and $Ar^{23}$ are not selected the same; more preferred $Ar^{21}$, $Ar^{22}$ and $Ar^{23}$ are not selected the same.

According to an embodiment, wherein $Ar^{21}$ is selected from phenyl, naphthyl, biphenyl, phenanthrenyl and formulae (C1) to (C58); $Ar^{22}$ is selected from a single bond, phenylene or naphthalene; and $Ar^{23}$ is selected from formulae (D1) to (D43); or $Ar^{21}$ is selected from (C2) to (C56), more preferred from (C2) to (C6) and (C14) to (C45) and (C47) to (C56); $Ar^{22}$ is selected from a single bond, phenylene or naphthalene; and $A^{23}$ is selected from formulae (D1) to (D40), more preferred (D1) to (D32); or $Ar^{21}$ and $Ar^{23}$ are not selected the same; or $Ar^{21}$, $Ar^{22}$ and $Ar^{23}$ are not selected the same.

The second organic compound and/or compound of formula (II) may be selected from formulae (E1) to (E13)

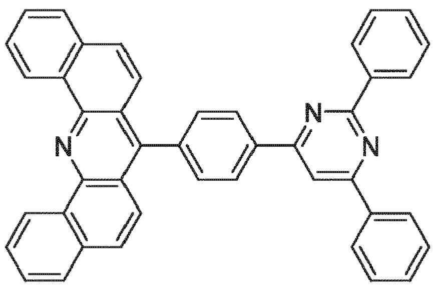
(E1),

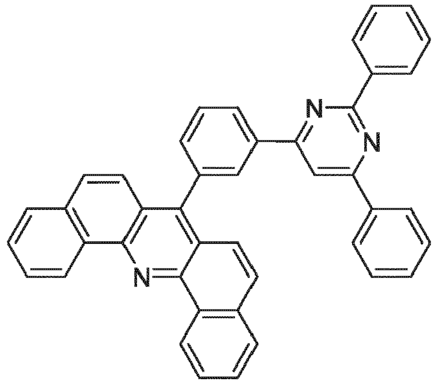
(E2),

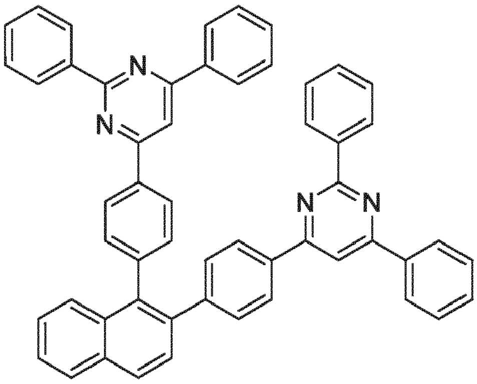
(E3),

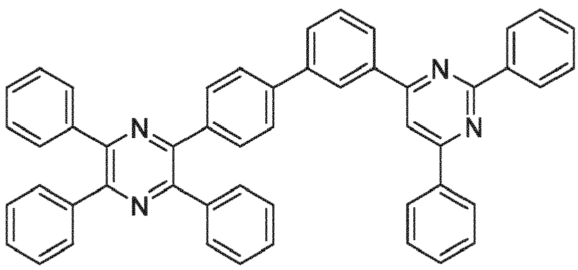
(E4),

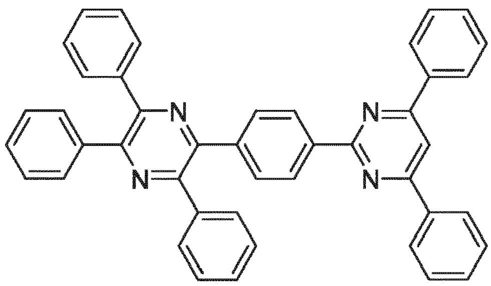
(E5),

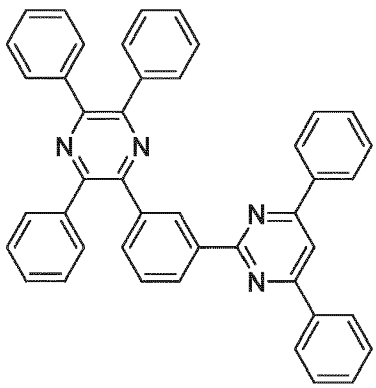
(E6),

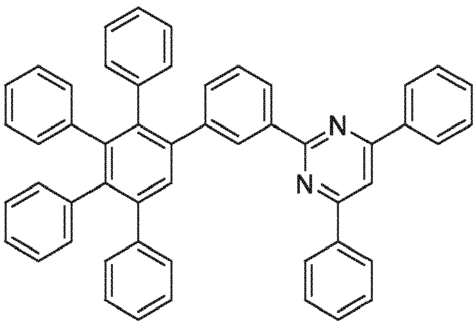
(E7),

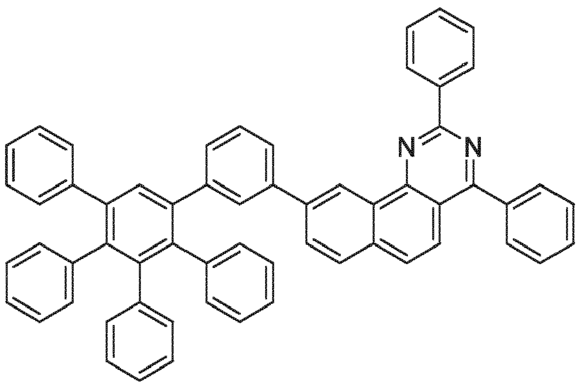
(E8),

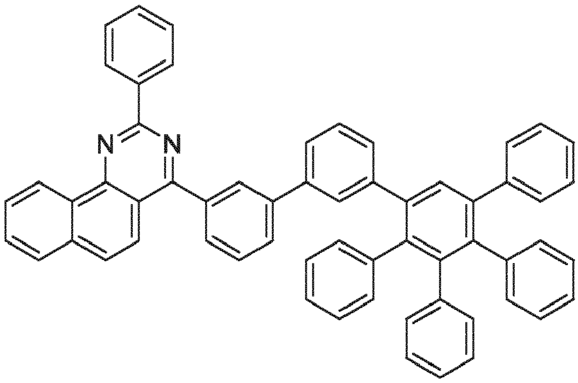 (E9), 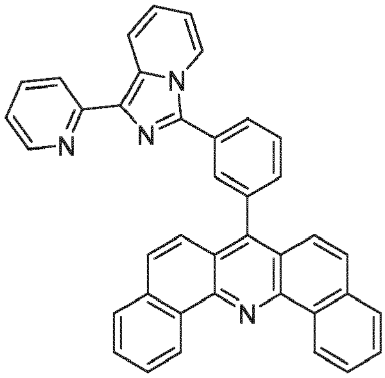 (E10),

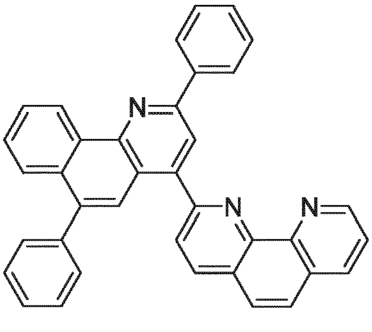 (E11), 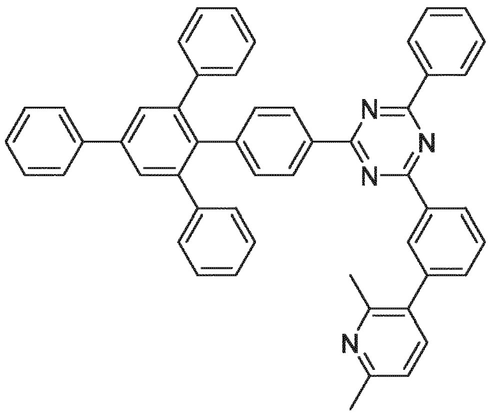 (E12),

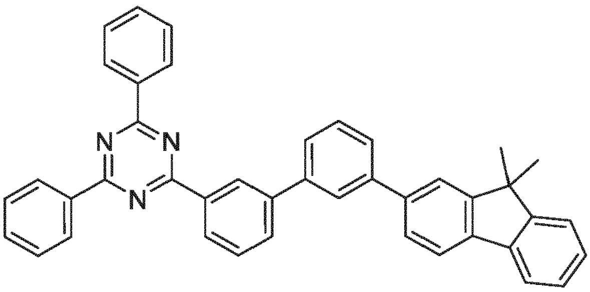 (E13);

preferably the second organic compound is selected from (E1) to (E9), also preferred from (E1) to (E6) or (E7) to (E9).

**First organic p-dopant**

According to one embodiment, wherein the first organic p-dopant comprises at least ≥ 4 CN groups or ≥ 5 to ≤ 8 CN groups.

According to one embodiment, wherein the HOMO energy level of the first organic p-dopant is selected in the range of ≥ -8.5 eV to ≤ -6.8 eV, preferably in the range of ≥ -8.2 eV to ≤ -7 eV.

According to one embodiment, wherein the first organic p-dopant comprises at least two groups independently of each other selected from $C_6$ to $C_{19}$ aryl group or $C_3$ to $C_{12}$ heteroaryl group, wherein each of the $C_6$ to $C_{19}$ aryl group or $C_3$ to $C_{12}$ heteroaryl group is substituted, wherein the one or more substituents are independently of each other selected from halogen, F, CN, partially perfluorinated $C_1$ to $C_{12}$ alkyl, perfluorinated $C_1$ to $C_{12}$ alkyl, $CF_3$.

According to one embodiment, wherein the first organic p-dopant comprises independently of each other at least two groups selected from $C_6$ to $C_{19}$ aryl group, wherein each of the $C_6$ to $C_{19}$ aryl group is substituted, wherein the one or more substituents are independently of each other selected from halogen, F, CN, partially perfluorinated $C_1$ to $C_{12}$ alkyl, perfluorinated $C_1$ to $C_{12}$ alkyl, $CF_3$.

According to one embodiment, wherein the first organic p-dopant is selected from a compound of formula (III):

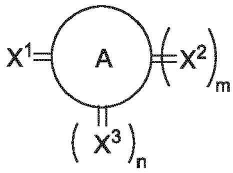

(III),

wherein

n is an integer including 0, 1, 2, 3, 4, 5 or 6, preferably 0, 2, or 4;

m is an integer selected from 0 or 1;

$X^1$, $X^2$ and $X^3$ are independently selected from O, S, $CR^{1a}R^{2a}$, $CR^{1b}R^{2b}$, $NR^{3a}$, $NR^{3b}$ or at least one of $X^1$, $X^2$, and $X^3$ form a fused ring with A, and wherein each $X^3$ is selected the same or different, preferably the same,

$R^{1a}$, $R^{2a}$, $R^{1b}$, and $R^{2b}$ are independently selected from an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted aryl, substituted or unsubstituted heteroaryl,

wherein the one or more substituents on $R^{1a}$, $R^{2a}$, $R^{1b}$, and $R^{2b}$ are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to C alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl;

wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

$R^{3a}$ and $R^{3b}$ is selected from an electron-withdrawing group, CN, partially fluorinated $C_1$ to $C_6$ alkyl, perfluorinated $C_1$ to $C_6$ alkyl, $CF_3$, substituted or unsubstituted $C_6$ to $C_{30}$ aryl, or substituted or unsubstituted $C_3$ to $C_{30}$ heteroaryl,

wherein the one or more substituents on $R^{3a}$ and $R^{3b}$ are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl;

wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

A is selected from substituted or unsubstituted $C_3$ to $C_{40}$ cyclohydrocarbon group, substituted or unsubstituted $C_3$ to $C_{40}$ cycloalkane group, substituted or unsubstituted $C_3$ to $C_{40}$ cycloalkane group containing one or more double-bonds, substituted or unsubstituted $C_3$ to $C_{40}$ cycloalkene group, substituted or unsubstituted $C_2$ to $C_{40}$ heterocycloalkane group, substituted or unsubstituted $C_2$ to $C_{40}$ heterocycloalkane group containing one or more double-bonds, substituted or unsubstituted $C_2$ to $C_{40}$ heterocycloalkene group, substituted or unsubstituted $C_6$ to $C_{40}$ aromatic group, substituted or unsubstituted $C_2$ to $C_{40}$ heteroaromatic group,

wherein the one or more substituents on A are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted $C_6$ to $C_{30}$ aryl, substituted or unsubstituted $C_2$ to $C_{30}$ heteroaryl,

wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F,

CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy,

and wherein preferably the compound of formula (III) comprises at least two groups selected from substituted $C_6$ to $C_{19}$ aryl group or substituted $C_3$ to $C_{12}$ heteroaryl group, wherein each of the substituents of $C_6$ to $C_{19}$ aryl group or $C_3$ to $C_{12}$ heteroaryl group are independently of each other selected from halogen, F, CN, partially perfluorinated $C_1$ to $C_{12}$ alkyl, perfluorinated $C_1$ to $C_{12}$ alkyl, or $CF_3$.

The $C_6$ to $C_{40}$ aromatic group may be a group which is aromatic, or a group containing at least one aromatic moiety, i.e. an aromatic group may also contain a fused non-aromatic moiety. The moiety can contain different atoms.

The $C_2$ to $C_{40}$ heteroaromatic group may be a group which is heteroaromatic, or a group containing at least one heteroaromatic moiety, i.e. a heteroaromatic group may also contain a fused non-aromatic moiety. The moiety can contain different atoms.

**n**

According to an embodiment, n can be an integer selected from 0, 1, 2, 3, or 4.

According to a preferred embodiment, n can be an integer selected from 0, 1, or 2.

**m**

According to a preferred embodiment, m can be an integer selected from 1.

**$X^1$, $X^2$, and $X^3$**

According to an embodiment, $X^1$, $X^2$, and $X^3$ are independently selected from $CR^{1a}R^{2a}$, $CR^{1b}R^{2b}$, $NR^{3a}$, $NR^{3b}$; wherein each $X^3$ can be selected the same or different.

According to an embodiment, $X^1$, $X^2$, and $X^3$ are independently selected from $CR^{1a}R^{2a}$, $CR^{1b}R^{2b}$; wherein each $X^3$ can be selected the same or different.

According to an embodiment, wherein A of formula (III) is selected from a group of G1 to G72:

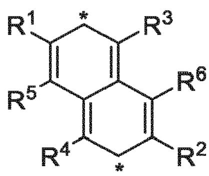 (G1), 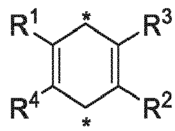 (G2), 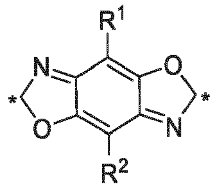 (G3),

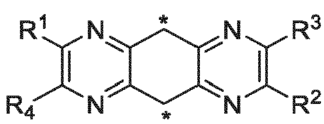 (G4), 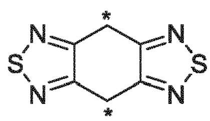 (G5), 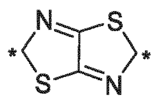 (G6), 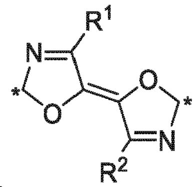 (G7),

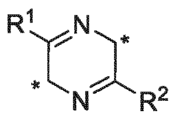 (G8), 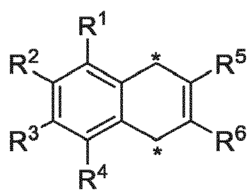 (G9), 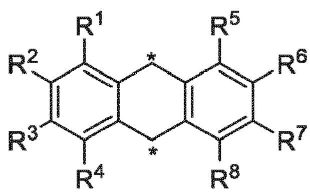 (G10),

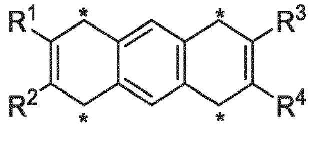 (G11), 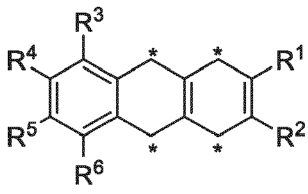 (G12), 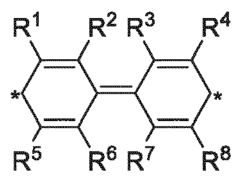 (G13),

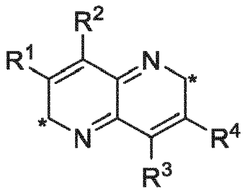 (G14), 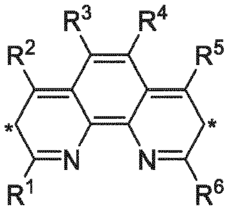 (G15), 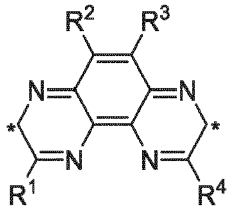 (G16),

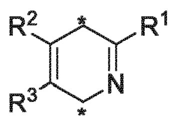 (G17), 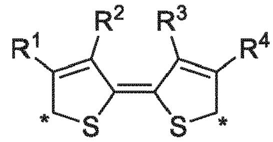 (G18), 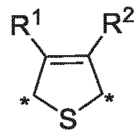 (G19),

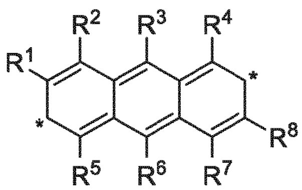 (G20), 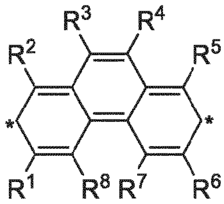 (G21), 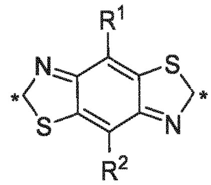 (G22), 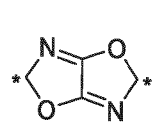 (G23),

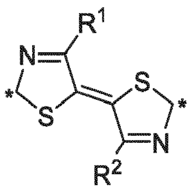 (G24), 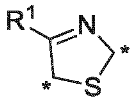 (G25), 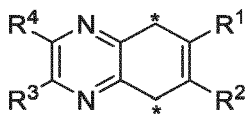 (G26), 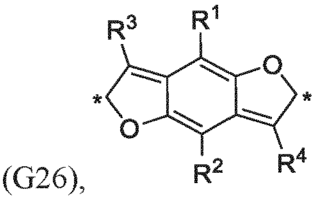 (G27),

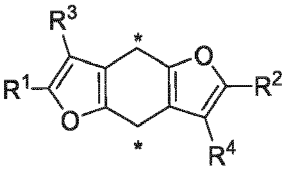 (G28), 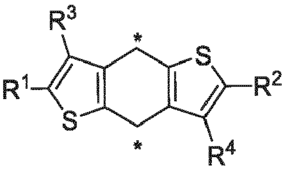 (G29), 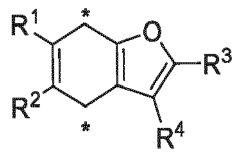 (G30),

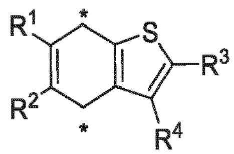 (G31), 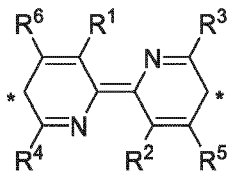 (G32), 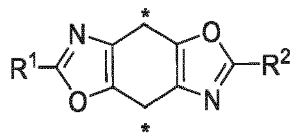 (G33),

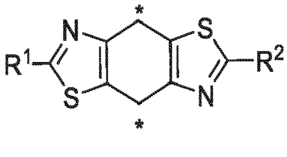 (G34), 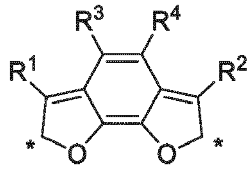 (G35), 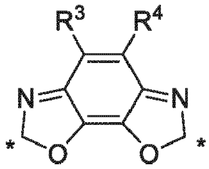 (G36),

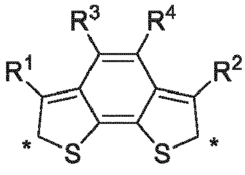 (G37), 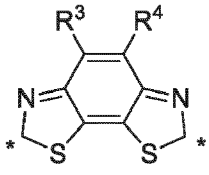 (G38),

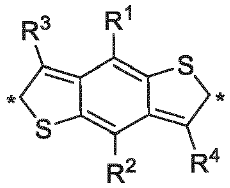 (G39), 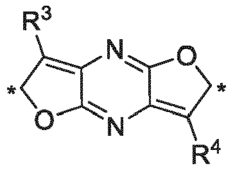 (G40), 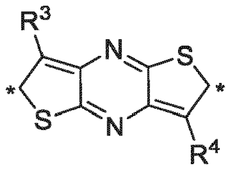 (G41), 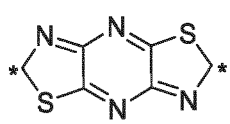

(G42), 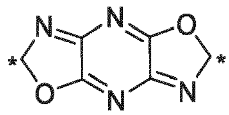 (G43), 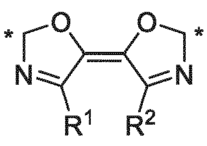 (G44), 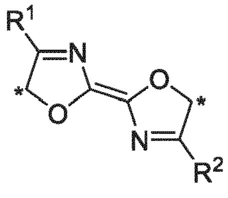 (G45),

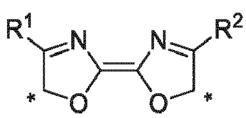 (G46), 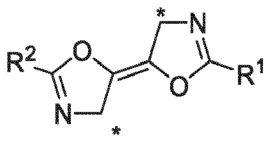 (G47), 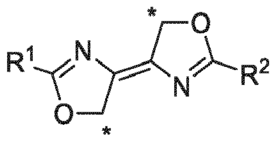 (G48),

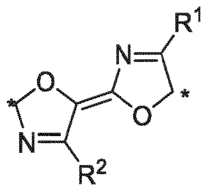 (G49), 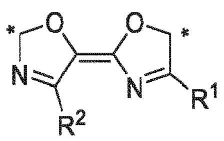 (G50), 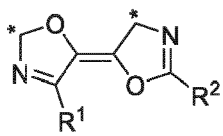 (G51), 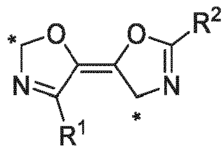 (G52),

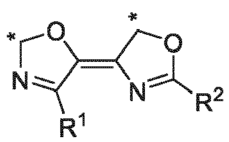 (G53), 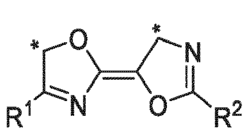 (G54), 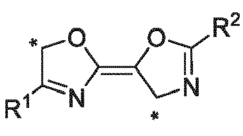 (G55), 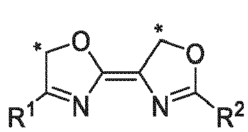

(G56), 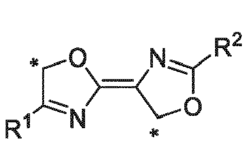 (G57), 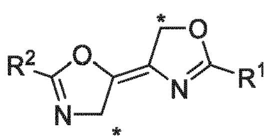 (G58), 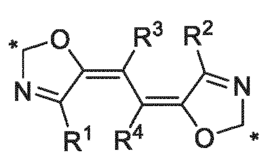 (G59),

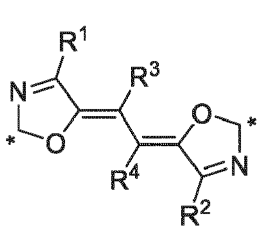 (G60), 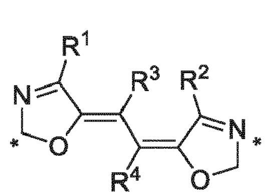 (G61), 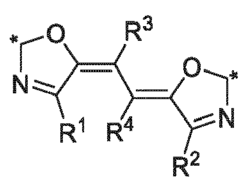 (G62),

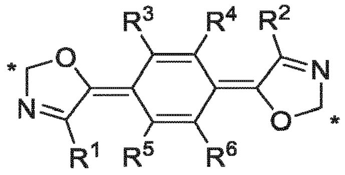 (G63), 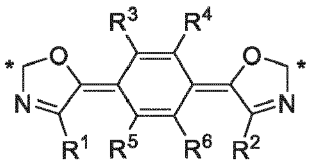 (G64), 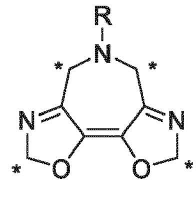 (G65),

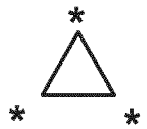 (G66), 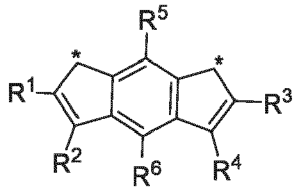 (G67), 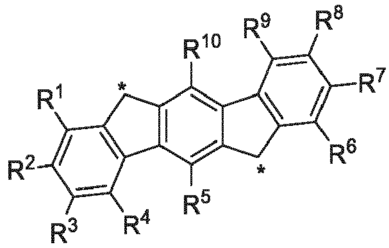 (G68),

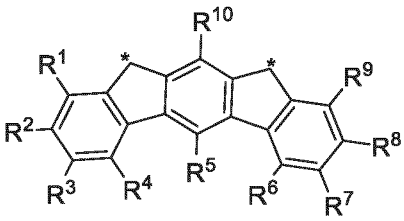 (G69), 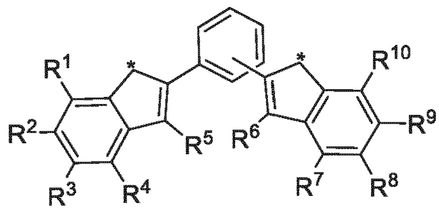 (G70),

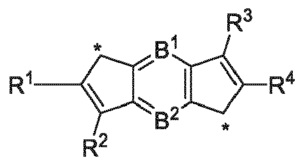 (G71),

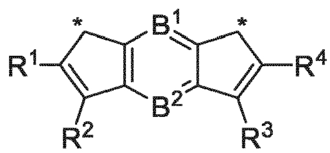 (G72),

wherein the asteri sk "*" denotes the binding position;

| | |
|---|---|
| $R^1$, $R^2$, $R^3$, $R^4$, $R^5$, $R^6$, $R^7$ and $R^8$ | are independently selected from H, D, halogen, Cl, F, substituted or unsubstituted $C_1$ to $C_6$ alkyl, partially fluorinated $C_1$ to $C_6$ alkyl, perfluorinated $C_1$ to $C_6$ alkyl, $CF_3$, substituted or unsubstituted $C_1$ to $C_6$ alkoxy, partially fluorinated $C_1$ to $C_6$ alkoxy, perfluorinated $C_1$ to $C_6$ alkoxy, $OCF_3$, substituted or unsubstituted $C_6$ to $C_{30}$ aryloxy, partially fluorinated $C_6$ to $C_{30}$ aryloxy, perfluorinated $C_6$ to $C_{30}$ aryloxy, substituted or unsubstituted $C_6$ to $C_{30}$ aryl, substituted or unsubstituted $C_3$ to $C_{30}$ heteroaryl, CN, isocyano, SCN, OCN, $NO_2$, $SF_5$, wherein the substituents are selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$, |
| $B^1$ and $B^2$ | are independently of each other selected from N, $CR^{5A'}$, or $CR^{6A'}$, wherein |
| $CR^{5A'}$, or $CR^{6A'}$ | are each independently selected from other from H, D, F, a substituted or unsubstituted $C_6$ to $C_{12}$ aryl, a substituted or unsubstituted $C_1$ to $C_{12}$ heteroaryl with 1 to 4 heteroatoms one among O, N, S and Si, a substituted or unsubstituted $C_1$ to $C_{12}$ alkyl, a substituted or unsubstituted $C_1$ to $C_{12}$ alkoxy, a substituted or unsubstituted $C_1$ to $C_{12}$ ether group, CN, $CF_3$, $OCF_3$, halogen, Cl, F, $Si(CH_3)_3$, prefer- |

ably at least one among $R^1$ to $R^6$ comprises CN, wherein the one or more substituents on $CR^{5A'}$, or $CR^{6A'}$ are independently selected from each other from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to C alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl,

wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from each other from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy.

According to an embodiment, wherein A of formula (III) is selected from a group of E1 to E27, E44 to E46, E49, E50, E66 to E72:

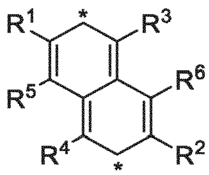 (E1), 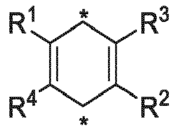 (E2), 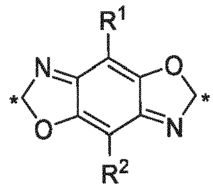 (E3),

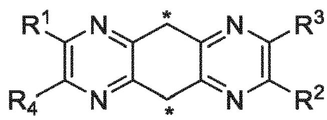 (E4), 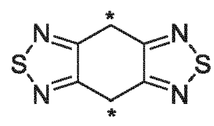 (E5), 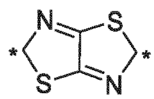 (E6), 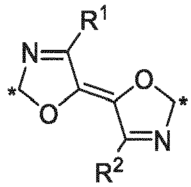 (E7),

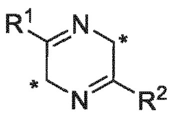 (E8), 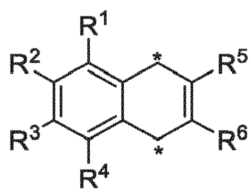 (E9), 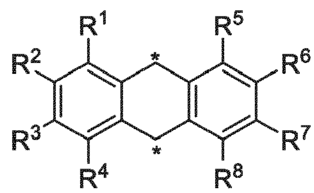 (E10),

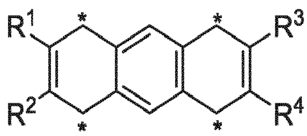 (E11), 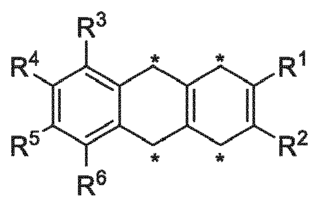 (E12), 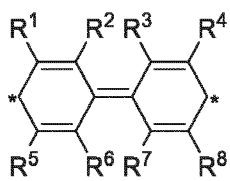 (E13),

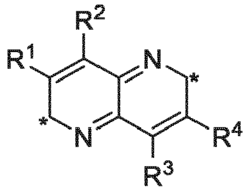 (E14), 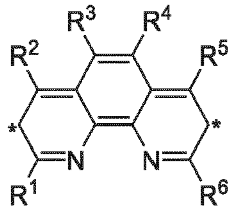 (E15), 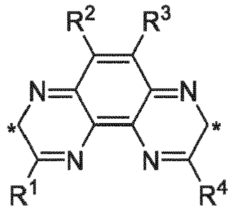 (E16),

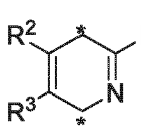 (E17), 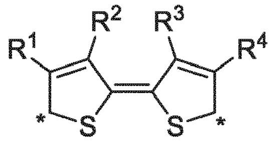 (E18), 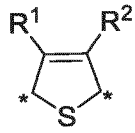 (E19),

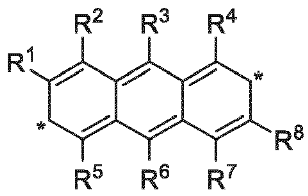 (E20), 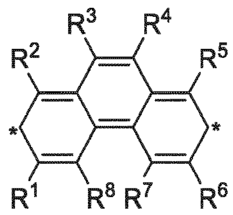 (E21), 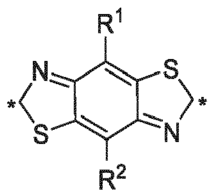 (E22), 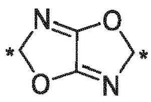

(E23), 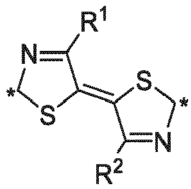 (E24), 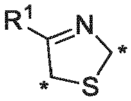 (E25), 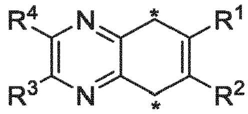 (E26),

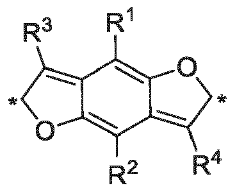 (E27), 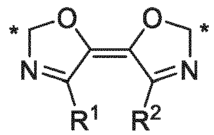 (E44), 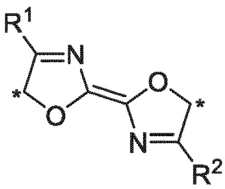 (E45),

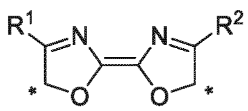 (E46), 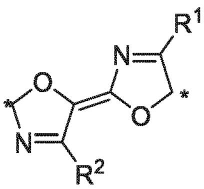 (E49), 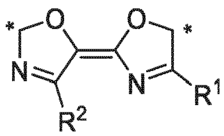 (E50),

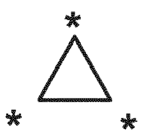 (E66), 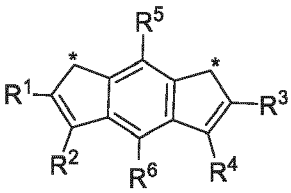 (E67), 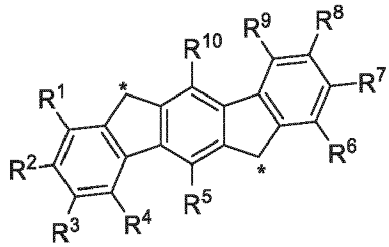 (E68),

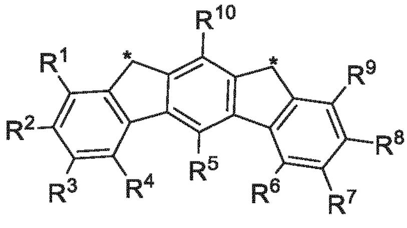 (E69), 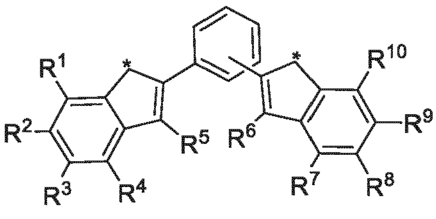 (E70),

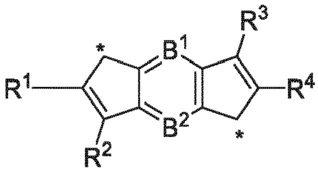 (E71), 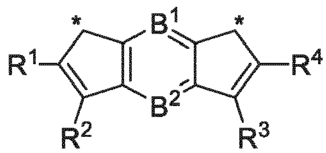 (E72),

wherein the asterisk "*" denotes the binding position;

$R^1$, $R^2$, $R^3$, $R^4$, $R^5$, $R^6$, $R^7$ and $R^8$ are independently selected from H, D, halogen, Cl, F, substituted or unsubstituted $C_1$ to $C_6$ alkyl, partially fluorinated $C_1$ to $C_6$ alkyl, perfluorinated $C_1$ to $C_6$ alkyl, $CF_3$, substituted or unsubstituted $C_1$ to $C_6$ alkoxy, partially fluorinated $C_1$ to $C_6$ alkoxy, perfluorinated $C_1$ to $C_6$ alkoxy, $OCF_3$, substituted or unsubstituted $C_6$ to $C_{30}$ aryloxy, partially fluorinated $C_6$ to $C_{30}$ aryloxy, perfluorinated $C_6$ to $C_{30}$ aryloxy, substituted or unsubstituted $C_6$ to $C_{30}$ aryl, substituted or unsubstituted $C_3$ to $C_{30}$ heteroaryl, CN, isocyano, SCN, OCN, $NO_2$, $SF_5$,
wherein the substituents are selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$,
$B^1$ and $B^2$ are independently of each other selected from N, $CR^{5A'}$, or $CR^{6A'}$, wherein $CR^{5A'}$, or $CR^{6A'}$ are each independently selected from each other from H, D, F, a substituted or unsubstituted $C_6$ to $C_{12}$ aryl, a substituted or unsubstituted $C_1$ to $C_{12}$ heteroaryl with 1 to 4 heteroatoms one among O, N, S and Si, a substituted or unsubstituted $C_1$ to $C_{12}$ alkyl, a substituted or unsubstituted $C_1$ to $C_{12}$ alkoxy, a substituted or unsubstituted $C_1$ to $C_{12}$ ether group, CN, $CF_3$, $OCF_3$, halogen, Cl, F, $Si(CH_3)_3$, preferably at least one among $R^1$ to $R^6$ comprises CN, wherein
the one or more substituents on $CR^{5A'}$, or $CR^{6A'}$are independently of each other selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to C alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl, wherein
the one or more substituents of $C_6$ to $C_{30}$ aryl, $C_6$ to $C_{30}$ heteroaryl, $C_1$ to $C_8$ alkyl, $C_1$ to $C_8$ alkoxy are independently of each other selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy.

According to an embodiment, wherein A may be preferably selected from a compound W1 to W22:

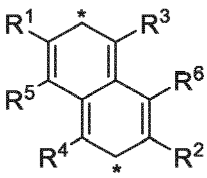 (W1), 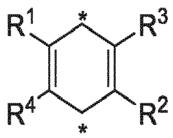 (W2), 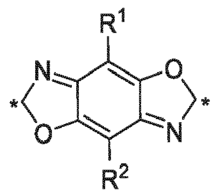 (W3)

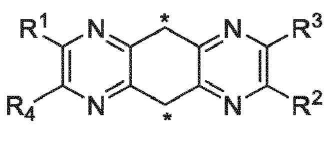 (W4), 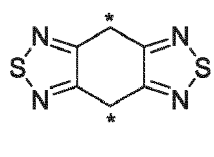 (W5), 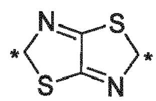 (W6),

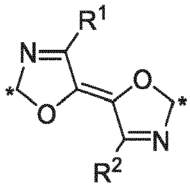 (W7), 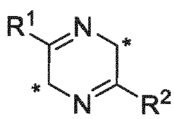 (W8),

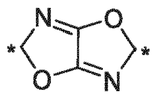 (W9),

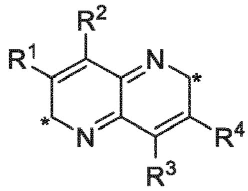

(W10).

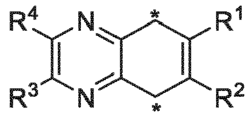

(W11),

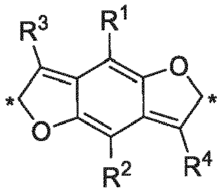 (W12),

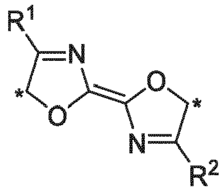

(W13),

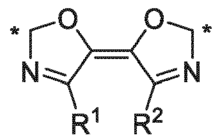

(W14),

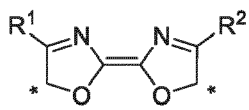

(W15),

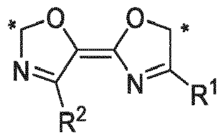

(W16),

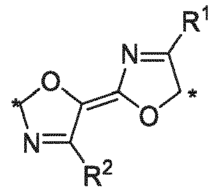

(W17),

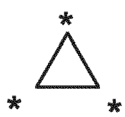 (W18)

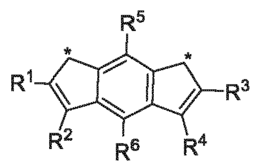

(W19),

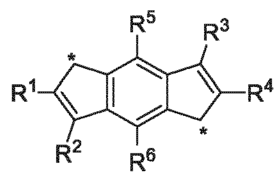

(W20),

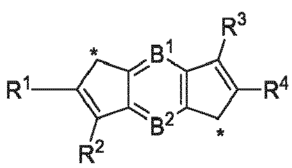

(W21),

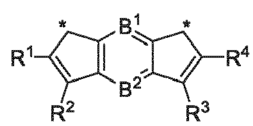

(W22).

According to an embodiment, wherein A may be preferably selected from a compound of W1, W2, W3, W4, W7, W8, W10, W11, W13, W15, W18, W19, W20, W21 and/or W22.

According to an embodiment, wherein A may be preferably selected from a compound of W1, W2, W18, W19, W20, W21 and/or W22.

According to an embodiment, wherein A may be preferably selected from one of the following compounds W2, W18, W19 and/or W20.

**Radialene**

According to an embodiment, the first organic p-dopant is selected from a compound of formula (IV):

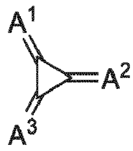

(IV),

wherein in formula (IV)

- $A^1$ is independently selected from a group of formula (IVa):

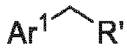

(IVa),

wherein
$Ar^1$ is independently selected from substituted or unsubstituted aryl and substituted or unsubstituted heteroaryl, wherein for the case that $Ar^1$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl, and
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
- $A^2$ is independently selected from a group of formula (IVb):

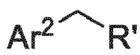

(IVb),

wherein
$Ar^2$ is independently selected from substituted or unsubstituted aryl and substituted or unsubstituted heteroaryl, wherein for the case that $Ar^2$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl, and
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
- $A^3$ is independently selected from a group of formula (IVc)

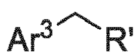

(IVc),

wherein
$Ar^3$ is independently selected from substituted or unsubstituted aryl and substituted or unsubstituted heteroaryl, wherein for the case that $Ar^3$ is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl, and
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein in $A^1$, $A^2$, $A^3$ each R' is independently selected from substituted or unsubstituted $C_6$ to $C_{18}$ aryl, $C_3$ to $C_{18}$ heteroaryl, electron-withdrawing group, substituted or unsubstituted $C_1$ to $C_8$ alkyl, partially fluorinated $C_1$ to $C_8$ alkyl, perfluorinated $C_1$ to $C_8$ alkyl, halogen, F and CN; and

wherein preferably the compound of formula (IV) comprises at least two groups selected from aryl $C_6$ to $C_{19}$ aryl groups, or $C_3$ to $C_{12}$ heteroaryl group, wherein each of the $C_6$ to $C_{19}$ aryl group or $C_3$ to $C_{12}$ heteroaryl group is substituted, wherein the one or more substituents are independently of each other selected from halogen, F, CN, partially perfluorinated $C_1$ to $C_{12}$ alkyl, perfluorinated $C_1$ to $C_{12}$ alkyl, $CF_3$.

The term "electron-withdrawing group" refers to a chemical group in a molecule, which can draw electrons away from an adjacent part of the molecule. The distance over which the electron-withdrawing group can exert its effect, namely the number of bonds over which the electron-withdrawing effect spans, is extended by conjugated pi-electron systems such as aromatic systems. Examples of electron-withdrawing groups include $NO_2$, CN, halogen, Cl, F, partially fluorinated or perfluorinated alkyl and partially fluorinated or perfluorinated C1 to C12 alkyl, partially fluorinated or perfluorinated alkoxy, partially fluorinated or perfluorinated C1 to C6 alkoxy.

**Quinoid-like**

The first organic p-dopant is a quinoid-like compound when it is reduced, i.e. when oxidation level of said compounds is lowered by one, two, three or four electrons, results in an at least partial aromatization of said first organic p-dopant or of said first organic p-dopant, preferably the quinoid-like compound comprises at least two groups selected from $C_6$ to $C_{19}$ aryl group or $C_3$ to $C_{12}$ heteroaryl group, wherein each of the $C_6$ to $C_{19}$ aryl group or $C_3$ to $C_{12}$ heteroaryl group is substituted, wherein the one or more substituents are independently of each other selected from halogen, F, CN, partially perfluorinated $C_1$ to $C_{12}$ alkyl, perfluorinated $C_1$ to $C_{12}$ alkyl, $CF_3$.

According to an embodiment, the first organic p-dopant is a quinoid-like compound, whereby the term "quinoid-like compound" means and/includes a compound which contains a moiety which is (formally) derived from a compound comprising an annelated aromatic system or non-annelated aromatic system whereby one or more carbon atoms of said annelated aromatic system or non-annelated aromatic system are double bonded to an atom or a group outside said annelated aromatic system or non-annelated aromatic system with any necessary rearrangement of double bonds preferably the quinoid-like compound comprises at least two groups selected from $C_6$ to $C_{19}$ aryl group or $C_3$ to $C_{12}$ heteroaryl group, wherein each of the $C_6$ to $C_{19}$ aryl group or $C_3$ to $C_{12}$ heteroaryl group is substituted, wherein the one or more substituents are independently of each other selected from halogen, F, CN, partially perfluorinated $C_1$ to $C_{12}$ alkyl, perfluorinated $C_1$ to $C_{12}$ alkyl, $CF_3$.

According to an embodiment, the first organic p-dopant is a quinoid-like compound, whereby the term "quinoid-like compound" means and/includes a compound which contains a moiety which is (formally) derived from a compound comprising an annelated aromatic system or non-annelated aromatic system whereby one or more carbon atoms of said annelated aromatic system or non-annelated aromatic system are double bonded to an atom or a group outside said annelated aromatic system or non-annelated aromatic system with any necessary rearrangement of double bonds and resulting in at least a partial lift of aromaticity in the annelated aromatic system or non-annelated aromatic system; preferably the quinoid-like compound comprises at least two groups selected from $C_6$ to $C_{19}$ aryl group or $C_3$ to $C_{12}$ heteroaryl group, wherein each of the $C_6$ to $C_{19}$ aryl group or $C_3$ to $C_{12}$ heteroaryl group is substituted, wherein the one or more substituents are independently of each other selected from halogen, F, CN, partially perfluorinated $C_1$ to $C_{12}$ alkyl, perfluorinated $C_1$ to $C_{12}$ alkyl, $CF_3$.

According to an embodiment, the first organic p-dopant is a quinoid compound, whereby the term "quinoid compound" means/includes a compound which contains a moiety which is (formally) derived from a compound comprising an annelated aromatic system or non-annelated aromatic system whereby an even number of carbon atoms of said annelated aromatic system or non-annelated aromatic system are double bonded to an atom or a group outside said annelated aromatic system or non-annelated aromatic system with any necessary rearrangement of double bonds and resulting in at least a partial lift of aromaticity in the annelated aromatic system or non-annelated aromatic system, wherein the even number of carbon atoms of said annelated aromatic system or non-annelated aromatic system which are double bonded to an atom or a group outside said annelated aromatic system or non-annelated aromatic system were a -CH= of said aromatic system or non-annelated aromatic system; preferably the quinoid compound comprises at least two groups selected from $C_6$ to $C_{19}$ aryl group or $C_3$ to $C_{12}$ heteroaryl group, wherein each of the $C_6$ to $C_{19}$ aryl group or $C_3$ to $C_{12}$ heteroaryl group is substituted, wherein the one or more substituents are independently of each other selected from halogen, F, CN, partially perfluorinated $C_1$ to $C_{12}$ alkyl, perfluorinated $C_1$ to $C_{12}$ alkyl, $CF_3$. Reduction of the quinoid compound by one or two electrons, i.e. when the oxidation level of said compounds is lowered by adding two electrons, results in an at least partial aromatization of the quinoid compound.

According to an embodiment, the first organic p-dopant has a quinoid structure.

According to an embodiment, the first organic p-dopant is a quinoid compound and represented by formula (V), whereby the term "quinoid compound" means and/includes a compound which contains a moiety which is (formally) derived from a compound comprising an annelated aromatic system or non-annelated aromatic system whereby an even number of carbon atoms of said annelated aromatic system or non-annelated aromatic system are double bonded to an

atom or a group outside said annelated aromatic system or non-annelated aromatic system with any necessary rearrangement of double bonds and resulting in at least a partial lift of aromaticity in the annelated aromatic system or non-annelated aromatic system, preferably the quinoid compound comprises at least two groups selected from $C_6$ to $C_{19}$ aryl group or $C_3$ to $C_{12}$ heteroaryl group, wherein each of the $C_6$ to $C_{19}$ aryl group or $C_3$ to $C_{12}$ heteroaryl group is substituted, wherein the one or more substituents are independently of each other selected from halogen, F, CN, partially perfluorinated $C_1$ to $C_{12}$ alkyl, perfluorinated $C_1$ to $C_{12}$ alkyl, $CF_3$; wherein the even number of carbon atoms of said annelated aromatic system or non-annelated aromatic system which are double bonded to an atom or a group outside said annelated aromatic system or non-annelated aromatic system were a -CH= of said aromatic system or non-annelated aromatic system. Reduction of the quinoid compound by one or two electrons, i.e. when the oxidation level of said compounds is lowered by adding two electrons, results in an at least partial aromatization of the quinoid compound.

According to an embodiment, wherein the first organic p-dopant is selected from a compound comprising a quinoid structure, an indacenedione structure or a compound of formula (V):

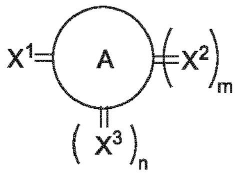

(V),

| | |
|---|---|
| n | is an integer including 0, 1, 2, 3, 4, 5 or 6, preferably 0, 2, or 4; |
| m | is an integer selected from 0 or 1; |
| $X^1$, $X^2$ and $X^3$ | are independently selected from O, S, $CR^{1a}R^{2a}$, $CR^{1b}R^{2b}$, $NR^{3a}$, $NR^{3b}$ or at least one of $X^1$, $X^2$, and $X^3$ form a fused ring with A, and wherein each $X^3$ is selected the same or different, preferably the same, |
| $R^{1a}$, $R^{2a}$, $R^{1b}$, and $R^{2b}$ | are independently selected from an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted aryl, substituted or unsubstituted heteroaryl,<br>wherein the one or more substituents on $R^{1a}$, $R^{2a}$, $R^{1b}$, and $R^{2b}$ are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to C alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl;<br>wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy; |
| $R^{3a}$ and $R^{3b}$ | is selected from an electron-withdrawing group, CN, partially fluorinated $C_1$ to $C_6$ alkyl, perfluorinated $C_1$ to $C_6$ alkyl, $CF_3$, substituted or unsubstituted $C_6$ to $C_{30}$ aryl, or substituted or unsubstituted $C_3$ to $C_{30}$ heteroaryl,<br>wherein the one or more substituents on $R^{3a}$ and $R^{3b}$ are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl;<br>wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy; |
| A | is selected from substituted or unsubstituted $C_3$ to $C_{40}$ cycloalkane group containing at least one or more double-bonds, substituted or unsubstituted $C_3$ to $C_{40}$ cycloalkene group, substituted or unsubstituted $C_2$ to $C_{40}$ heterocycloalkane group, substituted or unsubstituted $C_2$ to $C_{40}$ heterocycloalkane group containing one or more double-bonds, substituted or unsubstituted $C_2$ to $C_{40}$ heterocycloalkene group, substituted or unsubstituted $C_6$ to $C_{40}$ |

aromatic group, substituted or unsubstituted $C_2$ to $C_{40}$ heteroaromatic group, wherein $X^1$, $X^2$, and/or $X^3$ are conjugated to each other via a double-bond in A;
wherein the substituents on A, when present, are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted $C_6$ to $C_{30}$ aryl, substituted or unsubstituted $C_2$ to $C_{30}$ heteroaryl,
wherein the substituent of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

and wherein preferably the compound of formula (V) comprises at least two groups selected from substituted $C_6$ to $C_{19}$ aryl group or substituted $C_3$ to $C_{12}$ heteroaryl group,
wherein each of the substituted $C_6$ to $C_{19}$ aryl group or substituted $C_3$ to $C_{12}$ heteroaryl group is substituted with a substituent independently selected from halogen, F, CN, partially perfluorinated $C_1$ to $C_{12}$ alkyl, perfluorinated $C_1$ to $C_{12}$ alkyl, or $CF_3$.

The $C_6$ to $C_{40}$ aromatic group may be a group which is aromatic, or a group containing at least one aromatic moiety, i.e. an aromatic group may also contain a fused non-aromatic moiety. The moiety can contain different atoms. The $C_2$ to $C_{40}$ heteroaromatic group may be a group which is heteroaromatic, or a group containing at least one heteroaromatic moiety, i.e. a heteroaromatic group may also contain a fused non-aromatic moiety. The moiety can contain different atoms.

According to an embodiment, the first organic p-dopant is a compound of formula (V)

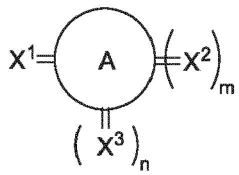

(V),

wherein

n is an even integer including 0 preferably n is selected from 0, 2, or 4,
m is an integer selected from 1,
$X^1$, $X^2$, and $X^3$ are independently selected from O, S, $CR^{1a}R^{2a}$, $CR^{1b}R^{2b}$, $NR^{3a}$, $NR^{3b}$; wherein each $X^3$ can be selected the same or different,
wherein
$X^1$, $X^2$, and $X^3$ can independently of each other form a fused ring with A;
wherein $R^{1a}$, $R^{2a}$, $R^{1b}$, and $R^{2b}$, are independently selected from an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted aryl, substituted or unsubstituted heteroaryl,
wherein the one or more substituents on $R^{1a}$, $R^{2a}$, $R^{1b}$, and $R^{2b}$, when present, are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to C alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl;
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
wherein $R^{3a}$ and $R^{3b}$ is selected from an electron-withdrawing group, CN, partially fluorinated $C_1$ to $C_6$ alkyl, perfluorinated $C_1$ to $C_6$ alkyl, $CF_3$, substituted or unsubstituted $C_6$ to $C_{30}$ aryl, or substituted or unsubstituted $C_3$ to $C_{30}$ heteroaryl,
wherein the one or more substituents on $R^{3a}$ and $R^{3b}$, when present, are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy,

perfluorinated $C_1$ to $C_8$ alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl;

wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

wherein A is selected from substituted or unsubstituted $C_3$ to $C_{40}$ cycloalkane group containing at least one or more double-bonds, substituted or unsubstituted $C_3$ to $C_{40}$ cycloalkene group, substituted or unsubstituted $C_2$ to $C_{40}$ heterocycloalkane group, substituted or unsubstituted $C_2$ to $C_{40}$ heterocycloalkane group containing one or more double-bonds, substituted or unsubstituted $C_2$ to $C_{40}$ heterocycloalkene group, substituted or unsubstituted $C_6$ to $C_{40}$ aromatic group, substituted or unsubstituted $C_2$ to $C_{40}$ heteroaromatic group, wherein $X^1$, each $X^2$, and each $X^3$ are conjugated to each other via a double-bond in A;

wherein the one or more substituents on A, when present, are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted $C_6$ to $C_{30}$ aryl, substituted or unsubstituted $C_2$ to $C_{30}$ heteroaryl,

wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy.

According to one embodiment, wherein the compound of formula (V) comprises at least two groups selected from $C_6$ to $C_{19}$ aryl group or $C_3$ to $C_{12}$ heteroaryl group, wherein each of the $C_6$ to $C_{19}$ aryl group or $C_3$ to $C_{12}$ heteroaryl group is substituted, wherein the one or more substituents are independently of each other selected from halogen, F, CN, partially perfluorinated $C_1$ to $C_{12}$ alkyl, perfluorinated $C_1$ to $C_{12}$ alkyl, $CF_3$.

**Indacendione or indacenedione type compounds**

According to an embodiment, the first organic p-dopant is an indacenedione-type compound whereby the term "indacendione-type compound" means and/includes a compound which contains a moiety which is (formally) derived from a compound comprising an annelated aromatic system or non-annelated aromatic system whereby one or more carbon atoms of said annelated aromatic system or non-annelated aromatic system are double bonded to an atom or a group outside said annelated aromatic system or non-annelated aromatic system without a rearrangement of double bonds, preferably the indacenedione-type compound comprises at least two groups selected from $C_6$ to $C_{19}$ aryl group or $C_3$ to $C_{12}$ heteroaryl group, wherein each of the $C_6$ to $C_{19}$ aryl group or $C_3$ to $C_{12}$ heteroaryl group is substituted, wherein the one or more substituents are independently of each other selected from halogen, F, CN, partially perfluorinated $C_1$ to $C_{12}$ alkyl, perfluorinated $C_1$ to $C_{12}$ alkyl, $CF_3$.

According to an embodiment, the first organic p-dopant is an indacenedione-type compound whereby the term "indacendione-type compound" means and/includes indacenedione or a compound which contains a moiety which is (formally) derived indacenedione whereby at least one of the two oxygens are replaced by other atoms preferably carbon atoms, without a rearrangement of double bonds preferably the indacenedione-type compound comprises at least two groups selected from $C_6$ to $C_{19}$ aryl group or $C_3$ to $C_{12}$ heteroaryl group, wherein each of the $C_6$ to $C_{19}$ aryl group or $C_3$ to $C_{12}$ heteroaryl group is substituted, wherein the one or more substituents are independently of each other selected from halogen, F, CN, partially perfluorinated $C_1$ to $C_{12}$ alkyl, perfluorinated $C_1$ to $C_{12}$ alkyl, $CF_3$.

According to an embodiment, the first organic p-dopant is selected from a compound of comprising a indacenedione structure, a radialene compound of formula (IV), or a compound of formula (VIa) or (VIb):

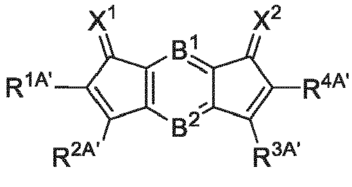 (VIa), 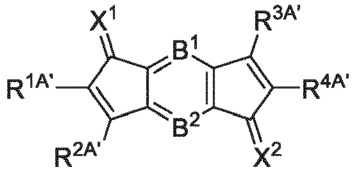 (VIb),

wherein

B[1] and B[2] are independently of each other selected from N, $CR^{5A'}$ or $CR^{6A'}$,

$R^{1A'}$, $R^{2A'}$, $R^{3A'}$, $R^{4A'}$, $R^{5A'}$, and $R^{6A'}$ are independently selected from each other from H, D, F, a substituted or unsubstituted $C_6$ to $C_{12}$ aryl, a substituted or unsubstituted $C_1$ to $C_{12}$ heteroaryl with 1 to 4 heteroatoms one among O, N, S and Si, a substituted or unsubstituted $C_1$ to $C_{12}$ alkyl, a substituted or unsubstituted $C_1$ to $C_{12}$ alkoxy, a substituted or unsubstituted $C_1$ to $C_{12}$ ether group, CN, $CF_3$, $OCF_3$, halogen, Cl, F, $Si(CH_3)_3$, preferably at least one among $R^1$ to $R^6$ comprises CN, wherein

the one or more substituents on $CR^{5A'}$, or $CR^{6A'}$are independently selected from each other from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to C alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl, wherein

the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from each other from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

$X^1$ and $X^2$ are independently of each other selected from formula (VIc)

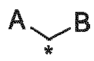

(VIc),

wherein

A and B are independently of each other is selected from H, D, a substituted or unsubstituted $C_6$ to $C_{12}$ aryl, a substituted or unsubstituted $C_1$ to $C_{12}$ heteroaryl with 1 to 4 heteroatoms one among O, N, S and Si, a substituted or unsubstituted $C_1$ to $C_{12}$ alkyl, a substituted or unsubstituted $C_1$ to $C_{12}$ alkoxy, a substituted or unsubstituted $C_1$ to $C_{12}$ ether group, CN, $CF_3$, $OCF_3$, halogen, Cl, F, $Si(CH_3)_3$, preferably the compound of formula (VIa) or (VIb) comprises at least two groups selected from $C_6$ to $C_{19}$ aryl group or $C_3$ to $C_{12}$ heteroaryl group, wherein each of the $C_6$ to $C_{19}$ aryl group or $C_3$ to $C_{12}$ heteroaryl group is substituted, wherein

the one or more substituents are independently of each other selected from halogen, F, CN, partially perfluorinated $C_1$ to $C_{12}$ alkyl, perfluorinated $C_1$ to $C_{12}$ alkyl, $CF_3$.

According to an embodiment, the first organic p-dopant is selected from a compound of formula (VIa) or (VIb):

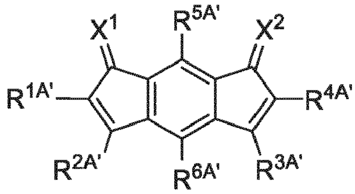

(VIa)

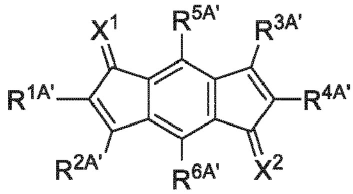

(VIb)

wherein

$R^{1A'}$, $R^{2A'}$, $R^{3A'}$, $R^{4A'}$, $R^{5A'}$, and $R^{6A'}$, are each independently of each other selected from H, D, a substituted or unsubstituted $C_6$ to $C_{12}$ aryl, a substituted or unsubstituted $C_1$ to $C_{12}$ heteroaryl with 1 to 4 heteroatoms one among O, N, S and Si, a substituted or unsubstituted $C_1$ to $C_{12}$ alkyl, a substituted or unsubstituted $C_1$ to $C_{12}$ alkoxy, a substituted or unsubstituted $C_1$ to $C_{12}$ ether group, CN, $CF_3$, $OCF_3$, halogen, Cl, F, $Si(CH_3)_3$, preferably at least one among $R^1$ to $R^6$ comprises CN; and

$X^1$ and $X^2$ are independently of each other selected from formula (VIc)

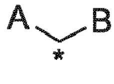

(VIc)

wherein A and B are independently of each other is selected from H, D, a substituted or unsubstituted $C_6$ to $C_{12}$ aryl, a substituted or unsubstituted $C_1$ to $C_{12}$ heteroaryl with 1 to 4 heteroatoms one among O, N, S and Si, a substituted or unsubstituted $C_1$ to $C_{12}$ alkyl, a substituted or unsubstituted $C_1$ to $C_{12}$ alkoxy, a substituted or unsubstituted $C_1$ to $C_{12}$ ether group, CN, $CF_3$, $OCF_3$, halogen, Cl, F, $Si(CH_3)_3$, preferably the compound of formula (VIa) or (VIb) comprises at least two groups selected from $C_6$ to $C_{19}$ aryl group or $C_3$ to $C_{12}$ heteroaryl group, wherein each of the $C_6$ to $C_{19}$ aryl

group or $C_3$ to $C_{12}$ heteroaryl group is substituted, wherein the one or more substituents are independently of each other selected from halogen, F, CN, partially perfluorinated $C_1$ to $C_{12}$ alkyl, perfluorinated $C_1$ to $C_{12}$ alkyl, $CF_3$.

According to an embodiment, in formula (IV), (V), (VIa), (VIb) the one or more substituents of the aryl, heteroaryl, alkyl, alkoxy, and ether group, when present, are independently of each other selected from $C_1$ to $C_{12}$ alkyl, $C_1$ to $C_{12}$ alkoxy, a $C_1$ to $C_{15}$ heteroalkyl with 1 to 4 heteroatoms one among O, N, O, S, and Si, CN, halogen Cl, F, $CF_3$, $OCF_3$, $Si(CH_3)_3$.

According to an embodiment, the first organic p-dopant, preferably the compound of formula (IV), (V), (VIa) or (VIb), may be selected from a compound H1 to H10:

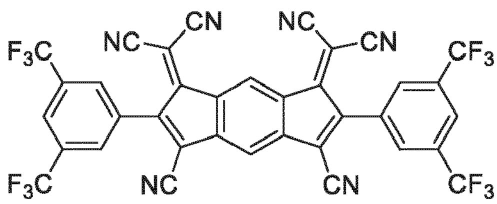 (H1), 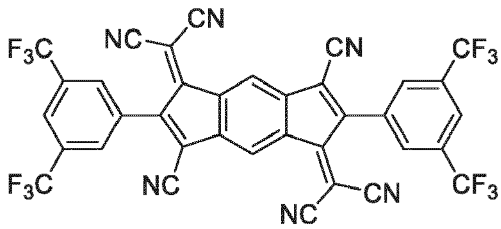 (H2),

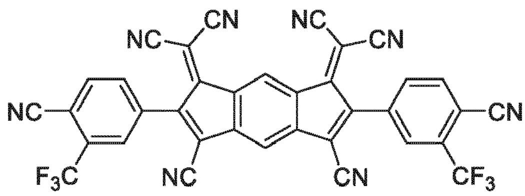 (H3), 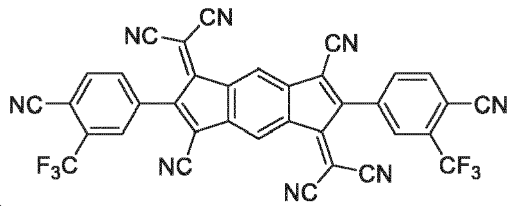 (H4),

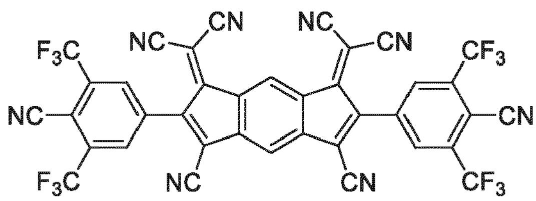 (H5), 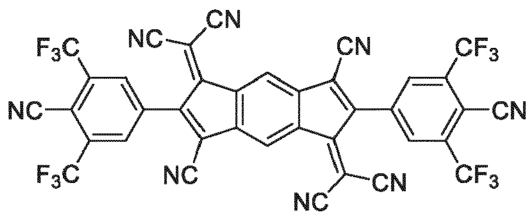 (H6),

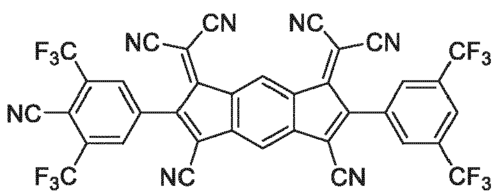 (H7), 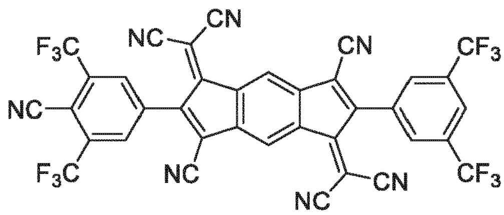 (H8) ,

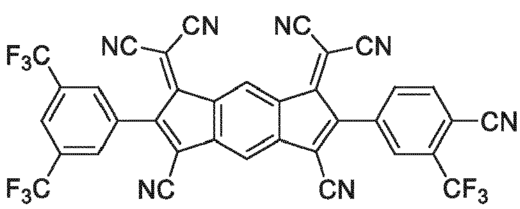 (H9), 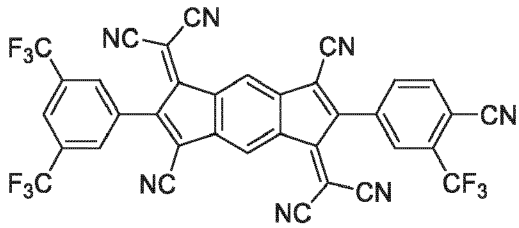 (H10).

**First organic p-dopant and/or the first organic p-dopant, preferably of formula (IV)**

According to one embodiment, wherein the first organic p-dopant is selected from a compound of K1 to K26:

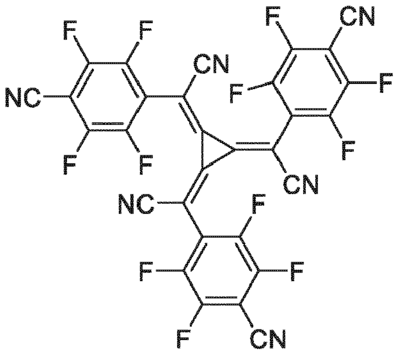 (K1), 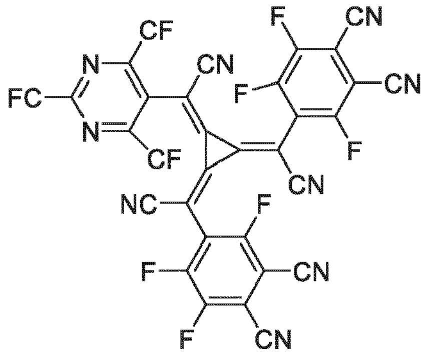 (K2),

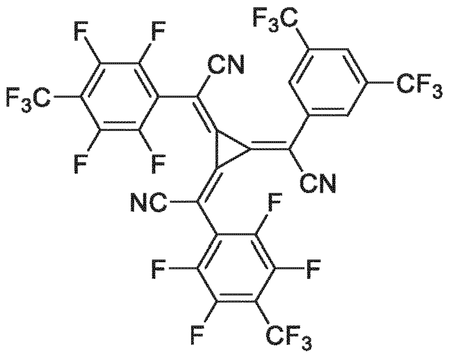 (K3), 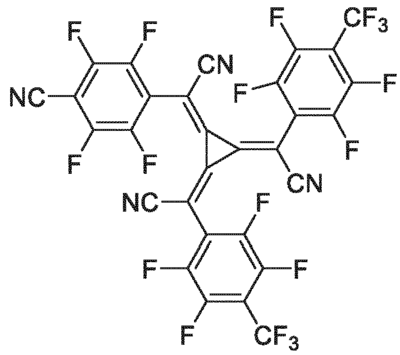 (K4),

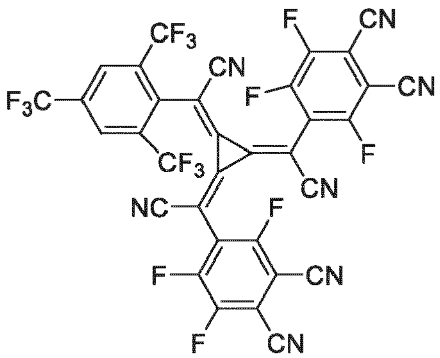 (K5), 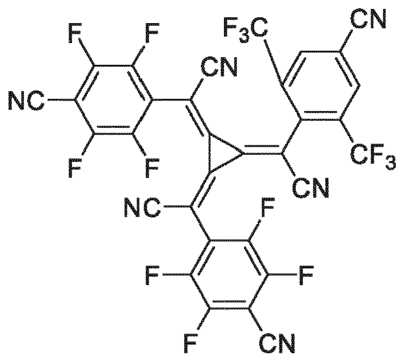 (K6),

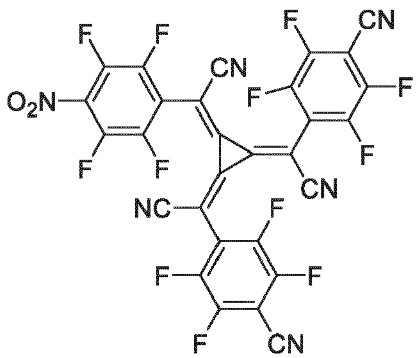 (K7), 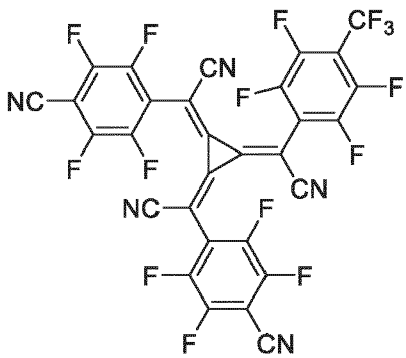 (K8),

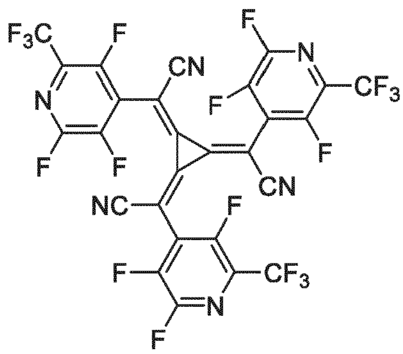 (K9), 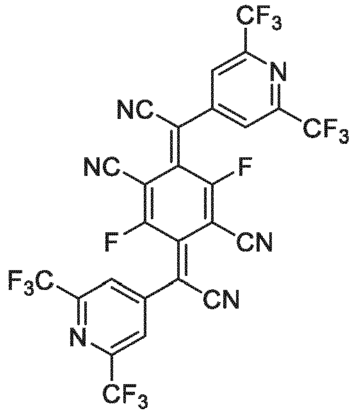 (K10),

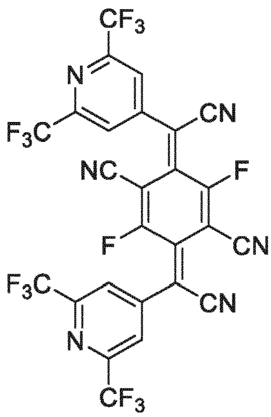 (K11), 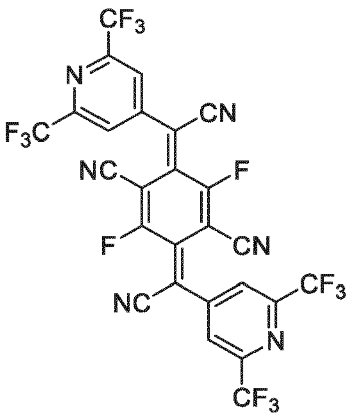 (K12), 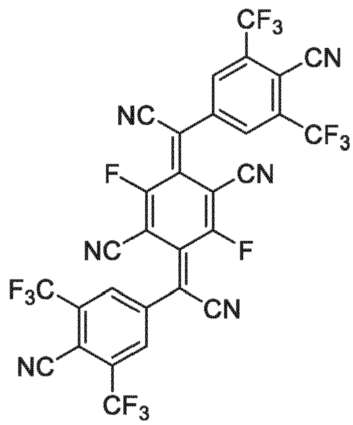 (K13),

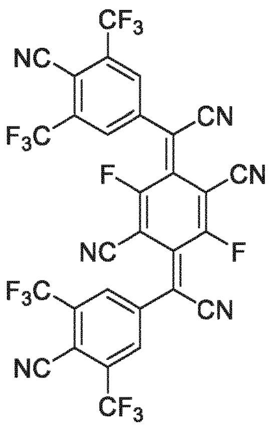 (K14), 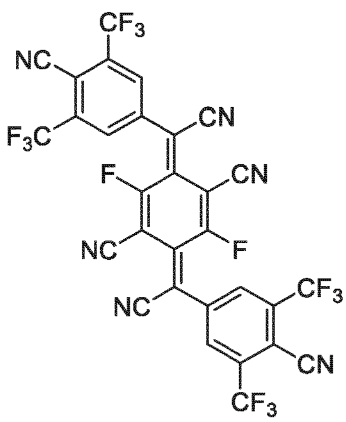 (K15), 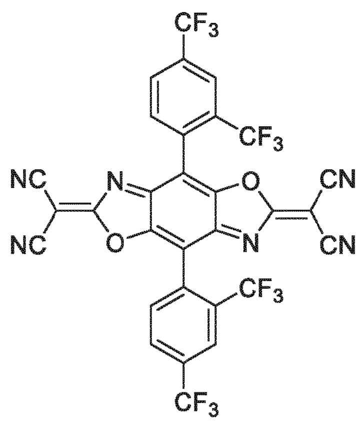 (K16),

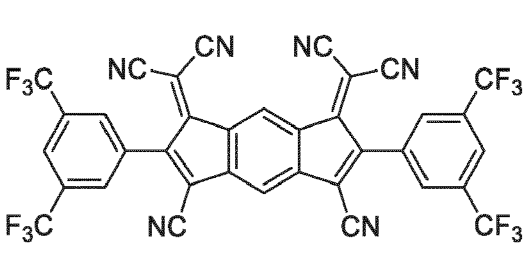 (K17), 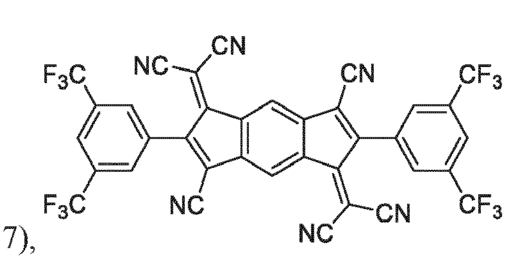 (K18),

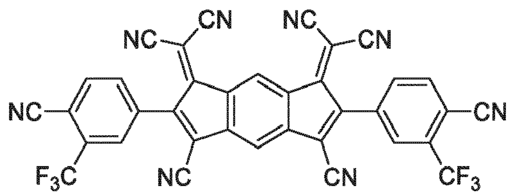 (K19), 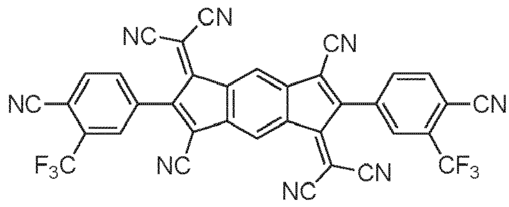 (K20),

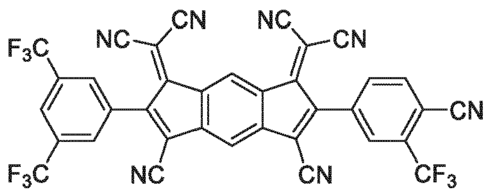 (K21), 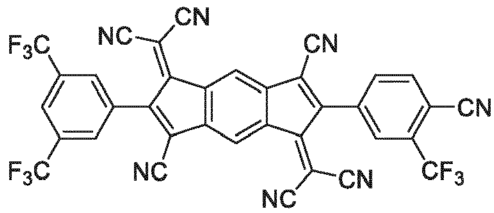 (K22),

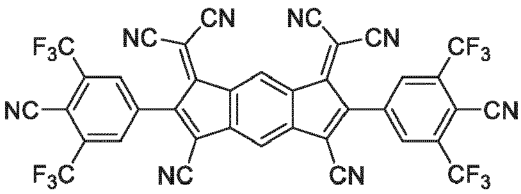 (K23), 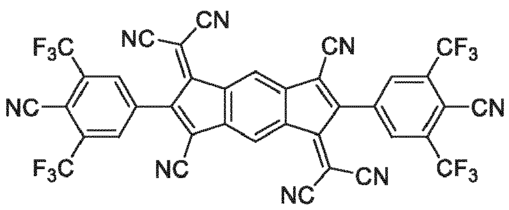 (K24),

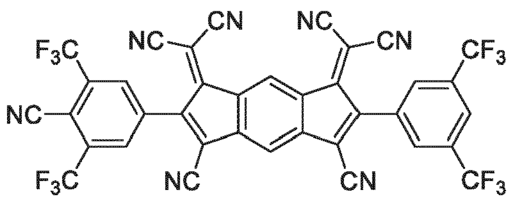 (K25), 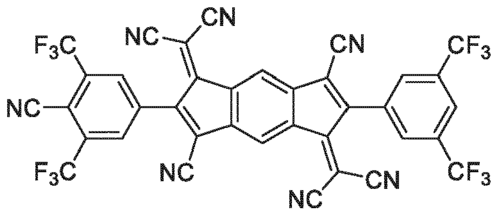 (K26).

According to one embodiment, wherein the first organic p-dopant is selected from K1 to K15. According to one embodiment, wherein the first organic p-dopant is selected from K10 to K16. According to one embodiment, wherein the first organic p-dopant is selected from K17 to K26.

According to one embodiment, wherein the first organic p-dopant is free of HAT-CN, F4-TCNQ and/or F6-TCNNQ.

## Composition

According to an embodiment, the hole injection layer comprises a composition comprising

- a first organic compound comprising ≥ 7 to ≤ 14 aromatic rings and at least one triarylamine moiety; and
- a second organic compound comprising ≥ 7 to ≤ 14 aromatic rings, wherein the second organic compound comprises at least one substituted or unsubstituted $C_3$ to $C_{24}$ heteroaryl group, azine group, 5-membered N-heteroaryl group, 6-membered N-heteroaryl group, or 6-membered heteroaryl group comprising between 1 and 3 N atoms, wherein
  the substituents of the at least one substituted or unsubstituted $C_3$ to $C_{24}$ heteroaryl group are selected from the group comprising H, D, F, C(-O)$R^{22}$, CN, Si($R^{22}$)$_3$, P(-O)($R^{22}$)$_2$, O$R^{22}$, S(-O)$R^{22}$, S(-O)$_2R^{22}$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted substituted or unsubstituted aromatic ring systems having 6 to 40 aromatic ring atoms, and substituted or unsubstituted heteroaromatic ring systems having 5 to 40 aromatic ring atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to

7-member ring of a non-heterocycle, and 6-member ring of an aromatic non-heterocycle, wherein

$R^{22}$ is selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl; and

- a first organic p-dopant comprises at least three CN groups, wherein the first organic p-dopant comprises independently of each other at least two groups selected from $C_6$ to $C_{19}$ aryl group or $C_3$ to $C_{12}$ heteroaryl group, wherein each of the $C_6$ to $C_{19}$ aryl group or $C_3$ to $C_{12}$ heteroaryl group is substituted,

wherein

the one or more substituents are independently selected from halogen, F, CN, partially perfluorinated $C_1$ to $C_{12}$ alkyl, perfluorinated $C_1$ to $C_{12}$ alkyl, $CF_3$;

wherein

optionally the second organic compound comprising ≥ 7 to ≤ 14 aromatic rings, if formed as a separated organic semiconductor layer, said separated organic semiconductor layer consisting of the second organic compound has a spontaneous orientation polarization in the range of ≥ 0 mV/nm to ≤ 150 mV/nm.

According to an embodiment, the composition of the hole injection layer consists of:

- a first organic compound comprising ≥ 7 to ≤ 14 aromatic rings and at least one triarylamine moiety; and
- a second organic compound comprising ≥ 7 to ≤ 14 aromatic rings; and
- a first organic p-dopant comprising at least three CN groups, and wherein the first organic p-dopant has a molecular weight of ≥ 400 g/mol and ≤ 2000 g/mol.

According to an embodiment, the LUMO energy level:

- of the first organic compound is the range of ≥ -1.5 eV to ≤ -0.7 eV, preferably ≥ -1.3 eV to ≤ - 0.8 eV, more preferably ≥ -1.2 eV to ≤ -0.85 eV; and/or
- of the second organic compound is the range of ≥ -3 eV to ≤ 0 eV, preferably ≥ -3 eV to ≤ -1 eV, more preferably ≥ -2.5 eV to ≤ -1 eV, most preferably ≥ -2 eV to ≤ -1.5 eV.

According to an embodiment, the dipole moment:

- of the first organic compound is in the range of ≥ 0.2 Debye to ≤ 3 Debye, and preferably ≥ 0.25 Debye to ≤ 2.5 Debye, and/or
- of the second organic compound is in the range of ≥ 0.2 Debye to ≤ 7 Debye, preferably ≥ 0.3 Debye to ≤ 6 Debye; more preferred ≥ 0.5 Debye to ≤ 5 Debye; alternatively ≥ 0.5 Debye to ≤ 4.8 Debye.

According to an embodiment, the composition may comprise ≤ 90 wt.-% first organic compound, ≥ 5 wt.-% second organic compound, and ≥ 1 wt.-% first organic p-dopant, preferably ≤ 85 wt.-% first organic compound, ≥ 10 wt.-% second organic compound, and ≥ 1 wt.-% first organic p-dopant; more preferred ≤ 88 wt.-% first organic compound, ≥ 10 wt.-% second organic compound, and ≥ 2 wt.-% first organic p-dopant.

According to an embodiment, the composition may comprise ≥ 55 and ≤ 90 wt.-% first organic compound, ≥ 10 and ≤ 35 wt.-% second organic compound and ≥ 1 and ≤ 10 wt.-% first organic p-dopant, preferably ≥ 60 and ≤ 90 wt.-% first organic compound, ≥ 10 and ≤ 30 wt.-% second organic compound and ≥ 1 and ≤ 10 wt.-% first organic p-dopant.

According to an embodiment, the composition may comprise:

≤ 90 wt.-% first organic compound, ≥ 5 wt.-% second organic compound, and ≥ 1 wt.-% first organic p-dopant, preferably ≤ 85 wt.-% first organic compound, ≥ 10 wt.-% second organic compound, and ≥ 1 wt.-% first organic p-dopant; more preferred ≤ 88 wt.-% first organic compound, > 10 wt.-% second organic compound, and ≥ 2 wt.-% first organic p-dopant; or

≥ 55 to ≤ 90 wt.-% first organic compound, ≥ 10 to ≤ 35 wt.-% second organic compound and ≥ 1 to ≤ 10 wt.-% first organic p-dopant, preferably ≥ 60 to ≤ 90 wt.-% first organic compound, ≥ 10 to ≤ 30 wt.-% second organic compound and ≥ 1 to ≤ 10 wt.-% first organic p-dopant.

The term "Δ [LUMO energy level of the first organic compound - LUMO energy level of the second organic compound]", also named "Δ [LUMO (first organic compound) - LUMO (second organic compound)]", refers to the

difference Δ between the LUMO energy level of the second organic compound and the LUMO energy level of the first organic compound. The difference "Δ [LUMO energy level of the first organic compound - LUMO energy level of the second organic compound]" is calculated by subtracting the LUMO energy level of the second organic compound from the LUMO energy level of the first organic compound.

According to an embodiment, the Δ [LUMO energy level of the first organic compound - LUMO energy level of the second organic compound] is > 0.2 eV and < 2.5 eV, preferably > 0.3 eV and ≤ 1.5 eV, more preferred > 0.4 eV and ≤ 1.3 eV.

According to an embodiment, the Δ [LUMO energy level of the first organic compound - LUMO energy level of the second organic compound] is > 0.3 eV and < 1.5 eV, preferably > 0.4 eV and ≤ 1.4 eV.

According to an embodiment, the Δ [LUMO energy level of the first organic compound - LUMO energy level of the second organic compound] is > 0.2 eV and < 2.5 eV, preferably > 0.3 eV and ≤ 1.5 eV, more preferred > 0.4 eV and ≤ 1.3 eV; wherein the LUMO energy level is calculated using the hybrid functional B3LYP with a Gaussian 6-31G* basis set as implemented in the program package TURBOMOLE V6.5.

According to an embodiment, the Δ [LUMO energy level of the first organic compound - LUMO energy level of the second organic compound] is > 0.3 eV and ≤ 1.5 eV, preferably > 0.4 eV and ≤ 1.4 eV; wherein the LUMO energy level is calculated using the hybrid functional B3LYP with a Gaussian 6-31G* basis set as implemented in the program package TURBOMOLE V6.5.

If the LUMO energy level of the first organic compound and the LUMO of the second organic compound are selected in this range, particularly improved performance may be obtained.

The term "Δ [HOMO energy level of the first organic compound - LUMO energy level of the first organic p-dopant]", also named "Δ [HOMO (first organic compound) - LUMO (first organic p-dopant)]", refers to the difference Δ between the LUMO energy level of the first organic p-dopant and the HOMO energy level of the first organic compound. The difference Δ [HOMO energy level of the first organic compound - LUMO energy level of the first organic p-dopant] is calculated by subtracting the LUMO energy level of the first organic p-dopant from the HOMO energy level of the first organic compound.

According to an embodiment, the difference Δ [HOMO energy level of the first organic compound - LUMO energy level of the first organic p-dopant] is ≥ 0.05 eV, preferably Δ [HOMO energy level of the first organic compound - LUMO energy level of the first organic p-dopant] ≥ 0.1 eV, wherein the HOMO and LUMO energy levels are calculated using the hybrid functional B3LYP with a Gaussian 6-31G* basis set as implemented in the program package TURBOMOLE V6.5.

According to an embodiment, the difference Δ [HOMO energy level of the first organic compound - LUMO energy level of the first organic p-dopant] is > 0 eV and ≤ 2 eV, preferably Δ [HOMO energy level of the first organic compound - LUMO energy level of the first organic p-dopant] ≥ 0.05 eV and ≤ 1.5 eV, more preferred Δ [HOMO energy level of the first organic compound - LUMO energy level of the first organic p-dopant] is ≥ 0.1 eV and ≤ 1 eV, wherein the HOMO and LUMO energy levels are calculated using the hybrid functional B3LYP with a Gaussian 6-31G* basis set as implemented in the program package TURBOMOLE V6.5. Thereby, particularly efficient p-doping of the first organic compound may be achieved.

According to an embodiment, the Δ [LUMO energy level of the first organic compound - LUMO energy level of the second organic compound] is > 0.2 eV and < 3 eV and the Δ [HOMO energy level of the first organic compound - LUMO energy level of the first organic p-dopant] > 0 eV and ≤ 2 eV, preferably the Δ [LUMO energy level of the first organic compound - LUMO energy level of the second organic compound] is > 0.3 eV and ≤ 1.4 eV and the Δ [HOMO energy level of the first organic compound - LUMO energy level of the first organic p-dopant] ≥ 0.05 eV and ≤ 1.5 eV, more preferred the Δ [LUMO energy level of the first organic compound - LUMO energy level of the second organic compound] is > 0.4 eV and ≤ 1.3 eV and the Δ [HOMO energy level of the first organic compound - LUMO energy level of the first organic p-dopant] ≥ 0.1 eV and ≤ 1 eV, wherein the HOMO and LUMO energy levels are calculated using the hybrid functional B3LYP with a Gaussian 6-31G* basis set as implemented in the program package TURBOMOLE V6.5.

Thereby, particularly improved performance of an organic electroluminescent device may be obtained.

According to an embodiment, the composition comprises a first organic compound, a second organic compound and a first organic p-dopant, wherein the first organic compound and/or the second organic compound are free of CN groups or partially or perfluorinated alkyl groups.

**Hole injection layer**

The composition of the hole injection layer may comprise ≤ 90 wt.-% first organic compound, > 5 wt.-% second organic compound, and ≥ 1 wt.-% first organic p-dopant, preferably ≤ 85 wt.-% first organic compound, ≥ 10 wt.-% second organic compound, and ≥ 1 wt.-% first organic p-dopant; more preferred ≤ 88 wt.-% first organic compound, ≥ 10 wt.-% second organic compound, and ≥ 2 wt.-% first organic p-dopant.

The composition of the hole injection layer may comprise ≥ 55 to ≤ 90 wt.-% first organic compound, > 10 to ≤ 35 wt.-% second organic compound and ≥ 1 to ≤ 10 wt.-% first organic p-dopant, preferably ≥ 60 to ≤ 90 wt.-% first organic compound, > 10 to ≤ 30 wt.-% second organic compound and ≥ 1 to ≤ 10 wt.-% first organic p-dopant.

The thickness of the HIL may be in the range from about 1 nm to about 100 nm, and for example, from about 1 nm

to about 25 nm. When the thickness of the HIL is within this range, the HIL may have excellent hole injecting characteristics, without a substantial penalty in driving voltage.

The hole injection layer (HIL) is formed on the anode electrode by vacuum deposition. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of $10^{-8}$ to $10^{-3}$ Torr (1 Torr equals 133.322 Pa), and a deposition rate of 0.1 to 10 nm/sec.

The hole injection layer is preferably "essentially non-emissive" and more preferred "non-emissive".

In the context of the present specification the term "essentially non-emissive" or "non-emissive" means that the contribution of the compound or layer to the visible emission spectrum from the device is less than 10 %, preferably less than 5 % relative to the visible emission spectrum. The visible emission spectrum is an emission spectrum with a wavelength of about ≥ 380 nm to about ≤ 780 nm.

**Further layers**

In accordance with the invention, the organic electroluminescent device may comprise, besides the layers already mentioned above, further layers. Exemplary embodiments of respective layers are described in the following:

**Substrate**

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate or a silicon substrate.

**Anode layer**

The anode layer, also named anode electrode, may be formed by depositing or sputtering a material that is used to form the anode layer. The material used to form the anode layer may be a high work-function material, so as to facilitate hole injection. The anode layer may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode layer. The anode layer may also be formed using metals, typically silver (Ag), gold (Au), or metal alloys.

The anode layer may comprise two or more anode sub-layers.

According to one embodiment, the anode layer comprises a first anode sub-layer and a second anode sub-layer, wherein the first anode sub-layer is arranged closer to the substrate and the second anode sub-layer is arranged closer to the cathode layer.

According to one embodiment, the anode layer may comprise a first anode sub-layer comprising or consisting of Ag or Au and a second anode-sub-layer comprising or consisting of transparent conductive oxide.

According to one embodiment, the anode layer comprises a first anode sub-layer, a second anode sub-layer and a third anode sub-layer, wherein the first anode sub-layer is arranged closer to the substrate and the second anode sub-layer is arranged closer to the cathode layer, and the third anode sub-layer is arranged between the substrate and the first anode sub-layer.

According to one embodiment, the anode layer may comprise a first anode sub-layer comprising or consisting of Ag or Au, a second anode-sub-layer comprising or consisting of transparent conductive oxide and optionally a third anode sub-layer comprising or consisting of transparent conductive oxide. Preferably the first anode sub-layer may comprise or consists of Ag, the second anode-sublayer may comprise or consists of ITO or IZO and the third anode sub-layer may comprises or consists of ITO or IZO.

Preferably the first anode sub-layer may comprise or consists of Ag, the second anode-sublayer may comprise or consists of ITO and the third anode sub-layer may comprise or consist of ITO.

Preferably, the transparent conductive oxide in the second and third anode sub-layer may be selected the same.

According to one embodiment, the anode layer may comprise a first anode sub-layer comprising Ag or Au having a thickness of 100 to 150 nm, a second anode sub-layer comprising or consisting of a transparent conductive oxide having a thickness of 3 to 20 nm and a third anode sub-layer comprising or consisting of a transparent conductive oxide having a thickness of 3 to 20 nm.

It is to be understood that the third anode layer is not part of the substrate.

## Hole transport layer

According to one embodiment of the present invention, the organic electroluminescent device further comprises a hole transport layer, wherein the hole transport layer is arranged between the hole injection layer and the at least one first emission layer.

The hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference.

According to one embodiment of the present invention, the hole transport layer may comprise a first organic compound as described above.

According to one embodiment of the present invention, the hole transport layer may comprise a compound of formula (Ia) or (Ib) as described above.

According to one embodiment of the present invention, the hole injection layer and the hole transport layer comprises the same first organic compound as described above.

According to one embodiment of the present invention, the hole injection layer and the hole transport layer comprise the same compound of formula (Ia) or (Ib) as described above.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

According to one embodiment of the present invention, the organic electroluminescent device further comprises a hole transport layer, wherein the hole transport layer is arranged between the hole injection layer and the at least one emission layer.

According to one embodiment of the present invention, the hole transport layer comprises a compound of formula (Ia) or (Ib), wherein more preferably the compound of formula (Ia) or (Ib) in the hole injection layer and hole transport layer is selected the same.

Thereby, only a small number of vacuum thermal evaporation sources is required for manufacture of organic electroluminescent devices according to invention.

## Electron blocking layer

The function of an electron blocking layer (EBL) is to prevent electrons from being transferred from an emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

## Emission layer (EML)

The emission layer (EML), also named first emission layer, may be formed on the HTL by vacuum deposition, spin coating, slot-die coat-ing, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

According to one embodiment, wherein the first emission layer (EML) comprises an organic emitter host compound and a light-emitting compound.

According to one embodiment, wherein the first emission layer comprises an organic emitter host compound and a light-emitting compound.

In the present specification the light-emitting compound may also be named emitter dopant.

According to one embodiment of the present invention, the first emission layer does not comprise the first organic compound and/or second organic compound.

According to one embodiment of the present invention, the first emission layer does not comprise the compound of formula (Ia), (Ib) or (II).

The first emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2Ir(acac), but are not limited thereto. These compounds are phosphorescent emitters, however, fluorescent red emitter dopants could also be used.

Examples of phosphorescent green emitter dopants are Ir(ppy)3 (ppy = phenylpyridine), Ir(ppy)2(acac), Ir(mpyp) 3.

Examples of phosphorescent blue emitter dopants are F2Irpic, (F2ppy)2Ir(tmd) and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the first emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

According to a preferred embodiment, the first emission layer comprises a light-emitting compound of formula (X):

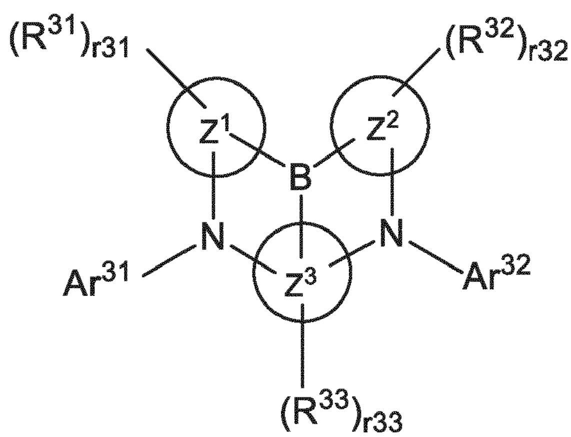

(X),

wherein

| | |
|---|---|
| $Z^1$, $Z^2$ and $Z^3$ | are the same as or different from each other, and are each independently selected from the group comprising a monocyclic to polycyclic aromatic hydrocarbon ring or monocyclic to polycyclic aromatic hetero ring; |
| $Ar^{31}$ and $Ar^{32}$ | are the same as or selected different from each other, and are each independently a substituted or unsubstituted alkyl group, a substituted or unsubstituted aryl group, or a substituted or unsubstituted heteroaryl group, or are bonded to an adjacent substituent to form a substituted or unsubstituted aromatic ring or a substituted or unsubstituted aliphatic ring; |
| $R^{31}$, $R^{32}$ and $R^{33}$ | are the same as or different from each other, and are each independently selected from the group comprising hydrogen, deuterium, a substituted or unsubstituted alkyl group, a substituted or unsubstituted silyl group, a substituted or unsubstituted amine group, a substituted or unsubstituted aryl group, or a substituted or unsubstituted heteroaryl group, or adjacent substituents are bonded to each other to form a substituted or unsubstituted aromatic ring or a substituted or un- |

substituted aliphatic ring,

wherein one or more substituents selected from the group consisting of deuterium, an alkyl group having 1 to 6 carbon atoms, an alkyl silyl group having 1 to 30 carbon atoms, an aryl silyl group having 6 to 50 carbon atoms, an alkylamine group having 1 to 30 carbon atoms, an alkylarylamine group having 1 to 50 carbon atoms, an arylamine group having 6 to 50 carbon atoms, an aryl group having 6 to 30 carbon atoms, and a heteroaryl group having 2 to 30 carbon atoms, or a substituent to which two or more substituents selected from the group are linked, or adjacent substituents are bonded to each other to form an aliphatic hydrocarbon ring having 3 to 60 carbon atoms, which is unsubstituted or substituted with the substituent;

$r^{31}$, $r^{32}$ and $r^{33}$ are each an integer from 0, 1, 2, 3 or 4, and when $r^{31}$ to $r^{13}$ are 2 or higher, substituents in the parenthesis are the same as or different from each other.

According to one embodiment, for formula (X):

$Z^1$, $Z^2$ and $Z^3$ are the same as or selected different from each other, and are each independently selected from the group comprising a monocyclic to bicyclic aromatic hydrocarbon ring, or a monocyclic to bicyclic aromatic hetero ring containing O, N or S;

$Ar^{31}$ and $Ar^{32}$ are the same as or selected different from, and are each independently selected from the group comprising an alkyl group having 1 to 10 carbon atoms, which is unsubstituted or substituted with an aryl group, an aryl group having 6 to 30 carbon atoms, which is unsubstituted or substituted with an aryl group, or a heteroaryl group having 2 to 30 carbon atoms;

$R^{31}$, $R^{32}$ and $R^{33}$ are the same as or selected different from each other, and are each independently selected from the group comprising hydrogen, deuterium, a substituted or unsubstituted alkyl group, a substituted or unsubstituted cycloalkyl group, a substituted or unsubstituted silyl group, a substituted or unsubstituted aryl group, or a substituted or unsubstituted heteroaryl group.

According to one embodiment, wherein for formula (X):

Z1, $Z^2$ and $Z^3$ are the same as or selected different from each other, and are each independently selected from the group comprising a benzene ring or a thiophene ring;

$Ar^{31}$ and $Ar^{32}$ are the same as or selected different from each other, and are each independently selected from the group comprising phenyl group, a biphenyl group, a naphthyl group, a dimethyl fluorenyl group, a diphenyl fluorenyl group, a dibenzofuran group, or a dibenzothiophene group;

$R^{31}$, $R^{32}$ and $R^{33}$ are the same as or selected different from each other, and are each independently selected from the group comprising hydrogen, deuterium, a substituted or unsubstituted alkyl group having 1 to 10 carbon atoms, a substituted or unsubstituted cycloalkyl group having 5 to 30 carbon atoms, a substituted or unsubstituted silyl group having 1 to 10 carbon atoms, a substituted or unsubstituted aryl group having 6 to 30 carbon atoms, or a substituted or unsubstituted heteroaryl group having 2 to 30 carbon atoms.

According to a preferred embodiment, the first emission layer comprises a light-emitting compound of formula (X), which is selected from formulae (BD 1) to (BD9):

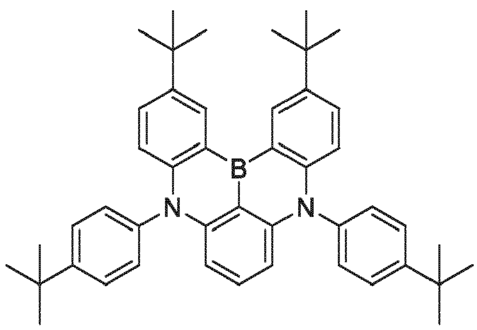
(BD1),

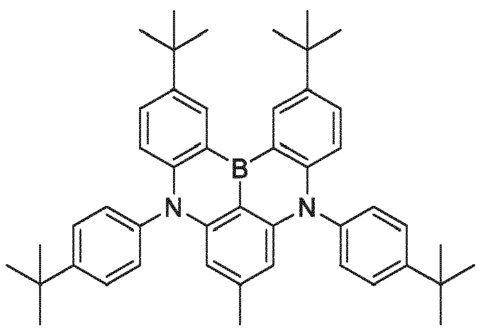
(BD2),

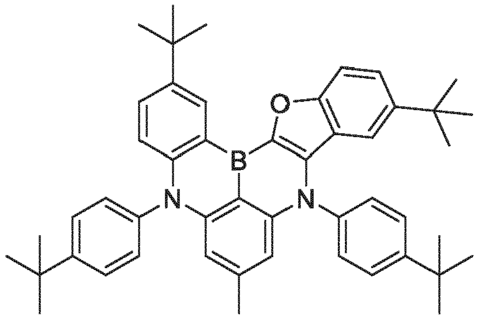 (BD3), 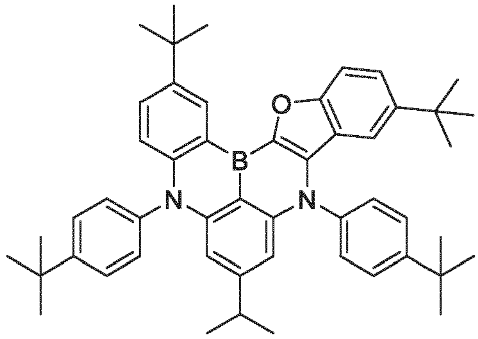 (BD4),

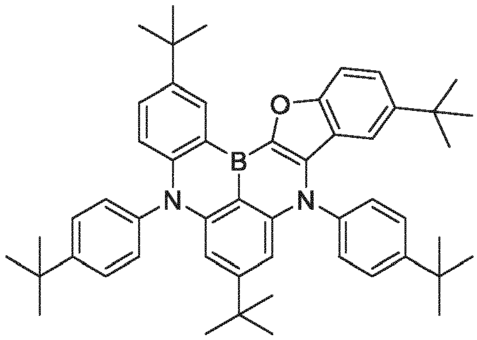 (BD5), 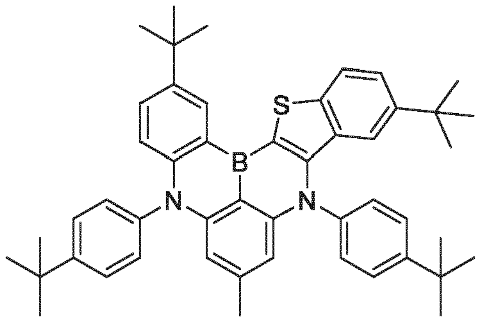 (BD6),

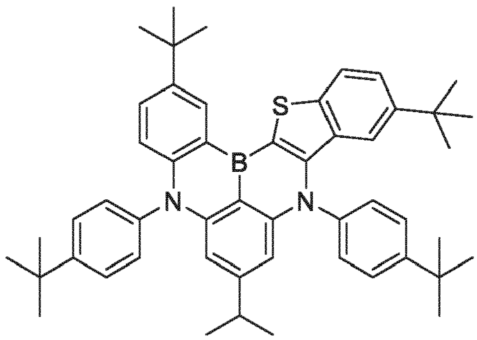 (BD7), 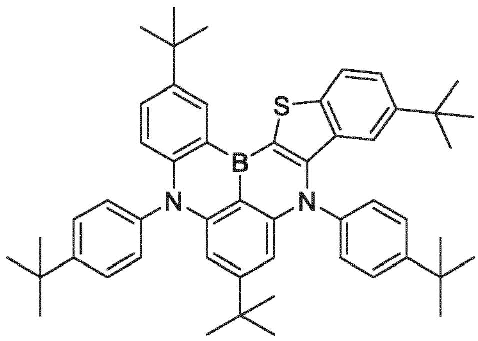 (BD8),

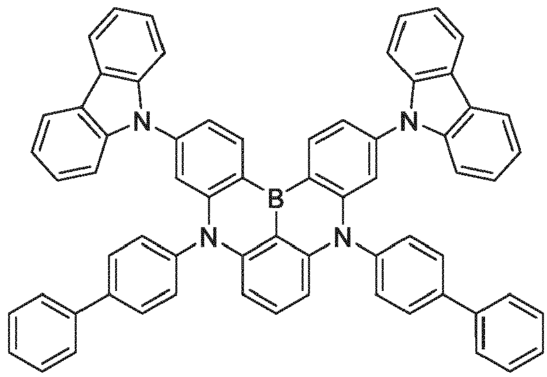 (BD9).

According to a preferred embodiment of the present invention, the first emission layer comprises an organic emitter host compound, wherein the organic emitter host compound comprises

- at least one condensed aromatic ring system consisting of 3 to 5 rings, and
- 3 to 7 aromatic or heteroaromatic rings, wherein one or more sub-groups of the aromatic and/or heteroaromatic rings may be condensed to form fused aromatic or heteroaromatic ring systems;

wherein the molecular weight Mw of the organic emitter host compound is in the range of ≥ 400 and ≤ 2000 g/mol.

According to a preferred embodiment of the present invention, the organic emitter host compound has the formula (XI)

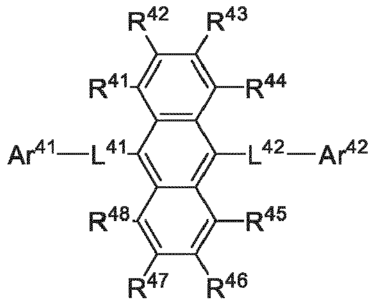

(XI),

wherein

$Ar^{41}$ and $Ar^{42}$ are independently selected from substituted or unsubstituted $C_6$ to $C_{24}$ aryl, substituted or unsubstituted $C_3$ to $C_{24}$ heteroaryl;

$L^{41}$ and $L^{42}$ are independently selected from a direct bond or substituted or unsubstituted $C_6$ to $C_{24}$ arylene, substituted or unsubstituted $C_3$ to $C_{24}$ heteroarylene;

$R^{41}$ to $R^{48}$ are independently selected from H, D, substituted or unsubstituted $C_1$ to $C_{12}$ alkyl, substituted or unsubstituted $C_6$ to $C_{19}$ aryl, substituted or unsubstituted $C_3$ to $C_{12}$ heteroaryl;

wherein

the substituents on $Ar^{41}$, $Ar^{42}$, $L^{41}$, $L^{42}$, $R^{41}$ to $R^{48}$ are independently selected from D, $C_6$ to $C_{10}$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy, halogen, F or CN.

According to a preferred embodiment of the present invention, the organic emitter host and/or compound of formula (XI) is selected from formulae (BH1) to (BH13):

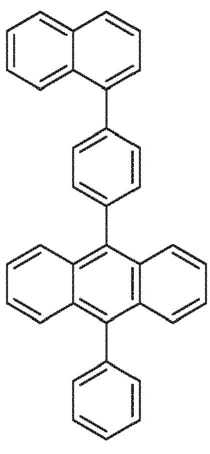

(BH1),

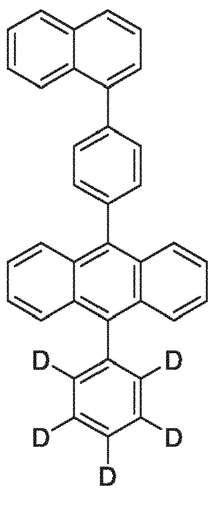

(BH2),

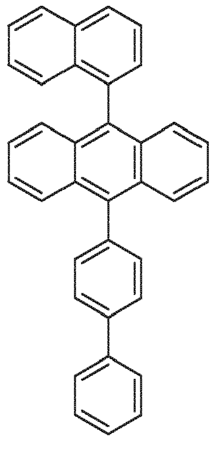

(BH3),

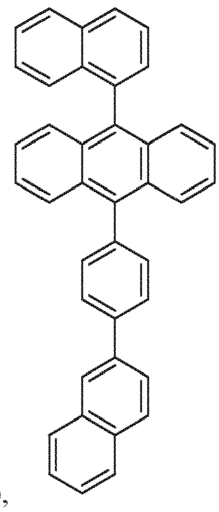

(BH4),

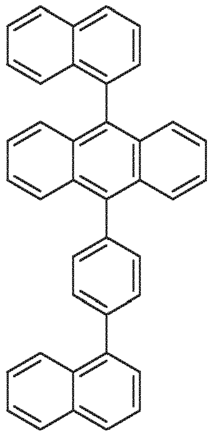 (BH5),

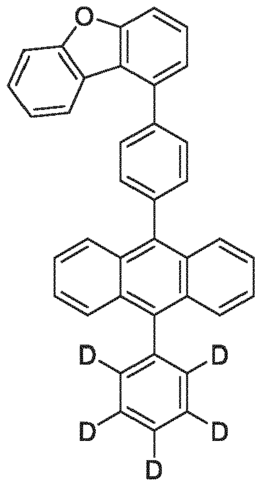 (BH6),

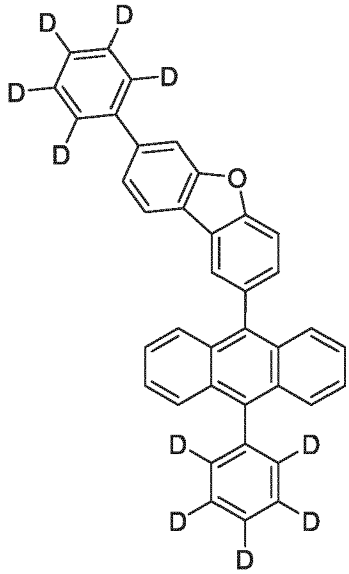 (BH7),

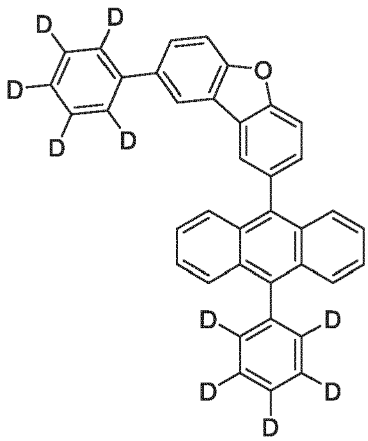 (BH8),

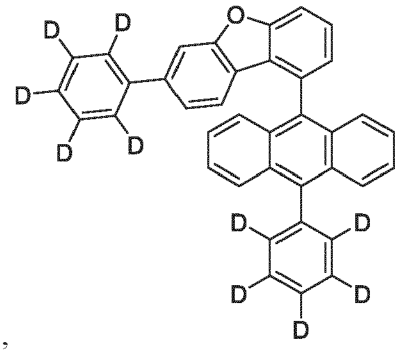 (BH9),

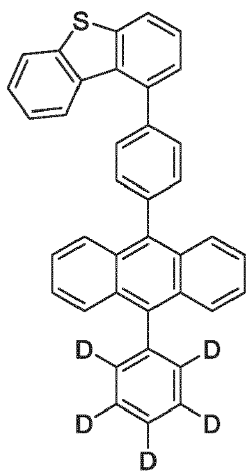 (BH10),

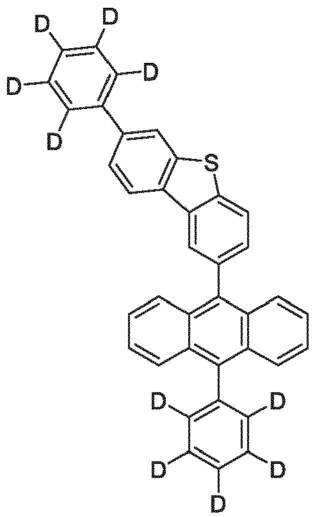 (BH11),

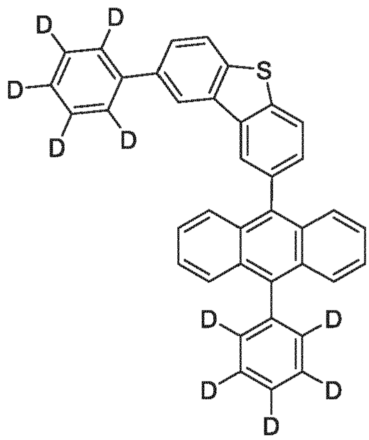
(BH12),

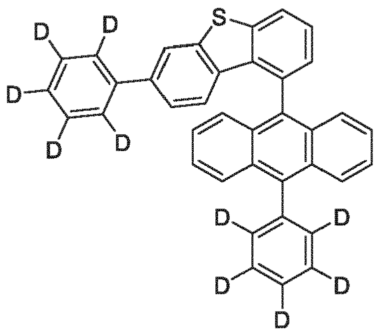
(BH13).

According to a preferred embodiment of the present invention, the first emission layer comprises a light-emitting dopant of formula (X) and an organic emitter host of formula (XI).

According to a preferred embodiment of the organic electroluminescent device, the hole injection layer comprises a compound of formula (Ia) and/or formula (Ib),a compound of formula (II) and a compound of formula (III), the hole transport layer comprises a compound of formula (Ia) and/or formula (Ib), preferably the hole injection layer and the hole transport layer comprise the same compound of formula (Ia) and/or formula (Ib) and the first emission layer comprises a light-emitting dopant of formula (X) and an organic emitter host of formula (XI);
wherein the hole transport layer is arranged between the hole injection layer and the first emission layer, and the first emission layer is arranged between the hole transport layer and the cathode layer.

According to a preferred embodiment of the organic electroluminescent device, the hole injection layer comprises a compound of formula (Ia) and/or formula (Ib),a compound of formula (II) and a compound of formula (III), the hole transport layer comprises a compound of formula (Ia) and/or formula (Ib), preferably the hole injection layer and the hole transport layer comprise the same compound of formula (Ia) and/or formula (Ib) and the first emission layer comprises a light-emitting dopant of formula (X) and an organic emitter host of formula (XI);

wherein the hole transport layer is arranged between the hole injection layer and the first emission layer, and the first emission layer is arranged between the hole transport layer and the cathode layer;
wherein the anode layer may comprise a first anode sub-layer comprising Ag or Au having a thickness of 100 to 150 nm, a second anode sub-layer comprising or consisting of a transparent conductive oxide having a thickness of 3 to 20 nm and a third anode sub-layer comprising or consisting of a transparent conductive oxide having a thickness of 3 to 20 nm, preferably the transparent conductive oxide is selected from ITO or IZO.

According to another embodiment of the present invention, the organic electroluminescent device further comprises a second emission layer, wherein the composition of the second emission layer may be selected the same or differently from the first emission layer, preferably, the composition of the second emission layer is selected the same as the first emission layer.

**Hole blocking layer (HBL)**

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and azine derivatives, preferably triazine or pyrimidine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

According to an embodiment, the hole blocking layer is free of second organic compound and/or compound of formula (II).

## Electron transport layer (ETL)

The organic electroluminescent device according to the present invention may further comprise an electron transport layer (ETL).

According to another embodiment of the present invention, the electron transport layer may further comprise an azine compound, preferably a triazine compound.

In one embodiment, the electron transport layer may further comprise a dopant selected from an alkali organic complex, preferably LiQ.

The thickness of the ETL may be in the range from about 15 nm to about 50 nm, for example, in the range from about 20 nm to about 40 nm. When the thickness of the EII, is within this range, the ETL may have satisfactory electron-injecting properties, without a substantial penalty in driving voltage.

According to another embodiment of the present invention, the organic electroluminescent device may further comprise an electron transport layer, wherein the electron transport layer comprises a second organic compound and or compound of formula (II).

According to another embodiment of the present invention, the organic electroluminescent device may further comprise an electron transport layer, wherein the electron transport layer and the hole injection layer comprise the same second organic compound and or compound of formula (II).

Thereby, only a small number of vacuum thermal evaporation sources is required for manufacture of organic electroluminescent devices according to invention.

According to another embodiment of the present invention, the organic electroluminescent device may further comprise a hole blocking layer and an electron transport layer, wherein the hole blocking layer and the electron transport layer comprise an azine compound. Preferably, the azine compound is a triazine compound.

According to another embodiment of the present invention, the organic electroluminescent device may further comprise a hole blocking layer and an electron transport layer, wherein the electron transport layer and the hole injection layer comprise the same second organic compound and or compound of formula (II).

## Electron injection layer (EIL)

An optional EIL, which may facilitates injection of electrons from the cathode, may be formed on the ETL, preferably directly on the electron transport layer. Examples of materials for forming the EII, include lithium 8-hydroxyquinolinolate (LiQ), LiF, NaCl, CsF, Li2O, BaO, Ca, Ba, Yb, Mg which are known in the art. Deposition and coating conditions for forming the EII, are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EII, is within this range, the EII, may have satisfactory electron-injecting properties, without a substantial penalty in driving voltage.

## Cathode layer

The cathode layer is formed on the ETL or optional EIL. The cathode layer may be formed of a metal, an alloy, an electrically conductive compound, or a mixture thereof. The cathode layer may have a low work function. For example, the cathode layer may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode layer may be formed of a transparent conductive oxide, such as ITO or IZO.

The thickness of the cathode layer may be in the range from about 5 nm to about 1000 nm, for example, in the range from about 10 nm to about 100 nm. When the thickness of the cathode layer is in the range from about 5 nm to about 50 nm, the cathode layer may be transparent or semitransparent even if formed from a metal or metal alloy.

According to a preferred embodiment of the present invention, the cathode is transparent.

It is to be understood that the cathode layer is not part of an electron injection layer or the electron transport layer.

## Organic electroluminescent device

The organic electroluminscent device according to the invention may be an organic light-emitting device, also named organic light-emitting diode (OLED).

According to one aspect of the present invention, there is provided an organic electroluminescent device comprising: a substrate; an anode layer formed on the substrate; a hole injection layer comprising a composition comprising a first organic compound, a second organic compound and a first p-dopant, a hole transport layer, an emission layer, an electron transport layer and a cathode layer.

According to another aspect of the present invention, there is provided an organic electroluminescent device comprising: a substrate; an anode layer formed on the substrate; a hole injection layer comprising a composition comprising a first organic compound, a second organic compound and a first organic p-dopant, a hole transport layer, an electron blocking layer, an emission layer, a hole blocking layer, an electron transport layer and a cathode layer.

According to another aspect of the present invention, there is provided an organic electroluminescent device comprising: a substrate; an anode layer formed on the substrate; a hole injection layer comprising a composition comprising a first organic compound, a second organic compound and a first organic p-dopant, a hole transport layer, an electron blocking layer, an emission layer, a hole blocking layer, an electron transport layer, an electron injection layer, and a cathode layer.

According to various embodiments of the present invention, there may be provided further layers arranged between the above mentioned layers, on the substrate or on the top electrode.

**Display device**

The present invention furthermore relates to a display device comprising an organic electroluminscent device according to the present invention.

In the display device, the organic electroluminescent device is arranged on a substrate.

The display device may comprise several organic electroluminescent devices, wherein the the organic electroluminescent devices are arranged on the substrate. In this arrangement, the organic electroluminescent devices may also be described as pixels.

The present invention furthermore relates to a display device comprising a substrate and several organic electroluminescent devices according to the present invention, wherein the organic electroluminescent devices are formed on the substrate as adjacent pixels, wherein the hole injection layer is formed as a common hole injection layer on the adjacent pixels.

**Method of manufacturing**

According to another aspect of the present invention, there is provided a method of manufacturing an organic electroluminescent device, the method using:

- at least one deposition source, preferably two deposition sources and more preferred at least three deposition sources.

The methods for deposition that can be suitable comprise:

- deposition via vacuum thermal evaporation;
- deposition via solution processing, preferably the processing is selected from spin-coating, printing, casting; and/or
- slot-die coating.

According to various embodiments of the present invention, the method may further include forming on the anode layer, at least one layer selected from the group consisting of forming a hole injection layer, a hole transport layer, an electron blocking layer, a first emission layer, a hole blocking layer, an electron transport layer and an electron injection layer between the anode layer and the cathode layer.

According to various embodiments of the present invention, the method may further include the steps for forming an organic electroluminescent device, wherein

- on a substrate an anode layer is formed,
- on the anode layer a hole injection layer comprising a composition comprising a first organic compound, a second organic compound and a first organic p-dopant is formed,
- on the hole injection layer comprising a composition comprising a first organic compound, a second organic compound and first organic dopant a hole transport layer is formed,
- optionally on the hole transport layer an electron blocking layer is formed,
- on the hole transport layer, or electron blocking layer if present, a first emission layer is formed,
- optionally on the first emission layer a hole blocking layer is formed,
- on the first emission layer, or hole blocking layer if present, an electron transport layer is formed,
- on the electron transport layer an electron injection layer is formed,
- and finally a cathode layer is formed.

According to various embodiments, the organic electroluminescent device may have the following layer structure, wherein the layers having the following order:
Anode layer, hole injection layer comprising a composition comprising a first organic compound, a second organic compound and first organic dopant, a hole transport layer, optionally an electron blocking layer, a first emission layer, optionally a hole blocking layer, an electron transport layer, optionally an electron injection layer, and cathode layer.

The present invention furthermore relates to a method of preparing an organic electroluminescent device according to the present invention, wherein the method involves a step of depositing the hole injection layer on the anode layer in vacuum, preferably the first organic compound is deposited from a first vacuum thermal evaporation source, the second organic compound is deposited from a second vacuum thermal evaporation source and the first organic p-dopant is deposited from a third vacuum thermal evaporation source.

The present invention furthermore relates to a method of preparing a display according to the present invention, wherein the method involves a step of depositing the hole injection layer on the anode layer in vacuum, preferably the first organic compound is deposited from a first vacuum thermal evaporation source, the second organic compound is deposited from a second vacuum thermal evaporation source and the first organic p-dopant is deposited from a third vacuum thermal evaporation source.

The present invention further more relates to a method of preparing a display device comprising a substrate and several organic electroluminescent devices according to the present invention, wherein the organic electroluminescent devices are formed in vaccum on the substrate as adjacent pixels, wherein the hole injection layer is formed in vacuum as a common hole injection layer on the adjacent pixels, preferably the first organic compound is deposited from a first vacuum thermal evaporation source, the second organic compound is deposited from a second vacuum thermal evaporation source and the first organic p-dopant is deposited from a third vacuum thermal evaporation source.

Hereinafter, the embodiments are illustrated in more detail with reference to examples. However, the present disclosure is not limited to the following examples. Reference will now be made in detail to the exemplary aspects.

## Description of the Drawings

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object are disclosed in the dependent claims and the following description of the respective figures which in an exemplary fashion show preferred embodiments according to the invention. Any embodiment does not necessarily represent the full scope, however, and reference is made therefore to the claims and herein for interpreting the scope. It is to be understood that both the foregoing general description and the following detailed description are exemplary and explanatory only and are intended to provide further explanation of the present invention as claimed.

Figures 1 to 14

FIG. 1 is a schematic sectional view of an organic electroluminescent device 100, according to an exemplary embodiment of the present invention;

FIG. 2 is a schematic sectional view of an organic electroluminescent device 100, according to an exemplary embodiment of the present invention.

FIG. 3 is a schematic sectional view of an organic electroluminescent device 100, according to an exemplary embodiment of the present invention;

FIG. 4 is a schematic sectional view of an organic electroluminescent device 100, according to an exemplary embodiment of the present invention;

FIG. 5 is a schematic sectional view of a separated organic electronic device 200 to determine the spontaneous orientation polarization of the second organic compound or the composition of the hole injection layer;

FIG. 6 shows an exemplary diagram of the voltage-capacitance characteristics of four devices d1 to d4 according to FIG. 5 comprising an organic semiconductor layer (240) comprising the second organic compound E1;

FIG. 6 shows an exemplary diagram of the voltage-capacitance characteristics of an organic electronic device 200 according to FIG. 5 comprising an organic semiconductor layer (240) having a thickness of 100 nm and comprising the second organic compound E1;

FIG. 8 shows an exemplary diagram in which the thickness of the organic semiconductor layer (240) comprising E1 is plotted against the transition voltage;

FIG. 9 is a schematic sectional view of a test element to determine the sheet resistance;
FIG. 10 is a schematic sectional view of deposited layer stack to determine the sheet resistance;
FIG. 11 is a schematic sectional view of a test element to determine the sheet resistance;
FIG. 12 shows an ITO coated substrate to determine the sheet resistance;
FIG. 13 is an exemplary diagram of a current-voltage measurement in the test element of FIG. 11;
FIG. 14 is an exemplary diagram of sheet resistances.

Hereinafter, the Figures 1 to 14 are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

FIG. 1 is a schematic sectional view of an organic electroluminescent device (OLED) 100, according to an exemplary embodiment of the present invention. The organic electroluminescent device 100 includes a substrate (110), an anode layer (120) and a hole injection layer (HIL) (130) which may comprise the composition comprising a first organic compound, a second organic compound and a first organic p-dopant. The HIL (130) is disposed on the anode layer (120). Onto the HIL (130), a first emission layer (EML) (150), and a cathode layer (190) are disposed.

FIG. 2 is a schematic sectional view of an organic electroluminescent device (OLED) 100, according to an exemplary embodiment of the present invention. The organic electroluminescent device 100 includes a substrate (110), an anode layer (120) and a hole injection layer (HIL) 130 which may comprise the composition comprising a first organic compound, a second organic compound and a first organic p-dopant. The HIL (130) is disposed on the anode layer (120). Onto the HIL (130), a hole transport layer (HTL) (140), a first emission layer (EML) (150), an electron transport layer (ETL) (160), an electron injection layer (EIL) (180) and a cathode layer (190) are disposed. Instead of a single electron transport layer (160), optionally an electron transport layer stack (ETL) can be used.

FIG. 3 is a schematic sectional view of an organic electroluminescent device (OLED) 100, according to an exemplary embodiment of the present invention. The organic electroluminescent device 100 includes a substrate (110), an anode layer (120) that comprises a first anode sub-layer (121) and a second anode sub-layer (122), a hole injection layer (HIL) (130) which may comprise the composition comprising a first organic compound, a second organic compound and a first organic p-dopant, a hole transport layer (HTL) (140), an electron blocking layer (EBL) (145), a first emission layer (EML) (150), a hole blocking layer (EBL) (155), an electron transport layer (ETL) (160) and a cathode layer (190). The layers are disposed exactly in the order as mentioned before.

FIG. 4 is a schematic sectional view of an organic electroluminescent device (OLED) 100, according to an exemplary embodiment of the present invention. The organic electroluminescent device 100 includes a substrate (110), an anode layer (120) that comprises a first anode sub-layer (121), a second anode sub-layer (122) and a third anode sub-layer (123), a hole injection layer (HIL) (130) which may comprise the composition comprising a first organic compound, a second organic compound and a first organic p-dopant, a hole transport layer (HTL) (140), an electron blocking layer (EBL) (145), a first emission layer (EML) (150), a hole blocking layer (EBL) (155), an electron transport layer (ETL) (160) and a cathode layer (190). The layers are disposed exactly in the order as mentioned before.

While not shown in FIG. 1 to FIG. 4, a capping and/or a sealing layer may further be formed on the cathode layer (190), in order to seal the organic electroluminescent device 100. In addition, various other modifications may be applied thereto.

FIG. 5 is a schematic sectional view of a separated organic electronic device 200 to determine the spontaneous orientation polarization of an organic semiconductor layer. The separated organic electronic device 200 includes a substrate (210), an anode layer (220) and a transport layer (HTL) (230). The HTL (230) is disposed on the anode layer (220). Onto the HTL (230), an organic semiconductor layer (240) comprising the second organic compound or the composition of the hole injection layer is disposed. Onto the organic semiconductor layer (240), the cathode layer (250) is disposed.

While not shown in FIG. 5, a sealing layer may further be formed on the cathode layer 250, in order to seal the separated organic electronic device 200.

FIG. 6 shows an exemplary diagram to determine the capacitance of the separated organic electronic device 200 of FIG. 5, wherein the organic semiconductor layer (240) consists of second organic compound E1 with a thickness of 50 nm, 100 nm, 150 nm and 200 nm. The capacitance in nano farad (nF) is plotted against the voltage in Volt.

FIG. 7 shows an exemplary diagram to determine the capacitance of the separated organic electronic device 200 of FIG. 5, wherein the organic semiconductor layer (240) consists of second organic compound E1 with a thickness of 100 nm. The capacitance in nF is plotted against the voltage in Volt. The voltage is determined at the point at which the capacitance increases. This is the so-called transition voltage. To accurately determine the transition voltage it may be beneficial to draw guidelines, see the dotted and dashed line in FIG. 7.

FIG. 8 shows an exemplary diagram to determine the spontaneous orientation polarization of second organic compound E1. The transition voltage determined in FIG. 7 for four devices comprising the organic semiconductor layer 240 consisting of second organic compound E1 with a thickness of 50 nm, 100 nm, 150 nm and 200 nm is plotted against the thickness of the organic semiconductor layer. The slope is the spontaneous orientation polarization.
FIG. 9 shows the test element comprising two highly conductive electrodes with a gap "l" between the two highly conductive electrodes and a width "w" for the respective highly conductive electrodes.
FIG. 10 shows schematic representation of a deposited layer stack on a test element group for determining the sheet resistance. The test element consists of a channel (test element). The deposition layer (300) lies on top of the electrode.
FIG. 11 shows the test element comprising two highly conductive electrodes with interdigitated finger pattern with a gap "1" between electrode fingers and total width "w" as product of interdigitation width "we" and number of interdigitation areas.
FIG. 12 shows an ITO coated substrate with 90nm ITO with 10 Ohm/sq sheet resistance patterned with electrode pairs with 4 different channel lengths combined on one substrate with 25×25mm$^2$ dimension.
FIG. 13 shows an exemplary diagram of a current-voltage measurement on a substrate shown in Figure 11.
FIG. 14 shows an exemplary diagram of sheet resistances derived from current-voltage measurement displayed in FIG. 13 plotted over corresponding channel length and calculation of slope thereof.
Hereinafter, the embodiments are illustrated in more detail with reference to examples. However, the present disclosure is not limited to the following examples.

**Detailed description**

The invention is furthermore illustrated by the following examples which are illustrative only and non-binding.
The first organic compound, second organic compound, and compounds of formulae (Ia), (Ib), (II), (III) to (VI) may be prepared by methods known in the art.

**Calculated HOMO energy level and LUMO energy level**

The HOMO energy level and LUMO energy level are calculated with the program package TURBOMOLE V6.5 (TURBOMOLE GmbH, Litzenhardtstrasse 19, 76135 Karlsruhe, Germany). The optimized geometries and the HOMO energy level and LUMO energy level of the molecular structures are determined by applying the hybrid functional B3LYP with a 6-31G* basis set in the gas phase. If more than one conformation is viable, the conformation with the lowest total energy is selected.
The HOMO energy level and LUMO energy level in Tables 1, 2, 3 and 4 were determined by this method unless noted otherwise.

**Dipole moment**

The dipole moment $|\bar{\mu}|$ of a molecule containing N atoms is given by:

$$\vec{\mu} = \sum_{i}^{N} q_i \vec{r_i}$$

$$|\vec{\mu}| = \sqrt{\mu_x^2 + \mu_y^2 + \mu_z^2}$$

where $q_i$ and $\vec{r_i}$ are the partial charge and position of atom i in the molecule.
The dipole moment is determined by a semi-empirical molecular orbital method.
The geometries of the molecular structures are optimized using the hybrid functional B3LYP with the 6-31G* basis set in the gas phase as implemented in the program package TURBOMOLE V6.5 (TURBOMOLE GmbH, Litzenhardtstrasse 19, 76135 Karlsruhe, Germany). If more than one conformation is viable, the conformation with the lowest total energy is selected to determine the bond lengths of the molecules.
The dipole moment in Tables 1 and 2 was determined by this method.

## Spontaneous orientation polarization of the second organic compound determined via impedance measurements

To determine the spontaneous orientation polarization of second organic compounds and comparative compounds in Table 2, an organic electronic device 200 is prepared as described below.

A glass substrate with an anode layer comprising a first anode sub-layer of 120 nm Ag, a second anode sub-layer of 8 nm ITO and a third anode sub-layer of 10 nm ITO was cut to a size of 25 mm × 25 mm × 0.7 mm, ultrasonically washed with water for 60 minutes and then with isopropanol for 20 minutes. The liquid film was removed in a nitrogen stream, followed by plasma treatment to prepare the anode layer. The plasma treatment was performed in an atmosphere comprising 97.6 vol.-% nitrogen and 2.4 vol.-% oxygen.

Then, the substrate was transferred to a vacuum chamber and biphenyl-4-yl(9,9-diphenyl-9H-fluoren-2-yl)-[4-(9-phenyl-9H-carbazol-3-yl)phenyl] -amine (CAS 1242056-42-3) was vacuum deposited at a rate of 1 Å/s at $10^{-7}$ to $8.10^{-7}$ mbar on the anode, to form a HTL (230) having a thickness of 50 nm.

Then, the second organic compound or comparative compound is vacuum deposited at a rate of 1 Å/s at $10^{-7}$ to $8 \cdot 10^{-7}$ mbar on the HTL to form an organic semiconductor layer (240) with a thickness of 50 nm (device d1 with thickness 11), 100 nm (device d2 with thickness t2), 150 nm (device d3 with thickness t3) or 200 nm (device d4 with thickness t4). A BPG400 BA Pirani Gauge was used to determine the process pressure at a distance to Substrate > 60 cm.

Then, the cathode layer (250) is vacuum deposited on the organic semiconductor layer by evaporating Ag:Mg (90:10 vol.-%) at a rate of 0.01 to 1 Å/s at $10^{-7}$ mbar.

Substrate temperature during deposition process is at room temperature. Waiting time in between individual layers is less than 60 minutes. Deposition is done in the dark.

The device stack is protected from ambient conditions by encapsulation of the device with a glass lid. The glass lid provides a cavity, which includes a getter material for further protection.

Prior evaluation the device is annealed for 3 h at a temperature of 85°C.

To determine the spontaneous orientation polarization of the organic semiconductor layer, the impedance is measured in the dark at a fixed frequency of 1 kHz and a room temperature of 20°C in Rp-Cp mode by applying a swept bias voltage from -20 V to 20 V in 0.1 V increments and using an AC-amplitude of 50mV for each of the four devices d1 to d4, wherein the thickness of the layer comprising the second organic compound is varied between 50 and 200 nm in 50 nm increments. An impedance analyzer Wayne-Kerr-6500P was used to determine the parallel capacitance in Rp-Cp mode. The Rp-Cp mode may also be named parallel resistor-capacitor mode.

The parallel capacitance Cp in nano Farad (nF) is plotted against the voltage in V. The transition voltage v1 to v4 is determined as the lowest applied bias voltage at which the capacitance increases, see Figure 7. If the voltage applied to the organic electronic device is very high current may start to flow. Therefore, valid data points fulfill the equation Rp x Apix > 1 $M\Omega mm^2$, wherein Rp is the parallel resistance in MS2 and Apix is the device electrically active area measured in $mm^2$.

The transition voltage v1 to v4 is plotted against the layer thickness t1 to t4 and the spontaneous orientation polarization in mV/nm is determined by determining the slope of a linear fit of the data points, see Figure 8.

Unless stated otherwise, the spontaneous orientation polarization in Table 2 was determined by this method.

## General procedure for fabrication of organic electroluminescent devices (OLEDs)

For inventive examples and comparative examples in Tables 5 and 6, a glass substrate with an anode layer comprising a first anode sub-layer of 120 nm Ag, a second anode sub-layer of 8 nm ITO and a third anode sub-layer of 10 nm ITO was cut to a size of 25 mm × 25 mm × 0.7 mm, ultrasonically washed with water for 60 minutes and then with isopropanol for 20 minutes. The liquid film was removed in a nitrogen stream, followed by plasma treatment to prepare the anode layer. The plasma treatment was performed in an atmosphere comprising 97.6 vol.-% nitrogen and 2.4 vol.-% oxygen.

Then, the first organic compound or the compound of formula (I), the second organic compound or the compound of formula (II) and first organic p-dopant or the compound of formula (III) or comparative compounds were co-deposited in vacuum on the anode layer, to form a hole injection layer (HIL). The composition of the hole injection layer can be seen in Tables 5 and 6. The thickness of the HIL was 10 nm unless noted otherwise. The formulae of the first organic compounds or compounds of formula (I) are described above or can be seen in Table 1. The formulae of the second organic compounds or compounds of formula (II) are described above or can be seen in Table 2. The formulae of the first organic p-dopant or compounds of formula (III) are described above or can be seen in Table 3. The formulae of comparative compounds can be seen in Tables 1 and 2.

Then, the first organic compound or compound of formula (I) was vacuum deposited on the HIL, to form a HTL. The first organic compound or compound of formula (I) in the HTL is selected the same as the first organic compound in the HIL. The thickness of the HTL was 128 nm unless noted otherwise. In comparative example 1-2, first organic compound F18 was vacuum deposited to form the HTL having a thickness of 128 nm.

Then N,N-di([1,1'-biphenyl]-4-yl)-3'-(9H-carbazol-9-yl)-[1,1'-biphenyl]-4-amine was vacuum deposited on the HTL, to form an electron blocking layer (EBL) having a thickness of 5 nm.

Then the first emission layer (EML) was formed on the EBL having a thickness of 20 nm by co-depositing in vacuum 99 vol.-% EML host compound BH9 and 1 vol.-% EML dopant BD8.

Then a hole blocking layer (HBL) was formed with a thickness of 5 nm by depositing 2-(3'-(9,9-dimethyl-9H-fluoren-2-yl)-[1,1'-biphenyl]-3-yl)-4,6-diphenyl-1,3,5-triazine in vacuum on the first emission layer EML.

Then the electron transport layer (ETL) having a thickness of 31 nm was formed on the hole blocking layer by co-depositing in vacuum 50 wt.-% 2-(2',6'-diphenyl-[1,1':4',1"-terphenyl]-4-yl)-4-phenyl-6-(3-(pyridin-4-yl)phenyl)-1,3,5-triazine and 50 wt.-% of LiQ.

Then an electron injection layer (EIL) was formed on the electron transport layer by vacuum depositing a layer of 2 nm Yb.

Then Ag:Mg (90:10 vol.-%) was evaporated at a rate of 0.01 to 1 Å/s at $10^{-7}$ mbar to form a cathode layer with a thickness of 13 nm on the electron injection layer.

Then, N-([1,1'-biphenyl]-4-yl)-9,9-dimethyl-N-(4-(9-phenyl-9H-carbazol-3-yl)phenyl)-9H-fluoren-2-amine was vacuum deposited on the cathode layer to form a capping layer with a thickness of 75 nm.

The OLED stack is protected from ambient conditions by encapsulation of the device with a glass slide. Thereby, a cavity is formed, which includes a getter material for further protection.

To assess the performance of the inventive examples compared to the prior art, the current efficiency is measured at 20°C. The current-voltage characteristic is determined using a Keithley 2635 source measure unit, by sourcing an operating voltage U in V and measuring the current in mA flowing through the device under test. The voltage applied to the device is varied in steps of 0.1V in the range between 0V and 10V. Likewise, the luminance-voltage characteristics and CIE coordinates are determined by measuring the luminance in $cd/m^2$ using an Instrument Systems CAS-140CT array spectrometer (calibrated by Deutsche Akkreditierungsstelle (DAkkS)) for each of the voltage values.

In top emission devices, the emission is forward directed, non-Lambertian and also highly dependent on the micro-cavity. In order to minimize the effect of the micro-cavity and thus of the emission color on the device performance, the efficiency Eff. is measured in Candela per Ampere (cd/A) and divided by the CIE-y. Thereby, the CEff/CIE-y values are obtained.

**Sheet resistance Rs**

The sheet resistance Rs of an organic semiconductor layer comprising the composition according to invention and comparative compositions is determined by the transmission line below. The transmission line method may also be described as transfer length method.

The sheet resistance Rs cannot be determined in an organic electroluminescent device, as the other layers would interfere with the measurement.

**Substrate and sample preparation**

To determine the sheet resistance Rs in GΩ/sq of Examples and comparative examples in Tables 5 and 6, the substrate and samples were prepared as described below.

ITO coated substrates with 90 nm ITO with 10 Ohm/sq sheet resistance (Corning Eagle XG) were patterned with interdigitated finger structure according to Figure 11. 12 ITO fingers on both electrodes form a total of 23 conductive areas: n=23. Interdigitation length $w_e$ was 4.5mm. Thus total channel width was 103.5mm. Channel length w was varied between 20 and 80 μm in 20μm steps. Electrode pairs with 4 different channel lengths were combined on one substrate with $25\times25mm^2$ dimension like displayed in Figure 12. After wet cleaning with water based tenside solution and drying by blowing with nitrogen followed by 200°C 120 minutes baking in nitrogen atmosphere, the substrates are conditioned with nitrogen plasma.

The organic semiconductor layers were deposited on the substrate in such a way that the complete interdigitated finger pattern was covered, as shown in Figure 10.

On the substrates, the compounds or compositions according to examples and comparatives examples in Tables 5 and 6 were deposited by co-evaporation in vacuum to form a first organic semiconductor layer having a thickness of 10 nm. The deposition of the composition or comparative composition took place at constant rate of approx. 1Å/s (Angström per second). The composition of the first organic semiconductor layer was selected the same as the composition of the hole injection layer in the corresponding OLED device, see Tables 5 and 6.

On the first organic semiconductor layer, a second organic semiconductor layer with a thickness of 120 nm was deposited in a high vacuum by thermal evaporation at a deposition rate of 2 Å/s. The vacuum chamber pressure was 3e-7 mbar during the whole deposition process. The composition of the second organic semiconductor layer was selected the same as the composition of the hole transport layer in the corresponding OLED device in Tables 5 and 6.

The substrate layer devices obtained by this method were encapsulated in a Nitrogen filled glovebox using glass lids with integrated desiccant, to prevent sample degradation, after organic layer deposition.

**Method for determining the sheet resistance Rs**

The method for determining the sheet resistance Rs of the substrate layer devices obtained above is described below.

The sheet resistance Rs is measured for a given deposited layer stack on a test element group (see Figure 9) consisting of test elements called channel providing two highly conductive electrodes with gap "l" between each other and a width "w" of each (see Figure 9). To improve noise level and reduce test element size, electrodes are formed in interdigitated finger structure (see Figure 11). Four of such channels with channel length l1=20μm, l2=40μm, l3=60μm and l4=80μm were used for Rs determination. Channel width "w" for all 4 channels was 103500μm. (see Figure 12).

For each channel "n" with channel length "ln" resistance "Rn" is determined by performing the following steps:

1. The voltage is swept between -5V to +5V with step size of 0.5V and the current is measured.
2. The voltage values from step 1 are plotted over measured current values from step 1 (see Figure 13).
3. The slope of linear fit of plot from step 2 results in the resistance "Rn".

After determination of resistances "Rn" channel width "w" multiplied with slope of a linear fit with resistances "Rn" plotted over channel length "ln" (see Figure 14) gives sheet resistance Rs for deposited layer stack.

The substrate temperature during this measurement was 23+/-2 °C. The Rs is determined in MΩ/sq. The Rs values in Tables 5 and 6 were determined by this method.

**Technical Effect of the invention**

In Table 1 are shown the chemical formulae and physical properties of the first organic compound.

Table 1: Chemical formulae and physical properties of the first organic compound

| Referred to as: | Chemical formula | LUMO [eV] | HOMO [eV] | Dipole moment [Debye] |
|---|---|---|---|---|
| F1 | 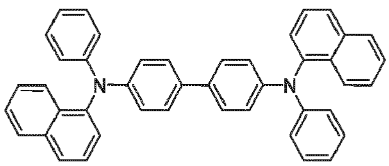 | -1.13 | -4.72 | 0.20 |
| F2 | 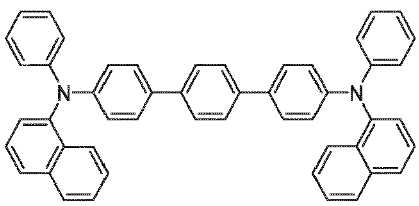 | -1.18 | -4.81 | 0.76 |

(continued)

| Referred to as: | Chemical formula | LUMO [eV] | HOMO [eV] | Dipole moment [Debye] |
|---|---|---|---|---|
| F3 | 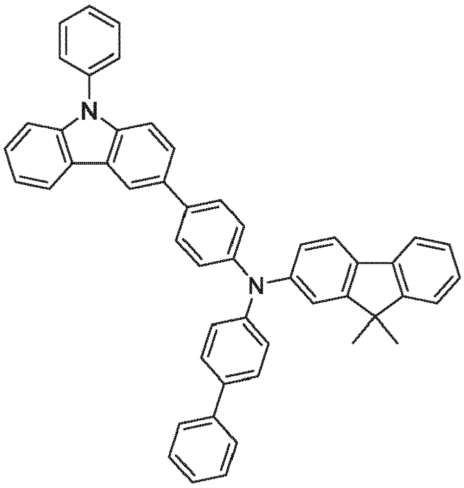 | -0.89 | -4.69 | 2.46 |
| F4 | 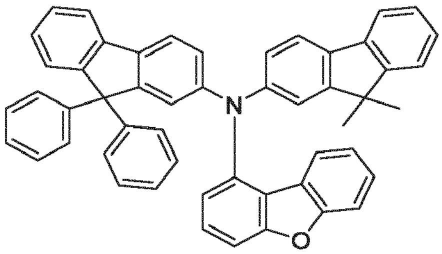 | -1.09 | -4.85 | 0.80 |
| F5 | 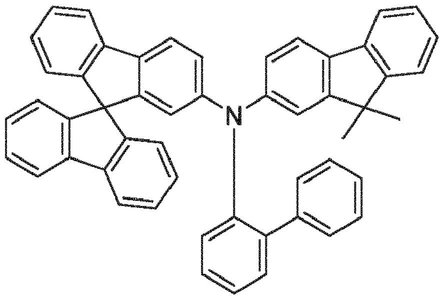 | -0.93 | -4.73 | 0.58 |
| F6 | 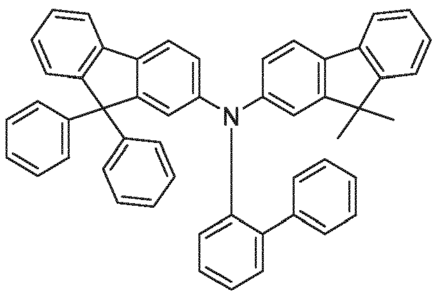 | -0.93 | -4.75 | 0.98 |

(continued)

| Referred to as: | Chemical formula | LUMO [eV] | HOMO [eV] | Dipole moment [Debye] |
|---|---|---|---|---|
| F7 | 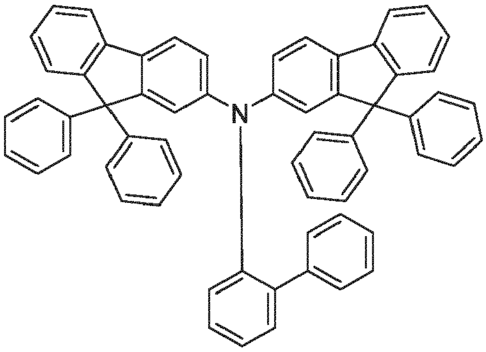 | -0.96 | -4.77 | 0.69 |
| F8 | 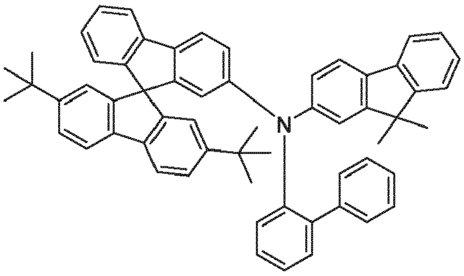 | -0.89 | -4.71 | 0.59 |
| F9 | 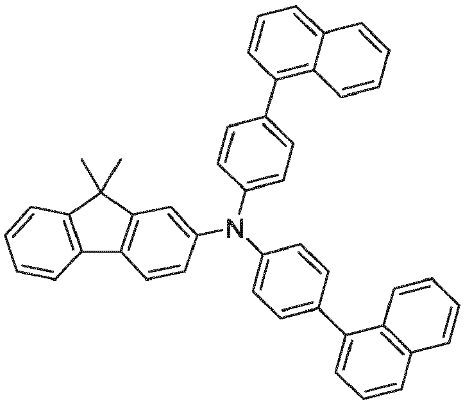 | -1.15 | -4.84 | 0.55 |
| F10 | 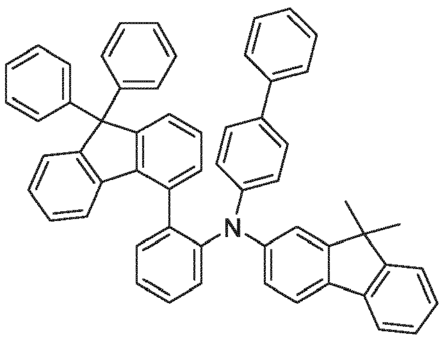 | -1.04 | -4.84 | 0.29 |

(continued)

| Referred to as: | Chemical formula | LUMO [eV] | HOMO [eV] | Dipole moment [Debye] |
|---|---|---|---|---|
| F11 | 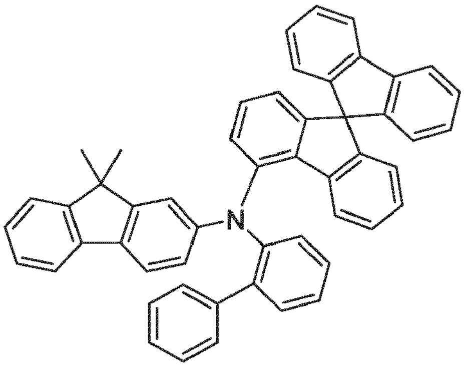 | -0.86 | -4.93 | 0.93 |
| F12 | 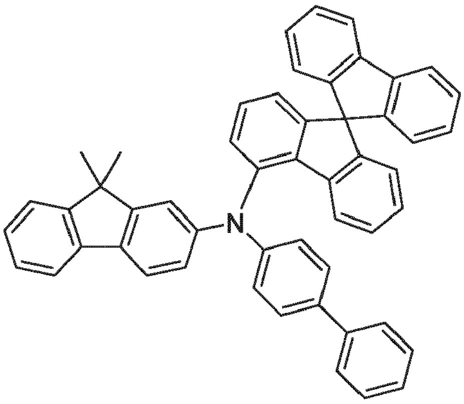 | -0.99 | -4.87 | 1.20 |
| F13 | 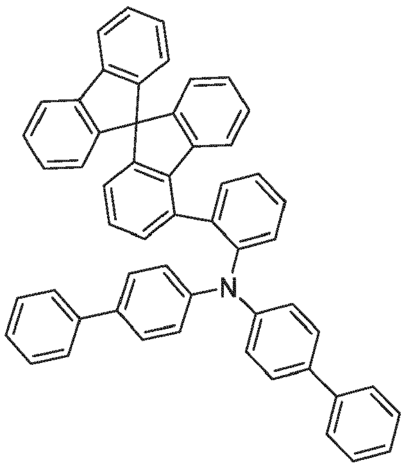 | -1.01 | -4.92 | 0.57 |

(continued)

| Referred to as: | Chemical formula | LUMO [eV] | HOMO [eV] | Dipole moment [Debye] |
|---|---|---|---|---|
| F14 | 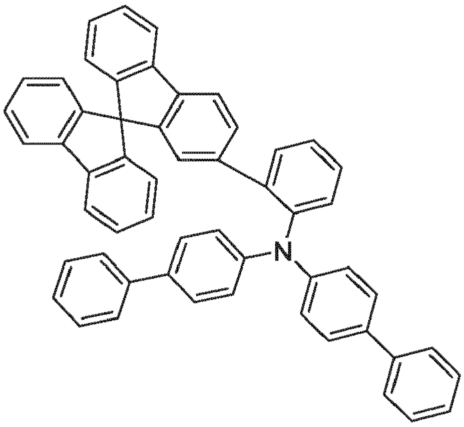 | -1.08 | -4.84 | 0.86 |
| F15 | 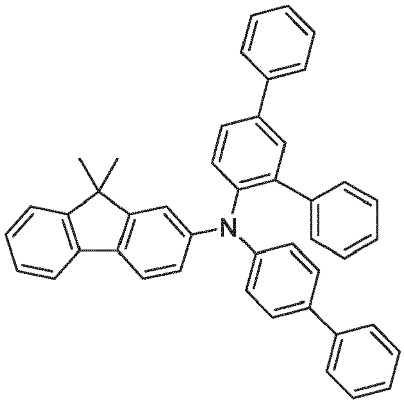 | -1.01 | -4.79 | 0.55 |
| F16 | 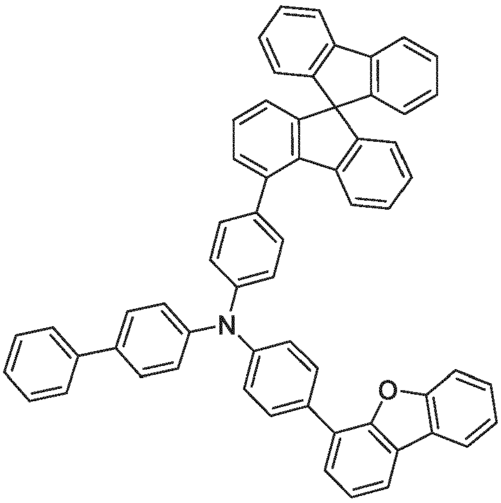 | -1.15 | -4.90 | 0.77 |

(continued)

| Referred to as: | Chemical formula | LUMO [eV] | HOMO [eV] | Dipole moment [Debye] |
|---|---|---|---|---|
| F17 | 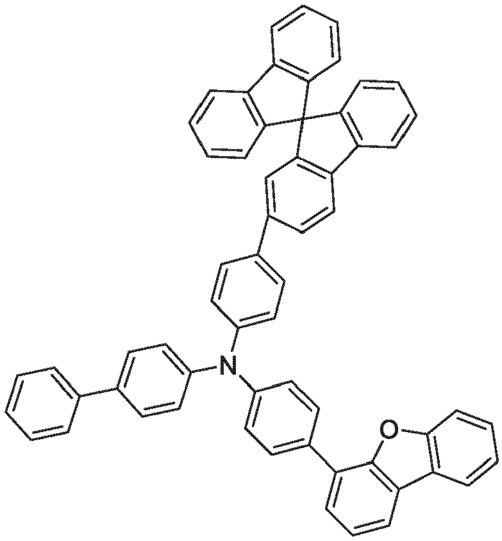 | -1.17 | -4.82 | 1.98 |
| F18 | 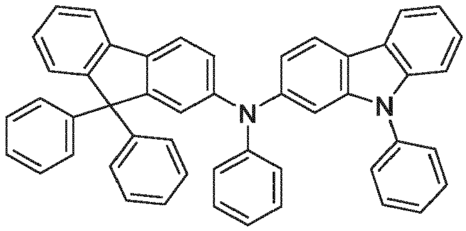 | -0.92 | -4.73 | 1.50 |
| F22 | 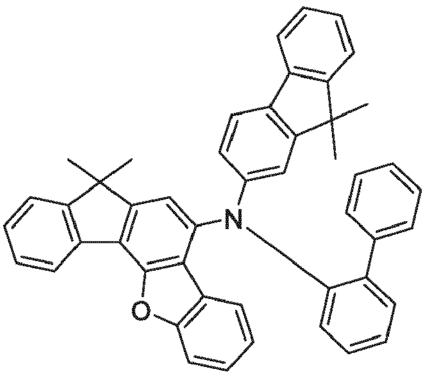 | -1.10 | -4.82 | 0.92 |
| F23 | 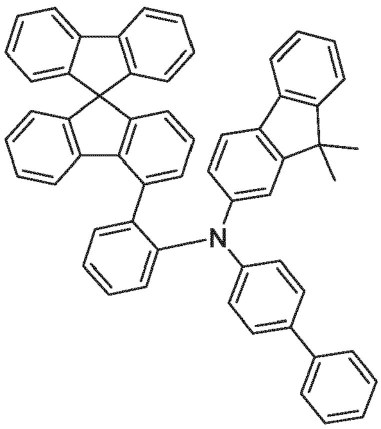 | -1.0 | -4.84 | 0.21 |

As can be seen in Table 1, the physical properties are in the range suitable for organic electroluminescent devices of the present invention.

In Table 2 are shown the chemical formulae and physical properties of the second organic compound and of an organic semiconductor layer consisting of the second organic compound.

Table 2: Chemical formulae and physical properties of the second organic compound and spontaneous orientation polarization (SOP) of an organic semiconductor layer consisting of the second organic compound

| Referred to as: | Chemical formula | SOP [mV/nm] | Molecular weight [g/mol] | LUMO [eV] | HOMO [eV] | Dipole Moment [Debye] |
|---|---|---|---|---|---|---|
| E1 | 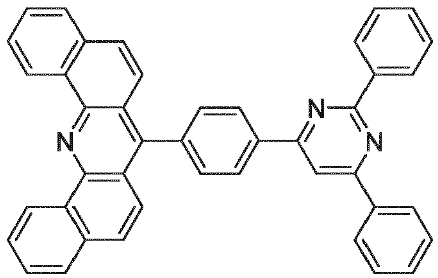 | 35 | 585.69 | -1.86 | -5.69 | 1.95 |
| E2 | 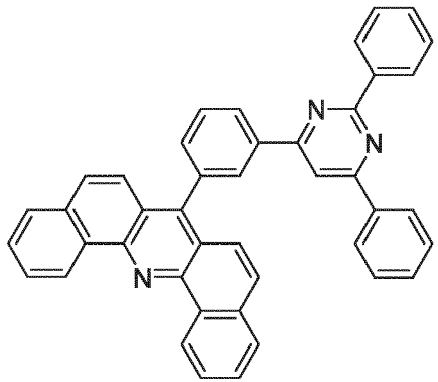 | 34 | 585.69 | -1.83 | -5.70 | 0.58 |

(continued)

| Referred to as: | Chemical formula | SOP [mV/nm] | Molecular weight [g/mol] | LUMO [eV] | HOMO [eV] | Dipole Moment [Debye] |
|---|---|---|---|---|---|---|
| E3 | 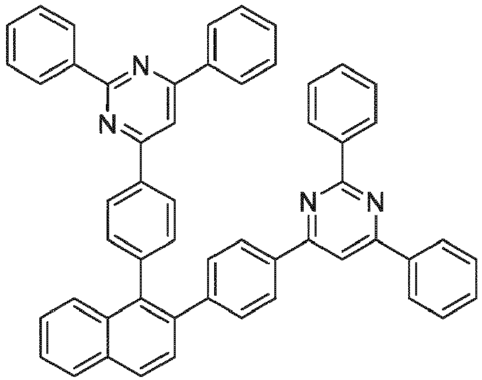 | 52 | 740.89 | -1.81 | -5.74 | 0.54 |
| E4 | 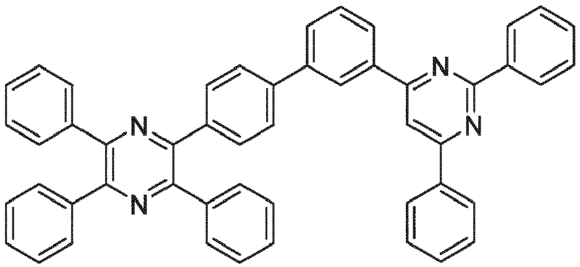 | 40 | 690.83 | -1.74 | -5.62 | 2.10 |
| E5 | 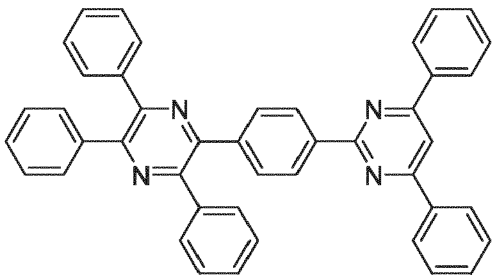 | 3 3 | 614.74 | -1.73 | -5.68 | 1.89 |

(continued)

| Referred to as: | Chemical formula | SOP [mV/nm] | Molecular weight [g/mol] | LUMO [eV] | HOMO [eV] | Dipole Moment [Debye] |
|---|---|---|---|---|---|---|
| E6 | 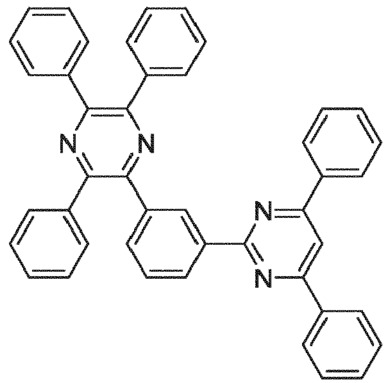 | 23 | 614.74 | -1.68 | -5.70 | 2.11 |
| E7 | 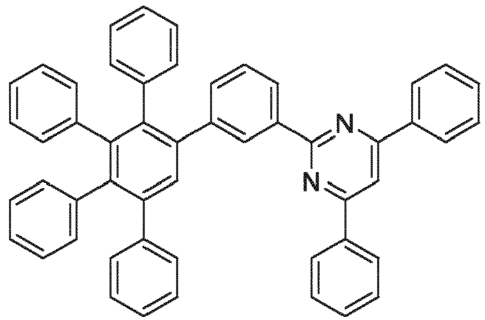 | 22 | 688.86 | -1.63 | -5.73 | 0.58 |

(continued)

| Referred to as: | Chemical formula | SOP [mV/nm] | Molecular weight [g/mol] | LUMO [eV] | HOMO [eV] | Dipole Moment [Debye] |
|---|---|---|---|---|---|---|
| E8 | 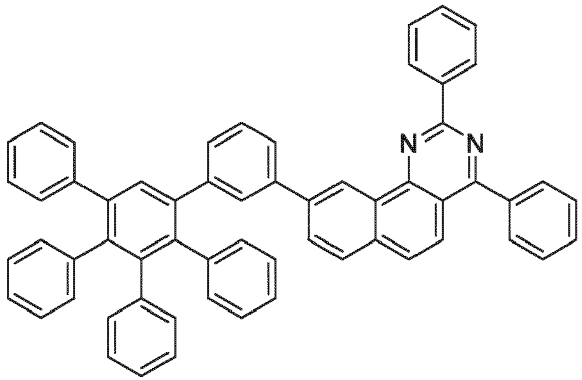 | 34 | 788.97 | -1.78 | -5.61 | 1.88 |
| E9 | 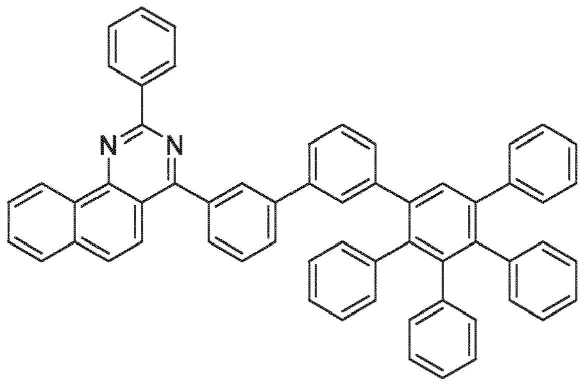 | 27 | 788.97 | -1.75 | -5.77 | 1.59 |

(continued)

| Referred to as: | Chemical formula | SOP [mV/nm] | Molecular weight [g/mol] | LUMO [eV] | HOMO [eV] | Dipole Moment [Debye] |
|---|---|---|---|---|---|---|
| E10 | 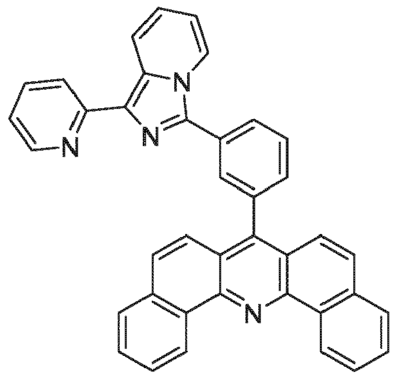 | 14 | 548.63 | -1.81 | -5.03 | 0.98 |
| E11 | 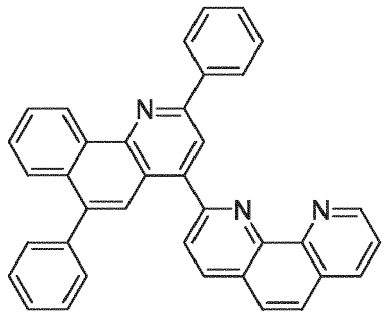 | 9 | 509.60 | -1.87 | -5.48 | 4.80 |

(continued)

| Referred to as: | Chemical formula | SOP [mV/nm] | Molecular weight [g/mol] | LUMO [eV] | HOMO [eV] | Dipole Moment [Debye] |
|---|---|---|---|---|---|---|
| E12 | 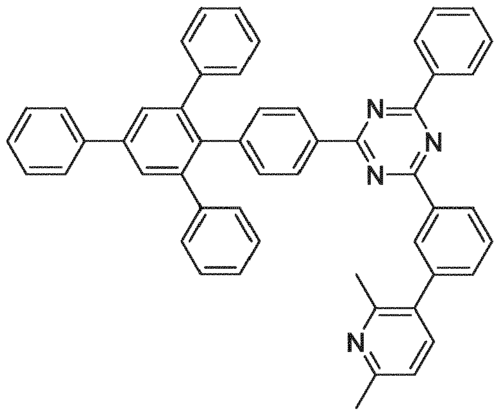 | 39 | 718.89 | -1.86 | -5.83 | 1.61 |
| E13 | 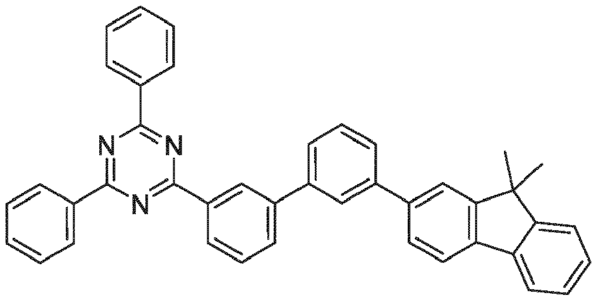 | 0 | 577.72 | -1.84 | -5.57 | 0.48 |
| Comparative compound 1 (CC-1) | 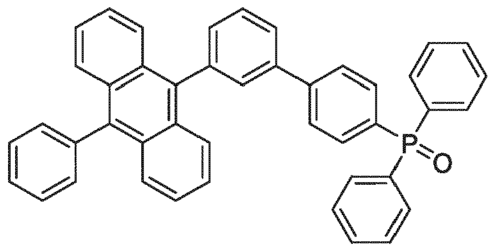 | -47 | 606.69 | -1.67 | -5.16 | 4.13 |

(continued)

| Referred to as: | Chemical formula | SOP [mV/nm] | Molecular weight [g/mol] | LUMO [eV] | HOMO [eV] | Dipole Moment [Debye] |
|---|---|---|---|---|---|---|
| Comparative compound 2 (CC-2) | 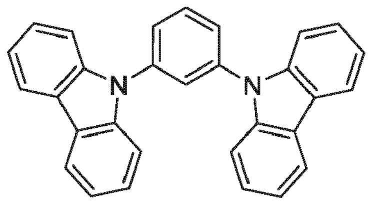 | 0 [1)] | 408.49 | -0.75 | -5.45 | 1.34 |

1) Noguchi et al., J. Soc. Inf. Display, 2021, 29, 29-37.

As can be seen in Table 2, the physical properties of the second organic compound are in the range suitable for organic electroluminescent devices of the present invention.

Additionally, the spontaneous orientation polarization of an organic semiconductor layer consisting of the second organic compound is within the range suitable for organic electroluminescent devices of the present invention.

In comparative compound 1 (CC-1), the spontaneous orientation polarization is -47 mV/nm.

In comparative compound 2 (CC-2), the LUMO energy level is -0.75 eV.

In Table 3 are shown the chemical formulae, LUMO and HOMO energy levels of a range of first organic p-dopants.

Table 3: Chemical formulas, LUMO and HOMO energy levels of first organic p-dopant

| Referred to as: | Chemical formula | LUMO [eV] | HOMO [eV] |
|---|---|---|---|
| K1 | 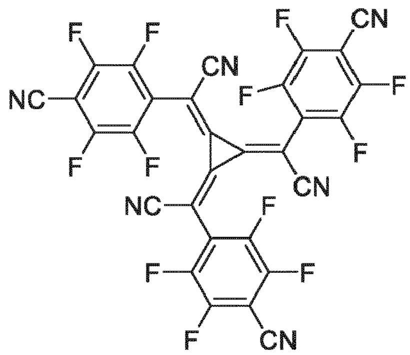 | -5.19 | -7.82 |
| K2 | 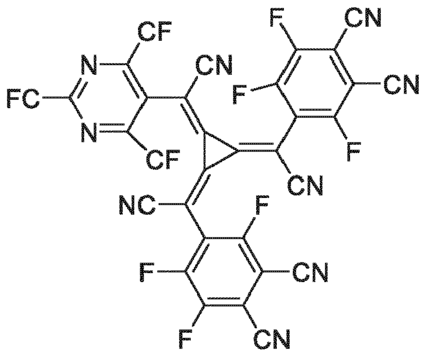 | -5.44 | -8.13 |
| K3 | 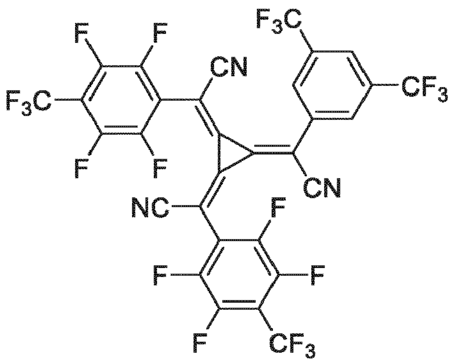 | -4.82 | -7.45 |

(continued)

| Referred to as: | Chemical formula | LUMO [eV] | HOMO [eV] |
|---|---|---|---|
| K4 | 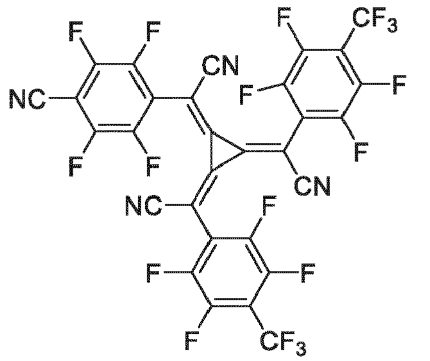 | -5.00 | -7.69 |
| K5 | 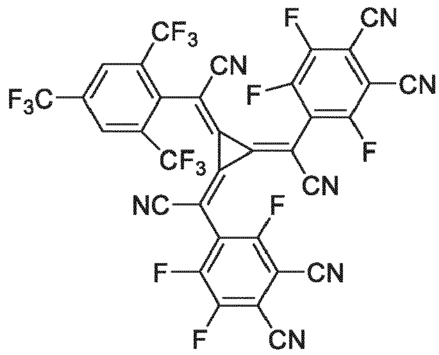 | -5.22 | -7.98 |
| K8 | 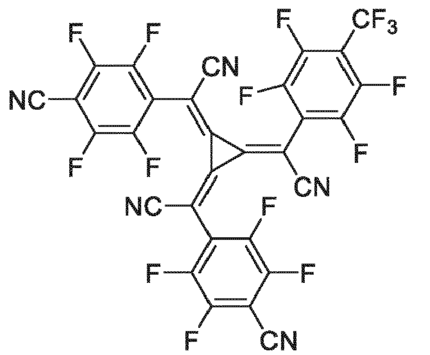 | -5.10 | -7.74 |
| K6 | 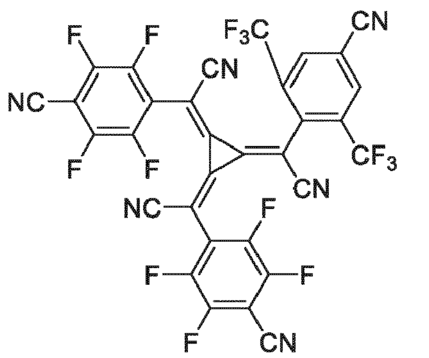 | -5.07 | -7.76 |

(continued)

| Referred to as: | Chemical formula | LUMO [eV] | HOMO [eV] |
|---|---|---|---|
| K7 | 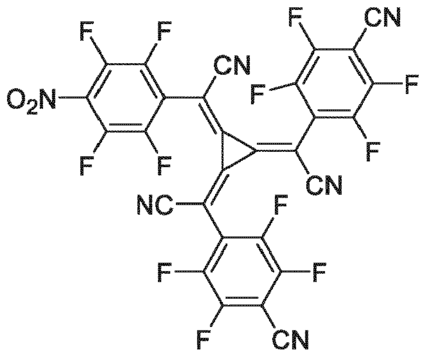 | -5.21 | -7.81 |
| K10 | 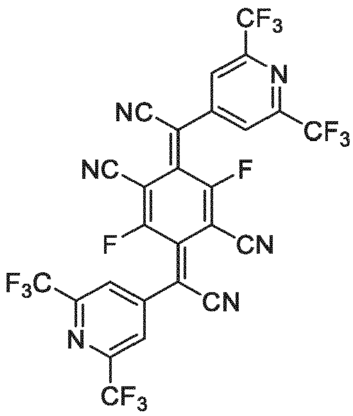 | -5.31 | -7.55 |
| K11 | 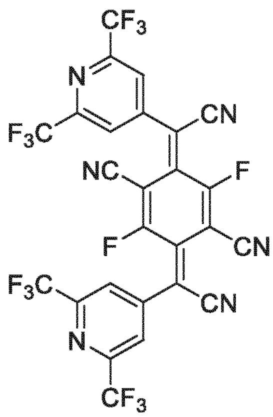 | -5.24 | -7.58 |
| K12 | 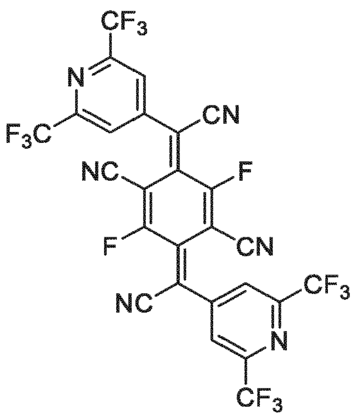 | -5.20 | -7.64 |

(continued)

| Referred to as: | Chemical formula | LUMO [eV] | HOMO [eV] |
|---|---|---|---|
| K13 | 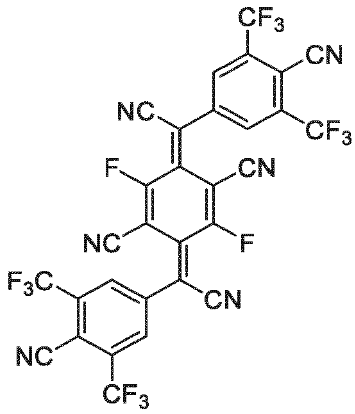 | -5.25 | -7.45 |
| K14 | 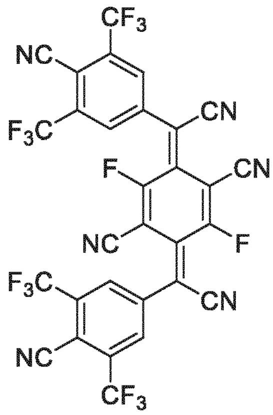 | -5.28 | -7.43 |
| K15 | 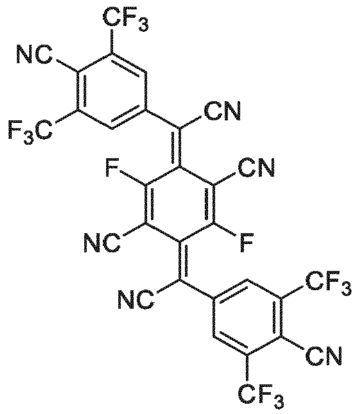 | -5.32 | -7.42 |
| K16 | 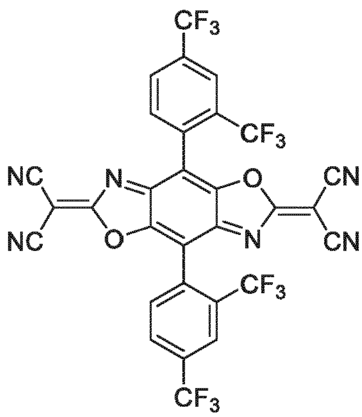 | -5.35 | -7.21 |

(continued)

| Referred to as: | Chemical formula | LUMO [eV] | HOMO [eV] |
|---|---|---|---|
| K17 | 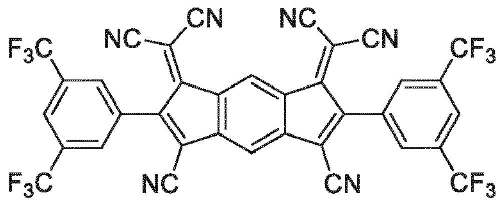 | -4.99 | -7.43 |
| K18 | 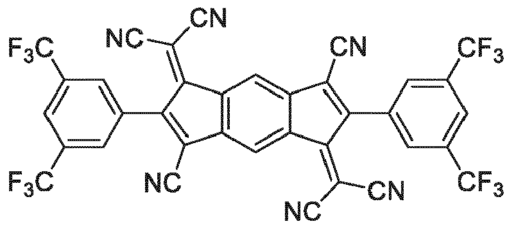 | -5.07 | -7.33 |
| K19 | 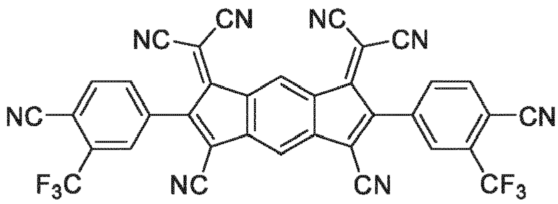 | -5.15 | -7.57 |
| K20 | 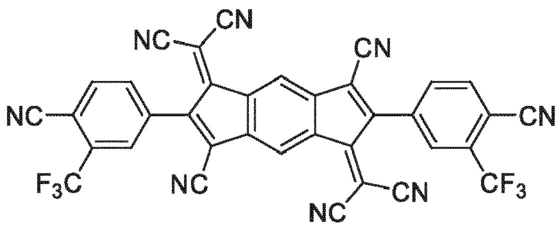 | -5.22 | -7.44 |
| K23 | 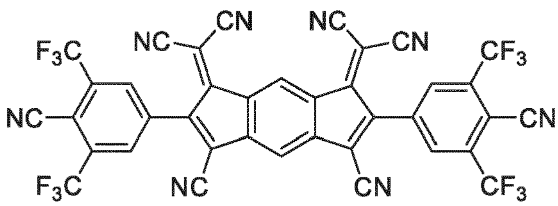 | -5.31 | -7.78 |
| K24 | 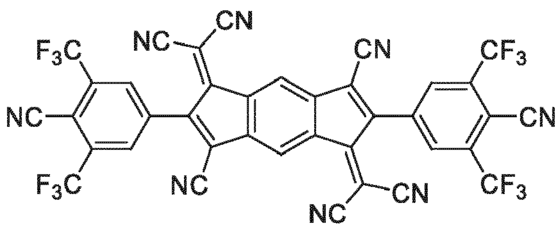 | -5.38 | -7.62 |
| K25 | 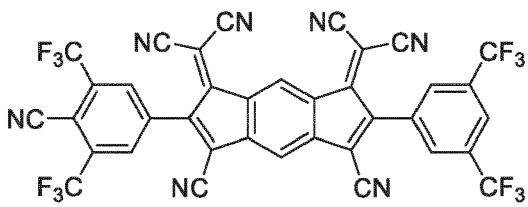 | -5.16 | -7.56 |

(continued)

| Referred to as: | Chemical formula | LUMO [eV] | HOMO [eV] |
|---|---|---|---|
| K26 | 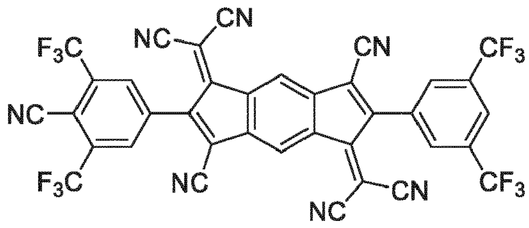 | -5.22 | -7.46 |
| K21 | 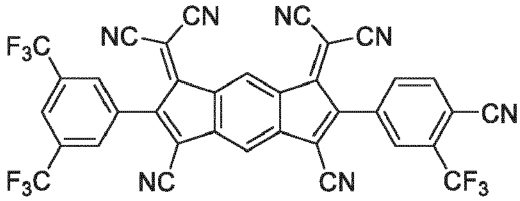 | -5.07 | -7.46 |
| K22 | 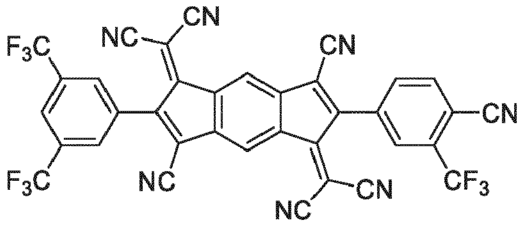 | -5.14 | -7.73 |

As can be seen in Table 3, the HOMO and LUMO energy levels of the first organic p-dopant are in the range suitable for organic electroluminescent devices.

In Table 4 are shown the compositions comprising a first organic compound, a second organic compound and a first organic p-dopant, wherein the following equations (a) and (b) are fulfilled:

(a) 0.2 eV < Δ [LUMO energy level of the first organic compound - LUMO energy level of the second organic compound] < 3.5 eV; and

(b) 0 eV < Δ [HOMO energy level of the first organic compound - LUMO energy level of the first organic p-dopant] < 1.5eV; and comparative compositions.

Table 4: Composition comprising a first organic compound, a second organic compound and a first organic p-dopant and comparative compositions

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 1-1 | F18 | -0.92 | -4.73 | E1 | -1.86 | K1 | -5.19 | 0.94 | 0.46 |
| Composition 1-2 | F18 | -0.92 | -4.73 | E1 | -1.86 | K2 | -5.44 | 0.94 | 0.71 |
| Composition 1-3 | F18 | -0.92 | -4.73 | E1 | -1.86 | K3 | -4.82 | 0.94 | 0.09 |
| Composition 1-4 | F18 | -0.92 | -4.73 | E1 | -1.86 | K4 | -5 | 0.94 | 0.27 |
| Composition 1-5 | F18 | -0.92 | -4.73 | E1 | -1.86 | K5 | -5.22 | 0.94 | 0.49 |
| Composition 1-6 | F18 | -0.92 | -4.73 | E1 | -1.86 | K8 | -5.1 | 0.94 | 0.37 |
| Composition 1-7 | F18 | -0.92 | -4.73 | E1 | -1.86 | K6 | -5.07 | 0.94 | 0.34 |
| Composition 1-8 | F18 | -0.92 | -4.73 | E1 | -1.86 | K7 | -5.21 | 0.94 | 0.48 |
| Composition 1-9 | F18 | -0.92 | -4.73 | E1 | -1.86 | K10 | -5.31 | 0.94 | 0.58 |
| Composition 1-10 | F18 | -0.92 | -4.73 | E1 | -1.86 | K11 | -5.24 | 0.94 | 0.51 |
| Composition 1-11 | F18 | -0.92 | -4.73 | E1 | -1.86 | K12 | -5.2 | 0.94 | 0.47 |
| Composition 1-12 | F18 | -0.92 | -4.73 | E1 | -1.86 | K13 | -5.25 | 0.94 | 0.52 |
| Composition 1-13 | F18 | -0.92 | -4.73 | E1 | -1.86 | K14 | -5.28 | 0.94 | 0.55 |
| Composition 1-14 | F18 | -0.92 | -4.73 | E1 | -1.86 | K15 | -5.32 | 0.94 | 0.59 |
| Composition 1-15 | F18 | -0.92 | -4.73 | E1 | -1.86 | K16 | -5.35 | 0.94 | 0.62 |
| Composition 1-16 | F18 | -0.92 | -4.73 | E1 | -1.86 | K17 | -4.99 | 0.94 | 0.26 |
| Composition 1-17 | F18 | -0.92 | -4.73 | E1 | -1.86 | K18 | -5.07 | 0.94 | 0.34 |
| Composition 1-18 | F18 | -0.92 | -4.73 | E1 | -1.86 | K19 | -5.15 | 0.94 | 0.42 |
| Composition 1-19 | F18 | -0.92 | -4.73 | E1 | -1.86 | K20 | -5.22 | 0.94 | 0.49 |
| Composition 1-20 | F18 | -0.92 | -4.73 | E1 | -1.86 | K21 | -5.31 | 0.94 | 0.58 |
| Composition 1-21 | F18 | -0.92 | -4.73 | E1 | -1.86 | K24 | -5.38 | 0.94 | 0.65 |
| Composition 1-22 | F18 | -0.92 | -4.73 | E1 | -1.86 | K25 | -5.16 | 0.94 | 0.43 |
| Composition 1-23 | F18 | -0.92 | -4.73 | E1 | -1.86 | K26 | -5.22 | 0.94 | 0.49 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 1-24 | F18 | -0.92 | -4.73 | E1 | -1.86 | K21 | -5.07 | 0.94 | 0.34 |
| Composition 1-25 | F18 | -0.92 | -4.73 | E1 | -1.86 | K22 | -5.14 | 0.94 | 0.41 |
| Composition 1-26 | F18 | -0.92 | -4.73 | E2 | -1.83 | K1 | -5.19 | 0.91 | 0.46 |
| Composition 1-27 | F18 | -0.92 | -4.73 | E2 | -1.83 | K2 | -5.44 | 0.91 | 0.71 |
| Composition 1-28 | F18 | -0.92 | -4.73 | E2 | -1.83 | K3 | -4.82 | 0.91 | 0.09 |
| Composition 1-29 | F18 | -0.92 | -4.73 | E2 | -1.83 | K4 | -5 | 0.91 | 0.27 |
| Composition 1-30 | F18 | -0.92 | -4.73 | E2 | -1.83 | K5 | -5.22 | 0.91 | 0.49 |
| Composition 1-31 | F18 | -0.92 | -4.73 | E2 | -1.83 | K8 | -5.1 | 0.91 | 0.37 |
| Composition 1-32 | F18 | -0.92 | -4.73 | E2 | -1.83 | K6 | -5.07 | 0.91 | 0.34 |
| Composition 1-33 | F18 | -0.92 | -4.73 | E2 | -1.83 | K7 | -5.21 | 0.91 | 0.48 |
| Composition 1-34 | F18 | -0.92 | -4.73 | E2 | -1.83 | K10 | -5.31 | 0.91 | 0.58 |
| Composition 1-35 | F18 | -0.92 | -4.73 | E2 | -1.83 | K11 | -5.24 | 0.91 | 0.51 |
| Composition 1-36 | F18 | -0.92 | -4.73 | E2 | -1.83 | K12 | -5.2 | 0.91 | 0.47 |
| Composition 1-37 | F18 | -0.92 | -4.73 | E2 | -1.83 | K13 | -5.25 | 0.91 | 0.52 |
| Composition 1-38 | F18 | -0.92 | -4.73 | E2 | -1.83 | K14 | -5.28 | 0.91 | 0.55 |
| Composition 1-39 | F18 | -0.92 | -4.73 | E2 | -1.83 | K15 | -5.32 | 0.91 | 0.59 |
| Composition 1-40 | F18 | -0.92 | -4.73 | E2 | -1.83 | K16 | -5.35 | 0.91 | 0.62 |
| Composition 1-41 | F18 | -0.92 | -4.73 | E2 | -1.83 | K17 | -4.99 | 0.91 | 0.26 |
| Composition 1-42 | F18 | -0.92 | -4.73 | E2 | -1.83 | K18 | -5.07 | 0.91 | 0.34 |
| Composition 1-43 | F18 | -0.92 | -4.73 | E2 | -1.83 | K19 | -5.15 | 0.91 | 0.42 |
| Composition 1-44 | F18 | -0.92 | -4.73 | E2 | -1.83 | K20 | -5.22 | 0.91 | 0.49 |
| Composition 1-45 | F18 | -0.92 | -4.73 | E2 | -1.83 | K21 | -5.31 | 0.91 | 0.58 |
| Composition 1-46 | F18 | -0.92 | -4.73 | E2 | -1.83 | K24 | -5.38 | 0.91 | 0.65 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 1-47 | F18 | -0.92 | -4.73 | E2 | -1.83 | K25 | -5.16 | 0.91 | 0.43 |
| Composition 1-48 | F18 | -0.92 | -4.73 | E2 | -1.83 | K26 | -5.22 | 0.91 | 0.49 |
| Composition 1-49 | F18 | -0.92 | -4.73 | E2 | -1.83 | K21 | -5.07 | 0.91 | 0.34 |
| Composition 1-50 | F18 | -0.92 | -4.73 | E2 | -1.83 | K22 | -5.14 | 0.91 | 0.41 |
| Composition 1-51 | F18 | -0.92 | -4.73 | E12 | -1.86 | K1 | -5.19 | 0.94 | 0.46 |
| Composition 1-52 | F18 | -0.92 | -4.73 | E12 | -1.86 | K2 | -5.44 | 0.94 | 0.71 |
| Composition 1-53 | F18 | -0.92 | -4.73 | E12 | -1.86 | K3 | -4.82 | 0.94 | 0.09 |
| Composition 1-54 | F18 | -0.92 | -4.73 | E12 | -1.86 | K4 | -5 | 0.94 | 0.27 |
| Composition 1-55 | F18 | -0.92 | -4.73 | E12 | -1.86 | K5 | -5.22 | 0.94 | 0.49 |
| Composition 1-56 | F18 | -0.92 | -4.73 | E12 | -1.86 | K8 | -5.1 | 0.94 | 0.37 |
| Composition 1-57 | F18 | -0.92 | -4.73 | E12 | -1.86 | K6 | -5.07 | 0.94 | 0.34 |
| Composition 1-58 | F18 | -0.92 | -4.73 | E12 | -1.86 | K7 | -5.21 | 0.94 | 0.48 |
| Composition 1-59 | F18 | -0.92 | -4.73 | E12 | -1.86 | K10 | -5.31 | 0.94 | 0.58 |
| Composition 1-60 | F18 | -0.92 | -4.73 | E12 | -1.86 | K11 | -5.24 | 0.94 | 0.51 |
| Composition 1-61 | F18 | -0.92 | -4.73 | E12 | -1.86 | K12 | -5.2 | 0.94 | 0.47 |
| Composition 1-62 | F18 | -0.92 | -4.73 | E12 | -1.86 | K13 | -5.25 | 0.94 | 0.52 |
| Composition 1-63 | F18 | -0.92 | -4.73 | E12 | -1.86 | K14 | -5.28 | 0.94 | 0.55 |
| Composition 1-64 | F18 | -0.92 | -4.73 | E12 | -1.86 | K15 | -5.32 | 0.94 | 0.59 |
| Composition 1-65 | F18 | -0.92 | -4.73 | E12 | -1.86 | K16 | -5.35 | 0.94 | 0.62 |
| Composition 1-66 | F18 | -0.92 | -4.73 | E12 | -1.86 | K17 | -4.99 | 0.94 | 0.26 |
| Composition 1-67 | F18 | -0.92 | -4.73 | E12 | -1.86 | K18 | -5.07 | 0.94 | 0.34 |
| Composition 1-68 | F18 | -0.92 | -4.73 | E12 | -1.86 | K19 | -5.15 | 0.94 | 0.42 |
| Composition 1-69 | F18 | -0.92 | -4.73 | E12 | -1.86 | K20 | -5.22 | 0.94 | 0.49 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 1-70 | F18 | -0.92 | -4.73 | E12 | -1.86 | K21 | -5.31 | 0.94 | 0.58 |
| Composition 1-71 | F18 | -0.92 | -4.73 | E12 | -1.86 | K24 | -5.38 | 0.94 | 0.65 |
| Composition 1-72 | F18 | -0.92 | -4.73 | E12 | -1.86 | K25 | -5.16 | 0.94 | 0.43 |
| Composition 1-73 | F18 | -0.92 | -4.73 | E12 | -1.86 | K26 | -5.22 | 0.94 | 0.49 |
| Composition 1-74 | F18 | -0.92 | -4.73 | E12 | -1.86 | K21 | -5.07 | 0.94 | 0.34 |
| Composition 1-75 | F18 | -0.92 | -4.73 | E12 | -1.86 | K22 | -5.14 | 0.94 | 0.41 |
| Composition 1-76 | F18 | -0.92 | -4.73 | E3 | -1.81 | K1 | -5.19 | 0.89 | 0.46 |
| Composition 1-77 | F18 | -0.92 | -4.73 | E3 | -1.81 | K2 | -5.44 | 0.89 | 0.71 |
| Composition 1-78 | F18 | -0.92 | -4.73 | E3 | -1.81 | K3 | -4.82 | 0.89 | 0.09 |
| Composition 1-79 | F18 | -0.92 | -4.73 | E3 | -1.81 | K4 | -5 | 0.89 | 0.27 |
| Composition 1-80 | F18 | -0.92 | -4.73 | E3 | -1.81 | K5 | -5.22 | 0.89 | 0.49 |
| Composition 1-81 | F18 | -0.92 | -4.73 | E3 | -1.81 | K8 | -5.1 | 0.89 | 0.37 |
| Composition 1-82 | F18 | -0.92 | -4.73 | E3 | -1.81 | K6 | -5.07 | 0.89 | 0.34 |
| Composition 1-83 | F18 | -0.92 | -4.73 | E3 | -1.81 | K7 | -5.21 | 0.89 | 0.48 |
| Composition 1-84 | F18 | -0.92 | -4.73 | E3 | -1.81 | K10 | -5.31 | 0.89 | 0.58 |
| Composition 1-85 | F18 | -0.92 | -4.73 | E3 | -1.81 | K11 | -5.24 | 0.89 | 0.51 |
| Composition 1-86 | F18 | -0.92 | -4.73 | E3 | -1.81 | K12 | -5.2 | 0.89 | 0.47 |
| Composition 1-87 | F18 | -0.92 | -4.73 | E3 | -1.81 | K13 | -5.25 | 0.89 | 0.52 |
| Composition 1-88 | F18 | -0.92 | -4.73 | E3 | -1.81 | K14 | -5.28 | 0.89 | 0.55 |
| Composition 1-89 | F18 | -0.92 | -4.73 | E3 | -1.81 | K15 | -5.32 | 0.89 | 0.59 |
| Composition 1-90 | F18 | -0.92 | -4.73 | E3 | -1.81 | K16 | -5.35 | 0.89 | 0.62 |
| Composition 1-91 | F18 | -0.92 | -4.73 | E3 | -1.81 | K17 | -4.99 | 0.89 | 0.26 |
| Composition 1-92 | F18 | -0.92 | -4.73 | E3 | -1.81 | K18 | -5.07 | 0.89 | 0.34 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 1-93 | F18 | -0.92 | -4.73 | E3 | -1.81 | K19 | -5.15 | 0.89 | 0.42 |
| Composition 1-94 | F18 | -0.92 | -4.73 | E3 | -1.81 | K20 | -5.22 | 0.89 | 0.49 |
| Composition 1-95 | F18 | -0.92 | -4.73 | E3 | -1.81 | K21 | -5.31 | 0.89 | 0.58 |
| Composition 1-96 | F18 | -0.92 | -4.73 | E3 | -1.81 | K24 | -5.38 | 0.89 | 0.65 |
| Composition 1-97 | F18 | -0.92 | -4.73 | E3 | -1.81 | K25 | -5.16 | 0.89 | 0.43 |
| Composition 1-98 | F18 | -0.92 | -4.73 | E3 | -1.81 | K26 | -5.22 | 0.89 | 0.49 |
| Composition 1-99 | F18 | -0.92 | -4.73 | E3 | -1.81 | K21 | -5.07 | 0.89 | 0.34 |
| Composition 1-100 | F18 | -0.92 | -4.73 | E3 | -1.81 | K22 | -5.14 | 0.89 | 0.41 |
| Composition 1-101 | F18 | -0.92 | -4.73 | E4 | -1.74 | K1 | -5.19 | 0.82 | 0.46 |
| Composition 1-102 | F18 | -0.92 | -4.73 | E4 | -1.74 | K2 | -5.44 | 0.82 | 0.71 |
| Composition 1-103 | F18 | -0.92 | -4.73 | E4 | -1.74 | K3 | -4.82 | 0.82 | 0.09 |
| Composition 1-104 | F18 | -0.92 | -4.73 | E4 | -1.74 | K4 | -5 | 0.82 | 0.27 |
| Composition 1-105 | F18 | -0.92 | -4.73 | E4 | -1.74 | K5 | -5.22 | 0.82 | 0.49 |
| Composition 1-106 | F18 | -0.92 | -4.73 | E4 | -1.74 | K8 | -5.1 | 0.82 | 0.37 |
| Composition 1-107 | F18 | -0.92 | -4.73 | E4 | -1.74 | K6 | -5.07 | 0.82 | 0.34 |
| Composition 1-108 | F18 | -0.92 | -4.73 | E4 | -1.74 | K7 | -5.21 | 0.82 | 0.48 |
| Composition 1-109 | F18 | -0.92 | -4.73 | E4 | -1.74 | K10 | -5.31 | 0.82 | 0.58 |
| Composition 1-110 | F18 | -0.92 | -4.73 | E4 | -1.74 | K11 | -5.24 | 0.82 | 0.51 |
| Composition 1-111 | F18 | -0.92 | -4.73 | E4 | -1.74 | K12 | -5.2 | 0.82 | 0.47 |
| Composition 1-112 | F18 | -0.92 | -4.73 | E4 | -1.74 | K13 | -5.25 | 0.82 | 0.52 |
| Composition 1-113 | F18 | -0.92 | -4.73 | E4 | -1.74 | K14 | -5.28 | 0.82 | 0.55 |
| Composition 1-114 | F18 | -0.92 | -4.73 | E4 | -1.74 | K15 | -5.32 | 0.82 | 0.59 |
| Composition 1-115 | F18 | -0.92 | -4.73 | E4 | -1.74 | K16 | -5.35 | 0.82 | 0.62 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 1-116 | F18 | -0.92 | -4.73 | E4 | -1.74 | K17 | -4.99 | 0.82 | 0.26 |
| Composition 1-117 | F18 | -0.92 | -4.73 | E4 | -1.74 | K18 | -5.07 | 0.82 | 0.34 |
| Composition 1-118 | F18 | -0.92 | -4.73 | E4 | -1.74 | K19 | -5.15 | 0.82 | 0.42 |
| Composition 1-119 | F18 | -0.92 | -4.73 | E4 | -1.74 | K20 | -5.22 | 0.82 | 0.49 |
| Composition 1-120 | F18 | -0.92 | -4.73 | E4 | -1.74 | K21 | -5.31 | 0.82 | 0.58 |
| Composition 1-121 | F18 | -0.92 | -4.73 | E4 | -1.74 | K24 | -5.38 | 0.82 | 0.65 |
| Composition 1-122 | F18 | -0.92 | -4.73 | E4 | -1.74 | K25 | -5.16 | 0.82 | 0.43 |
| Composition 1-123 | F18 | -0.92 | -4.73 | E4 | -1.74 | K26 | -5.22 | 0.82 | 0.49 |
| Composition 1-124 | F18 | -0.92 | -4.73 | E4 | -1.74 | K21 | -5.07 | 0.82 | 0.34 |
| Composition 1-125 | F18 | -0.92 | -4.73 | E4 | -1.74 | K22 | -5.14 | 0.82 | 0.41 |
| Composition 1-126 | F18 | -0.92 | -4.73 | E5 | -1.73 | K1 | -5.19 | 0.81 | 0.46 |
| Composition 1-127 | F18 | -0.92 | -4.73 | E5 | -1.73 | K2 | -5.44 | 0.81 | 0.71 |
| Composition 1-128 | F18 | -0.92 | -4.73 | E5 | -1.73 | K3 | -4.82 | 0.81 | 0.09 |
| Composition 1-129 | F18 | -0.92 | -4.73 | E5 | -1.73 | K4 | -5 | 0.81 | 0.27 |
| Composition 1-130 | F18 | -0.92 | -4.73 | E5 | -1.73 | K5 | -5.22 | 0.81 | 0.49 |
| Composition 1-131 | F18 | -0.92 | -4.73 | E5 | -1.73 | K8 | -5.1 | 0.81 | 0.37 |
| Composition 1-132 | F18 | -0.92 | -4.73 | E5 | -1.73 | K6 | -5.07 | 0.81 | 0.34 |
| Composition 1-133 | F18 | -0.92 | -4.73 | E5 | -1.73 | K7 | -5.21 | 0.81 | 0.48 |
| Composition 1-134 | F18 | -0.92 | -4.73 | E5 | -1.73 | K10 | -5.31 | 0.81 | 0.58 |
| Composition 1-135 | F18 | -0.92 | -4.73 | E5 | -1.73 | K11 | -5.24 | 0.81 | 0.51 |
| Composition 1-136 | F18 | -0.92 | -4.73 | E5 | -1.73 | K12 | -5.2 | 0.81 | 0.47 |
| Composition 1-137 | F18 | -0.92 | -4.73 | E5 | -1.73 | K13 | -5.25 | 0.81 | 0.52 |
| Composition 1-138 | F18 | -0.92 | -4.73 | E5 | -1.73 | K14 | -5.28 | 0.81 | 0.55 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 1-139 | F18 | -0.92 | -4.73 | E5 | -1.73 | K15 | -5.32 | 0.81 | 0.59 |
| Composition 1-140 | F18 | -0.92 | -4.73 | E5 | -1.73 | K16 | -5.35 | 0.81 | 0.62 |
| Composition 1-141 | F18 | -0.92 | -4.73 | E5 | -1.73 | K17 | -4.99 | 0.81 | 0.26 |
| Composition 1-142 | F18 | -0.92 | -4.73 | E5 | -1.73 | K18 | -5.07 | 0.81 | 0.34 |
| Composition 1-143 | F18 | -0.92 | -4.73 | E5 | -1.73 | K19 | -5.15 | 0.81 | 0.42 |
| Composition 1-144 | F18 | -0.92 | -4.73 | E5 | -1.73 | K20 | -5.22 | 0.81 | 0.49 |
| Composition 1-145 | F18 | -0.92 | -4.73 | E5 | -1.73 | K21 | -5.31 | 0.81 | 0.58 |
| Composition 1-146 | F18 | -0.92 | -4.73 | E5 | -1.73 | K24 | -5.38 | 0.81 | 0.65 |
| Composition 1-147 | F18 | -0.92 | -4.73 | E5 | -1.73 | K25 | -5.16 | 0.81 | 0.43 |
| Composition 1-148 | F18 | -0.92 | -4.73 | E5 | -1.73 | K26 | -5.22 | 0.81 | 0.49 |
| Composition 1-149 | F18 | -0.92 | -4.73 | E5 | -1.73 | K21 | -5.07 | 0.81 | 0.34 |
| Composition 1-150 | F18 | -0.92 | -4.73 | E5 | -1.73 | K22 | -5.14 | 0.81 | 0.41 |
| Composition 1-151 | F18 | -0.92 | -4.73 | E6 | -1.68 | K1 | -5.19 | 0.76 | 0.46 |
| Composition 1-152 | F18 | -0.92 | -4.73 | E6 | -1.68 | K2 | -5.44 | 0.76 | 0.71 |
| Composition 1-153 | F18 | -0.92 | -4.73 | E6 | -1.68 | K3 | -4.82 | 0.76 | 0.09 |
| Composition 1-154 | F18 | -0.92 | -4.73 | E6 | -1.68 | K4 | -5 | 0.76 | 0.27 |
| Composition 1-155 | F18 | -0.92 | -4.73 | E6 | -1.68 | K5 | -5.22 | 0.76 | 0.49 |
| Composition 1-156 | F18 | -0.92 | -4.73 | E6 | -1.68 | K8 | -5.1 | 0.76 | 0.37 |
| Composition 1-157 | F18 | -0.92 | -4.73 | E6 | -1.68 | K6 | -5.07 | 0.76 | 0.34 |
| Composition 1-158 | F18 | -0.92 | -4.73 | E6 | -1.68 | K7 | -5.21 | 0.76 | 0.48 |
| Composition 1-159 | F18 | -0.92 | -4.73 | E6 | -1.68 | K10 | -5.31 | 0.76 | 0.58 |
| Composition 1-160 | F18 | -0.92 | -4.73 | E6 | -1.68 | K11 | -5.24 | 0.76 | 0.51 |
| Composition 1-161 | F18 | -0.92 | -4.73 | E6 | -1.68 | K12 | -5.2 | 0.76 | 0.47 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 1-162 | F18 | -0.92 | -4.73 | E6 | -1.68 | K13 | -5.25 | 0.76 | 0.52 |
| Composition 1-163 | F18 | -0.92 | -4.73 | E6 | -1.68 | K14 | -5.28 | 0.76 | 0.55 |
| Composition 1-164 | F18 | -0.92 | -4.73 | E6 | -1.68 | K15 | -5.32 | 0.76 | 0.59 |
| Composition 1-165 | F18 | -0.92 | -4.73 | E6 | -1.68 | K16 | -5.35 | 0.76 | 0.62 |
| Composition 1-166 | F18 | -0.92 | -4.73 | E6 | -1.68 | K17 | -4.99 | 0.76 | 0.26 |
| Composition 1-167 | F18 | -0.92 | -4.73 | E6 | -1.68 | K18 | -5.07 | 0.76 | 0.34 |
| Composition 1-168 | F18 | -0.92 | -4.73 | E6 | -1.68 | K19 | -5.15 | 0.76 | 0.42 |
| Composition 1-169 | F18 | -0.92 | -4.73 | E6 | -1.68 | K20 | -5.22 | 0.76 | 0.49 |
| Composition 1-170 | F18 | -0.92 | -4.73 | E6 | -1.68 | K21 | -5.31 | 0.76 | 0.58 |
| Composition 1-171 | F18 | -0.92 | -4.73 | E6 | -1.68 | K24 | -5.38 | 0.76 | 0.65 |
| Composition 1-172 | F18 | -0.92 | -4.73 | E6 | -1.68 | K25 | -5.16 | 0.76 | 0.43 |
| Composition 1-173 | F18 | -0.92 | -4.73 | E6 | -1.68 | K26 | -5.22 | 0.76 | 0.49 |
| Composition 1-174 | F18 | -0.92 | -4.73 | E6 | -1.68 | K21 | -5.07 | 0.76 | 0.34 |
| Composition 1-175 | F18 | -0.92 | -4.73 | E6 | -1.68 | K22 | -5.14 | 0.76 | 0.41 |
| Composition 1-176 | F18 | -0.92 | -4.73 | E7 | -1.63 | K1 | -5.19 | 0.71 | 0.46 |
| Composition 1-177 | F18 | -0.92 | -4.73 | E7 | -1.63 | K2 | -5.44 | 0.71 | 0.71 |
| Composition 1-178 | F18 | -0.92 | -4.73 | E7 | -1.63 | K3 | -4.82 | 0.71 | 0.09 |
| Composition 1-179 | F18 | -0.92 | -4.73 | E7 | -1.63 | K4 | -5 | 0.71 | 0.27 |
| Composition 1-180 | F18 | -0.92 | -4.73 | E7 | -1.63 | K5 | -5.22 | 0.71 | 0.49 |
| Composition 1-181 | F18 | -0.92 | -4.73 | E7 | -1.63 | K8 | -5.1 | 0.71 | 0.37 |
| Composition 1-182 | F18 | -0.92 | -4.73 | E7 | -1.63 | K6 | -5.07 | 0.71 | 0.34 |
| Composition 1-183 | F18 | -0.92 | -4.73 | E7 | -1.63 | K7 | -5.21 | 0.71 | 0.48 |
| Composition 1-184 | F18 | -0.92 | -4.73 | E7 | -1.63 | K10 | -5.31 | 0.71 | 0.58 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 1-185 | F18 | -0.92 | -4.73 | E7 | -1.63 | K11 | -5.24 | 0.71 | 0.51 |
| Composition 1-186 | F18 | -0.92 | -4.73 | E7 | -1.63 | K12 | -5.2 | 0.71 | 0.47 |
| Composition 1-187 | F18 | -0.92 | -4.73 | E7 | -1.63 | K13 | -5.25 | 0.71 | 0.52 |
| Composition 1-188 | F18 | -0.92 | -4.73 | E7 | -1.63 | K14 | -5.28 | 0.71 | 0.55 |
| Composition 1-189 | F18 | -0.92 | -4.73 | E7 | -1.63 | K15 | -5.32 | 0.71 | 0.59 |
| Composition 1-190 | F18 | -0.92 | -4.73 | E7 | -1.63 | K16 | -5.35 | 0.71 | 0.62 |
| Composition 1-191 | F18 | -0.92 | -4.73 | E7 | -1.63 | K17 | -4.99 | 0.71 | 0.26 |
| Composition 1-192 | F18 | -0.92 | -4.73 | E7 | -1.63 | K18 | -5.07 | 0.71 | 0.34 |
| Composition 1-193 | F18 | -0.92 | -4.73 | E7 | -1.63 | K19 | -5.15 | 0.71 | 0.42 |
| Composition 1-194 | F18 | -0.92 | -4.73 | E7 | -1.63 | K20 | -5.22 | 0.71 | 0.49 |
| Composition 1-195 | F18 | -0.92 | -4.73 | E7 | -1.63 | K21 | -5.31 | 0.71 | 0.58 |
| Composition 1-196 | F18 | -0.92 | -4.73 | E7 | -1.63 | K24 | -5.38 | 0.71 | 0.65 |
| Composition 1-197 | F18 | -0.92 | -4.73 | E7 | -1.63 | K25 | -5.16 | 0.71 | 0.43 |
| Composition 1-198 | F18 | -0.92 | -4.73 | E7 | -1.63 | K26 | -5.22 | 0.71 | 0.49 |
| Composition 1-199 | F18 | -0.92 | -4.73 | E7 | -1.63 | K21 | -5.07 | 0.71 | 0.34 |
| Composition 1-200 | F18 | -0.92 | -4.73 | E7 | -1.63 | K22 | -5.14 | 0.71 | 0.41 |
| Composition 1-201 | F18 | -0.92 | -4.73 | E8 | -1.78 | K1 | -5.19 | 0.86 | 0.46 |
| Composition 1-202 | F18 | -0.92 | -4.73 | E8 | -1.78 | K2 | -5.44 | 0.86 | 0.71 |
| Composition 1-203 | F18 | -0.92 | -4.73 | E8 | -1.78 | K3 | -4.82 | 0.86 | 0.09 |
| Composition 1-204 | F18 | -0.92 | -4.73 | E8 | -1.78 | K4 | -5 | 0.86 | 0.27 |
| Composition 1-205 | F18 | -0.92 | -4.73 | E8 | -1.78 | K5 | -5.22 | 0.86 | 0.49 |
| Composition 1-206 | F18 | -0.92 | -4.73 | E8 | -1.78 | K8 | -5.1 | 0.86 | 0.37 |
| Composition 1-207 | F18 | -0.92 | -4.73 | E8 | -1.78 | K6 | -5.07 | 0.86 | 0.34 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 1-208 | F18 | -0.92 | -4.73 | E8 | -1.78 | K7 | -5.21 | 0.86 | 0.48 |
| Composition 1-209 | F18 | -0.92 | -4.73 | E8 | -1.78 | K10 | -5.31 | 0.86 | 0.58 |
| Composition 1-210 | F18 | -0.92 | -4.73 | E8 | -1.78 | K11 | -5.24 | 0.86 | 0.51 |
| Composition 1-211 | F18 | -0.92 | -4.73 | E8 | -1.78 | K12 | -5.2 | 0.86 | 0.47 |
| Composition 1-212 | F18 | -0.92 | -4.73 | E8 | -1.78 | K13 | -5.25 | 0.86 | 0.52 |
| Composition 1-213 | F18 | -0.92 | -4.73 | E8 | -1.78 | K14 | -5.28 | 0.86 | 0.55 |
| Composition 1-214 | F18 | -0.92 | -4.73 | E8 | -1.78 | K15 | -5.32 | 0.86 | 0.59 |
| Composition 1-215 | F18 | -0.92 | -4.73 | E8 | -1.78 | K16 | -5.35 | 0.86 | 0.62 |
| Composition 1-216 | F18 | -0.92 | -4.73 | E8 | -1.78 | K17 | -4.99 | 0.86 | 0.26 |
| Composition 1-217 | F18 | -0.92 | -4.73 | E8 | -1.78 | K18 | -5.07 | 0.86 | 0.34 |
| Composition 1-218 | F18 | -0.92 | -4.73 | E8 | -1.78 | K19 | -5.15 | 0.86 | 0.42 |
| Composition 1-219 | F18 | -0.92 | -4.73 | E8 | -1.78 | K20 | -5.22 | 0.86 | 0.49 |
| Composition 1-220 | F18 | -0.92 | -4.73 | E8 | -1.78 | K21 | -5.31 | 0.86 | 0.58 |
| Composition 1-221 | F18 | -0.92 | -4.73 | E8 | -1.78 | K24 | -5.38 | 0.86 | 0.65 |
| Composition 1-222 | F18 | -0.92 | -4.73 | E8 | -1.78 | K25 | -5.16 | 0.86 | 0.43 |
| Composition 1-223 | F18 | -0.92 | -4.73 | E8 | -1.78 | K26 | -5.22 | 0.86 | 0.49 |
| Composition 1-224 | F18 | -0.92 | -4.73 | E8 | -1.78 | K21 | -5.07 | 0.86 | 0.34 |
| Composition 1-225 | F18 | -0.92 | -4.73 | E8 | -1.78 | K22 | -5.14 | 0.86 | 0.41 |
| Composition 1-226 | F18 | -0.92 | -4.73 | E9 | -1.75 | K1 | -5.19 | 0.83 | 0.46 |
| Composition 1-227 | F18 | -0.92 | -4.73 | E9 | -1.75 | K2 | -5.44 | 0.83 | 0.71 |
| Composition 1-228 | F18 | -0.92 | -4.73 | E9 | -1.75 | K3 | -4.82 | 0.83 | 0.09 |
| Composition 1-229 | F18 | -0.92 | -4.73 | E9 | -1.75 | K4 | -5 | 0.83 | 0.27 |
| Composition 1-230 | F18 | -0.92 | -4.73 | E9 | -1.75 | K5 | -5.22 | 0.83 | 0.49 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 1-231 | F18 | -0.92 | -4.73 | E9 | -1.75 | K8 | -5.1 | 0.83 | 0.37 |
| Composition 1-232 | F18 | -0.92 | -4.73 | E9 | -1.75 | K6 | -5.07 | 0.83 | 0.34 |
| Composition 1-233 | F18 | -0.92 | -4.73 | E9 | -1.75 | K7 | -5.21 | 0.83 | 0.48 |
| Composition 1-234 | F18 | -0.92 | -4.73 | E9 | -1.75 | K10 | -5.31 | 0.83 | 0.58 |
| Composition 1-235 | F18 | -0.92 | -4.73 | E9 | -1.75 | K11 | -5.24 | 0.83 | 0.51 |
| Composition 1-236 | F18 | -0.92 | -4.73 | E9 | -1.75 | K12 | -5.2 | 0.83 | 0.47 |
| Composition 1-237 | F18 | -0.92 | -4.73 | E9 | -1.75 | K13 | -5.25 | 0.83 | 0.52 |
| Composition 1-238 | F18 | -0.92 | -4.73 | E9 | -1.75 | K14 | -5.28 | 0.83 | 0.55 |
| Composition 1-239 | F18 | -0.92 | -4.73 | E9 | -1.75 | K15 | -5.32 | 0.83 | 0.59 |
| Composition 1-240 | F18 | -0.92 | -4.73 | E9 | -1.75 | K16 | -5.35 | 0.83 | 0.62 |
| Composition 1-241 | F18 | -0.92 | -4.73 | E9 | -1.75 | K17 | -4.99 | 0.83 | 0.26 |
| Composition 1-242 | F18 | -0.92 | -4.73 | E9 | -1.75 | K18 | -5.07 | 0.83 | 0.34 |
| Composition 1-243 | F18 | -0.92 | -4.73 | E9 | -1.75 | K19 | -5.15 | 0.83 | 0.42 |
| Composition 1-244 | F18 | -0.92 | -4.73 | E9 | -1.75 | K20 | -5.22 | 0.83 | 0.49 |
| Composition 1-245 | F18 | -0.92 | -4.73 | E9 | -1.75 | K21 | -5.31 | 0.83 | 0.58 |
| Composition 1-246 | F18 | -0.92 | -4.73 | E9 | -1.75 | K24 | -5.38 | 0.83 | 0.65 |
| Composition 1-247 | F18 | -0.92 | -4.73 | E9 | -1.75 | K25 | -5.16 | 0.83 | 0.43 |
| Composition 1-248 | F18 | -0.92 | -4.73 | E9 | -1.75 | K26 | -5.22 | 0.83 | 0.49 |
| Composition 1-249 | F18 | -0.92 | -4.73 | E9 | -1.75 | K21 | -5.07 | 0.83 | 0.34 |
| Composition 1-250 | F18 | -0.92 | -4.73 | E9 | -1.75 | K22 | -5.14 | 0.83 | 0.41 |
| Composition 1-251 | F18 | -0.92 | -4.73 | E10 | -1.81 | K1 | -5.19 | 0.89 | 0.46 |
| Composition 1-252 | F18 | -0.92 | -4.73 | E10 | -1.81 | K2 | -5.44 | 0.89 | 0.71 |
| Composition 1-253 | F18 | -0.92 | -4.73 | E10 | -1.81 | K3 | -4.82 | 0.89 | 0.09 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 1-254 | F18 | -0.92 | -4.73 | E10 | -1.81 | K4 | -5 | 0.89 | 0.27 |
| Composition 1-255 | F18 | -0.92 | -4.73 | E10 | -1.81 | K5 | -5.22 | 0.89 | 0.49 |
| Composition 1-256 | F18 | -0.92 | -4.73 | E10 | -1.81 | K8 | -5.1 | 0.89 | 0.37 |
| Composition 1-257 | F18 | -0.92 | -4.73 | E10 | -1.81 | K6 | -5.07 | 0.89 | 0.34 |
| Composition 1-258 | F18 | -0.92 | -4.73 | E10 | -1.81 | K7 | -5.21 | 0.89 | 0.48 |
| Composition 1-259 | F18 | -0.92 | -4.73 | E10 | -1.81 | K10 | -5.31 | 0.89 | 0.58 |
| Composition 1-260 | F18 | -0.92 | -4.73 | E10 | -1.81 | K11 | -5.24 | 0.89 | 0.51 |
| Composition 1-261 | F18 | -0.92 | -4.73 | E10 | -1.81 | K12 | -5.2 | 0.89 | 0.47 |
| Composition 1-262 | F18 | -0.92 | -4.73 | E10 | -1.81 | K13 | -5.25 | 0.89 | 0.52 |
| Composition 1-263 | F18 | -0.92 | -4.73 | E10 | -1.81 | K14 | -5.28 | 0.89 | 0.55 |
| Composition 1-264 | F18 | -0.92 | -4.73 | E10 | -1.81 | K15 | -5.32 | 0.89 | 0.59 |
| Composition 1-265 | F18 | -0.92 | -4.73 | E10 | -1.81 | K16 | -5.35 | 0.89 | 0.62 |
| Composition 1-266 | F18 | -0.92 | -4.73 | E10 | -1.81 | K17 | -4.99 | 0.89 | 0.26 |
| Composition 1-267 | F18 | -0.92 | -4.73 | E10 | -1.81 | K18 | -5.07 | 0.89 | 0.34 |
| Composition 1-268 | F18 | -0.92 | -4.73 | E10 | -1.81 | K19 | -5.15 | 0.89 | 0.42 |
| Composition 1-269 | F18 | -0.92 | -4.73 | E10 | -1.81 | K20 | -5.22 | 0.89 | 0.49 |
| Composition 1-270 | F18 | -0.92 | -4.73 | E10 | -1.81 | K21 | -5.31 | 0.89 | 0.58 |
| Composition 1-271 | F18 | -0.92 | -4.73 | E10 | -1.81 | K24 | -5.38 | 0.89 | 0.65 |
| Composition 1-272 | F18 | -0.92 | -4.73 | E10 | -1.81 | K25 | -5.16 | 0.89 | 0.43 |
| Composition 1-273 | F18 | -0.92 | -4.73 | E10 | -1.81 | K26 | -5.22 | 0.89 | 0.49 |
| Composition 1-274 | F18 | -0.92 | -4.73 | E10 | -1.81 | K21 | -5.07 | 0.89 | 0.34 |
| Composition 1-275 | F18 | -0.92 | -4.73 | E10 | -1.81 | K22 | -5.14 | 0.89 | 0.41 |
| Composition 1-276 | F18 | -0.92 | -4.73 | E11 | -1.87 | K1 | -5.19 | 0.95 | 0.46 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 1-277 | F18 | -0.92 | -4.73 | E11 | -1.87 | K2 | -5.44 | 0.95 | 0.71 |
| Composition 1-278 | F18 | -0.92 | -4.73 | E11 | -1.87 | K3 | -4.82 | 0.95 | 0.09 |
| Composition 1-279 | F18 | -0.92 | -4.73 | E11 | -1.87 | K4 | -5 | 0.95 | 0.27 |
| Composition 1-280 | F18 | -0.92 | -4.73 | E11 | -1.87 | K5 | -5.22 | 0.95 | 0.49 |
| Composition 1-281 | F18 | -0.92 | -4.73 | E11 | -1.87 | K8 | -5.1 | 0.95 | 0.37 |
| Composition 1-282 | F18 | -0.92 | -4.73 | E11 | -1.87 | K6 | -5.07 | 0.95 | 0.34 |
| Composition 1-283 | F18 | -0.92 | -4.73 | E11 | -1.87 | K7 | -5.21 | 0.95 | 0.48 |
| Composition 1-284 | F18 | -0.92 | -4.73 | E11 | -1.87 | K10 | -5.31 | 0.95 | 0.58 |
| Composition 1-285 | F18 | -0.92 | -4.73 | E11 | -1.87 | K11 | -5.24 | 0.95 | 0.51 |
| Composition 1-286 | F18 | -0.92 | -4.73 | E11 | -1.87 | K12 | -5.2 | 0.95 | 0.47 |
| Composition 1-287 | F18 | -0.92 | -4.73 | E11 | -1.87 | K13 | -5.25 | 0.95 | 0.52 |
| Composition 1-288 | F18 | -0.92 | -4.73 | E11 | -1.87 | K14 | -5.28 | 0.95 | 0.55 |
| Composition 1-289 | F18 | -0.92 | -4.73 | E11 | -1.87 | K15 | -5.32 | 0.95 | 0.59 |
| Composition 1-290 | F18 | -0.92 | -4.73 | E11 | -1.87 | K16 | -5.35 | 0.95 | 0.62 |
| Composition 1-291 | F18 | -0.92 | -4.73 | E11 | -1.87 | K17 | -4.99 | 0.95 | 0.26 |
| Composition 1-292 | F18 | -0.92 | -4.73 | E11 | -1.87 | K18 | -5.07 | 0.95 | 0.34 |
| Composition 1-293 | F18 | -0.92 | -4.73 | E11 | -1.87 | K19 | -5.15 | 0.95 | 0.42 |
| Composition 1-294 | F18 | -0.92 | -4.73 | E11 | -1.87 | K20 | -5.22 | 0.95 | 0.49 |
| Composition 1-295 | F18 | -0.92 | -4.73 | E11 | -1.87 | K21 | -5.31 | 0.95 | 0.58 |
| Composition 1-296 | F18 | -0.92 | -4.73 | E11 | -1.87 | K24 | -5.38 | 0.95 | 0.65 |
| Composition 1-297 | F18 | -0.92 | -4.73 | E11 | -1.87 | K25 | -5.16 | 0.95 | 0.43 |
| Composition 1-298 | F18 | -0.92 | -4.73 | E11 | -1.87 | K26 | -5.22 | 0.95 | 0.49 |
| Composition 1-299 | F18 | -0.92 | -4.73 | E11 | -1.87 | K21 | -5.07 | 0.95 | 0.34 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 1-300 | F18 | -0.92 | -4.73 | E11 | -1.87 | K22 | -5.14 | 0.95 | 0.41 |
| Composition 1-301 | F18 | -0.92 | -4.73 | E13 | -1.84 | K1 | -5.19 | 0.92 | 0.46 |
| Composition 1-302 | F18 | -0.92 | -4.73 | E13 | -1.84 | K2 | -5.44 | 0.92 | 0.71 |
| Composition 1-303 | F18 | -0.92 | -4.73 | E13 | -1.84 | K3 | -4.82 | 0.92 | 0.09 |
| Composition 1-304 | F18 | -0.92 | -4.73 | E13 | -1.84 | K4 | -5 | 0.92 | 0.27 |
| Composition 1-305 | F18 | -0.92 | -4.73 | E13 | -1.84 | K5 | -5.22 | 0.92 | 0.49 |
| Composition 1-306 | F18 | -0.92 | -4.73 | E13 | -1.84 | K8 | -5.1 | 0.92 | 0.37 |
| Composition 1-307 | F18 | -0.92 | -4.73 | E13 | -1.84 | K6 | -5.07 | 0.92 | 0.34 |
| Composition 1-308 | F18 | -0.92 | -4.73 | E13 | -1.84 | K7 | -5.21 | 0.92 | 0.48 |
| Composition 1-309 | F18 | -0.92 | -4.73 | E13 | -1.84 | K10 | -5.31 | 0.92 | 0.58 |
| Composition 1-310 | F18 | -0.92 | -4.73 | E13 | -1.84 | K11 | -5.24 | 0.92 | 0.51 |
| Composition 1-311 | F18 | -0.92 | -4.73 | E13 | -1.84 | K12 | -5.2 | 0.92 | 0.47 |
| Composition 1-312 | F18 | -0.92 | -4.73 | E13 | -1.84 | K13 | -5.25 | 0.92 | 0.52 |
| Composition 1-313 | F18 | -0.92 | -4.73 | E13 | -1.84 | K14 | -5.28 | 0.92 | 0.55 |
| Composition 1-314 | F18 | -0.92 | -4.73 | E13 | -1.84 | K15 | -5.32 | 0.92 | 0.59 |
| Composition 1-315 | F18 | -0.92 | -4.73 | E13 | -1.84 | K16 | -5.35 | 0.92 | 0.62 |
| Composition 1-316 | F18 | -0.92 | -4.73 | E13 | -1.84 | K17 | -4.99 | 0.92 | 0.26 |
| Composition 1-317 | F18 | -0.92 | -4.73 | E13 | -1.84 | K18 | -5.07 | 0.92 | 0.34 |
| Composition 1-318 | F18 | -0.92 | -4.73 | E13 | -1.84 | K19 | -5.15 | 0.92 | 0.42 |
| Composition 1-319 | F18 | -0.92 | -4.73 | E13 | -1.84 | K20 | -5.22 | 0.92 | 0.49 |
| Composition 1-320 | F18 | -0.92 | -4.73 | E13 | -1.84 | K21 | -5.31 | 0.92 | 0.58 |
| Composition 1-321 | F18 | -0.92 | -4.73 | E13 | -1.84 | K24 | -5.38 | 0.92 | 0.65 |
| Composition 1-322 | F18 | -0.92 | -4.73 | E13 | -1.84 | K25 | -5.16 | 0.92 | 0.43 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 1-323 | F18 | -0.92 | -4.73 | E13 | -1.84 | K26 | -5.22 | 0.92 | 0.49 |
| Composition 1-324 | F18 | -0.92 | -4.73 | E13 | -1.84 | K21 | -5.07 | 0.92 | 0.34 |
| Composition 1-325 | F18 | -0.92 | -4.73 | E13 | -1.84 | K22 | -5.14 | 0.92 | 0.41 |
| Composition 2-1 | F3 | -0.89 | -4.69 | E1 | -1.86 | K1 | -5.19 | 0.97 | 0.5 |
| Composition 2-2 | F3 | -0.89 | -4.69 | E1 | -1.86 | K2 | -5.44 | 0.97 | 0.75 |
| Composition 2-3 | F3 | -0.89 | -4.69 | E1 | -1.86 | K3 | -4.82 | 0.97 | 0.13 |
| Composition 2-4 | F3 | -0.89 | -4.69 | E1 | -1.86 | K4 | -5 | 0.97 | 0.31 |
| Composition 2-5 | F3 | -0.89 | -4.69 | E1 | -1.86 | K5 | -5.22 | 0.97 | 0.53 |
| Composition 2-6 | F3 | -0.89 | -4.69 | E1 | -1.86 | K8 | -5.1 | 0.97 | 0.41 |
| Composition 2-7 | F3 | -0.89 | -4.69 | E1 | -1.86 | K6 | -5.07 | 0.97 | 0.38 |
| Composition 2-8 | F3 | -0.89 | -4.69 | E1 | -1.86 | K7 | -5.21 | 0.97 | 0.52 |
| Composition 2-9 | F3 | -0.89 | -4.69 | E1 | -1.86 | K10 | -5.31 | 0.97 | 0.62 |
| Composition 2-10 | F3 | -0.89 | -4.69 | E1 | -1.86 | K11 | -5.24 | 0.97 | 0.55 |
| Composition 2-11 | F3 | -0.89 | -4.69 | E1 | -1.86 | K12 | -5.2 | 0.97 | 0.51 |
| Composition 2-12 | F3 | -0.89 | -4.69 | E1 | -1.86 | K13 | -5.25 | 0.97 | 0.56 |
| Composition 2-13 | F3 | -0.89 | -4.69 | E1 | -1.86 | K14 | -5.28 | 0.97 | 0.59 |
| Composition 2-14 | F3 | -0.89 | -4.69 | E1 | -1.86 | K15 | -5.32 | 0.97 | 0.63 |
| Composition 2-15 | F3 | -0.89 | -4.69 | E1 | -1.86 | K16 | -5.35 | 0.97 | 0.66 |
| Composition 2-16 | F3 | -0.89 | -4.69 | E1 | -1.86 | K17 | -4.99 | 0.97 | 0.3 |
| Composition 2-17 | F3 | -0.89 | -4.69 | E1 | -1.86 | K18 | -5.07 | 0.97 | 0.38 |
| Composition 2-18 | F3 | -0.89 | -4.69 | E1 | -1.86 | K19 | -5.15 | 0.97 | 0.46 |
| Composition 2-19 | F3 | -0.89 | -4.69 | E1 | -1.86 | K20 | -5.22 | 0.97 | 0.53 |
| Composition 2-20 | F3 | -0.89 | -4.69 | E1 | -1.86 | K21 | -5.31 | 0.97 | 0.62 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 2-21 | F3 | -0.89 | -4.69 | E1 | -1.86 | K24 | -5.38 | 0.97 | 0.69 |
| Composition 2-22 | F3 | -0.89 | -4.69 | E1 | -1.86 | K25 | -5.16 | 0.97 | 0.47 |
| Composition 2-23 | F3 | -0.89 | -4.69 | E1 | -1.86 | K26 | -5.22 | 0.97 | 0.53 |
| Composition 2-24 | F3 | -0.89 | -4.69 | E1 | -1.86 | K21 | -5.07 | 0.97 | 0.38 |
| Composition 2-25 | F3 | -0.89 | -4.69 | E1 | -1.86 | K22 | -5.14 | 0.97 | 0.45 |
| Composition 2-26 | F3 | -0.89 | -4.69 | E2 | -1.83 | K1 | -5.19 | 0.94 | 0.5 |
| Composition 2-27 | F3 | -0.89 | -4.69 | E2 | -1.83 | K2 | -5.44 | 0.94 | 0.75 |
| Composition 2-28 | F3 | -0.89 | -4.69 | E2 | -1.83 | K3 | -4.82 | 0.94 | 0.13 |
| Composition 2-29 | F3 | -0.89 | -4.69 | E2 | -1.83 | K4 | -5 | 0.94 | 0.31 |
| Composition 2-30 | F3 | -0.89 | -4.69 | E2 | -1.83 | K5 | -5.22 | 0.94 | 0.53 |
| Composition 2-3 1 | F3 | -0.89 | -4.69 | E2 | -1.83 | K8 | -5.1 | 0.94 | 0.41 |
| Composition 2-32 | F3 | -0.89 | -4.69 | E2 | -1.83 | K6 | -5.07 | 0.94 | 0.38 |
| Composition 2-33 | F3 | -0.89 | -4.69 | E2 | -1.83 | K7 | -5.21 | 0.94 | 0.52 |
| Composition 2-34 | F3 | -0.89 | -4.69 | E2 | -1.83 | K10 | -5.31 | 0.94 | 0.62 |
| Composition 2-35 | F3 | -0.89 | -4.69 | E2 | -1.83 | K11 | -5.24 | 0.94 | 0.55 |
| Composition 2-36 | F3 | -0.89 | -4.69 | E2 | -1.83 | K12 | -5.2 | 0.94 | 0.51 |
| Composition 2-37 | F3 | -0.89 | -4.69 | E2 | -1.83 | K13 | -5.25 | 0.94 | 0.56 |
| Composition 2-38 | F3 | -0.89 | -4.69 | E2 | -1.83 | K14 | -5.28 | 0.94 | 0.59 |
| Composition 2-39 | F3 | -0.89 | -4.69 | E2 | -1.83 | K15 | -5.32 | 0.94 | 0.63 |
| Composition 2-40 | F3 | -0.89 | -4.69 | E2 | -1.83 | K16 | -5.35 | 0.94 | 0.66 |
| Composition 2-41 | F3 | -0.89 | -4.69 | E2 | -1.83 | K17 | -4.99 | 0.94 | 0.3 |
| Composition 2-42 | F3 | -0.89 | -4.69 | E2 | -1.83 | K18 | -5.07 | 0.94 | 0.38 |
| Composition 2-43 | F3 | -0.89 | -4.69 | E2 | -1.83 | K19 | -5.15 | 0.94 | 0.46 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 2-44 | F3 | -0.89 | -4.69 | E2 | -1.83 | K20 | -5.22 | 0.94 | 0.53 |
| Composition 2-45 | F3 | -0.89 | -4.69 | E2 | -1.83 | K21 | -5.31 | 0.94 | 0.62 |
| Composition 2-46 | F3 | -0.89 | -4.69 | E2 | -1.83 | K24 | -5.38 | 0.94 | 0.69 |
| Composition 2-47 | F3 | -0.89 | -4.69 | E2 | -1.83 | K25 | -5.16 | 0.94 | 0.47 |
| Composition 2-48 | F3 | -0.89 | -4.69 | E2 | -1.83 | K26 | -5.22 | 0.94 | 0.53 |
| Composition 2-49 | F3 | -0.89 | -4.69 | E2 | -1.83 | K21 | -5.07 | 0.94 | 0.38 |
| Composition 2-50 | F3 | -0.89 | -4.69 | E2 | -1.83 | K22 | -5.14 | 0.94 | 0.45 |
| Composition 2-51 | F3 | -0.89 | -4.69 | E12 | -1.86 | K1 | -5.19 | 0.97 | 0.5 |
| Composition 2-52 | F3 | -0.89 | -4.69 | E12 | -1.86 | K2 | -5.44 | 0.97 | 0.75 |
| Composition 2-53 | F3 | -0.89 | -4.69 | E12 | -1.86 | K3 | -4.82 | 0.97 | 0.13 |
| Composition 2-54 | F3 | -0.89 | -4.69 | E12 | -1.86 | K4 | -5 | 0.97 | 0.31 |
| Composition 2-55 | F3 | -0.89 | -4.69 | E12 | -1.86 | K5 | -5.22 | 0.97 | 0.53 |
| Composition 2-56 | F3 | -0.89 | -4.69 | E12 | -1.86 | K8 | -5.1 | 0.97 | 0.41 |
| Composition 2-57 | F3 | -0.89 | -4.69 | E12 | -1.86 | K6 | -5.07 | 0.97 | 0.38 |
| Composition 2-58 | F3 | -0.89 | -4.69 | E12 | -1.86 | K7 | -5.21 | 0.97 | 0.52 |
| Composition 2-59 | F3 | -0.89 | -4.69 | E12 | -1.86 | K10 | -5.31 | 0.97 | 0.62 |
| Composition 2-60 | F3 | -0.89 | -4.69 | E12 | -1.86 | K1I | -5.24 | 0.97 | 0.55 |
| Composition 2-61 | F3 | -0.89 | -4.69 | E12 | -1.86 | K12 | -5.2 | 0.97 | 0.51 |
| Composition 2-62 | F3 | -0.89 | -4.69 | E12 | -1.86 | K13 | -5.25 | 0.97 | 0.56 |
| Composition 2-63 | F3 | -0.89 | -4.69 | E12 | -1.86 | K14 | -5.28 | 0.97 | 0.59 |
| Composition 2-64 | F3 | -0.89 | -4.69 | E12 | -1.86 | K15 | -5.32 | 0.97 | 0.63 |
| Composition 2-65 | F3 | -0.89 | -4.69 | E12 | -1.86 | K16 | -5.35 | 0.97 | 0.66 |
| Composition 2-66 | F3 | -0.89 | -4.69 | E12 | -1.86 | K17 | -4.99 | 0.97 | 0.3 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 2-67 | F3 | -0.89 | -4.69 | E12 | -1.86 | K18 | -5.07 | 0.97 | 0.38 |
| Composition 2-68 | F3 | -0.89 | -4.69 | E12 | -1.86 | K19 | -5.15 | 0.97 | 0.46 |
| Composition 2-69 | F3 | -0.89 | -4.69 | E12 | -1.86 | K20 | -5.22 | 0.97 | 0.53 |
| Composition 2-70 | F3 | -0.89 | -4.69 | E12 | -1.86 | K21 | -5.31 | 0.97 | 0.62 |
| Composition 2-71 | F3 | -0.89 | -4.69 | E12 | -1.86 | K24 | -5.38 | 0.97 | 0.69 |
| Composition 2-72 | F3 | -0.89 | -4.69 | E12 | -1.86 | K25 | -5.16 | 0.97 | 0.47 |
| Composition 2-73 | F3 | -0.89 | -4.69 | E12 | -1.86 | K26 | -5.22 | 0.97 | 0.53 |
| Composition 2-74 | F3 | -0.89 | -4.69 | E12 | -1.86 | K21 | -5.07 | 0.97 | 0.38 |
| Composition 2-75 | F3 | -0.89 | -4.69 | E12 | -1.86 | K22 | -5.14 | 0.97 | 0.45 |
| Composition 2-76 | F3 | -0.89 | -4.69 | E3 | -1.81 | K1 | -5.19 | 0.92 | 0.5 |
| Composition 2-77 | F3 | -0.89 | -4.69 | E3 | -1.81 | K2 | -5.44 | 0.92 | 0.75 |
| Composition 2-78 | F3 | -0.89 | -4.69 | E3 | -1.81 | K3 | -4.82 | 0.92 | 0.13 |
| Composition 2-79 | F3 | -0.89 | -4.69 | E3 | -1.81 | K4 | -5 | 0.92 | 0.31 |
| Composition 2-80 | F3 | -0.89 | -4.69 | E3 | -1.81 | K5 | -5.22 | 0.92 | 0.53 |
| Composition 2-81 | F3 | -0.89 | -4.69 | E3 | -1.81 | K8 | -5.1 | 0.92 | 0.41 |
| Composition 2-82 | F3 | -0.89 | -4.69 | E3 | -1.81 | K6 | -5.07 | 0.92 | 0.38 |
| Composition 2-83 | F3 | -0.89 | -4.69 | E3 | -1.81 | K7 | -5.21 | 0.92 | 0.52 |
| Composition 2-84 | F3 | -0.89 | -4.69 | E3 | -1.81 | K10 | -5.31 | 0.92 | 0.62 |
| Composition 2-85 | F3 | -0.89 | -4.69 | E3 | -1.81 | K11 | -5.24 | 0.92 | 0.55 |
| Composition 2-86 | F3 | -0.89 | -4.69 | E3 | -1.81 | K12 | -5.2 | 0.92 | 0.51 |
| Composition 2-87 | F3 | -0.89 | -4.69 | E3 | -1.81 | K13 | -5.25 | 0.92 | 0.56 |
| Composition 2-88 | F3 | -0.89 | -4.69 | E3 | -1.81 | K14 | -5.28 | 0.92 | 0.59 |
| Composition 2-89 | F3 | -0.89 | -4.69 | E3 | -1.81 | K15 | -5.32 | 0.92 | 0.63 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 2-90 | F3 | -0.89 | -4.69 | E3 | -1.81 | K16 | -5.35 | 0.92 | 0.66 |
| Composition 2-91 | F3 | -0.89 | -4.69 | E3 | -1.81 | K17 | -4.99 | 0.92 | 0.3 |
| Composition 2-92 | F3 | -0.89 | -4.69 | E3 | -1.81 | K18 | -5.07 | 0.92 | 0.38 |
| Composition 2-93 | F3 | -0.89 | -4.69 | E3 | -1.81 | K19 | -5.15 | 0.92 | 0.46 |
| Composition 2-94 | F3 | -0.89 | -4.69 | E3 | -1.81 | K20 | -5.22 | 0.92 | 0.53 |
| Composition 2-95 | F3 | -0.89 | -4.69 | E3 | -1.81 | K21 | -5.31 | 0.92 | 0.62 |
| Composition 2-96 | F3 | -0.89 | -4.69 | E3 | -1.81 | K24 | -5.38 | 0.92 | 0.69 |
| Composition 2-97 | F3 | -0.89 | -4.69 | E3 | -1.81 | K25 | -5.16 | 0.92 | 0.47 |
| Composition 2-98 | F3 | -0.89 | -4.69 | E3 | -1.81 | K26 | -5.22 | 0.92 | 0.53 |
| Composition 2-99 | F3 | -0.89 | -4.69 | E3 | -1.81 | K21 | -5.07 | 0.92 | 0.38 |
| Composition 2-100 | F3 | -0.89 | -4.69 | E3 | -1.81 | K22 | -5.14 | 0.92 | 0.45 |
| Composition 2-101 | F3 | -0.89 | -4.69 | E4 | -1.74 | K1 | -5.19 | 0.85 | 0.5 |
| Composition 2-102 | F3 | -0.89 | -4.69 | E4 | -1.74 | K2 | -5.44 | 0.85 | 0.75 |
| Composition 2-103 | F3 | -0.89 | -4.69 | E4 | -1.74 | K3 | -4.82 | 0.85 | 0.13 |
| Composition 2-104 | F3 | -0.89 | -4.69 | E4 | -1.74 | K4 | -5 | 0.85 | 0.31 |
| Composition 2-105 | F3 | -0.89 | -4.69 | E4 | -1.74 | K5 | -5.22 | 0.85 | 0.53 |
| Composition 2-106 | F3 | -0.89 | -4.69 | E4 | -1.74 | K8 | -5.1 | 0.85 | 0.41 |
| Composition 2-107 | F3 | -0.89 | -4.69 | E4 | -1.74 | K6 | -5.07 | 0.85 | 0.38 |
| Composition 2-108 | F3 | -0.89 | -4.69 | E4 | -1.74 | K7 | -5.21 | 0.85 | 0.52 |
| Composition 2-109 | F3 | -0.89 | -4.69 | E4 | -1.74 | K10 | -5.31 | 0.85 | 0.62 |
| Composition 2-110 | F3 | -0.89 | -4.69 | E4 | -1.74 | K11 | -5.24 | 0.85 | 0.55 |
| Composition 2-111 | F3 | -0.89 | -4.69 | E4 | -1.74 | K12 | -5.2 | 0.85 | 0.51 |
| Composition 2-112 | F3 | -0.89 | -4.69 | E4 | -1.74 | K13 | -5.25 | 0.85 | 0.56 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 2-113 | F3 | -0.89 | -4.69 | E4 | -1.74 | K14 | -5.28 | 0.85 | 0.59 |
| Composition 2-114 | F3 | -0.89 | -4.69 | E4 | -1.74 | K15 | -5.32 | 0.85 | 0.63 |
| Composition 2-115 | F3 | -0.89 | -4.69 | E4 | -1.74 | K16 | -5.35 | 0.85 | 0.66 |
| Composition 2-116 | F3 | -0.89 | -4.69 | E4 | -1.74 | K17 | -4.99 | 0.85 | 0.3 |
| Composition 2-117 | F3 | -0.89 | -4.69 | E4 | -1.74 | K18 | -5.07 | 0.85 | 0.38 |
| Composition 2-118 | F3 | -0.89 | -4.69 | E4 | -1.74 | K19 | -5.15 | 0.85 | 0.46 |
| Composition 2-119 | F3 | -0.89 | -4.69 | E4 | -1.74 | K20 | -5.22 | 0.85 | 0.53 |
| Composition 2-120 | F3 | -0.89 | -4.69 | E4 | -1.74 | K21 | -5.31 | 0.85 | 0.62 |
| Composition 2-121 | F3 | -0.89 | -4.69 | E4 | -1.74 | K24 | -5.38 | 0.85 | 0.69 |
| Composition 2-122 | F3 | -0.89 | -4.69 | E4 | -1.74 | K25 | -5.16 | 0.85 | 0.47 |
| Composition 2-123 | F3 | -0.89 | -4.69 | E4 | -1.74 | K26 | -5.22 | 0.85 | 0.53 |
| Composition 2-124 | F3 | -0.89 | -4.69 | E4 | -1.74 | K21 | -5.07 | 0.85 | 0.38 |
| Composition 2-125 | F3 | -0.89 | -4.69 | E4 | -1.74 | K22 | -5.14 | 0.85 | 0.45 |
| Composition 2-126 | F3 | -0.89 | -4.69 | E5 | -1.73 | K1 | -5.19 | 0.84 | 0.5 |
| Composition 2-127 | F3 | -0.89 | -4.69 | E5 | -1.73 | K2 | -5.44 | 0.84 | 0.75 |
| Composition 2-128 | F3 | -0.89 | -4.69 | E5 | -1.73 | K3 | -4.82 | 0.84 | 0.13 |
| Composition 2-129 | F3 | -0.89 | -4.69 | E5 | -1.73 | K4 | -5 | 0.84 | 0.31 |
| Composition 2-130 | F3 | -0.89 | -4.69 | E5 | -1.73 | K5 | -5.22 | 0.84 | 0.53 |
| Composition 2-131 | F3 | -0.89 | -4.69 | E5 | -1.73 | K8 | -5.1 | 0.84 | 0.41 |
| Composition 2-132 | F3 | -0.89 | -4.69 | E5 | -1.73 | K6 | -5.07 | 0.84 | 0.38 |
| Composition 2-133 | F3 | -0.89 | -4.69 | E5 | -1.73 | K7 | -5.21 | 0.84 | 0.52 |
| Composition 2-134 | F3 | -0.89 | -4.69 | E5 | -1.73 | K10 | -5.31 | 0.84 | 0.62 |
| Composition 2-135 | F3 | -0.89 | -4.69 | E5 | -1.73 | K11 | -5.24 | 0.84 | 0.55 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 2-136 | F3 | -0.89 | -4.69 | E5 | -1.73 | K12 | -5.2 | 0.84 | 0.51 |
| Composition 2-137 | F3 | -0.89 | -4.69 | E5 | -1.73 | K13 | -5.25 | 0.84 | 0.56 |
| Composition 2-138 | F3 | -0.89 | -4.69 | E5 | -1.73 | K14 | -5.28 | 0.84 | 0.59 |
| Composition 2-139 | F3 | -0.89 | -4.69 | E5 | -1.73 | K15 | -5.32 | 0.84 | 0.63 |
| Composition 2-140 | F3 | -0.89 | -4.69 | E5 | -1.73 | K16 | -5.35 | 0.84 | 0.66 |
| Composition 2-141 | F3 | -0.89 | -4.69 | E5 | -1.73 | K17 | -4.99 | 0.84 | 0.3 |
| Composition 2-142 | F3 | -0.89 | -4.69 | E5 | -1.73 | K18 | -5.07 | 0.84 | 0.38 |
| Composition 2-143 | F3 | -0.89 | -4.69 | E5 | -1.73 | K19 | -5.15 | 0.84 | 0.46 |
| Composition 2-144 | F3 | -0.89 | -4.69 | E5 | -1.73 | K20 | -5.22 | 0.84 | 0.53 |
| Composition 2-145 | F3 | -0.89 | -4.69 | E5 | -1.73 | K21 | -5.31 | 0.84 | 0.62 |
| Composition 2-146 | F3 | -0.89 | -4.69 | E5 | -1.73 | K24 | -5.38 | 0.84 | 0.69 |
| Composition 2-147 | F3 | -0.89 | -4.69 | E5 | -1.73 | K25 | -5.16 | 0.84 | 0.47 |
| Composition 2-148 | F3 | -0.89 | -4.69 | E5 | -1.73 | K26 | -5.22 | 0.84 | 0.53 |
| Composition 2-149 | F3 | -0.89 | -4.69 | E5 | -1.73 | K21 | -5.07 | 0.84 | 0.38 |
| Composition 2-150 | F3 | -0.89 | -4.69 | E5 | -1.73 | K22 | -5.14 | 0.84 | 0.45 |
| Composition 2-151 | F3 | -0.89 | -4.69 | E6 | -1.68 | K1 | -5.19 | 0.79 | 0.5 |
| Composition 2-152 | F3 | -0.89 | -4.69 | E6 | -1.68 | K2 | -5.44 | 0.79 | 0.75 |
| Composition 2-153 | F3 | -0.89 | -4.69 | E6 | -1.68 | K3 | -4.82 | 0.79 | 0.13 |
| Composition 2-154 | F3 | -0.89 | -4.69 | E6 | -1.68 | K4 | -5 | 0.79 | 0.31 |
| Composition 2-155 | F3 | -0.89 | -4.69 | E6 | -1.68 | K5 | -5.22 | 0.79 | 0.53 |
| Composition 2-156 | F3 | -0.89 | -4.69 | E6 | -1.68 | K8 | -5.1 | 0.79 | 0.41 |
| Composition 2-157 | F3 | -0.89 | -4.69 | E6 | -1.68 | K6 | -5.07 | 0.79 | 0.38 |
| Composition 2-158 | F3 | -0.89 | -4.69 | E6 | -1.68 | K7 | -5.21 | 0.79 | 0.52 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 2-159 | F3 | -0.89 | -4.69 | E6 | -1.68 | K10 | -5.31 | 0.79 | 0.62 |
| Composition 2-160 | F3 | -0.89 | -4.69 | E6 | -1.68 | K11 | -5.24 | 0.79 | 0.55 |
| Composition 2-161 | F3 | -0.89 | -4.69 | E6 | -1.68 | K12 | -5.2 | 0.79 | 0.51 |
| Composition 2-162 | F3 | -0.89 | -4.69 | E6 | -1.68 | K13 | -5.25 | 0.79 | 0.56 |
| Composition 2-163 | F3 | -0.89 | -4.69 | E6 | -1.68 | K14 | -5.28 | 0.79 | 0.59 |
| Composition 2-164 | F3 | -0.89 | -4.69 | E6 | -1.68 | K15 | -5.32 | 0.79 | 0.63 |
| Composition 2-165 | F3 | -0.89 | -4.69 | E6 | -1.68 | K16 | -5.35 | 0.79 | 0.66 |
| Composition 2-166 | F3 | -0.89 | -4.69 | E6 | -1.68 | K17 | -4.99 | 0.79 | 0.3 |
| Composition 2-167 | F3 | -0.89 | -4.69 | E6 | -1.68 | K18 | -5.07 | 0.79 | 0.38 |
| Composition 2-168 | F3 | -0.89 | -4.69 | E6 | -1.68 | K19 | -5.15 | 0.79 | 0.46 |
| Composition 2-169 | F3 | -0.89 | -4.69 | E6 | -1.68 | K20 | -5.22 | 0.79 | 0.53 |
| Composition 2-170 | F3 | -0.89 | -4.69 | E6 | -1.68 | K21 | -5.31 | 0.79 | 0.62 |
| Composition 2-171 | F3 | -0.89 | -4.69 | E6 | -1.68 | K24 | -5.38 | 0.79 | 0.69 |
| Composition 2-172 | F3 | -0.89 | -4.69 | E6 | -1.68 | K25 | -5.16 | 0.79 | 0.47 |
| Composition 2-173 | F3 | -0.89 | -4.69 | E6 | -1.68 | K26 | -5.22 | 0.79 | 0.53 |
| Composition 2-174 | F3 | -0.89 | -4.69 | E6 | -1.68 | K21 | -5.07 | 0.79 | 0.38 |
| Composition 2-175 | F3 | -0.89 | -4.69 | E6 | -1.68 | K22 | -5.14 | 0.79 | 0.45 |
| Composition 2-176 | F3 | -0.89 | -4.69 | E7 | -1.63 | K1 | -5.19 | 0.74 | 0.5 |
| Composition 2-177 | F3 | -0.89 | -4.69 | E7 | -1.63 | K2 | -5.44 | 0.74 | 0.75 |
| Composition 2-178 | F3 | -0.89 | -4.69 | E7 | -1.63 | K3 | -4.82 | 0.74 | 0.13 |
| Composition 2-179 | F3 | -0.89 | -4.69 | E7 | -1.63 | K4 | -5 | 0.74 | 0.31 |
| Composition 2-180 | F3 | -0.89 | -4.69 | E7 | -1.63 | K5 | -5.22 | 0.74 | 0.53 |
| Composition 2-181 | F3 | -0.89 | -4.69 | E7 | -1.63 | K8 | -5.1 | 0.74 | 0.41 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 2-182 | F3 | -0.89 | -4.69 | E7 | -1.63 | K6 | -5.07 | 0.74 | 0.38 |
| Composition 2-183 | F3 | -0.89 | -4.69 | E7 | -1.63 | K7 | -5.21 | 0.74 | 0.52 |
| Composition 2-184 | F3 | -0.89 | -4.69 | E7 | -1.63 | K10 | -5.31 | 0.74 | 0.62 |
| Composition 2-185 | F3 | -0.89 | -4.69 | E7 | -1.63 | K11 | -5.24 | 0.74 | 0.55 |
| Composition 2-186 | F3 | -0.89 | -4.69 | E7 | -1.63 | K12 | -5.2 | 0.74 | 0.51 |
| Composition 2-187 | F3 | -0.89 | -4.69 | E7 | -1.63 | K13 | -5.25 | 0.74 | 0.56 |
| Composition 2-188 | F3 | -0.89 | -4.69 | E7 | -1.63 | K14 | -5.28 | 0.74 | 0.59 |
| Composition 2-189 | F3 | -0.89 | -4.69 | E7 | -1.63 | K15 | -5.32 | 0.74 | 0.63 |
| Composition 2-190 | F3 | -0.89 | -4.69 | E7 | -1.63 | K16 | -5.35 | 0.74 | 0.66 |
| Composition 2-191 | F3 | -0.89 | -4.69 | E7 | -1.63 | K17 | -4.99 | 0.74 | 0.3 |
| Composition 2-192 | F3 | -0.89 | -4.69 | E7 | -1.63 | K18 | -5.07 | 0.74 | 0.38 |
| Composition 2-193 | F3 | -0.89 | -4.69 | E7 | -1.63 | K19 | -5.15 | 0.74 | 0.46 |
| Composition 2-194 | F3 | -0.89 | -4.69 | E7 | -1.63 | K20 | -5.22 | 0.74 | 0.53 |
| Composition 2-195 | F3 | -0.89 | -4.69 | E7 | -1.63 | K21 | -5.31 | 0.74 | 0.62 |
| Composition 2-196 | F3 | -0.89 | -4.69 | E7 | -1.63 | K24 | -5.38 | 0.74 | 0.69 |
| Composition 2-197 | F3 | -0.89 | -4.69 | E7 | -1.63 | K25 | -5.16 | 0.74 | 0.47 |
| Composition 2-198 | F3 | -0.89 | -4.69 | E7 | -1.63 | K26 | -5.22 | 0.74 | 0.53 |
| Composition 2-199 | F3 | -0.89 | -4.69 | E7 | -1.63 | K21 | -5.07 | 0.74 | 0.38 |
| Composition 2-200 | F3 | -0.89 | -4.69 | E7 | -1.63 | K22 | -5.14 | 0.74 | 0.45 |
| Composition 2-201 | F3 | -0.89 | -4.69 | E8 | -1.78 | K1 | -5.19 | 0.89 | 0.5 |
| Composition 2-202 | F3 | -0.89 | -4.69 | E8 | -1.78 | K2 | -5.44 | 0.89 | 0.75 |
| Composition 2-203 | F3 | -0.89 | -4.69 | E8 | -1.78 | K3 | -4.82 | 0.89 | 0.13 |
| Composition 2-204 | F3 | -0.89 | -4.69 | E8 | -1.78 | K4 | -5 | 0.89 | 0.31 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 2-205 | F3 | -0.89 | -4.69 | E8 | -1.78 | K5 | -5.22 | 0.89 | 0.53 |
| Composition 2-206 | F3 | -0.89 | -4.69 | E8 | -1.78 | K8 | -5.1 | 0.89 | 0.41 |
| Composition 2-207 | F3 | -0.89 | -4.69 | E8 | -1.78 | K6 | -5.07 | 0.89 | 0.38 |
| Composition 2-208 | F3 | -0.89 | -4.69 | E8 | -1.78 | K7 | -5.21 | 0.89 | 0.52 |
| Composition 2-209 | F3 | -0.89 | -4.69 | E8 | -1.78 | K10 | -5.31 | 0.89 | 0.62 |
| Composition 2-210 | F3 | -0.89 | -4.69 | E8 | -1.78 | K11 | -5.24 | 0.89 | 0.55 |
| Composition 2-211 | F3 | -0.89 | -4.69 | E8 | -1.78 | K12 | -5.2 | 0.89 | 0.51 |
| Composition 2-212 | F3 | -0.89 | -4.69 | E8 | -1.78 | K13 | -5.25 | 0.89 | 0.56 |
| Composition 2-213 | F3 | -0.89 | -4.69 | E8 | -1.78 | K14 | -5.28 | 0.89 | 0.59 |
| Composition 2-214 | F3 | -0.89 | -4.69 | E8 | -1.78 | K15 | -5.32 | 0.89 | 0.63 |
| Composition 2-215 | F3 | -0.89 | -4.69 | E8 | -1.78 | K16 | -5.35 | 0.89 | 0.66 |
| Composition 2-216 | F3 | -0.89 | -4.69 | E8 | -1.78 | K17 | -4.99 | 0.89 | 0.3 |
| Composition 2-217 | F3 | -0.89 | -4.69 | E8 | -1.78 | K18 | -5.07 | 0.89 | 0.38 |
| Composition 2-218 | F3 | -0.89 | -4.69 | E8 | -1.78 | K19 | -5.15 | 0.89 | 0.46 |
| Composition 2-219 | F3 | -0.89 | -4.69 | E8 | -1.78 | K20 | -5.22 | 0.89 | 0.53 |
| Composition 2-220 | F3 | -0.89 | -4.69 | E8 | -1.78 | K21 | -5.31 | 0.89 | 0.62 |
| Composition 2-221 | F3 | -0.89 | -4.69 | E8 | -1.78 | K24 | -5.38 | 0.89 | 0.69 |
| Composition 2-222 | F3 | -0.89 | -4.69 | E8 | -1.78 | K25 | -5.16 | 0.89 | 0.47 |
| Composition 2-223 | F3 | -0.89 | -4.69 | E8 | -1.78 | K26 | -5.22 | 0.89 | 0.53 |
| Composition 2-224 | F3 | -0.89 | -4.69 | E8 | -1.78 | K21 | -5.07 | 0.89 | 0.38 |
| Composition 2-225 | F3 | -0.89 | -4.69 | E8 | -1.78 | K22 | -5.14 | 0.89 | 0.45 |
| Composition 2-226 | F3 | -0.89 | -4.69 | E9 | -1.75 | K1 | -5.19 | 0.86 | 0.5 |
| Composition 2-227 | F3 | -0.89 | -4.69 | E9 | -1.75 | K2 | -5.44 | 0.86 | 0.75 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 2-228 | F3 | -0.89 | -4.69 | E9 | -1.75 | K3 | -4.82 | 0.86 | 0.13 |
| Composition 2-229 | F3 | -0.89 | -4.69 | E9 | -1.75 | K4 | -5 | 0.86 | 0.31 |
| Composition 2-230 | F3 | -0.89 | -4.69 | E9 | -1.75 | K5 | -5.22 | 0.86 | 0.53 |
| Composition 2-231 | F3 | -0.89 | -4.69 | E9 | -1.75 | K8 | -5.1 | 0.86 | 0.41 |
| Composition 2-232 | F3 | -0.89 | -4.69 | E9 | -1.75 | K6 | -5.07 | 0.86 | 0.38 |
| Composition 2-233 | F3 | -0.89 | -4.69 | E9 | -1.75 | K7 | -5.21 | 0.86 | 0.52 |
| Composition 2-234 | F3 | -0.89 | -4.69 | E9 | -1.75 | K10 | -5.31 | 0.86 | 0.62 |
| Composition 2-235 | F3 | -0.89 | -4.69 | E9 | -1.75 | K11 | -5.24 | 0.86 | 0.55 |
| Composition 2-236 | F3 | -0.89 | -4.69 | E9 | -1.75 | K12 | -5.2 | 0.86 | 0.51 |
| Composition 2-237 | F3 | -0.89 | -4.69 | E9 | -1.75 | K13 | -5.25 | 0.86 | 0.56 |
| Composition 2-238 | F3 | -0.89 | -4.69 | E9 | -1.75 | K14 | -5.28 | 0.86 | 0.59 |
| Composition 2-239 | F3 | -0.89 | -4.69 | E9 | -1.75 | K15 | -5.32 | 0.86 | 0.63 |
| Composition 2-240 | F3 | -0.89 | -4.69 | E9 | -1.75 | K16 | -5.35 | 0.86 | 0.66 |
| Composition 2-241 | F3 | -0.89 | -4.69 | E9 | -1.75 | K17 | -4.99 | 0.86 | 0.3 |
| Composition 2-242 | F3 | -0.89 | -4.69 | E9 | -1.75 | K18 | -5.07 | 0.86 | 0.38 |
| Composition 2-243 | F3 | -0.89 | -4.69 | E9 | -1.75 | K19 | -5.15 | 0.86 | 0.46 |
| Composition 2-244 | F3 | -0.89 | -4.69 | E9 | -1.75 | K20 | -5.22 | 0.86 | 0.53 |
| Composition 2-245 | F3 | -0.89 | -4.69 | E9 | -1.75 | K21 | -5.31 | 0.86 | 0.62 |
| Composition 2-246 | F3 | -0.89 | -4.69 | E9 | -1.75 | K24 | -5.38 | 0.86 | 0.69 |
| Composition 2-247 | F3 | -0.89 | -4.69 | E9 | -1.75 | K25 | -5.16 | 0.86 | 0.47 |
| Composition 2-248 | F3 | -0.89 | -4.69 | E9 | -1.75 | K26 | -5.22 | 0.86 | 0.53 |
| Composition 2-249 | F3 | -0.89 | -4.69 | E9 | -1.75 | K21 | -5.07 | 0.86 | 0.38 |
| Composition 2-250 | F3 | -0.89 | -4.69 | E9 | -1.75 | K22 | -5.14 | 0.86 | 0.45 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 2-251 | F3 | -0.89 | -4.69 | E10 | -1.81 | K1 | -5.19 | 0.92 | 0.5 |
| Composition 2-252 | F3 | -0.89 | -4.69 | E10 | -1.81 | K2 | -5.44 | 0.92 | 0.75 |
| Composition 2-253 | F3 | -0.89 | -4.69 | E10 | -1.81 | K3 | -4.82 | 0.92 | 0.13 |
| Composition 2-254 | F3 | -0.89 | -4.69 | E10 | -1.81 | K4 | -5 | 0.92 | 0.31 |
| Composition 2-255 | F3 | -0.89 | -4.69 | E10 | -1.81 | K5 | -5.22 | 0.92 | 0.53 |
| Composition 2-256 | F3 | -0.89 | -4.69 | E10 | -1.81 | K8 | -5.1 | 0.92 | 0.41 |
| Composition 2-257 | F3 | -0.89 | -4.69 | E10 | -1.81 | K6 | -5.07 | 0.92 | 0.38 |
| Composition 2-258 | F3 | -0.89 | -4.69 | E10 | -1.81 | K7 | -5.21 | 0.92 | 0.52 |
| Composition 2-259 | F3 | -0.89 | -4.69 | E10 | -1.81 | K10 | -5.31 | 0.92 | 0.62 |
| Composition 2-260 | F3 | -0.89 | -4.69 | E10 | -1.81 | K11 | -5.24 | 0.92 | 0.55 |
| Composition 2-261 | F3 | -0.89 | -4.69 | E10 | -1.81 | K12 | -5.2 | 0.92 | 0.51 |
| Composition 2-262 | F3 | -0.89 | -4.69 | E10 | -1.81 | K13 | -5.25 | 0.92 | 0.56 |
| Composition 2-263 | F3 | -0.89 | -4.69 | E10 | -1.81 | K14 | -5.28 | 0.92 | 0.59 |
| Composition 2-264 | F3 | -0.89 | -4.69 | E10 | -1.81 | K15 | -5.32 | 0.92 | 0.63 |
| Composition 2-265 | F3 | -0.89 | -4.69 | E10 | -1.81 | K16 | -5.35 | 0.92 | 0.66 |
| Composition 2-266 | F3 | -0.89 | -4.69 | E10 | -1.81 | K17 | -4.99 | 0.92 | 0.3 |
| Composition 2-267 | F3 | -0.89 | -4.69 | E10 | -1.81 | K18 | -5.07 | 0.92 | 0.38 |
| Composition 2-268 | F3 | -0.89 | -4.69 | E10 | -1.81 | K19 | -5.15 | 0.92 | 0.46 |
| Composition 2-269 | F3 | -0.89 | -4.69 | E10 | -1.81 | K20 | -5.22 | 0.92 | 0.53 |
| Composition 2-270 | F3 | -0.89 | -4.69 | E10 | -1.81 | K21 | -5.31 | 0.92 | 0.62 |
| Composition 2-271 | F3 | -0.89 | -4.69 | E10 | -1.81 | K24 | -5.38 | 0.92 | 0.69 |
| Composition 2-272 | F3 | -0.89 | -4.69 | E10 | -1.81 | K25 | -5.16 | 0.92 | 0.47 |
| Composition 2-273 | F3 | -0.89 | -4.69 | E10 | -1.81 | K26 | -5.22 | 0.92 | 0.53 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 2-274 | F3 | -0.89 | -4.69 | E10 | -1.81 | K21 | -5.07 | 0.92 | 0.38 |
| Composition 2-275 | F3 | -0.89 | -4.69 | E10 | -1.81 | K22 | -5.14 | 0.92 | 0.45 |
| Composition 2-276 | F3 | -0.89 | -4.69 | E11 | -1.87 | K1 | -5.19 | 0.98 | 0.5 |
| Composition 2-277 | F3 | -0.89 | -4.69 | E11 | -1.87 | K2 | -5.44 | 0.98 | 0.75 |
| Composition 2-278 | F3 | -0.89 | -4.69 | E11 | -1.87 | K3 | -4.82 | 0.98 | 0.13 |
| Composition 2-279 | F3 | -0.89 | -4.69 | E11 | -1.87 | K4 | -5 | 0.98 | 0.31 |
| Composition 2-280 | F3 | -0.89 | -4.69 | E11 | -1.87 | K5 | -5.22 | 0.98 | 0.53 |
| Composition 2-281 | F3 | -0.89 | -4.69 | E11 | -1.87 | K8 | -5.1 | 0.98 | 0.41 |
| Composition 2-282 | F3 | -0.89 | -4.69 | E11 | -1.87 | K6 | -5.07 | 0.98 | 0.38 |
| Composition 2-283 | F3 | -0.89 | -4.69 | E11 | -1.87 | K7 | -5.21 | 0.98 | 0.52 |
| Composition 2-284 | F3 | -0.89 | -4.69 | E11 | -1.87 | K10 | -5.31 | 0.98 | 0.62 |
| Composition 2-285 | F3 | -0.89 | -4.69 | E11 | -1.87 | K11 | -5.24 | 0.98 | 0.55 |
| Composition 2-286 | F3 | -0.89 | -4.69 | E11 | -1.87 | K12 | -5.2 | 0.98 | 0.51 |
| Composition 2-287 | F3 | -0.89 | -4.69 | E11 | -1.87 | K13 | -5.25 | 0.98 | 0.56 |
| Composition 2-288 | F3 | -0.89 | -4.69 | E11 | -1.87 | K14 | -5.28 | 0.98 | 0.59 |
| Composition 2-289 | F3 | -0.89 | -4.69 | E11 | -1.87 | K15 | -5.32 | 0.98 | 0.63 |
| Composition 2-290 | F3 | -0.89 | -4.69 | E11 | -1.87 | K16 | -5.35 | 0.98 | 0.66 |
| Composition 2-291 | F3 | -0.89 | -4.69 | E11 | -1.87 | K17 | -4.99 | 0.98 | 0.3 |
| Composition 2-292 | F3 | -0.89 | -4.69 | E11 | -1.87 | K18 | -5.07 | 0.98 | 0.38 |
| Composition 2-293 | F3 | -0.89 | -4.69 | E11 | -1.87 | K19 | -5.15 | 0.98 | 0.46 |
| Composition 2-294 | F3 | -0.89 | -4.69 | E11 | -1.87 | K20 | -5.22 | 0.98 | 0.53 |
| Composition 2-295 | F3 | -0.89 | -4.69 | E11 | -1.87 | K21 | -5.31 | 0.98 | 0.62 |
| Composition 2-296 | F3 | -0.89 | -4.69 | E11 | -1.87 | K24 | -5.38 | 0.98 | 0.69 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 2-297 | F3 | -0.89 | -4.69 | E11 | -1.87 | K25 | -5.16 | 0.98 | 0.47 |
| Composition 2-298 | F3 | -0.89 | -4.69 | E11 | -1.87 | K26 | -5.22 | 0.98 | 0.53 |
| Composition 2-299 | F3 | -0.89 | -4.69 | E11 | -1.87 | K21 | -5.07 | 0.98 | 0.38 |
| Composition 2-300 | F3 | -0.89 | -4.69 | E11 | -1.87 | K22 | -5.14 | 0.98 | 0.45 |
| Composition 3-1 | F23 | -1 | -4.84 | E1 | -1.86 | K1 | -5.19 | 0.86 | 0.35 |
| Composition 3-2 | F23 | -1 | -4.84 | E1 | -1.86 | K2 | -5.44 | 0.86 | 0.6 |
| Composition 3-3 | F23 | -1 | -4.84 | E1 | -1.86 | K4 | -5 | 0.86 | 0.16 |
| Composition 3-4 | F23 | -1 | -4.84 | E1 | -1.86 | K5 | -5.22 | 0.86 | 0.38 |
| Composition 3-5 | F23 | -1 | -4.84 | E1 | -1.86 | K8 | -5.1 | 0.86 | 0.26 |
| Composition 3-6 | F23 | -1 | -4.84 | E1 | -1.86 | K6 | -5.07 | 0.86 | 0.23 |
| Composition 3-7 | F23 | -1 | -4.84 | E1 | -1.86 | K7 | -5.21 | 0.86 | 0.37 |
| Composition 3-8 | F23 | -1 | -4.84 | E1 | -1.86 | K10 | -5.31 | 0.86 | 0.47 |
| Composition 3-9 | F23 | -1 | -4.84 | E1 | -1.86 | K11 | -5.24 | 0.86 | 0.4 |
| Composition 3-10 | F23 | -1 | -4.84 | E1 | -1.86 | K12 | -5.2 | 0.86 | 0.36 |
| Composition 3-11 | F23 | -1 | -4.84 | E1 | -1.86 | K13 | -5.25 | 0.86 | 0.41 |
| Composition 3-12 | F23 | -1 | -4.84 | E1 | -1.86 | K14 | -5.28 | 0.86 | 0.44 |
| Composition 3-13 | F23 | -1 | -4.84 | E1 | -1.86 | K15 | -5.32 | 0.86 | 0.48 |
| Composition 3-14 | F23 | -1 | -4.84 | E1 | -1.86 | K16 | -5.35 | 0.86 | 0.51 |
| Composition 3-15 | F23 | -1 | -4.84 | E1 | -1.86 | K17 | -4.99 | 0.86 | 0.15 |
| Composition 3-16 | F23 | -1 | -4.84 | E1 | -1.86 | K18 | -5.07 | 0.86 | 0.23 |
| Composition 3-17 | F23 | -1 | -4.84 | E1 | -1.86 | K19 | -5.15 | 0.86 | 0.31 |
| Composition 3-18 | F23 | -1 | -4.84 | E1 | -1.86 | K20 | -5.22 | 0.86 | 0.38 |
| Composition 3-19 | F23 | -1 | -4.84 | E1 | -1.86 | K21 | -5.31 | 0.86 | 0.47 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 3-20 | F23 | -1 | -4.84 | E1 | -1.86 | K24 | -5.38 | 0.86 | 0.54 |
| Composition 3-21 | F23 | -1 | -4.84 | E1 | -1.86 | K25 | -5.16 | 0.86 | 0.32 |
| Composition 3-22 | F23 | -1 | -4.84 | E1 | -1.86 | K26 | -5.22 | 0.86 | 0.38 |
| Composition 3-23 | F23 | -1 | -4.84 | E1 | -1.86 | K21 | -5.07 | 0.86 | 0.23 |
| Composition 3-24 | F23 | -1 | -4.84 | E1 | -1.86 | K22 | -5.14 | 0.86 | 0.3 |
| Composition 3-25 | F23 | -1 | -4.84 | E2 | -1.83 | K1 | -5.19 | 0.83 | 0.35 |
| Composition 3-26 | F23 | -1 | -4.84 | E2 | -1.83 | K2 | -5.44 | 0.83 | 0.6 |
| Composition 3-27 | F23 | -1 | -4.84 | E2 | -1.83 | K4 | -5 | 0.83 | 0.16 |
| Composition 3-28 | F23 | -1 | -4.84 | E2 | -1.83 | K5 | -5.22 | 0.83 | 0.38 |
| Composition 3-29 | F23 | -1 | -4.84 | E2 | -1.83 | K8 | -5.1 | 0.83 | 0.26 |
| Composition 3-30 | F23 | -1 | -4.84 | E2 | -1.83 | K6 | -5.07 | 0.83 | 0.23 |
| Composition 3-31 | F23 | -1 | -4.84 | E2 | -1.83 | K7 | -5.21 | 0.83 | 0.37 |
| Composition 3-32 | F23 | -1 | -4.84 | E2 | -1.83 | K10 | -5.31 | 0.83 | 0.47 |
| Composition 3-33 | F23 | -1 | -4.84 | E2 | -1.83 | K11 | -5.24 | 0.83 | 0.4 |
| Composition 3-34 | F23 | -1 | -4.84 | E2 | -1.83 | K12 | -5.2 | 0.83 | 0.36 |
| Composition 3-35 | F23 | -1 | -4.84 | E2 | -1.83 | K13 | -5.25 | 0.83 | 0.41 |
| Composition 3-36 | F23 | -1 | -4.84 | E2 | -1.83 | K14 | -5.28 | 0.83 | 0.44 |
| Composition 3-37 | F23 | -1 | -4.84 | E2 | -1.83 | K15 | -5.32 | 0.83 | 0.48 |
| Composition 3-38 | F23 | -1 | -4.84 | E2 | -1.83 | K16 | -5.35 | 0.83 | 0.51 |
| Composition 3-39 | F23 | -1 | -4.84 | E2 | -1.83 | K17 | -4.99 | 0.83 | 0.15 |
| Composition 3-40 | F23 | -1 | -4.84 | E2 | -1.83 | K18 | -5.07 | 0.83 | 0.23 |
| Composition 3-41 | F23 | -1 | -4.84 | E2 | -1.83 | K19 | -5.15 | 0.83 | 0.31 |
| Composition 3-42 | F23 | -1 | -4.84 | E2 | -1.83 | K20 | -5.22 | 0.83 | 0.38 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 3-43 | F23 | -1 | -4.84 | E2 | -1.83 | K21 | -5.31 | 0.83 | 0.47 |
| Composition 3-44 | F23 | -1 | -4.84 | E2 | -1.83 | K24 | -5.38 | 0.83 | 0.54 |
| Composition 3-45 | F23 | -1 | -4.84 | E2 | -1.83 | K25 | -5.16 | 0.83 | 0.32 |
| Composition 3-46 | F23 | -1 | -4.84 | E2 | -1.83 | K26 | -5.22 | 0.83 | 0.38 |
| Composition 3-47 | F23 | -1 | -4.84 | E2 | -1.83 | K21 | -5.07 | 0.83 | 0.23 |
| Composition 3-48 | F23 | -1 | -4.84 | E2 | -1.83 | K22 | -5.14 | 0.83 | 0.3 |
| Composition 3-49 | F23 | -1 | -4.84 | E12 | -1.86 | K1 | -5.19 | 0.86 | 0.35 |
| Composition 3-50 | F23 | -1 | -4.84 | E12 | -1.86 | K2 | -5.44 | 0.86 | 0.6 |
| Composition 3-51 | F23 | -1 | -4.84 | E12 | -1.86 | K4 | -5 | 0.86 | 0.16 |
| Composition 3-52 | F23 | -1 | -4.84 | E12 | -1.86 | K5 | -5.22 | 0.86 | 0.38 |
| Composition 3-53 | F23 | -1 | -4.84 | E12 | -1.86 | K8 | -5.1 | 0.86 | 0.26 |
| Composition 3-54 | F23 | -1 | -4.84 | E12 | -1.86 | K6 | -5.07 | 0.86 | 0.23 |
| Composition 3-55 | F23 | -1 | -4.84 | E12 | -1.86 | K7 | -5.21 | 0.86 | 0.37 |
| Composition 3-56 | F23 | -1 | -4.84 | E12 | -1.86 | K10 | -5.31 | 0.86 | 0.47 |
| Composition 3-57 | F23 | -1 | -4.84 | E12 | -1.86 | K11 | -5.24 | 0.86 | 0.4 |
| Composition 3-58 | F23 | -1 | -4.84 | E12 | -1.86 | K12 | -5.2 | 0.86 | 0.36 |
| Composition 3-59 | F23 | -1 | -4.84 | E12 | -1.86 | K13 | -5.25 | 0.86 | 0.41 |
| Composition 3-60 | F23 | -1 | -4.84 | E12 | -1.86 | K14 | -5.28 | 0.86 | 0.44 |
| Composition 3-61 | F23 | -1 | -4.84 | E12 | -1.86 | K15 | -5.32 | 0.86 | 0.48 |
| Composition 3-62 | F23 | -1 | -4.84 | E12 | -1.86 | K16 | -5.35 | 0.86 | 0.51 |
| Composition 3-63 | F23 | -1 | -4.84 | E12 | -1.86 | K17 | -4.99 | 0.86 | 0.15 |
| Composition 3-64 | F23 | -1 | -4.84 | E12 | -1.86 | K18 | -5.07 | 0.86 | 0.23 |
| Composition 3-65 | F23 | -1 | -4.84 | E12 | -1.86 | K19 | -5.15 | 0.86 | 0.31 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 3-66 | F23 | -1 | -4.84 | E12 | -1.86 | K20 | -5.22 | 0.86 | 0.38 |
| Composition 3-67 | F23 | -1 | -4.84 | E12 | -1.86 | K21 | -5.31 | 0.86 | 0.47 |
| Composition 3-68 | F23 | -1 | -4.84 | E12 | -1.86 | K24 | -5.38 | 0.86 | 0.54 |
| Composition 3-69 | F23 | -1 | -4.84 | E12 | -1.86 | K25 | -5.16 | 0.86 | 0.32 |
| Composition 3-70 | F23 | -1 | -4.84 | E12 | -1.86 | K26 | -5.22 | 0.86 | 0.38 |
| Composition 3-71 | F23 | -1 | -4.84 | E12 | -1.86 | K21 | -5.07 | 0.86 | 0.23 |
| Composition 3-72 | F23 | -1 | -4.84 | E12 | -1.86 | K22 | -5.14 | 0.86 | 0.3 |
| Composition 3-73 | F23 | -1 | -4.84 | E3 | -1.81 | K1 | -5.19 | 0.81 | 0.35 |
| Composition 3-74 | F23 | -1 | -4.84 | E3 | -1.81 | K2 | -5.44 | 0.81 | 0.6 |
| Composition 3-75 | F23 | -1 | -4.84 | E3 | -1.81 | K4 | -5 | 0.81 | 0.16 |
| Composition 3-76 | F23 | -1 | -4.84 | E3 | -1.81 | K5 | -5.22 | 0.81 | 0.38 |
| Composition 3-77 | F23 | -1 | -4.84 | E3 | -1.81 | K8 | -5.1 | 0.81 | 0.26 |
| Composition 3-78 | F23 | -1 | -4.84 | E3 | -1.81 | K6 | -5.07 | 0.81 | 0.23 |
| Composition 3-79 | F23 | -1 | -4.84 | E3 | -1.81 | K7 | -5.21 | 0.81 | 0.37 |
| Composition 3-80 | F23 | -1 | -4.84 | E3 | -1.81 | K10 | -5.31 | 0.81 | 0.47 |
| Composition 3-81 | F23 | -1 | -4.84 | E3 | -1.81 | K11 | -5.24 | 0.81 | 0.4 |
| Composition 3-82 | F23 | -1 | -4.84 | E3 | -1.81 | K12 | -5.2 | 0.81 | 0.36 |
| Composition 3-83 | F23 | -1 | -4.84 | E3 | -1.81 | K13 | -5.25 | 0.81 | 0.41 |
| Composition 3-84 | F23 | -1 | -4.84 | E3 | -1.81 | K14 | -5.28 | 0.81 | 0.44 |
| Composition 3-85 | F23 | -1 | -4.84 | E3 | -1.81 | K15 | -5.32 | 0.81 | 0.48 |
| Composition 3-86 | F23 | -1 | -4.84 | E3 | -1.81 | K16 | -5.35 | 0.81 | 0.51 |
| Composition 3-87 | F23 | -1 | -4.84 | E3 | -1.81 | K17 | -4.99 | 0.81 | 0.15 |
| Composition 3-88 | F23 | -1 | -4.84 | E3 | -1.81 | K18 | -5.07 | 0.81 | 0.23 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 3-89 | F23 | -1 | -4.84 | E3 | -1.81 | K19 | -5.15 | 0.81 | 0.31 |
| Composition 3-90 | F23 | -1 | -4.84 | E3 | -1.81 | K20 | -5.22 | 0.81 | 0.38 |
| Composition 3-91 | F23 | -1 | -4.84 | E3 | -1.81 | K21 | -5.31 | 0.81 | 0.47 |
| Composition 3-92 | F23 | -1 | -4.84 | E3 | -1.81 | K24 | -5.38 | 0.81 | 0.54 |
| Composition 3-93 | F23 | -1 | -4.84 | E3 | -1.81 | K25 | -5.16 | 0.81 | 0.32 |
| Composition 3-94 | F23 | -1 | -4.84 | E3 | -1.81 | K26 | -5.22 | 0.81 | 0.38 |
| Composition 3-95 | F23 | -1 | -4.84 | E3 | -1.81 | K21 | -5.07 | 0.81 | 0.23 |
| Composition 3-96 | F23 | -1 | -4.84 | E3 | -1.81 | K22 | -5.14 | 0.81 | 0.3 |
| Composition 3-97 | F23 | -1 | -4.84 | E4 | -1.74 | K1 | -5.19 | 0.74 | 0.35 |
| Composition 3-98 | F23 | -1 | -4.84 | E4 | -1.74 | K2 | -5.44 | 0.74 | 0.6 |
| Composition 3-99 | F23 | -1 | -4.84 | E4 | -1.74 | K4 | -5 | 0.74 | 0.16 |
| Composition 3-100 | F23 | -1 | -4.84 | E4 | -1.74 | K5 | -5.22 | 0.74 | 0.38 |
| Composition 3-101 | F23 | -1 | -4.84 | E4 | -1.74 | K8 | -5.1 | 0.74 | 0.26 |
| Composition 3-102 | F23 | -1 | -4.84 | E4 | -1.74 | K6 | -5.07 | 0.74 | 0.23 |
| Composition 3-103 | F23 | -1 | -4.84 | E4 | -1.74 | K7 | -5.21 | 0.74 | 0.37 |
| Composition 3-104 | F23 | -1 | -4.84 | E4 | -1.74 | K10 | -5.31 | 0.74 | 0.47 |
| Composition 3-105 | F23 | -1 | -4.84 | E4 | -1.74 | K11 | -5.24 | 0.74 | 0.4 |
| Composition 3-106 | F23 | -1 | -4.84 | E4 | -1.74 | K12 | -5.2 | 0.74 | 0.36 |
| Composition 3-107 | F23 | -1 | -4.84 | E4 | -1.74 | K13 | -5.25 | 0.74 | 0.41 |
| Composition 3-108 | F23 | -1 | -4.84 | E4 | -1.74 | K14 | -5.28 | 0.74 | 0.44 |
| Composition 3-109 | F23 | -1 | -4.84 | E4 | -1.74 | K15 | -5.32 | 0.74 | 0.48 |
| Composition 3-110 | F23 | -1 | -4.84 | E4 | -1.74 | K16 | -5.35 | 0.74 | 0.51 |
| Composition 3-111 | F23 | -1 | -4.84 | E4 | -1.74 | K17 | -4.99 | 0.74 | 0.15 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 3-112 | F23 | -1 | -4.84 | E4 | -1.74 | K18 | -5.07 | 0.74 | 0.23 |
| Composition 3-113 | F23 | -1 | -4.84 | E4 | -1.74 | K19 | -5.15 | 0.74 | 0.31 |
| Composition 3-114 | F23 | -1 | -4.84 | E4 | -1.74 | K20 | -5.22 | 0.74 | 0.38 |
| Composition 3-115 | F23 | -1 | -4.84 | E4 | -1.74 | K21 | -5.31 | 0.74 | 0.47 |
| Composition 3-116 | F23 | -1 | -4.84 | E4 | -1.74 | K24 | -5.38 | 0.74 | 0.54 |
| Composition 3-117 | F23 | -1 | -4.84 | E4 | -1.74 | K25 | -5.16 | 0.74 | 0.32 |
| Composition 3-118 | F23 | -1 | -4.84 | E4 | -1.74 | K26 | -5.22 | 0.74 | 0.38 |
| Composition 3-119 | F23 | -1 | -4.84 | E4 | -1.74 | K21 | -5.07 | 0.74 | 0.23 |
| Composition 3-120 | F23 | -1 | -4.84 | E4 | -1.74 | K22 | -5.14 | 0.74 | 0.3 |
| Composition 3-121 | F23 | -1 | -4.84 | E5 | -1.73 | K1 | -5.19 | 0.73 | 0.35 |
| Composition 3-122 | F23 | -1 | -4.84 | E5 | -1.73 | K2 | -5.44 | 0.73 | 0.6 |
| Composition 3-123 | F23 | -1 | -4.84 | E5 | -1.73 | K4 | -5 | 0.73 | 0.16 |
| Composition 3-124 | F23 | -1 | -4.84 | E5 | -1.73 | K5 | -5.22 | 0.73 | 0.38 |
| Composition 3-125 | F23 | -1 | -4.84 | E5 | -1.73 | K8 | -5.1 | 0.73 | 0.26 |
| Composition 3-126 | F23 | -1 | -4.84 | E5 | -1.73 | K6 | -5.07 | 0.73 | 0.23 |
| Composition 3-127 | F23 | -1 | -4.84 | E5 | -1.73 | K7 | -5.21 | 0.73 | 0.37 |
| Composition 3-128 | F23 | -1 | -4.84 | E5 | -1.73 | K10 | -5.31 | 0.73 | 0.47 |
| Composition 3-129 | F23 | -1 | -4.84 | E5 | -1.73 | K11 | -5.24 | 0.73 | 0.4 |
| Composition 3-130 | F23 | -1 | -4.84 | E5 | -1.73 | K12 | -5.2 | 0.73 | 0.36 |
| Composition 3-131 | F23 | -1 | -4.84 | E5 | -1.73 | K13 | -5.25 | 0.73 | 0.41 |
| Composition 3-132 | F23 | -1 | -4.84 | E5 | -1.73 | K14 | -5.28 | 0.73 | 0.44 |
| Composition 3-133 | F23 | -1 | -4.84 | E5 | -1.73 | K15 | -5.32 | 0.73 | 0.48 |
| Composition 3-134 | F23 | -1 | -4.84 | E5 | -1.73 | K16 | -5.35 | 0.73 | 0.51 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 3-135 | F23 | -1 | -4.84 | E5 | -1.73 | K17 | -4.99 | 0.73 | 0.15 |
| Composition 3-136 | F23 | -1 | -4.84 | E5 | -1.73 | K18 | -5.07 | 0.73 | 0.23 |
| Composition 3-137 | F23 | -1 | -4.84 | E5 | -1.73 | K19 | -5.15 | 0.73 | 0.31 |
| Composition 3-138 | F23 | -1 | -4.84 | E5 | -1.73 | K20 | -5.22 | 0.73 | 0.38 |
| Composition 3-139 | F23 | -1 | -4.84 | E5 | -1.73 | K21 | -5.31 | 0.73 | 0.47 |
| Composition 3-140 | F23 | -1 | -4.84 | E5 | -1.73 | K24 | -5.38 | 0.73 | 0.54 |
| Composition 3-141 | F23 | -1 | -4.84 | E5 | -1.73 | K25 | -5.16 | 0.73 | 0.32 |
| Composition 3-142 | F23 | -1 | -4.84 | E5 | -1.73 | K26 | -5.22 | 0.73 | 0.38 |
| Composition 3-143 | F23 | -1 | -4.84 | E5 | -1.73 | K21 | -5.07 | 0.73 | 0.23 |
| Composition 3-144 | F23 | -1 | -4.84 | E5 | -1.73 | K22 | -5.14 | 0.73 | 0.3 |
| Composition 3-145 | F23 | -1 | -4.84 | E6 | -1.68 | K1 | -5.19 | 0.68 | 0.35 |
| Composition 3-146 | F23 | -1 | -4.84 | E6 | -1.68 | K2 | -5.44 | 0.68 | 0.6 |
| Composition 3-147 | F23 | -1 | -4.84 | E6 | -1.68 | K4 | -5 | 0.68 | 0.16 |
| Composition 3-148 | F23 | -1 | -4.84 | E6 | -1.68 | K5 | -5.22 | 0.68 | 0.38 |
| Composition 3-149 | F23 | -1 | -4.84 | E6 | -1.68 | K8 | -5.1 | 0.68 | 0.26 |
| Composition 3-150 | F23 | -1 | -4.84 | E6 | -1.68 | K6 | -5.07 | 0.68 | 0.23 |
| Composition 3-151 | F23 | -1 | -4.84 | E6 | -1.68 | K7 | -5.21 | 0.68 | 0.37 |
| Composition 3-152 | F23 | -1 | -4.84 | E6 | -1.68 | K10 | -5.31 | 0.68 | 0.47 |
| Composition 3-153 | F23 | -1 | -4.84 | E6 | -1.68 | K11 | -5.24 | 0.68 | 0.4 |
| Composition 3-154 | F23 | -1 | -4.84 | E6 | -1.68 | K12 | -5.2 | 0.68 | 0.36 |
| Composition 3-155 | F23 | -1 | -4.84 | E6 | -1.68 | K13 | -5.25 | 0.68 | 0.41 |
| Composition 3-156 | F23 | -1 | -4.84 | E6 | -1.68 | K14 | -5.28 | 0.68 | 0.44 |
| Composition 3-157 | F23 | -1 | -4.84 | E6 | -1.68 | K15 | -5.32 | 0.68 | 0.48 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 3-158 | F23 | -1 | -4.84 | E6 | -1.68 | K16 | -5.35 | 0.68 | 0.51 |
| Composition 3-159 | F23 | -1 | -4.84 | E6 | -1.68 | K17 | -4.99 | 0.68 | 0.15 |
| Composition 3-160 | F23 | -1 | -4.84 | E6 | -1.68 | K18 | -5.07 | 0.68 | 0.23 |
| Composition 3-161 | F23 | -1 | -4.84 | E6 | -1.68 | K19 | -5.15 | 0.68 | 0.31 |
| Composition 3-162 | F23 | -1 | -4.84 | E6 | -1.68 | K20 | -5.22 | 0.68 | 0.38 |
| Composition 3-163 | F23 | -1 | -4.84 | E6 | -1.68 | K21 | -5.31 | 0.68 | 0.47 |
| Composition 3-164 | F23 | -1 | -4.84 | E6 | -1.68 | K24 | -5.38 | 0.68 | 0.54 |
| Composition 3-165 | F23 | -1 | -4.84 | E6 | -1.68 | K25 | -5.16 | 0.68 | 0.32 |
| Composition 3-166 | F23 | -1 | -4.84 | E6 | -1.68 | K26 | -5.22 | 0.68 | 0.38 |
| Composition 3-167 | F23 | -1 | -4.84 | E6 | -1.68 | K21 | -5.07 | 0.68 | 0.23 |
| Composition 3-168 | F23 | -1 | -4.84 | E6 | -1.68 | K22 | -5.14 | 0.68 | 0.3 |
| Composition 3-169 | F23 | -1 | -4.84 | E7 | -1.63 | K1 | -5.19 | 0.63 | 0.35 |
| Composition 3-170 | F23 | -1 | -4.84 | E7 | -1.63 | K2 | -5.44 | 0.63 | 0.6 |
| Composition 3-171 | F23 | -1 | -4.84 | E7 | -1.63 | K4 | -5 | 0.63 | 0.16 |
| Composition 3-172 | F23 | -1 | -4.84 | E7 | -1.63 | K5 | -5.22 | 0.63 | 0.38 |
| Composition 3-173 | F23 | -1 | -4.84 | E7 | -1.63 | K8 | -5.1 | 0.63 | 0.26 |
| Composition 3-174 | F23 | -1 | -4.84 | E7 | -1.63 | K6 | -5.07 | 0.63 | 0.23 |
| Composition 3-175 | F23 | -1 | -4.84 | E7 | -1.63 | K7 | -5.21 | 0.63 | 0.37 |
| Composition 3-176 | F23 | -1 | -4.84 | E7 | -1.63 | K10 | -5.31 | 0.63 | 0.47 |
| Composition 3-177 | F23 | -1 | -4.84 | E7 | -1.63 | K11 | -5.24 | 0.63 | 0.4 |
| Composition 3-178 | F23 | -1 | -4.84 | E7 | -1.63 | K12 | -5.2 | 0.63 | 0.36 |
| Composition 3-179 | F23 | -1 | -4.84 | E7 | -1.63 | K13 | -5.25 | 0.63 | 0.41 |
| Composition 3-180 | F23 | -1 | -4.84 | E7 | -1.63 | K14 | -5.28 | 0.63 | 0.44 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 3-181 | F23 | -1 | -4.84 | E7 | -1.63 | K15 | -5.32 | 0.63 | 0.48 |
| Composition 3-182 | F23 | -1 | -4.84 | E7 | -1.63 | K16 | -5.35 | 0.63 | 0.51 |
| Composition 3-183 | F23 | -1 | -4.84 | E7 | -1.63 | K17 | -4.99 | 0.63 | 0.15 |
| Composition 3-184 | F23 | -1 | -4.84 | E7 | -1.63 | K18 | -5.07 | 0.63 | 0.23 |
| Composition 3-185 | F23 | -1 | -4.84 | E7 | -1.63 | K19 | -5.15 | 0.63 | 0.31 |
| Composition 3-186 | F23 | -1 | -4.84 | E7 | -1.63 | K20 | -5.22 | 0.63 | 0.38 |
| Composition 3-187 | F23 | -1 | -4.84 | E7 | -1.63 | K21 | -5.31 | 0.63 | 0.47 |
| Composition 3-188 | F23 | -1 | -4.84 | E7 | -1.63 | K24 | -5.38 | 0.63 | 0.54 |
| Composition 3-189 | F23 | -1 | -4.84 | E7 | -1.63 | K25 | -5.16 | 0.63 | 0.32 |
| Composition 3-190 | F23 | -1 | -4.84 | E7 | -1.63 | K26 | -5.22 | 0.63 | 0.38 |
| Composition 3-191 | F23 | -1 | -4.84 | E7 | -1.63 | K21 | -5.07 | 0.63 | 0.23 |
| Composition 3-192 | F23 | -1 | -4.84 | E7 | -1.63 | K22 | -5.14 | 0.63 | 0.3 |
| Composition 3-193 | F23 | -1 | -4.84 | E8 | -1.78 | K1 | -5.19 | 0.78 | 0.35 |
| Composition 3-194 | F23 | -1 | -4.84 | E8 | -1.78 | K2 | -5.44 | 0.78 | 0.6 |
| Composition 3-195 | F23 | -1 | -4.84 | E8 | -1.78 | K4 | -5 | 0.78 | 0.16 |
| Composition 3-196 | F23 | -1 | -4.84 | E8 | -1.78 | K5 | -5.22 | 0.78 | 0.38 |
| Composition 3-197 | F23 | -1 | -4.84 | E8 | -1.78 | K8 | -5.1 | 0.78 | 0.26 |
| Composition 3-198 | F23 | -1 | -4.84 | E8 | -1.78 | K6 | -5.07 | 0.78 | 0.23 |
| Composition 3-199 | F23 | -1 | -4.84 | E8 | -1.78 | K7 | -5.21 | 0.78 | 0.37 |
| Composition 3-200 | F23 | -1 | -4.84 | E8 | -1.78 | K10 | -5.31 | 0.78 | 0.47 |
| Composition 3-201 | F23 | -1 | -4.84 | E8 | -1.78 | K11 | -5.24 | 0.78 | 0.4 |
| Composition 3-202 | F23 | -1 | -4.84 | E8 | -1.78 | K12 | -5.2 | 0.78 | 0.36 |
| Composition 3-203 | F23 | -1 | -4.84 | E8 | -1.78 | K13 | -5.25 | 0.78 | 0.41 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 3-204 | F23 | -1 | -4.84 | E8 | -1.78 | K14 | -5.28 | 0.78 | 0.44 |
| Composition 3-205 | F23 | -1 | -4.84 | E8 | -1.78 | K15 | -5.32 | 0.78 | 0.48 |
| Composition 3-206 | F23 | -1 | -4.84 | E8 | -1.78 | K16 | -5.35 | 0.78 | 0.51 |
| Composition 3-207 | F23 | -1 | -4.84 | E8 | -1.78 | K17 | -4.99 | 0.78 | 0.15 |
| Composition 3-208 | F23 | -1 | -4.84 | E8 | -1.78 | K18 | -5.07 | 0.78 | 0.23 |
| Composition 3-209 | F23 | -1 | -4.84 | E8 | -1.78 | K19 | -5.15 | 0.78 | 0.31 |
| Composition 3-210 | F23 | -1 | -4.84 | E8 | -1.78 | K20 | -5.22 | 0.78 | 0.38 |
| Composition 3-211 | F23 | -1 | -4.84 | E8 | -1.78 | K21 | -5.31 | 0.78 | 0.47 |
| Composition 3-212 | F23 | -1 | -4.84 | E8 | -1.78 | K24 | -5.38 | 0.78 | 0.54 |
| Composition 3-213 | F23 | -1 | -4.84 | E8 | -1.78 | K25 | -5.16 | 0.78 | 0.32 |
| Composition 3-214 | F23 | -1 | -4.84 | E8 | -1.78 | K26 | -5.22 | 0.78 | 0.38 |
| Composition 3-215 | F23 | -1 | -4.84 | E8 | -1.78 | K21 | -5.07 | 0.78 | 0.23 |
| Composition 3-216 | F23 | -1 | -4.84 | E8 | -1.78 | K22 | -5.14 | 0.78 | 0.3 |
| Composition 3-217 | F23 | -1 | -4.84 | E9 | -1.75 | K1 | -5.19 | 0.75 | 0.35 |
| Composition 3-218 | F23 | -1 | -4.84 | E9 | -1.75 | K2 | -5.44 | 0.75 | 0.6 |
| Composition 3-219 | F23 | -1 | -4.84 | E9 | -1.75 | K4 | -5 | 0.75 | 0.16 |
| Composition 3-220 | F23 | -1 | -4.84 | E9 | -1.75 | K5 | -5.22 | 0.75 | 0.38 |
| Composition 3-221 | F23 | -1 | -4.84 | E9 | -1.75 | K8 | -5.1 | 0.75 | 0.26 |
| Composition 3-222 | F23 | -1 | -4.84 | E9 | -1.75 | K6 | -5.07 | 0.75 | 0.23 |
| Composition 3-223 | F23 | -1 | -4.84 | E9 | -1.75 | K7 | -5.21 | 0.75 | 0.37 |
| Composition 3-224 | F23 | -1 | -4.84 | E9 | -1.75 | K10 | -5.31 | 0.75 | 0.47 |
| Composition 3-225 | F23 | -1 | -4.84 | E9 | -1.75 | K11 | -5.24 | 0.75 | 0.4 |
| Composition 3-226 | F23 | -1 | -4.84 | E9 | -1.75 | K12 | -5.2 | 0.75 | 0.36 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 3-227 | F23 | -1 | -4.84 | E9 | -1.75 | K13 | -5.25 | 0.75 | 0.41 |
| Composition 3-228 | F23 | -1 | -4.84 | E9 | -1.75 | K14 | -5.28 | 0.75 | 0.44 |
| Composition 3-229 | F23 | -1 | -4.84 | E9 | -1.75 | K15 | -5.32 | 0.75 | 0.48 |
| Composition 3-230 | F23 | -1 | -4.84 | E9 | -1.75 | K16 | -5.35 | 0.75 | 0.51 |
| Composition 3-231 | F23 | -1 | -4.84 | E9 | -1.75 | K17 | -4.99 | 0.75 | 0.15 |
| Composition 3-232 | F23 | -1 | -4.84 | E9 | -1.75 | K18 | -5.07 | 0.75 | 0.23 |
| Composition 3-233 | F23 | -1 | -4.84 | E9 | -1.75 | K19 | -5.15 | 0.75 | 0.31 |
| Composition 3-234 | F23 | -1 | -4.84 | E9 | -1.75 | K20 | -5.22 | 0.75 | 0.38 |
| Composition 3-235 | F23 | -1 | -4.84 | E9 | -1.75 | K21 | -5.31 | 0.75 | 0.47 |
| Composition 3-236 | F23 | -1 | -4.84 | E9 | -1.75 | K24 | -5.38 | 0.75 | 0.54 |
| Composition 3-237 | F23 | -1 | -4.84 | E9 | -1.75 | K25 | -5.16 | 0.75 | 0.32 |
| Composition 3-238 | F23 | -1 | -4.84 | E9 | -1.75 | K26 | -5.22 | 0.75 | 0.38 |
| Composition 3-239 | F23 | -1 | -4.84 | E9 | -1.75 | K21 | -5.07 | 0.75 | 0.23 |
| Composition 3-240 | F23 | -1 | -4.84 | E9 | -1.75 | K22 | -5.14 | 0.75 | 0.3 |
| Composition 3-241 | F23 | -1 | -4.84 | E10 | -1.81 | K1 | -5.19 | 0.81 | 0.35 |
| Composition 3-242 | F23 | -1 | -4.84 | E10 | -1.81 | K2 | -5.44 | 0.81 | 0.6 |
| Composition 3-243 | F23 | -1 | -4.84 | E10 | -1.81 | K4 | -5 | 0.81 | 0.16 |
| Composition 3-244 | F23 | -1 | -4.84 | E10 | -1.81 | K5 | -5.22 | 0.81 | 0.38 |
| Composition 3-245 | F23 | -1 | -4.84 | E10 | -1.81 | K8 | -5.1 | 0.81 | 0.26 |
| Composition 3-246 | F23 | -1 | -4.84 | E10 | -1.81 | K6 | -5.07 | 0.81 | 0.23 |
| Composition 3-247 | F23 | -1 | -4.84 | E10 | -1.81 | K7 | -5.21 | 0.81 | 0.37 |
| Composition 3-248 | F23 | -1 | -4.84 | E10 | -1.81 | K10 | -5.31 | 0.81 | 0.47 |
| Composition 3-249 | F23 | -1 | -4.84 | E10 | -1.81 | K11 | -5.24 | 0.81 | 0.4 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 3-250 | F23 | -1 | -4.84 | E10 | -1.81 | K12 | -5.2 | 0.81 | 0.36 |
| Composition 3-251 | F23 | -1 | -4.84 | E10 | -1.81 | K13 | -5.25 | 0.81 | 0.41 |
| Composition 3-252 | F23 | -1 | -4.84 | E10 | -1.81 | K14 | -5.28 | 0.81 | 0.44 |
| Composition 3-253 | F23 | -1 | -4.84 | E10 | -1.81 | K15 | -5.32 | 0.81 | 0.48 |
| Composition 3-254 | F23 | -1 | -4.84 | E10 | -1.81 | K16 | -5.35 | 0.81 | 0.51 |
| Composition 3-255 | F23 | -1 | -4.84 | E10 | -1.81 | K17 | -4.99 | 0.81 | 0.15 |
| Composition 3-256 | F23 | -1 | -4.84 | E10 | -1.81 | K18 | -5.07 | 0.81 | 0.23 |
| Composition 3-257 | F23 | -1 | -4.84 | E10 | -1.81 | K19 | -5.15 | 0.81 | 0.31 |
| Composition 3-258 | F23 | -1 | -4.84 | E10 | -1.81 | K20 | -5.22 | 0.81 | 0.38 |
| Composition 3-259 | F23 | -1 | -4.84 | E10 | -1.81 | K21 | -5.31 | 0.81 | 0.47 |
| Composition 3-260 | F23 | -1 | -4.84 | E10 | -1.81 | K24 | -5.38 | 0.81 | 0.54 |
| Composition 3-261 | F23 | -1 | -4.84 | E10 | -1.81 | K25 | -5.16 | 0.81 | 0.32 |
| Composition 3-262 | F23 | -1 | -4.84 | E10 | -1.81 | K26 | -5.22 | 0.81 | 0.38 |
| Composition 3-263 | F23 | -1 | -4.84 | E10 | -1.81 | K21 | -5.07 | 0.81 | 0.23 |
| Composition 3-264 | F23 | -1 | -4.84 | E10 | -1.81 | K22 | -5.14 | 0.81 | 0.3 |
| Composition 3-265 | F23 | -1 | -4.84 | E11 | -1.87 | K1 | -5.19 | 0.87 | 0.35 |
| Composition 3-266 | F23 | -1 | -4.84 | E11 | -1.87 | K2 | -5.44 | 0.87 | 0.6 |
| Composition 3-267 | F23 | -1 | -4.84 | E11 | -1.87 | K4 | -5 | 0.87 | 0.16 |
| Composition 3-268 | F23 | -1 | -4.84 | E11 | -1.87 | K5 | -5.22 | 0.87 | 0.38 |
| Composition 3-269 | F23 | -1 | -4.84 | E11 | -1.87 | K8 | -5.1 | 0.87 | 0.26 |
| Composition 3-270 | F23 | -1 | -4.84 | E11 | -1.87 | K6 | -5.07 | 0.87 | 0.23 |
| Composition 3-271 | F23 | -1 | -4.84 | E11 | -1.87 | K7 | -5.21 | 0.87 | 0.37 |
| Composition 3-272 | F23 | -1 | -4.84 | E11 | -1.87 | K10 | -5.31 | 0.87 | 0.47 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 3-273 | F23 | -1 | -4.84 | E11 | -1.87 | K11 | -5.24 | 0.87 | 0.4 |
| Composition 3-274 | F23 | -1 | -4.84 | E11 | -1.87 | K12 | -5.2 | 0.87 | 0.36 |
| Composition 3-275 | F23 | -1 | -4.84 | E11 | -1.87 | K13 | -5.25 | 0.87 | 0.41 |
| Composition 3-276 | F23 | -1 | -4.84 | E11 | -1.87 | K14 | -5.28 | 0.87 | 0.44 |
| Composition 3-277 | F23 | -1 | -4.84 | E11 | -1.87 | K15 | -5.32 | 0.87 | 0.48 |
| Composition 3-278 | F23 | -1 | -4.84 | E11 | -1.87 | K16 | -5.35 | 0.87 | 0.51 |
| Composition 3-279 | F23 | -1 | -4.84 | E11 | -1.87 | K17 | -4.99 | 0.87 | 0.15 |
| Composition 3-280 | F23 | -1 | -4.84 | E11 | -1.87 | K18 | -5.07 | 0.87 | 0.23 |
| Composition 3-281 | F23 | -1 | -4.84 | E11 | -1.87 | K19 | -5.15 | 0.87 | 0.31 |
| Composition 3-282 | F23 | -1 | -4.84 | E11 | -1.87 | K20 | -5.22 | 0.87 | 0.38 |
| Composition 3-283 | F23 | -1 | -4.84 | E11 | -1.87 | K21 | -5.31 | 0.87 | 0.47 |
| Composition 3-284 | F23 | -1 | -4.84 | E11 | -1.87 | K24 | -5.38 | 0.87 | 0.54 |
| Composition 3-285 | F23 | -1 | -4.84 | E11 | -1.87 | K25 | -5.16 | 0.87 | 0.32 |
| Composition 3-286 | F23 | -1 | -4.84 | E11 | -1.87 | K26 | -5.22 | 0.87 | 0.38 |
| Composition 3-287 | F23 | -1 | -4.84 | E11 | -1.87 | K21 | -5.07 | 0.87 | 0.23 |
| Composition 3-288 | F23 | -1 | -4.84 | E11 | -1.87 | K22 | -5.14 | 0.87 | 0.3 |
| Composition 4-1 | F4 | -1.09 | -4.85 | E1 | -1.86 | K1 | -5.19 | 0.77 | 0.34 |
| Composition 4-2 | F4 | -1.09 | -4.85 | E1 | -1.86 | K2 | -5.44 | 0.77 | 0.59 |
| Composition 4-3 | F4 | -1.09 | -4.85 | E1 | -1.86 | K4 | -5 | 0.77 | 0.15 |
| Composition 4-4 | F4 | -1.09 | -4.85 | E1 | -1.86 | K5 | -5.22 | 0.77 | 0.37 |
| Composition 4-5 | F4 | -1.09 | -4.85 | E1 | -1.86 | K8 | -5.1 | 0.77 | 0.25 |
| Composition 4-6 | F4 | -1.09 | -4.85 | E1 | -1.86 | K6 | -5.07 | 0.77 | 0.22 |
| Composition 4-7 | F4 | -1.09 | -4.85 | E1 | -1.86 | K7 | -5.21 | 0.77 | 0.36 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 4-8 | F4 | -1.09 | -4.85 | E1 | -1.86 | K10 | -5.31 | 0.77 | 0.46 |
| Composition 4-9 | F4 | -1.09 | -4.85 | E1 | -1.86 | K11 | -5.24 | 0.77 | 0.39 |
| Composition 4-10 | F4 | -1.09 | -4.85 | E1 | -1.86 | K12 | -5.2 | 0.77 | 0.35 |
| Composition 4-11 | F4 | -1.09 | -4.85 | E1 | -1.86 | K13 | -5.25 | 0.77 | 0.4 |
| Composition 4-12 | F4 | -1.09 | -4.85 | E1 | -1.86 | K14 | -5.28 | 0.77 | 0.43 |
| Composition 4-13 | F4 | -1.09 | -4.85 | E1 | -1.86 | K15 | -5.32 | 0.77 | 0.47 |
| Composition 4-14 | F4 | -1.09 | -4.85 | E1 | -1.86 | K16 | -5.35 | 0.77 | 0.5 |
| Composition 4-15 | F4 | -1.09 | -4.85 | E1 | -1.86 | K17 | -4.99 | 0.77 | 0.14 |
| Composition 4-16 | F4 | -1.09 | -4.85 | E1 | -1.86 | K18 | -5.07 | 0.77 | 0.22 |
| Composition 4-17 | F4 | -1.09 | -4.85 | E1 | -1.86 | K19 | -5.15 | 0.77 | 0.3 |
| Composition 4-18 | F4 | -1.09 | -4.85 | E1 | -1.86 | K20 | -5.22 | 0.77 | 0.37 |
| Composition 4-19 | F4 | -1.09 | -4.85 | E1 | -1.86 | K21 | -5.31 | 0.77 | 0.46 |
| Composition 4-20 | F4 | -1.09 | -4.85 | E1 | -1.86 | K24 | -5.38 | 0.77 | 0.53 |
| Composition 4-21 | F4 | -1.09 | -4.85 | E1 | -1.86 | K25 | -5.16 | 0.77 | 0.31 |
| Composition 4-22 | F4 | -1.09 | -4.85 | E1 | -1.86 | K26 | -5.22 | 0.77 | 0.37 |
| Composition 4-23 | F4 | -1.09 | -4.85 | E1 | -1.86 | K21 | -5.07 | 0.77 | 0.22 |
| Composition 4-24 | F4 | -1.09 | -4.85 | E1 | -1.86 | K22 | -5.14 | 0.77 | 0.29 |
| Composition 4-25 | F4 | -1.09 | -4.85 | E2 | -1.83 | K1 | -5.19 | 0.74 | 0.34 |
| Composition 4-26 | F4 | -1.09 | -4.85 | E2 | -1.83 | K2 | -5.44 | 0.74 | 0.59 |
| Composition 4-27 | F4 | -1.09 | -4.85 | E2 | -1.83 | K4 | -5 | 0.74 | 0.15 |
| Composition 4-28 | F4 | -1.09 | -4.85 | E2 | -1.83 | K5 | -5.22 | 0.74 | 0.37 |
| Composition 4-29 | F4 | -1.09 | -4.85 | E2 | -1.83 | K8 | -5.1 | 0.74 | 0.25 |
| Composition 4-30 | F4 | -1.09 | -4.85 | E2 | -1.83 | K6 | -5.07 | 0.74 | 0.22 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 4-31 | F4 | -1.09 | -4.85 | E2 | -1.83 | K7 | -5.21 | 0.74 | 0.36 |
| Composition 4-32 | F4 | -1.09 | -4.85 | E2 | -1.83 | K10 | -5.31 | 0.74 | 0.46 |
| Composition 4-33 | F4 | -1.09 | -4.85 | E2 | -1.83 | K11 | -5.24 | 0.74 | 0.39 |
| Composition 4-34 | F4 | -1.09 | -4.85 | E2 | -1.83 | K12 | -5.2 | 0.74 | 0.35 |
| Composition 4-35 | F4 | -1.09 | -4.85 | E2 | -1.83 | K13 | -5.25 | 0.74 | 0.4 |
| Composition 4-36 | F4 | -1.09 | -4.85 | E2 | -1.83 | K14 | -5.28 | 0.74 | 0.43 |
| Composition 4-37 | F4 | -1.09 | -4.85 | E2 | -1.83 | K15 | -5.32 | 0.74 | 0.47 |
| Composition 4-38 | F4 | -1.09 | -4.85 | E2 | -1.83 | K16 | -5.35 | 0.74 | 0.5 |
| Composition 4-39 | F4 | -1.09 | -4.85 | E2 | -1.83 | K17 | -4.99 | 0.74 | 0.14 |
| Composition 4-40 | F4 | -1.09 | -4.85 | E2 | -1.83 | K18 | -5.07 | 0.74 | 0.22 |
| Composition 4-41 | F4 | -1.09 | -4.85 | E2 | -1.83 | K19 | -5.15 | 0.74 | 0.3 |
| Composition 4-42 | F4 | -1.09 | -4.85 | E2 | -1.83 | K20 | -5.22 | 0.74 | 0.37 |
| Composition 4-43 | F4 | -1.09 | -4.85 | E2 | -1.83 | K21 | -5.31 | 0.74 | 0.46 |
| Composition 4-44 | F4 | -1.09 | -4.85 | E2 | -1.83 | K24 | -5.38 | 0.74 | 0.53 |
| Composition 4-45 | F4 | -1.09 | -4.85 | E2 | -1.83 | K25 | -5.16 | 0.74 | 0.31 |
| Composition 4-46 | F4 | -1.09 | -4.85 | E2 | -1.83 | K26 | -5.22 | 0.74 | 0.37 |
| Composition 4-47 | F4 | -1.09 | -4.85 | E2 | -1.83 | K21 | -5.07 | 0.74 | 0.22 |
| Composition 4-48 | F4 | -1.09 | -4.85 | E2 | -1.83 | K22 | -5.14 | 0.74 | 0.29 |
| Composition 4-49 | F4 | -1.09 | -4.85 | E12 | -1.86 | K1 | -5.19 | 0.77 | 0.34 |
| Composition 4-50 | F4 | -1.09 | -4.85 | E12 | -1.86 | K2 | -5.44 | 0.77 | 0.59 |
| Composition 4-51 | F4 | -1.09 | -4.85 | E12 | -1.86 | K4 | -5 | 0.77 | 0.15 |
| Composition 4-52 | F4 | -1.09 | -4.85 | E12 | -1.86 | K5 | -5.22 | 0.77 | 0.37 |
| Composition 4-53 | F4 | -1.09 | -4.85 | E12 | -1.86 | K8 | -5.1 | 0.77 | 0.25 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 4-54 | F4 | -1.09 | -4.85 | E12 | -1.86 | K6 | -5.07 | 0.77 | 0.22 |
| Composition 4-55 | F4 | -1.09 | -4.85 | E12 | -1.86 | K7 | -5.21 | 0.77 | 0.36 |
| Composition 4-56 | F4 | -1.09 | -4.85 | E12 | -1.86 | K10 | -5.31 | 0.77 | 0.46 |
| Composition 4-57 | F4 | -1.09 | -4.85 | E12 | -1.86 | K11 | -5.24 | 0.77 | 0.39 |
| Composition 4-58 | F4 | -1.09 | -4.85 | E12 | -1.86 | K12 | -5.2 | 0.77 | 0.35 |
| Composition 4-59 | F4 | -1.09 | -4.85 | E12 | -1.86 | K13 | -5.25 | 0.77 | 0.4 |
| Composition 4-60 | F4 | -1.09 | -4.85 | E12 | -1.86 | K14 | -5.28 | 0.77 | 0.43 |
| Composition 4-61 | F4 | -1.09 | -4.85 | E12 | -1.86 | K15 | -5.32 | 0.77 | 0.47 |
| Composition 4-62 | F4 | -1.09 | -4.85 | E12 | -1.86 | K16 | -5.35 | 0.77 | 0.5 |
| Composition 4-63 | F4 | -1.09 | -4.85 | E12 | -1.86 | K17 | -4.99 | 0.77 | 0.14 |
| Composition 4-64 | F4 | -1.09 | -4.85 | E12 | -1.86 | K18 | -5.07 | 0.77 | 0.22 |
| Composition 4-65 | F4 | -1.09 | -4.85 | E12 | -1.86 | K19 | -5.15 | 0.77 | 0.3 |
| Composition 4-66 | F4 | -1.09 | -4.85 | E12 | -1.86 | K20 | -5.22 | 0.77 | 0.37 |
| Composition 4-67 | F4 | -1.09 | -4.85 | E12 | -1.86 | K21 | -5.31 | 0.77 | 0.46 |
| Composition 4-68 | F4 | -1.09 | -4.85 | E12 | -1.86 | K24 | -5.38 | 0.77 | 0.53 |
| Composition 4-69 | F4 | -1.09 | -4.85 | E12 | -1.86 | K25 | -5.16 | 0.77 | 0.31 |
| Composition 4-70 | F4 | -1.09 | -4.85 | E12 | -1.86 | K26 | -5.22 | 0.77 | 0.37 |
| Composition 4-71 | F4 | -1.09 | -4.85 | E12 | -1.86 | K21 | -5.07 | 0.77 | 0.22 |
| Composition 4-72 | F4 | -1.09 | -4.85 | E12 | -1.86 | K22 | -5.14 | 0.77 | 0.29 |
| Composition 4-73 | F4 | -1.09 | -4.85 | E3 | -1.81 | K1 | -5.19 | 0.72 | 0.34 |
| Composition 4-74 | F4 | -1.09 | -4.85 | E3 | -1.81 | K2 | -5.44 | 0.72 | 0.59 |
| Composition 4-75 | F4 | -1.09 | -4.85 | E3 | -1.81 | K4 | -5 | 0.72 | 0.15 |
| Composition 4-76 | F4 | -1.09 | -4.85 | E3 | -1.81 | K5 | -5.22 | 0.72 | 0.37 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 4-77 | F4 | -1.09 | -4.85 | E3 | -1.81 | K8 | -5.1 | 0.72 | 0.25 |
| Composition 4-78 | F4 | -1.09 | -4.85 | E3 | -1.81 | K6 | -5.07 | 0.72 | 0.22 |
| Composition 4-79 | F4 | -1.09 | -4.85 | E3 | -1.81 | K7 | -5.21 | 0.72 | 0.36 |
| Composition 4-80 | F4 | -1.09 | -4.85 | E3 | -1.81 | K10 | -5.31 | 0.72 | 0.46 |
| Composition 4-81 | F4 | -1.09 | -4.85 | E3 | -1.81 | K11 | -5.24 | 0.72 | 0.39 |
| Composition 4-82 | F4 | -1.09 | -4.85 | E3 | -1.81 | K12 | -5.2 | 0.72 | 0.35 |
| Composition 4-83 | F4 | -1.09 | -4.85 | E3 | -1.81 | K13 | -5.25 | 0.72 | 0.4 |
| Composition 4-84 | F4 | -1.09 | -4.85 | E3 | -1.81 | K14 | -5.28 | 0.72 | 0.43 |
| Composition 4-85 | F4 | -1.09 | -4.85 | E3 | -1.81 | K15 | -5.32 | 0.72 | 0.47 |
| Composition 4-86 | F4 | -1.09 | -4.85 | E3 | -1.81 | K16 | -5.35 | 0.72 | 0.5 |
| Composition 4-87 | F4 | -1.09 | -4.85 | E3 | -1.81 | K17 | -4.99 | 0.72 | 0.14 |
| Composition 4-88 | F4 | -1.09 | -4.85 | E3 | -1.81 | K18 | -5.07 | 0.72 | 0.22 |
| Composition 4-89 | F4 | -1.09 | -4.85 | E3 | -1.81 | K19 | -5.15 | 0.72 | 0.3 |
| Composition 4-90 | F4 | -1.09 | -4.85 | E3 | -1.81 | K20 | -5.22 | 0.72 | 0.37 |
| Composition 4-91 | F4 | -1.09 | -4.85 | E3 | -1.81 | K21 | -5.31 | 0.72 | 0.46 |
| Composition 4-92 | F4 | -1.09 | -4.85 | E3 | -1.81 | K24 | -5.38 | 0.72 | 0.53 |
| Composition 4-93 | F4 | -1.09 | -4.85 | E3 | -1.81 | K25 | -5.16 | 0.72 | 0.31 |
| Composition 4-94 | F4 | -1.09 | -4.85 | E3 | -1.81 | K26 | -5.22 | 0.72 | 0.37 |
| Composition 4-95 | F4 | -1.09 | -4.85 | E3 | -1.81 | K21 | -5.07 | 0.72 | 0.22 |
| Composition 4-96 | F4 | -1.09 | -4.85 | E3 | -1.81 | K22 | -5.14 | 0.72 | 0.29 |
| Composition 4-97 | F4 | -1.09 | -4.85 | E4 | -1.74 | K1 | -5.19 | 0.65 | 0.34 |
| Composition 4-98 | F4 | -1.09 | -4.85 | E4 | -1.74 | K2 | -5.44 | 0.65 | 0.59 |
| Composition 4-99 | F4 | -1.09 | -4.85 | E4 | -1.74 | K4 | -5 | 0.65 | 0.15 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 4-100 | F4 | -1.09 | -4.85 | E4 | -1.74 | K5 | -5.22 | 0.65 | 0.37 |
| Composition 4-101 | F4 | -1.09 | -4.85 | E4 | -1.74 | K8 | -5.1 | 0.65 | 0.25 |
| Composition 4-102 | F4 | -1.09 | -4.85 | E4 | -1.74 | K6 | -5.07 | 0.65 | 0.22 |
| Composition 4-103 | F4 | -1.09 | -4.85 | E4 | -1.74 | K7 | -5.21 | 0.65 | 0.36 |
| Composition 4-104 | F4 | -1.09 | -4.85 | E4 | -1.74 | K10 | -5.31 | 0.65 | 0.46 |
| Composition 4-105 | F4 | -1.09 | -4.85 | E4 | -1.74 | K11 | -5.24 | 0.65 | 0.39 |
| Composition 4-106 | F4 | -1.09 | -4.85 | E4 | -1.74 | K12 | -5.2 | 0.65 | 0.35 |
| Composition 4-107 | F4 | -1.09 | -4.85 | E4 | -1.74 | K13 | -5.25 | 0.65 | 0.4 |
| Composition 4-108 | F4 | -1.09 | -4.85 | E4 | -1.74 | K14 | -5.28 | 0.65 | 0.43 |
| Composition 4-109 | F4 | -1.09 | -4.85 | E4 | -1.74 | K15 | -5.32 | 0.65 | 0.47 |
| Composition 4-110 | F4 | -1.09 | -4.85 | E4 | -1.74 | K16 | -5.35 | 0.65 | 0.5 |
| Composition 4-111 | F4 | -1.09 | -4.85 | E4 | -1.74 | K17 | -4.99 | 0.65 | 0.14 |
| Composition 4-112 | F4 | -1.09 | -4.85 | E4 | -1.74 | K18 | -5.07 | 0.65 | 0.22 |
| Composition 4-113 | F4 | -1.09 | -4.85 | E4 | -1.74 | K19 | -5.15 | 0.65 | 0.3 |
| Composition 4-114 | F4 | -1.09 | -4.85 | E4 | -1.74 | K20 | -5.22 | 0.65 | 0.37 |
| Composition 4-115 | F4 | -1.09 | -4.85 | E4 | -1.74 | K21 | -5.31 | 0.65 | 0.46 |
| Composition 4-116 | F4 | -1.09 | -4.85 | E4 | -1.74 | K24 | -5.38 | 0.65 | 0.53 |
| Composition 4-117 | F4 | -1.09 | -4.85 | E4 | -1.74 | K25 | -5.16 | 0.65 | 0.31 |
| Composition 4-118 | F4 | -1.09 | -4.85 | E4 | -1.74 | K26 | -5.22 | 0.65 | 0.37 |
| Composition 4-119 | F4 | -1.09 | -4.85 | E4 | -1.74 | K21 | -5.07 | 0.65 | 0.22 |
| Composition 4-120 | F4 | -1.09 | -4.85 | E4 | -1.74 | K22 | -5.14 | 0.65 | 0.29 |
| Composition 4-121 | F4 | -1.09 | -4.85 | E5 | -1.73 | K1 | -5.19 | 0.64 | 0.34 |
| Composition 4-122 | F4 | -1.09 | -4.85 | E5 | -1.73 | K2 | -5.44 | 0.64 | 0.59 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 4-123 | F4 | -1.09 | -4.85 | E5 | -1.73 | K4 | -5 | 0.64 | 0.15 |
| Composition 4-124 | F4 | -1.09 | -4.85 | E5 | -1.73 | K5 | -5.22 | 0.64 | 0.37 |
| Composition 4-125 | F4 | -1.09 | -4.85 | E5 | -1.73 | K8 | -5.1 | 0.64 | 0.25 |
| Composition 4-126 | F4 | -1.09 | -4.85 | E5 | -1.73 | K6 | -5.07 | 0.64 | 0.22 |
| Composition 4-127 | F4 | -1.09 | -4.85 | E5 | -1.73 | K7 | -5.21 | 0.64 | 0.36 |
| Composition 4-128 | F4 | -1.09 | -4.85 | E5 | -1.73 | K10 | -5.31 | 0.64 | 0.46 |
| Composition 4-129 | F4 | -1.09 | -4.85 | E5 | -1.73 | K11 | -5.24 | 0.64 | 0.39 |
| Composition 4-130 | F4 | -1.09 | -4.85 | E5 | -1.73 | K12 | -5.2 | 0.64 | 0.35 |
| Composition 4-131 | F4 | -1.09 | -4.85 | E5 | -1.73 | K13 | -5.25 | 0.64 | 0.4 |
| Composition 4-132 | F4 | -1.09 | -4.85 | E5 | -1.73 | K14 | -5.28 | 0.64 | 0.43 |
| Composition 4-133 | F4 | -1.09 | -4.85 | E5 | -1.73 | K15 | -5.32 | 0.64 | 0.47 |
| Composition 4-134 | F4 | -1.09 | -4.85 | E5 | -1.73 | K16 | -5.35 | 0.64 | 0.5 |
| Composition 4-135 | F4 | -1.09 | -4.85 | E5 | -1.73 | K17 | -4.99 | 0.64 | 0.14 |
| Composition 4-136 | F4 | -1.09 | -4.85 | E5 | -1.73 | K18 | -5.07 | 0.64 | 0.22 |
| Composition 4-137 | F4 | -1.09 | -4.85 | E5 | -1.73 | K19 | -5.15 | 0.64 | 0.3 |
| Composition 4-138 | F4 | -1.09 | -4.85 | E5 | -1.73 | K20 | -5.22 | 0.64 | 0.37 |
| Composition 4-139 | F4 | -1.09 | -4.85 | E5 | -1.73 | K21 | -5.31 | 0.64 | 0.46 |
| Composition 4-140 | F4 | -1.09 | -4.85 | E5 | -1.73 | K24 | -5.38 | 0.64 | 0.53 |
| Composition 4-141 | F4 | -1.09 | -4.85 | E5 | -1.73 | K25 | -5.16 | 0.64 | 0.31 |
| Composition 4-142 | F4 | -1.09 | -4.85 | E5 | -1.73 | K26 | -5.22 | 0.64 | 0.37 |
| Composition 4-143 | F4 | -1.09 | -4.85 | E5 | -1.73 | K21 | -5.07 | 0.64 | 0.22 |
| Composition 4-144 | F4 | -1.09 | -4.85 | E5 | -1.73 | K22 | -5.14 | 0.64 | 0.29 |
| Composition 4-145 | F4 | -1.09 | -4.85 | E6 | -1.68 | K1 | -5.19 | 0.59 | 0.34 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 4-146 | F4 | -1.09 | -4.85 | E6 | -1.68 | K2 | -5.44 | 0.59 | 0.59 |
| Composition 4-147 | F4 | -1.09 | -4.85 | E6 | -1.68 | K4 | -5 | 0.59 | 0.15 |
| Composition 4-148 | F4 | -1.09 | -4.85 | E6 | -1.68 | K5 | -5.22 | 0.59 | 0.37 |
| Composition 4-149 | F4 | -1.09 | -4.85 | E6 | -1.68 | K8 | -5.1 | 0.59 | 0.25 |
| Composition 4-150 | F4 | -1.09 | -4.85 | E6 | -1.68 | K6 | -5.07 | 0.59 | 0.22 |
| Composition 4-151 | F4 | -1.09 | -4.85 | E6 | -1.68 | K7 | -5.21 | 0.59 | 0.36 |
| Composition 4-152 | F4 | -1.09 | -4.85 | E6 | -1.68 | K10 | -5.31 | 0.59 | 0.46 |
| Composition 4-153 | F4 | -1.09 | -4.85 | E6 | -1.68 | K11 | -5.24 | 0.59 | 0.39 |
| Composition 4-154 | F4 | -1.09 | -4.85 | E6 | -1.68 | K12 | -5.2 | 0.59 | 0.35 |
| Composition 4-155 | F4 | -1.09 | -4.85 | E6 | -1.68 | K13 | -5.25 | 0.59 | 0.4 |
| Composition 4-156 | F4 | -1.09 | -4.85 | E6 | -1.68 | K14 | -5.28 | 0.59 | 0.43 |
| Composition 4-157 | F4 | -1.09 | -4.85 | E6 | -1.68 | K15 | -5.32 | 0.59 | 0.47 |
| Composition 4-158 | F4 | -1.09 | -4.85 | E6 | -1.68 | K16 | -5.35 | 0.59 | 0.5 |
| Composition 4-159 | F4 | -1.09 | -4.85 | E6 | -1.68 | K17 | -4.99 | 0.59 | 0.14 |
| Composition 4-160 | F4 | -1.09 | -4.85 | E6 | -1.68 | K18 | -5.07 | 0.59 | 0.22 |
| Composition 4-161 | F4 | -1.09 | -4.85 | E6 | -1.68 | K19 | -5.15 | 0.59 | 0.3 |
| Composition 4-162 | F4 | -1.09 | -4.85 | E6 | -1.68 | K20 | -5.22 | 0.59 | 0.37 |
| Composition 4-163 | F4 | -1.09 | -4.85 | E6 | -1.68 | K21 | -5.31 | 0.59 | 0.46 |
| Composition 4-164 | F4 | -1.09 | -4.85 | E6 | -1.68 | K24 | -5.38 | 0.59 | 0.53 |
| Composition 4-165 | F4 | -1.09 | -4.85 | E6 | -1.68 | K25 | -5.16 | 0.59 | 0.31 |
| Composition 4-166 | F4 | -1.09 | -4.85 | E6 | -1.68 | K26 | -5.22 | 0.59 | 0.37 |
| Composition 4-167 | F4 | -1.09 | -4.85 | E6 | -1.68 | K21 | -5.07 | 0.59 | 0.22 |
| Composition 4-168 | F4 | -1.09 | -4.85 | E6 | -1.68 | K22 | -5.14 | 0.59 | 0.29 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 4-169 | F4 | -1.09 | -4.85 | E7 | -1.63 | K1 | -5.19 | 0.54 | 0.34 |
| Composition 4-170 | F4 | -1.09 | -4.85 | E7 | -1.63 | K2 | -5.44 | 0.54 | 0.59 |
| Composition 4-171 | F4 | -1.09 | -4.85 | E7 | -1.63 | K4 | -5 | 0.54 | 0.15 |
| Composition 4-172 | F4 | -1.09 | -4.85 | E7 | -1.63 | K5 | -5.22 | 0.54 | 0.37 |
| Composition 4-173 | F4 | -1.09 | -4.85 | E7 | -1.63 | K8 | -5.1 | 0.54 | 0.25 |
| Composition 4-174 | F4 | -1.09 | -4.85 | E7 | -1.63 | K6 | -5.07 | 0.54 | 0.22 |
| Composition 4-175 | F4 | -1.09 | -4.85 | E7 | -1.63 | K7 | -5.21 | 0.54 | 0.36 |
| Composition 4-176 | F4 | -1.09 | -4.85 | E7 | -1.63 | K10 | -5.31 | 0.54 | 0.46 |
| Composition 4-177 | F4 | -1.09 | -4.85 | E7 | -1.63 | K11 | -5.24 | 0.54 | 0.39 |
| Composition 4-178 | F4 | -1.09 | -4.85 | E7 | -1.63 | K12 | -5.2 | 0.54 | 0.35 |
| Composition 4-179 | F4 | -1.09 | -4.85 | E7 | -1.63 | K13 | -5.25 | 0.54 | 0.4 |
| Composition 4-180 | F4 | -1.09 | -4.85 | E7 | -1.63 | K14 | -5.28 | 0.54 | 0.43 |
| Composition 4-181 | F4 | -1.09 | -4.85 | E7 | -1.63 | K15 | -5.32 | 0.54 | 0.47 |
| Composition 4-182 | F4 | -1.09 | -4.85 | E7 | -1.63 | K16 | -5.35 | 0.54 | 0.5 |
| Composition 4-183 | F4 | -1.09 | -4.85 | E7 | -1.63 | K17 | -4.99 | 0.54 | 0.14 |
| Composition 4-184 | F4 | -1.09 | -4.85 | E7 | -1.63 | K18 | -5.07 | 0.54 | 0.22 |
| Composition 4-185 | F4 | -1.09 | -4.85 | E7 | -1.63 | K19 | -5.15 | 0.54 | 0.3 |
| Composition 4-186 | F4 | -1.09 | -4.85 | E7 | -1.63 | K20 | -5.22 | 0.54 | 0.37 |
| Composition 4-187 | F4 | -1.09 | -4.85 | E7 | -1.63 | K21 | -5.31 | 0.54 | 0.46 |
| Composition 4-188 | F4 | -1.09 | -4.85 | E7 | -1.63 | K24 | -5.38 | 0.54 | 0.53 |
| Composition 4-189 | F4 | -1.09 | -4.85 | E7 | -1.63 | K25 | -5.16 | 0.54 | 0.31 |
| Composition 4-190 | F4 | -1.09 | -4.85 | E7 | -1.63 | K26 | -5.22 | 0.54 | 0.37 |
| Composition 4-191 | F4 | -1.09 | -4.85 | E7 | -1.63 | K21 | -5.07 | 0.54 | 0.22 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 4-192 | F4 | -1.09 | -4.85 | E7 | -1.63 | K22 | -5.14 | 0.54 | 0.29 |
| Composition 4-193 | F4 | -1.09 | -4.85 | E8 | -1.78 | K1 | -5.19 | 0.69 | 0.34 |
| Composition 4-194 | F4 | -1.09 | -4.85 | E8 | -1.78 | K2 | -5.44 | 0.69 | 0.59 |
| Composition 4-195 | F4 | -1.09 | -4.85 | E8 | -1.78 | K4 | -5 | 0.69 | 0.15 |
| Composition 4-196 | F4 | -1.09 | -4.85 | E8 | -1.78 | K5 | -5.22 | 0.69 | 0.37 |
| Composition 4-197 | F4 | -1.09 | -4.85 | E8 | -1.78 | K8 | -5.1 | 0.69 | 0.25 |
| Composition 4-198 | F4 | -1.09 | -4.85 | E8 | -1.78 | K6 | -5.07 | 0.69 | 0.22 |
| Composition 4-199 | F4 | -1.09 | -4.85 | E8 | -1.78 | K7 | -5.21 | 0.69 | 0.36 |
| Composition 4-200 | F4 | -1.09 | -4.85 | E8 | -1.78 | K10 | -5.31 | 0.69 | 0.46 |
| Composition 4-201 | F4 | -1.09 | -4.85 | E8 | -1.78 | K11 | -5.24 | 0.69 | 0.39 |
| Composition 4-202 | F4 | -1.09 | -4.85 | E8 | -1.78 | K12 | -5.2 | 0.69 | 0.35 |
| Composition 4-203 | F4 | -1.09 | -4.85 | E8 | -1.78 | K13 | -5.25 | 0.69 | 0.4 |
| Composition 4-204 | F4 | -1.09 | -4.85 | E8 | -1.78 | K14 | -5.28 | 0.69 | 0.43 |
| Composition 4-205 | F4 | -1.09 | -4.85 | E8 | -1.78 | K15 | -5.32 | 0.69 | 0.47 |
| Composition 4-206 | F4 | -1.09 | -4.85 | E8 | -1.78 | K16 | -5.35 | 0.69 | 0.5 |
| Composition 4-207 | F4 | -1.09 | -4.85 | E8 | -1.78 | K17 | -4.99 | 0.69 | 0.14 |
| Composition 4-208 | F4 | -1.09 | -4.85 | E8 | -1.78 | K18 | -5.07 | 0.69 | 0.22 |
| Composition 4-209 | F4 | -1.09 | -4.85 | E8 | -1.78 | K19 | -5.15 | 0.69 | 0.3 |
| Composition 4-210 | F4 | -1.09 | -4.85 | E8 | -1.78 | K20 | -5.22 | 0.69 | 0.37 |
| Composition 4-211 | F4 | -1.09 | -4.85 | E8 | -1.78 | K21 | -5.31 | 0.69 | 0.46 |
| Composition 4-212 | F4 | -1.09 | -4.85 | E8 | -1.78 | K24 | -5.38 | 0.69 | 0.53 |
| Composition 4-213 | F4 | -1.09 | -4.85 | E8 | -1.78 | K25 | -5.16 | 0.69 | 0.31 |
| Composition 4-214 | F4 | -1.09 | -4.85 | E8 | -1.78 | K26 | -5.22 | 0.69 | 0.37 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 4-215 | F4 | -1.09 | -4.85 | E8 | -1.78 | K21 | -5.07 | 0.69 | 0.22 |
| Composition 4-216 | F4 | -1.09 | -4.85 | E8 | -1.78 | K22 | -5.14 | 0.69 | 0.29 |
| Composition 4-217 | F4 | -1.09 | -4.85 | E9 | -1.75 | K1 | -5.19 | 0.66 | 0.34 |
| Composition 4-218 | F4 | -1.09 | -4.85 | E9 | -1.75 | K2 | -5.44 | 0.66 | 0.59 |
| Composition 4-219 | F4 | -1.09 | -4.85 | E9 | -1.75 | K4 | -5 | 0.66 | 0.15 |
| Composition 4-220 | F4 | -1.09 | -4.85 | E9 | -1.75 | K5 | -5.22 | 0.66 | 0.37 |
| Composition 4-221 | F4 | -1.09 | -4.85 | E9 | -1.75 | K8 | -5.1 | 0.66 | 0.25 |
| Composition 4-222 | F4 | -1.09 | -4.85 | E9 | -1.75 | K6 | -5.07 | 0.66 | 0.22 |
| Composition 4-223 | F4 | -1.09 | -4.85 | E9 | -1.75 | K7 | -5.21 | 0.66 | 0.36 |
| Composition 4-224 | F4 | -1.09 | -4.85 | E9 | -1.75 | K10 | -5.31 | 0.66 | 0.46 |
| Composition 4-225 | F4 | -1.09 | -4.85 | E9 | -1.75 | K11 | -5.24 | 0.66 | 0.39 |
| Composition 4-226 | F4 | -1.09 | -4.85 | E9 | -1.75 | K12 | -5.2 | 0.66 | 0.35 |
| Composition 4-227 | F4 | -1.09 | -4.85 | E9 | -1.75 | K13 | -5.25 | 0.66 | 0.4 |
| Composition 4-228 | F4 | -1.09 | -4.85 | E9 | -1.75 | K14 | -5.28 | 0.66 | 0.43 |
| Composition 4-229 | F4 | -1.09 | -4.85 | E9 | -1.75 | K15 | -5.32 | 0.66 | 0.47 |
| Composition 4-230 | F4 | -1.09 | -4.85 | E9 | -1.75 | K16 | -5.35 | 0.66 | 0.5 |
| Composition 4-231 | F4 | -1.09 | -4.85 | E9 | -1.75 | K17 | -4.99 | 0.66 | 0.14 |
| Composition 4-232 | F4 | -1.09 | -4.85 | E9 | -1.75 | K18 | -5.07 | 0.66 | 0.22 |
| Composition 4-233 | F4 | -1.09 | -4.85 | E9 | -1.75 | K19 | -5.15 | 0.66 | 0.3 |
| Composition 4-234 | F4 | -1.09 | -4.85 | E9 | -1.75 | K20 | -5.22 | 0.66 | 0.37 |
| Composition 4-235 | F4 | -1.09 | -4.85 | E9 | -1.75 | K21 | -5.31 | 0.66 | 0.46 |
| Composition 4-236 | F4 | -1.09 | -4.85 | E9 | -1.75 | K24 | -5.38 | 0.66 | 0.53 |
| Composition 4-237 | F4 | -1.09 | -4.85 | E9 | -1.75 | K25 | -5.16 | 0.66 | 0.31 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 4-238 | F4 | -1.09 | -4.85 | E9 | -1.75 | K26 | -5.22 | 0.66 | 0.37 |
| Composition 4-239 | F4 | -1.09 | -4.85 | E9 | -1.75 | K21 | -5.07 | 0.66 | 0.22 |
| Composition 4-240 | F4 | -1.09 | -4.85 | E9 | -1.75 | K22 | -5.14 | 0.66 | 0.29 |
| Composition 4-241 | F4 | -1.09 | -4.85 | E10 | -1.81 | K1 | -5.19 | 0.72 | 0.34 |
| Composition 4-242 | F4 | -1.09 | -4.85 | E10 | -1.81 | K2 | -5.44 | 0.72 | 0.59 |
| Composition 4-243 | F4 | -1.09 | -4.85 | E10 | -1.81 | K4 | -5 | 0.72 | 0.15 |
| Composition 4-244 | F4 | -1.09 | -4.85 | E10 | -1.81 | K5 | -5.22 | 0.72 | 0.37 |
| Composition 4-245 | F4 | -1.09 | -4.85 | E10 | -1.81 | K8 | -5.1 | 0.72 | 0.25 |
| Composition 4-246 | F4 | -1.09 | -4.85 | E10 | -1.81 | K6 | -5.07 | 0.72 | 0.22 |
| Composition 4-247 | F4 | -1.09 | -4.85 | E10 | -1.81 | K7 | -5.21 | 0.72 | 0.36 |
| Composition 4-248 | F4 | -1.09 | -4.85 | E10 | -1.81 | K10 | -5.31 | 0.72 | 0.46 |
| Composition 4-249 | F4 | -1.09 | -4.85 | E10 | -1.81 | K11 | -5.24 | 0.72 | 0.39 |
| Composition 4-250 | F4 | -1.09 | -4.85 | E10 | -1.81 | K12 | -5.2 | 0.72 | 0.35 |
| Composition 4-251 | F4 | -1.09 | -4.85 | E10 | -1.81 | K13 | -5.25 | 0.72 | 0.4 |
| Composition 4-252 | F4 | -1.09 | -4.85 | E10 | -1.81 | K14 | -5.28 | 0.72 | 0.43 |
| Composition 4-253 | F4 | -1.09 | -4.85 | E10 | -1.81 | K15 | -5.32 | 0.72 | 0.47 |
| Composition 4-254 | F4 | -1.09 | -4.85 | E10 | -1.81 | K16 | -5.35 | 0.72 | 0.5 |
| Composition 4-255 | F4 | -1.09 | -4.85 | E10 | -1.81 | K17 | -4.99 | 0.72 | 0.14 |
| Composition 4-256 | F4 | -1.09 | -4.85 | E10 | -1.81 | K18 | -5.07 | 0.72 | 0.22 |
| Composition 4-257 | F4 | -1.09 | -4.85 | E10 | -1.81 | K19 | -5.15 | 0.72 | 0.3 |
| Composition 4-258 | F4 | -1.09 | -4.85 | E10 | -1.81 | K20 | -5.22 | 0.72 | 0.37 |
| Composition 4-259 | F4 | -1.09 | -4.85 | E10 | -1.81 | K21 | -5.31 | 0.72 | 0.46 |
| Composition 4-260 | F4 | -1.09 | -4.85 | E10 | -1.81 | K24 | -5.38 | 0.72 | 0.53 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 4-261 | F4 | -1.09 | -4.85 | E10 | -1.81 | K25 | -5.16 | 0.72 | 0.31 |
| Composition 4-262 | F4 | -1.09 | -4.85 | E10 | -1.81 | K26 | -5.22 | 0.72 | 0.37 |
| Composition 4-263 | F4 | -1.09 | -4.85 | E10 | -1.81 | K21 | -5.07 | 0.72 | 0.22 |
| Composition 4-264 | F4 | -1.09 | -4.85 | E10 | -1.81 | K22 | -5.14 | 0.72 | 0.29 |
| Composition 4-265 | F4 | -1.09 | -4.85 | E11 | -1.87 | K1 | -5.19 | 0.78 | 0.34 |
| Composition 4-266 | F4 | -1.09 | -4.85 | E11 | -1.87 | K2 | -5.44 | 0.78 | 0.59 |
| Composition 4-267 | F4 | -1.09 | -4.85 | E11 | -1.87 | K4 | -5 | 0.78 | 0.15 |
| Composition 4-268 | F4 | -1.09 | -4.85 | E11 | -1.87 | K5 | -5.22 | 0.78 | 0.37 |
| Composition 4-269 | F4 | -1.09 | -4.85 | E11 | -1.87 | K8 | -5.1 | 0.78 | 0.25 |
| Composition 4-270 | F4 | -1.09 | -4.85 | E11 | -1.87 | K6 | -5.07 | 0.78 | 0.22 |
| Composition 4-271 | F4 | -1.09 | -4.85 | E11 | -1.87 | K7 | -5.21 | 0.78 | 0.36 |
| Composition 4-272 | F4 | -1.09 | -4.85 | E11 | -1.87 | K10 | -5.31 | 0.78 | 0.46 |
| Composition 4-273 | F4 | -1.09 | -4.85 | E11 | -1.87 | K11 | -5.24 | 0.78 | 0.39 |
| Composition 4-274 | F4 | -1.09 | -4.85 | E11 | -1.87 | K12 | -5.2 | 0.78 | 0.35 |
| Composition 4-275 | F4 | -1.09 | -4.85 | E11 | -1.87 | K13 | -5.25 | 0.78 | 0.4 |
| Composition 4-276 | F4 | -1.09 | -4.85 | E11 | -1.87 | K14 | -5.28 | 0.78 | 0.43 |
| Composition 4-277 | F4 | -1.09 | -4.85 | E11 | -1.87 | K15 | -5.32 | 0.78 | 0.47 |
| Composition 4-278 | F4 | -1.09 | -4.85 | E11 | -1.87 | K16 | -5.35 | 0.78 | 0.5 |
| Composition 4-279 | F4 | -1.09 | -4.85 | E11 | -1.87 | K17 | -4.99 | 0.78 | 0.14 |
| Composition 4-280 | F4 | -1.09 | -4.85 | E11 | -1.87 | K18 | -5.07 | 0.78 | 0.22 |
| Composition 4-281 | F4 | -1.09 | -4.85 | E11 | -1.87 | K19 | -5.15 | 0.78 | 0.3 |
| Composition 4-282 | F4 | -1.09 | -4.85 | E11 | -1.87 | K20 | -5.22 | 0.78 | 0.37 |
| Composition 4-283 | F4 | -1.09 | -4.85 | E11 | -1.87 | K21 | -5.31 | 0.78 | 0.46 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 4-284 | F4 | -1.09 | -4.85 | E11 | -1.87 | K24 | -5.38 | 0.78 | 0.53 |
| Composition 4-285 | F4 | -1.09 | -4.85 | E11 | -1.87 | K25 | -5.16 | 0.78 | 0.31 |
| Composition 4-286 | F4 | -1.09 | -4.85 | E11 | -1.87 | K26 | -5.22 | 0.78 | 0.37 |
| Composition 4-287 | F4 | -1.09 | -4.85 | E11 | -1.87 | K21 | -5.07 | 0.78 | 0.22 |
| Composition 4-288 | F4 | -1.09 | -4.85 | E11 | -1.87 | K22 | -5.14 | 0.78 | 0.29 |
| Composition 4-289 | F4 | -1.09 | -4.85 | E13 | -1.84 | K1 | -5.19 | 0.75 | 0.34 |
| Composition 4-290 | F4 | -1.09 | -4.85 | E13 | -1.84 | K2 | -5.44 | 0.75 | 0.59 |
| Composition 4-291 | F4 | -1.09 | -4.85 | E13 | -1.84 | K4 | -5 | 0.75 | 0.15 |
| Composition 4-292 | F4 | -1.09 | -4.85 | E13 | -1.84 | K5 | -5.22 | 0.75 | 0.37 |
| Composition 4-293 | F4 | -1.09 | -4.85 | E13 | -1.84 | K8 | -5.1 | 0.75 | 0.25 |
| Composition 4-294 | F4 | -1.09 | -4.85 | E13 | -1.84 | K6 | -5.07 | 0.75 | 0.22 |
| Composition 4-295 | F4 | -1.09 | -4.85 | E13 | -1.84 | K7 | -5.21 | 0.75 | 0.36 |
| Composition 4-296 | F4 | -1.09 | -4.85 | E13 | -1.84 | K10 | -5.31 | 0.75 | 0.46 |
| Composition 4-297 | F4 | -1.09 | -4.85 | E13 | -1.84 | K11 | -5.24 | 0.75 | 0.39 |
| Composition 4-298 | F4 | -1.09 | -4.85 | E13 | -1.84 | K12 | -5.2 | 0.75 | 0.35 |
| Composition 4-299 | F4 | -1.09 | -4.85 | E13 | -1.84 | K13 | -5.25 | 0.75 | 0.4 |
| Composition 4-300 | F4 | -1.09 | -4.85 | E13 | -1.84 | K14 | -5.28 | 0.75 | 0.43 |
| Composition 4-301 | F4 | -1.09 | -4.85 | E13 | -1.84 | K15 | -5.32 | 0.75 | 0.47 |
| Composition 4-302 | F4 | -1.09 | -4.85 | E13 | -1.84 | K16 | -5.35 | 0.75 | 0.5 |
| Composition 4-303 | F4 | -1.09 | -4.85 | E13 | -1.84 | K17 | -4.99 | 0.75 | 0.14 |
| Composition 4-304 | F4 | -1.09 | -4.85 | E13 | -1.84 | K18 | -5.07 | 0.75 | 0.22 |
| Composition 4-305 | F4 | -1.09 | -4.85 | E13 | -1.84 | K19 | -5.15 | 0.75 | 0.3 |
| Composition 4-306 | F4 | -1.09 | -4.85 | E13 | -1.84 | K20 | -5.22 | 0.75 | 0.37 |

(continued)

| Referred to as: | First organic compound | LUMO of first organic compound [eV] | HOMO of first organic compound [eV] | Second organic compound | LUMO of second organic compound [eV] | First organic p-dopant | LUMO of first organic p-dopant | Δ [LUMO (first organic compound) - LUMO (second organic compound)] [eV] | Δ [HOMO (first organic compound) - LUMO (first organic p-dopant)] [eV] |
|---|---|---|---|---|---|---|---|---|---|
| Composition 4-307 | F4 | -1.09 | -4.85 | E13 | -1.84 | K21 | -5.31 | 0.75 | 0.46 |
| Composition 4-308 | F4 | -1.09 | -4.85 | E13 | -1.84 | K24 | -5.38 | 0.75 | 0.53 |
| Composition 4-309 | F4 | -1.09 | -4.85 | E13 | -1.84 | K25 | -5.16 | 0.75 | 0.31 |
| Composition 4-310 | F4 | -1.09 | -4.85 | E13 | -1.84 | K26 | -5.22 | 0.75 | 0.37 |
| Composition 4-311 | F4 | -1.09 | -4.85 | E13 | -1.84 | K21 | -5.07 | 0.75 | 0.22 |
| Composition 4-312 | F4 | -1.09 | -4.85 | E13 | -1.84 | K22 | -5.14 | 0.75 | 0.29 |
| Comparative composition 1-1 | F18 | -0.92 | -4.73 | CC-1 | -1.67 | G1 | -5.19 | 0.75 | 0.46 |
| Comparative composition 1-2 | F18 | -0.92 | -4.73 | F3 | -0.89 | G1 | -5.19 | -0.03 | 0.46 |
| Comparative composition 1-3 | F18 | -0.92 | -4.73 | CC-2 | -0.75 | G1 | -5.19 | -0.17 | 0.46 |
| Comparative composition 1-4 | F18 | -0.92 | -4.73 | HAT-CN | -4.61 | G1 | -5.19 | 3.69 | 0.46 |

In compositions 1-1 to 1-325, 2-1 to 2-300, 3-1 to 3-288, 4-1 to 4-312,the following equations (a) and (b) are fulfilled:

(a) 0.2 eV < Δ [LUMO energy level of the first organic compound - LUMO energy level of the second organic compound] < 3.5 eV; and

(b) 0 eV < Δ [HOMO energy level of the first organic compound - LUMO energy level of the first organic p-dopant] < 1.5eV.

If the composition fulfils these criteria, particularly improved performance may be obtained of an organic electroluminescent device comprising the composition in the hole injection layer.

In comparative composition 1-1, the equations (a) and (b) are fulfilled. However, the spontaneous orientation polarization of comparative compound 1 (CC-1) is -47 mV/nm, see Table 2.

In comparative composition 1-2, the composition comprises two first organic compounds, namely formulae F18 and F3. The difference Δ [LUMO (first organic compound) - LUMO (second organic compound)] is -0.3 eV.

In comparative composition 1-3, the difference Δ [LUMO energy level of the first organic compound - LUMO energy level of the second organic compound] is -0.15 eV.

In comparative composition 1-4, the second organic compound is selected from HAT-CN (CAS Registry Number 105598-27-4). The LUMO of HAT-CN is -4.61 eV. The difference Δ [LUMO energy level of the first organic compound - LUMO energy level of the second organic compound] is 3.69 eV.

In Table 5 are shown the data for organic electroluminescent devices comprising a hole injection layer of the present invention and comparative examples, wherein the thickness of the hole injection layer is 10 nm.

Table 5: Organic electroluminescent device comprising a hole injection layer having a thickness of 10 nm

| Referred to as: | First organic compound in HIL | Wt.-% First organic compound in HIL | Second organic compound in HIL | Wt.-% second organic compound in HIL | First organic p-dopant in HIL | wt.-% first organic pdopant in HIL | Voltage rel. [%] at 15 mA/cm$^2$ | CEff/CIE-y rel. [%] at 15 mA/cm$^2$ | Rs rel. [%] |
|---|---|---|---|---|---|---|---|---|---|
| Comparative example 1-1 | F18 | 98 | -- | -- | G1 | 2 | 100 | 100 | 100 |
| Comparative example 1-2 | -- | -- | E1 | 98 | G1 | 2 | 202 | 84 | 19 |
| Example 1-1 | F18 | 88 | E1 | 10 | G1 | 2 | 99 | 100 | 147 |
| Example 1-2 | F18 | 78 | E1 | 20 | G1 | 2 | 99 | 99 | 184 |
| Example 1-3 | F18 | 68 | E1 | 30 | G1 | 2 | 98 | 101 | 115 |
| Example 1-4 | F18 | 68.5 | E1 | 30 | G1 | 1.5 | 98 | 99 | 132 |
| Example 1-5 | F18 | 69 | E1 | 30 | G1 | 1 | 99 | 99 | 179 |
| Example 1-6 | F18 | 78 | E9 | 20 | G1 | 2 | 99 | 100 | 133 |
| Example 1-7 | F18 | 78 | E13 | 20 | G1 | 2 | 100 | 100 | 237 |
| Comparative example 1-3 | F18 | 78 | CC-1 | 20 | G1 | 2 | 112 | 100 | 922 |
| Comparative example 1-4 | F18 | 78 | F3 | 20 | G1 | 2 | 100 | 98 | 75 |
| Comparative example 1-5 | F18 | 68 | F3 | 30 | G1 | 2 | 100 | 98 | 60 |
| Comparative example 1-6 | F18 | 68 | CC-2 | 30 | G1 | 2 | 99 | 101 | 44 |

In comparative example 1-1, the hole injection layer comprises 98 wt.-% first organic compound F18 and 2 wt.-% first organic p-dopant G1. The hole injection layer is free of second organic compound. The voltage, CEff/CIE-y and Rs are defined as 100%.
In comparative example 12, the hole injection layer comprises 98 wt.-% second organic compound and 2 wt.-% first organic p-dopant G1. The hole injection layer is free of first organic compound. The voltage is increased, the CEff/CIE-y is reduced and the sheet resistance Rs is reduced compared to comparative example 1-1. A low sheet resistance may result in high conductivity of the hole injection layer. Thereby, neighbouring pixels in a display devices may light up if a current is applied to one pixel. This may result in reduced image quality of the display device.

In Example 1-1, the hole injection layer comprises 88 wt.-% first organic compound F18, 10 wt.-% second organic compound E1 and 2 wt.-% first organic p-dopant G1. The voltage is slightly reduced to 99%, the CEff/CIE-y is unchanged and the sheet resistance Rs is increased. Thereby, in a display device a current can be applied to selected pixels without current flowing to neighbouring pixels. As a result, improved image quality may be obtained, in particular in a display device.

In Examples 1-2 to 1-5, the hole injection layer comprises a range of weight percentages of first organic compound, second organic compound and first organic p-dopant. As can be seen in Table 5, the voltage and CEff/CIE-y are unchanged or slightly improved relative to comparative example 1-1. However, the sheet resistance Rs is substantially increased relative to comparative example 1-1.

In Example 1-6, the hole injection layer comprises 78 wt.-% first organic compound F18, 20 wt.-% second organic compound E9 and 2 wt.-% first organic p-dopant G1. As can be seen in Table 5, the voltage is slightly improved and CEff/CIE-y is unchanged relative to comparative example 1-1. However, the sheet resistance Rs is substantially increased relative to comparative example 1-1.

In Example 1-7, the hole injection layer comprises 78 wt.-% first organic compound F18, 20 wt.-% second organic compound E13 and 2 wt.-% first organic p-dopant G1. As can be seen in Table 5, the voltage and CEff/CIE-y are unchanged relative to comparative example 1-1. However, the sheet resistance Rs is substantially increased relative to comparative example 1-1.

In comparative example 1-3, the spontaneous orientation polarization of the second organic compound is -47 mV/nm, see Table 2. The voltage is increased to 112%, the CEff/CIE-y is unchanged and the sheet resistance Rs is substantially increased to 922 % relative to comparative example 1-1. Thereby, the hole injection layer is essentially non-conductive.

In comparative example 1-4, the difference Δ [LUMO energy level of the first organic compound - LUMO energy level of the second organic compound] is -0.03 eV, see comparative composition 1-2 in Table 4. The voltage is unchanged, the CEff/CIE-y is reduced at 98% and the sheet resistance is reduced at 75% relative to comparative example 1-1. Thereby, the conductivity of the organic semiconductor layer and/or hole injection layer comprising the composition is increased relative to comparative example 1-1.

In comparative example 1-5, the comparative composition 1-2 comprises a higher amount of second organic compound compared to comparative example 1-4. The voltage and CEff/CIE-y are unchanged compared to comparative example 1-4. The sheet resistance is even further reduced to 60% compared to comparative example 1-1.

In comparative example 1-6, the hole injection layer comprises comparative composition 1-3. The difference Δ [LUMO energy level of the first organic compound - LUMO energy level of the second organic compound] is -0.17 eV, see comparative composition 1-3 in Table 4. The voltage is essentially unchanged at 99% and the efficiency is essentially unchanged at 101%. The sheet resistance Rs is substantially reduced to 44% relative to comparative example 1-1.

In summary, surprisingly an improvement in sheet resistance Rs has been obtained without substantial detrimental effect on the voltage and/or efficiency.

An increase in sheet resistance Rs may result in reduced conductivity of the hole injection layer. Thereby, selected pixels can be switched on in a display device without substantial current flowing to neighbouring pixels (so-called pixel crosstalk). As a result the colour purity and/or image quality of an organic electroluminescent device and/or display device may be improved, in particular of a display device.

Additionally, a reduction in voltage and/or an increase in efficiency CEff/CIE-y may be obtained.

A reduction in voltage and/or an increase in efficiency CEff/CIE-y may result in reduced power consumption of organic electroluminescent devices, in particular mobile devices.

In Table 6 are shown the data for organic electroluminescent devices comprising a hole injection layer of the present invention and comparative examples, wherein the thickness of the hole injection layer is 10 nm. The hole injection layer comprises a different first organic p-dopant compared to Examples 1-1 to 1-7.

Table 6: Organic electroluminescent device comprising a hole injection layer having a thickness of 10 nm

| Referred to as: | First organic compound in HIL | wt.-% First organic compound in HIL | Second organic compound in HIL | wt.-% second organic compound in HIL | First organic p-dopant in HIL | Wt.-% first organic p-dopant in HIL | Voltage rel. [%] at 15 $mA/cm^2$ | CEff/CIE-y rel. [%] at 15 $mA/cm^2$ | Rs rel. [%] |
|---|---|---|---|---|---|---|---|---|---|
| Comparative example 2-1 | F18 | 90 | - | - | G4 | 10 | 100 | 100 | 100 |
| Example 2-1 | F18 | 80 | E1 | 10 | G4 | 10 | 100 | 100 | 234 |
| Example 2-2 | F18 | 65 | E1 | 25 | G4 | 10 | 99 | 100 | 268 |
| Example 2-3 | F18 | 80 | E4 | 10 | G4 | 10 | 100 | 101 | 208 |
| Example 2-4 | F18 | 65 | E4 | 25 | G4 | 10 | 100 | 100 | 141 |

In comparative example 2-1, the hole injection layer comprises 98 wt.-% first organic compound F18 and 2 wt.-% first organic p-dopant G4. The hole injection layer is free of second organic compound. The voltage, CEff/CIE-y and Rs are defined as 100%.

In Example 2-1, the hole injection layer comprises 80 wt.-% first organic compound F18, 10 wt.-% second organic compound E1 and 10 wt.-% first organic p-dopant G4. The voltage and CEff/CIE-y are unchanged. However, the sheet resistance Rs is substantially increased to 234 % relative to comparative example 2-1.

In Example 2-2, the hole injection layer comprises 65 wt.-% first organic compound F18, 25 wt.-% second organic compound E1 and 10 wt.-% first organic p-dopant G4. The voltage is slightly reduced and the CEff/CIE-y is unchanged. The sheet resistance Rs is increased further to 268 % relative to comparative example 2-1.

In Example 2-1, the hole injection layer comprises 80 wt.-% first organic compound F18, 10 wt.-% second organic compound E4 and 10 wt.-% first organic p-dopant G4. Example 2-1 differs from Example 2-1 in the second organic compound. The voltage is unchanged, the CEff/CIE-y is slightly improved and the sheet resistance Rs is substantially increased to 208 % relative to comparative example 2-1.

In Example 2-4, the hole injection layer comprises 65 wt.-% first organic compound F18, 25 wt.-% second organic compound E4 and 10 wt.-% first organic p-dopant G4. The voltage and CEff/CIE-y are unchanged. However, the sheet resistance Rs is increased to 141 % relative to comparative example 2-1.

In summary, improved performance of an organic electroluminescent device, in particular improved sheet resistance Rs, has been obtained for different second organic compounds and first organic p-dopant.

The particular combinations of elements and features in the above detailed embodiments are exemplary only; the interchanging and substitution of these teachings with other teachings in this and the patents/applications incorporated by reference are also expressly contemplated. As those skilled in the art will recognize, variations, modifications, and other implementations of what is described herein can occur to those of ordinary skill in the art without departing from the spirit and the scope of the invention as claimed. Accordingly, the foregoing description is by way of example only and is not intended as limiting. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. The invention's scope is defined in the following claims and the equivalents thereto. Furthermore, reference signs used in the description and claims do not limit the scope of the invention as claimed.

## Claims

**1.** An organic electroluminescent device comprising an anode layer, a cathode layer, a first emission layer, and a hole injection layer,
the hole injection layer comprises a composition comprising:

- a first organic compound comprising ≥ 7 to ≤ 14 aromatic rings and at least one triarylamine moiety; and
- a second organic compound comprising ≥ 7 to ≤ 14 aromatic rings;
wherein the HOMO energy level of the second organic compound is in the range of ≤ -5 eV to ≥ -6.5 eV; and
- a first organic p-dopant comprising at least three CN groups, and wherein the first organic p-dopant has a molecular weight of ≥ 400 g/mol, and

wherein
the following equations (a) and (b) are fulfilled:

(a) 0.2 eV < Δ [LUMO energy level of the first organic compound - LUMO energy level of the second organic compound] < 3.5 eV; and
(b) 0 eV < Δ [HOMO energy level of the first organic compound - LUMO energy level of the first organic p-dopant] < 1.5eV;

wherein
the hole injection layer is in direct contact with the anode layer.

**2.** The organic electroluminescent device according to claim 1, wherein an organic semiconductor layer comprising the second organic compound comprising ≥ 7 to ≤ 14 aromatic rings, if formed as a separated organic semiconductor layer, said separated organic semiconductor layer consisting of the second organic compound has a spontaneous orientation polarization in the range of ≥ 0 mV/nm to ≤ 150 mV/nm, preferably a spontaneous orientation polarization of ≥ 5 mV/nm, more preferred ≥ 10 mV/nm, most preferred ≥ 15 mV/nm, or a spontaneous orientation polarization of ≥ 8

mV/nm to ≤ 100 mV/nm, preferably ≥ 9 mV/nm and ≤ 80 mV/nm, more preferred ≥ 10 mV/nm to ≤ 70 mV/nm.

3. The organic electroluminescent device according to claims 1 or 2, wherein the hole injection layer comprises a composition comprising

- a first organic compound comprising ≥ 7 to ≤ 14 aromatic rings and at least one triarylamine moiety; and
- a second organic compound comprising ≥ 7 to ≤ 14 aromatic rings, wherein the second organic compound comprises at least one substituted or unsubstituted $C_3$ to $C_{24}$ heteroaryl group, azine group, 5-membered N-heteroaryl group, 6-membered N-heteroaryl group, or 6-membered heteroaryl group comprising between 1 and 3 N atoms,
wherein the substituents of the at least one substituted or unsubstituted $C_3$ to $C_{24}$ heteroaryl group are selected from the group comprising H, D, F, C(-O)$R^{22}$, CN, Si($R^{22}$)$_3$, P(-O)($R^{22}$)$_2$, O$R^{22}$, S(-O)$R^{22}$, S(-O)$_2R^{22}$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted substituted or unsubstituted aromatic ring systems having 6 to 40 aromatic ring atoms, and substituted or unsubstituted heteroaromatic ring systems having 5 to 40 aromatic ring atoms, unsubstituted $C_6$ to Cis aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein $R^{22}$ is selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl; and
- a first organic p-dopant comprises at least three CN groups, wherein the first organic p-dopant comprises independently of each other at least two groups selected from $C_6$ to $C_{19}$ aryl group or $C_3$ to $C_{12}$ heteroaryl group, wherein each of the $C_6$ to $C_{19}$ aryl group or $C_3$ to $C_{12}$ heteroaryl group is substituted,
wherein the one or more substituents are independently selected from halogen, F, CN, partially perfluorinated $C_1$ to $C_{12}$ alkyl, perfluorinated $C_1$ to $C_{12}$ alkyl, $CF_3$;

wherein
optionally the second organic compound comprising ≥ 7 to ≤ 14 aromatic rings, if formed as a separated organic semiconductor layer, said separated organic semiconductor layer consisting of the second organic compound has a spontaneous orientation polarization in the range of ≥ 0 mV/nm to ≤ 150 mV/nm.

4. The organic electroluminescent device according to any of the preceding claims 1 to 3, wherein the composition of the hole injection layer consists of:

- a first organic compound comprising ≥ 7 to ≤ 14 aromatic rings and at least one triarylamine moiety; and
- a second organic compound comprising ≥ 7 to ≤ 14 aromatic rings; and
- a first organic p-dopant comprising at least three CN groups, and wherein the first organic p-dopant has a molecular weight of ≥ 400 g/mol and ≤ 2000 g/mol.

5. The organic electroluminescent device according to any of the preceding claims 1 to 4, wherein the LUMO energy level:

- of the first organic compound is the range of ≥ -1.5 eV to ≤ -0.7 eV, preferably ≥ -1.3 eV to ≤ -0.8 eV, more preferably ≥ -1.2 eV to ≤ -0.85 eV; and/or
- of the second organic compound is the range of ≥ -3 eV to ≤ -0.8 eV, preferably ≥ -3 eV to ≤ -1 eV, more preferably ≥ -2.5 eV to ≤ -1 eV, most preferably ≥ -2 eV to ≤ -1.5 eV.

6. The organic electroluminescent device according to any of the preceding claims 1 to 5, wherein the dipole moment:

- of the first organic compound is in the range of ≥ 0.2 Debye to ≤ 3 Debye, and preferably ≥ 0.25 Debye to ≤ 2.5 Debye, and/or
- of the second organic compound is in the range of ≥ 0.2 Debye to ≤ 7 Debye, preferably ≥ 0.3 Debye to ≤ 6 Debye; more preferred ≥ 0.5 Debye to ≤ 5 Debye; alternatively ≥ 0.5 Debye to < 4.8 Debye.

**7.** The organic electroluminescent device according to any of the preceding claims 1 to 6, wherein the first organic compound of the hole injection layer is selected from a compound of formula (Ia) or a compound of formula (Ib):

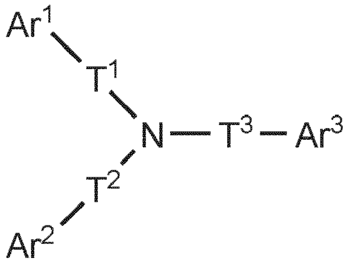 (Ia), 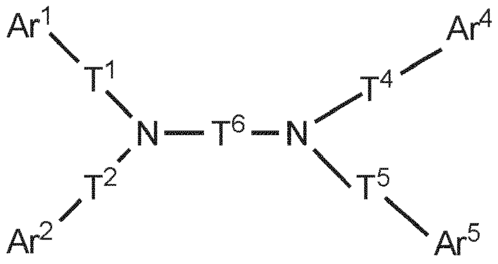 (Ib),

wherein:

$T^1$, $T^2$, $T^3$, $T^4$ and $T^5$ are independently selected from a single bond, phenylene, biphenylene, terphenylene or naphthenylene, preferably a single bond or phenylene;
$T^6$ is phenylene, biphenylene, terphenylene or naphthenylene;
$Ar^1$, $Ar^2$, $Ar^3$, $Ar^4$ and $Ar^5$ are independently selected from substituted or unsubstituted $C_6$ to $C_{20}$ aryl, or substituted or unsubstituted $C_3$ to $C_{20}$ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;
wherein the substituents of $Ar^1$, $Ar^2$, $Ar^3$, $Ar^4$ and $Ar^5$ are selected the same or different from the group comprising H, D, F, $C(-O)R^{11}$, CN, $Si(R^{11})_3$, $P(-O)(R^{11})_2$, $OR^{11}$, $S(-O)R^{11}$, $S(-O)_2R^{11}$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted substituted or unsubstituted aromatic ring systems having 6 to 40 aromatic ring atoms, and substituted or unsubstituted heteroaromatic ring systems having 5 to 40 aromatic ring atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein $R^{11}$ is selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl.

**8.** The organic electroluminescent device according to claim 7, wherein the substituents of $Ar^1$, $Ar^2$, $Ar^3$, $Ar^4$ and $Ar^5$ are selected the same or different from the group comprising H, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl, $C_3$ to $C_{18}$ heteroaryl, a fused ring system comprising 2 to 4 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle; more preferred the substituents are selected the same or different from the group consisting of H, straight-chain alkyl having 1 to 4 carbon atoms, branched alkyl having 1 to 4 carbon atoms, cyclic alkyl having 3 to 4 carbon atoms and/or phenyl.

**9.** The organic electroluminescent device according to claims 1 to 8 wherein $Ar^1$, $Ar^2$, $Ar^3$, $Ar^4$ and $Ar^5$ are independently selected from formulae A1 to A16:

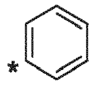 (A1), 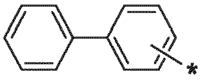 (A2), 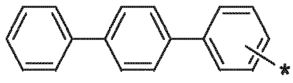 (A3), 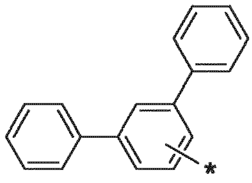 (A4),

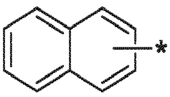 (A5), 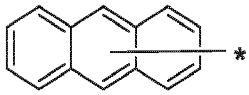 (A6), 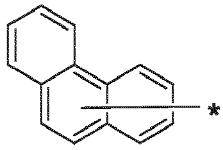 (A7), 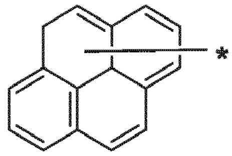 (A8),

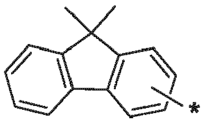 (A9), 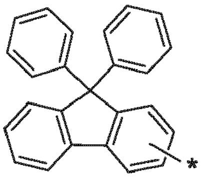 (A10), 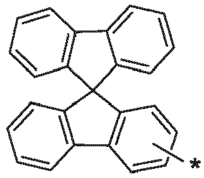 (A11),

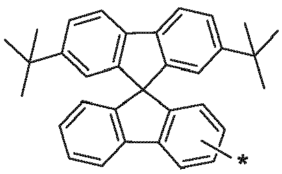 (A12), 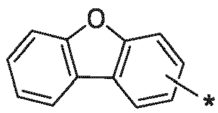 (A13), 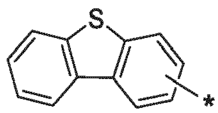 (A14),

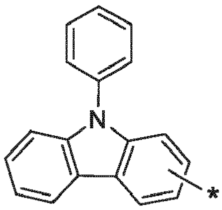 (A15), 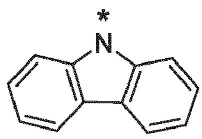 (A16),

wherein the asterix "*" denotes the binding position; and preferably $Ar^1$, $Ar^2$, $Ar^3$, $Ar^4$ and $Ar^5$ are independently selected from (A1) to (A15), and alternatively selected from (A1) to (A11) and (A13) to (A15).

**10.** The organic electroluminescent device according to any of the preceding claims 1 to 9, wherein the first organic compound of the hole injection layer is selected from formulae F 1 to F23:

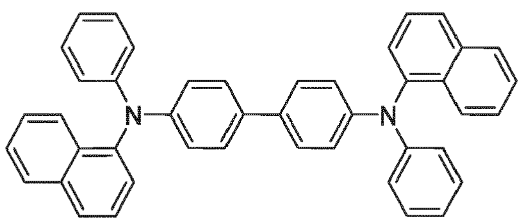 (F1), 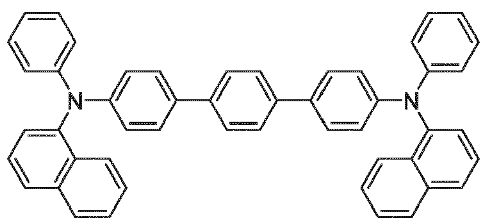 (F2),

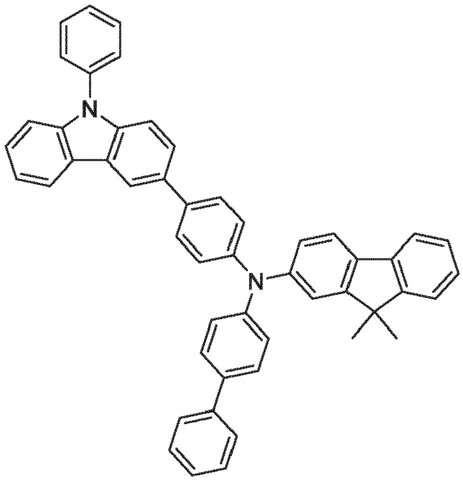
(F3),

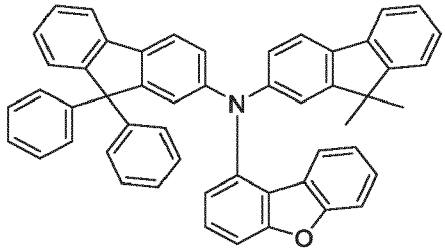
(F4),

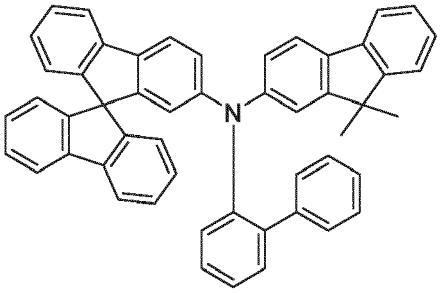
(F5),

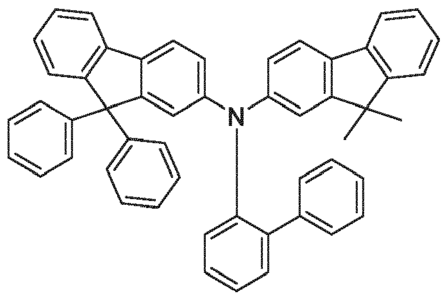
(F6),

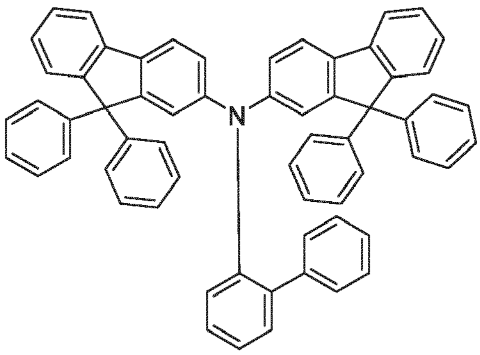
(F7),

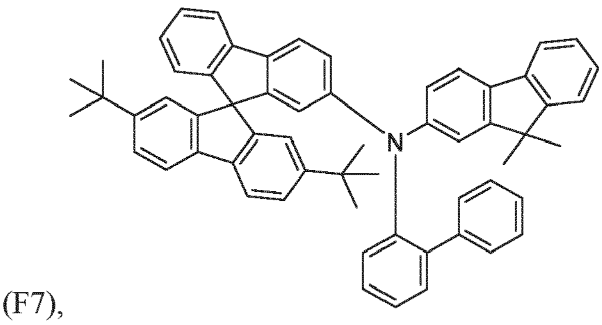
(F8),

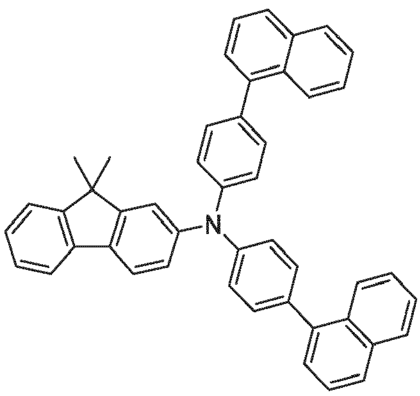
(F9),

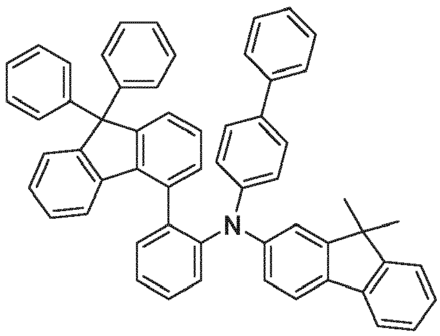
(F10),

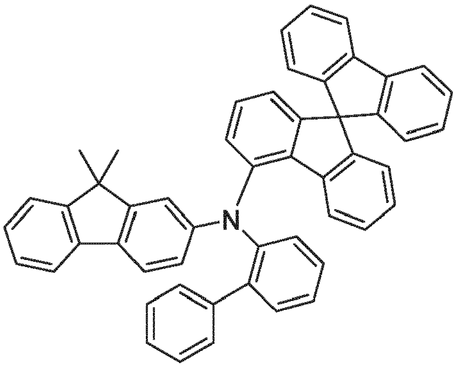
(F11),

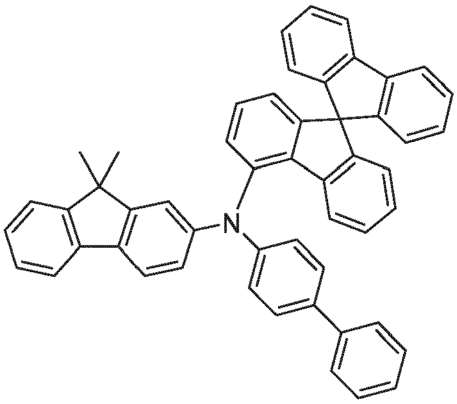
(F12),

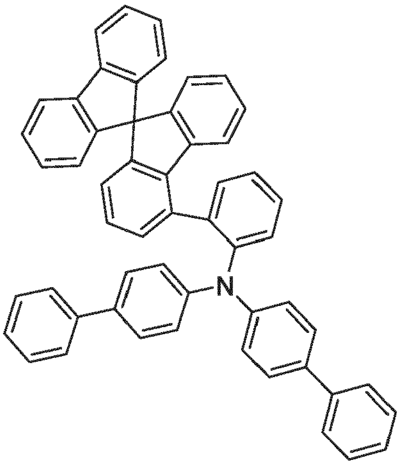
(F13),

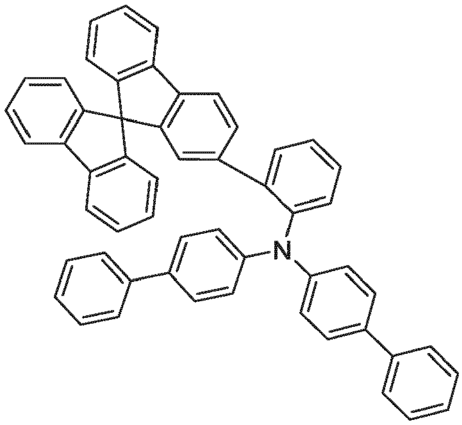
(F14),

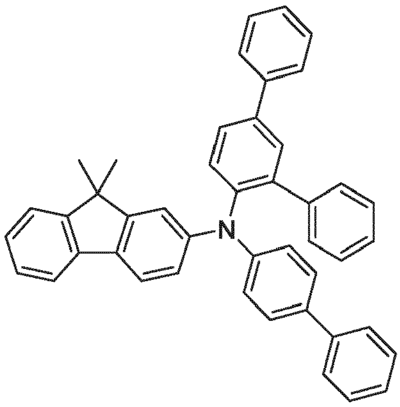
(F15),

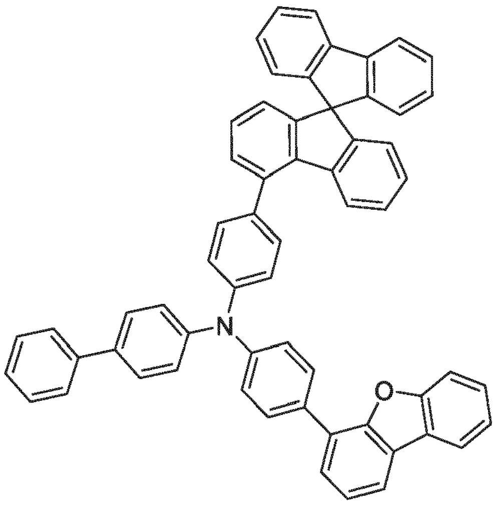
(F16),

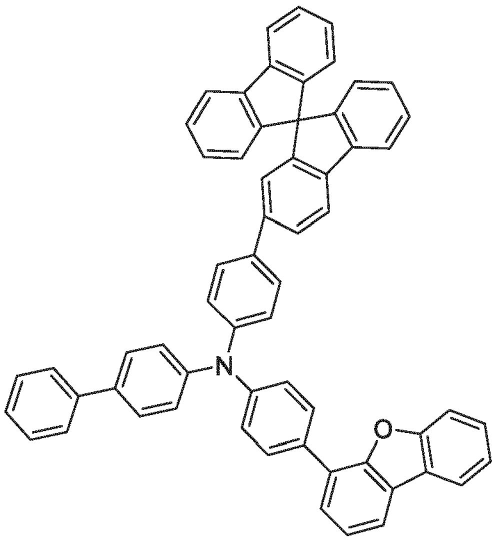

(F17),

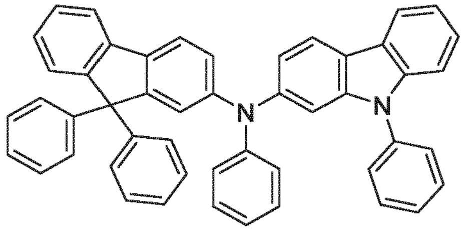

(F18),

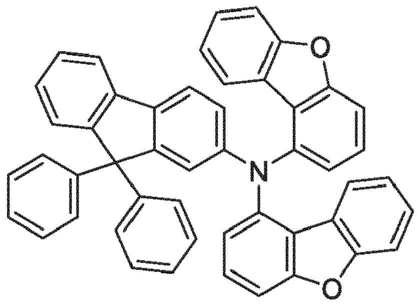

(F19),

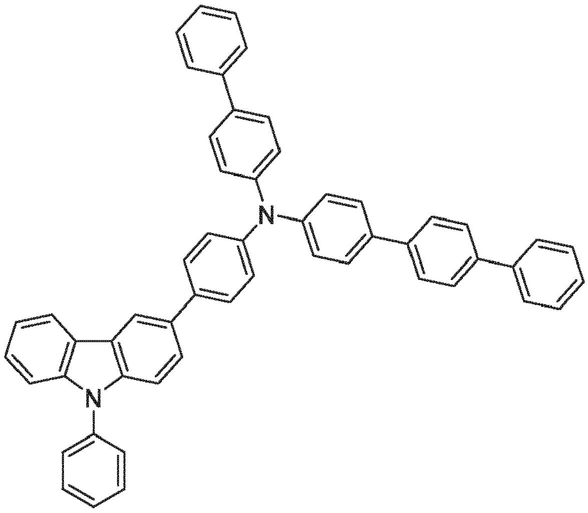

(F20),

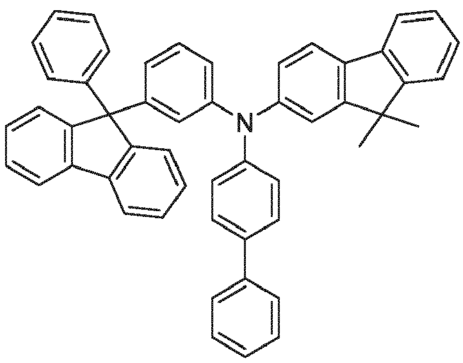

(F21),

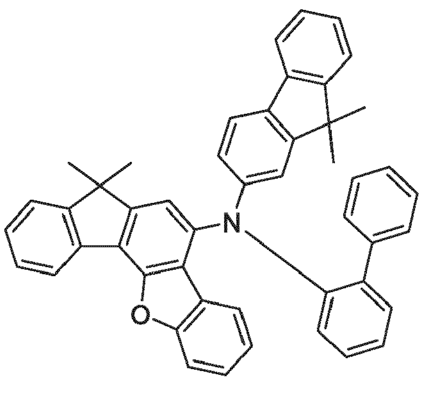

(F22),

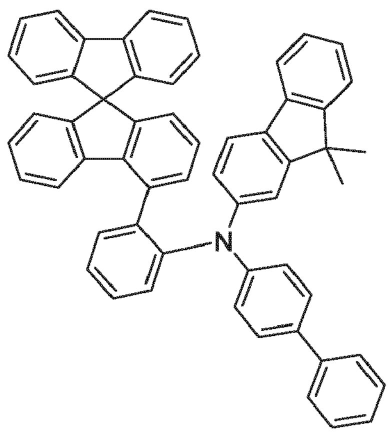

(F23);

preferably the first organic compound of the hole injection layer is selected from formulae (F3) to (F23), more preferred from (F4) to (F23), and most preferred from (F4), (F10), (F18), (F22) and (F23).

**11.** The organic electroluminescent device according to any of the preceding claims 1 to 10, wherein the second organic compound of the hole injection layer comprises an azine group, preferably a triazine group, a pyrimidine group, a pyridine group, an acridine group, a dibenzoacridine group, a dibenzo[c,h]acridine group, a benzo[h]quinazoline group and/or a 3,8a-dihydroimidazo[1,5-a]pyridine group, more preferred a pyrimidine group, a pyridine group and/or an acridine group.

**12.** The organic electroluminescent device according to any of the preceding claims 1 to 11, wherein the second organic compound of the hole injection layer comprises

- at least one $C_2$ to $C_{24}$ N-heteroaryl or P=X group, with X being O, S or Se, with O being especially preferred; wherein the at least one $C_2$ to $C_{24}$ N-heteroaryl optional be selected from a compound comprising at least one azine group, preferably at least two azine groups, also preferred three azine groups; and/or
- at least one group selected from the list consisting of pyridine, pyrimidine, triazine, imidazole, benzimidazole, benzooxazole, quinoline, quinoxaline, benzoquinoxaline, acridine, phenanthroline, benzoacridine, dibenzoacridine, imidazopyridine; and/or
- at least 15 covalently bound atoms, preferably at least 20 covalently bound atoms, more preferably at least 25 covalently bound atoms, and most preferably at least 30 covalently bound atoms; and/or
- a molecular weight Mw of ≥ 400 to ≤ 2000 g/mol, preferably a molecular weight Mw of ≥ 450 to ≤ 1500 g/mol, further preferred a molecular weight Mw of ≥ 500 to ≤ 1000 g/mol, further preferred a molecular weight Mw of ≥ 550 to ≤ 900 g/mol, in addition preferred a molecular weight Mw of ≥ 580 to ≤ 800 g/mol, also preferred a molecular weight Mw of ≥ 600 to ≤ 800 g/mol.

**13.** The organic electroluminescent device according to any of the preceding claims 1 to 12, wherein the second organic compound of the hole injection layer is a compound of formula (II):

$$\left(Ar^{21}\right)_n T^{21}-Ar^{22}-T^{22}\left(Ar^{23}\right)_m \quad \text{(II)},$$

$T^{21}$ and $T^{22}$ are independently selected from a single bond, phenylene, biphenylene, terphenylene or naphthenylene, preferably a single bond or phenylene;
n and m is an integer independently selected from 1, 2 or 3, preferably 1 or 2;
$Ar^{21}$ is selected from substituted or unsubstituted $C_6$ to $C_{42}$ aryl, or substituted or unsubstituted $C_3$ to $C_{41}$ heteroarylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of an aromatic heterocycle, (iii) unsaturated 5- to 7-member ring of a non-heterocycle, (iv) 6-member ring of an aromatic non-heterocycle;

$Ar^{22}$ is selected from substituted or unsubstituted $C_6$ to $C_{20}$ aryl, or substituted or unsubstituted $C_3$ to $C_{20}$ heteroarylene, a single bond, phenylene, biphenylene, terphenylene or naphthenylene, preferably a single bond, phenylene or naphthalene, and preferably selected from a single bond, phenylene or naphthalene;

$Ar^{23}$ is selected from a substituted or unsubstituted $C_3$ to $C_{41}$ heteroarylene, a substituted or unsubstituted 5-membered or 6-membered heteroarylene comprising 2 or 3 N atoms, substituted or unsubstituted azine, pyridine, pyrimidine, triazine, imidazole, benzimidazole, benzooxazole, quinoline, quinoxaline, benzoquinoxaline, acridine, phenanthroline, benzoacridine, dibenzoacridine, imadzopyridine;

wherein

the substituents of $Ar^{21}$, $Ar^{22}$, $Ar^{23}$ are selected the same or different from the group comprising H, D, F, C(-O)$R^{22}$, CN, Si$(R^{22})_3$, P(-O)$(R^{22})_2$, O$R^{22}$, S(-O)$R^{22}$, S(-O)$_2R^{22}$, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted substituted or unsubstituted aromatic ring systems having 6 to 40 aromatic ring atoms, and substituted or unsubstituted heteroaromatic ring systems having 5 to 40 aromatic ring atoms, unsubstituted $C_6$ to $C_{18}$ aryl, unsubstituted $C_3$ to $C_{18}$ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,

wherein $R^{22}$ is selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, $C_6$ to $C_{18}$ aryl or $C_3$ to $C_{18}$ heteroaryl.

**14.** The organic electroluminescent device according to claim 13, wherein $Ar^{21}$ is selected from phenyl, naphthyl, biphenyl, phenanthrenyl or formulae C1 to C58:

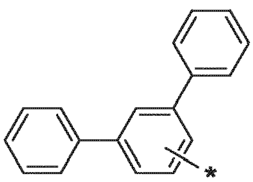
(C1),
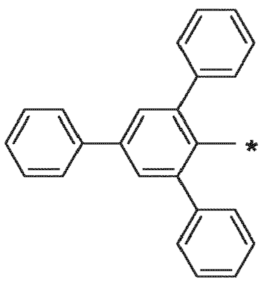
(C2),
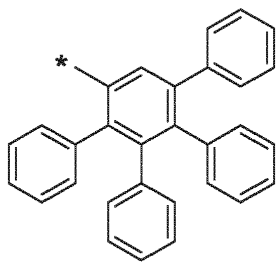
(C3),

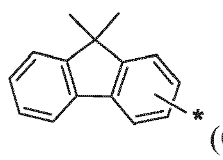
(C4),
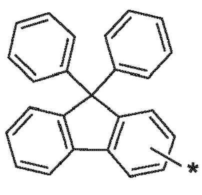
(C5),
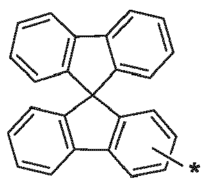
(C6),
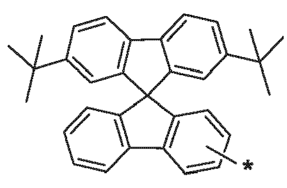
(C7),

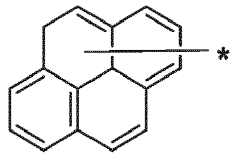 (C8), 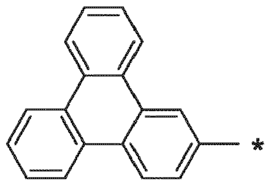 (C9), 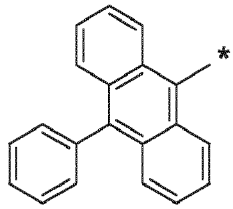 (C10),

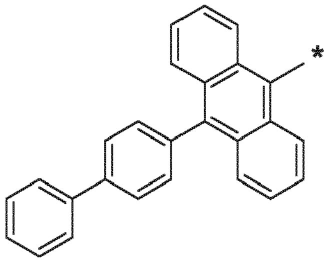 (C11), 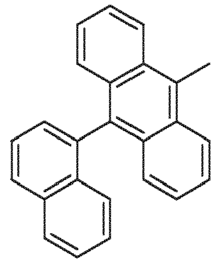 (C12), 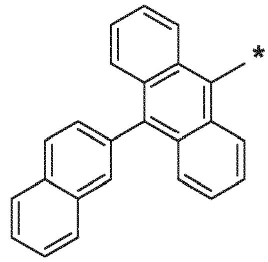 (C13),

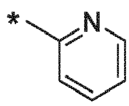 (C14), 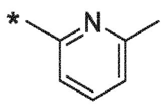 (C15), 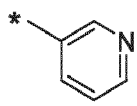 (C16), 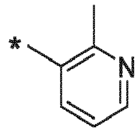 (C17),

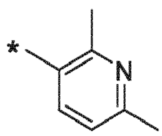 (C18), 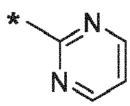 (C19), 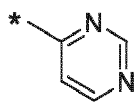 (C20), 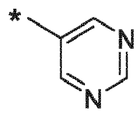 (C21),

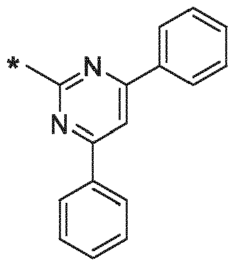 (C22), 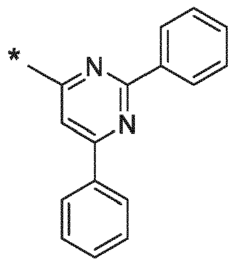 (C23), 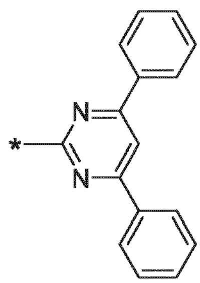 (C24),

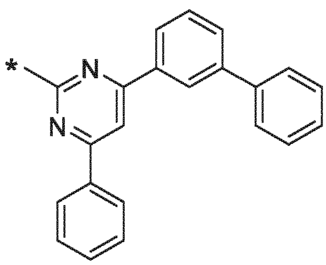 (C25), 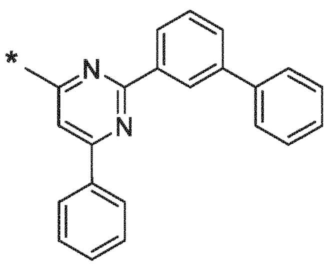 (C26), 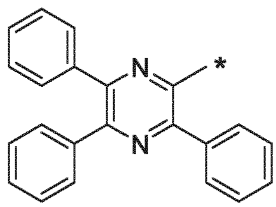 (C27),

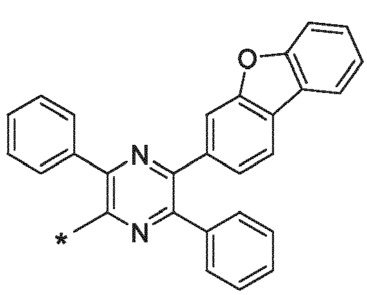 (C28), 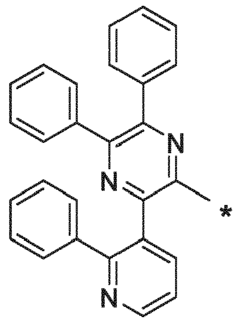 (C29), 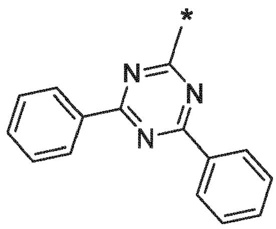 (C30),

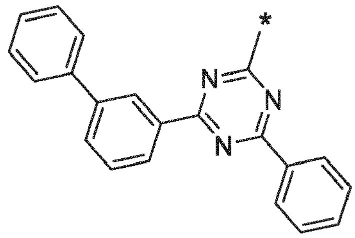 (C31), 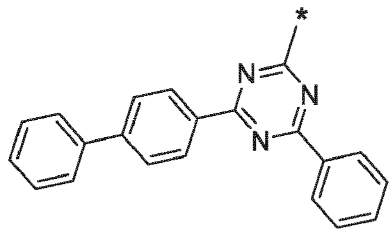 (C32),

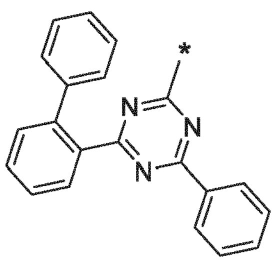 (C33), 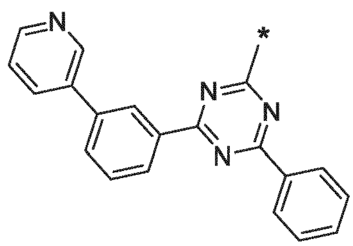 (C34), 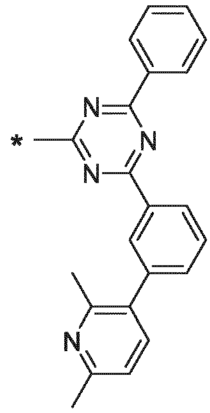 (C35),

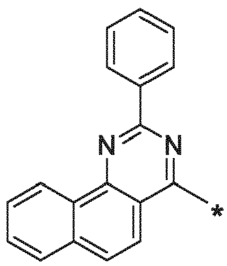 (C36), 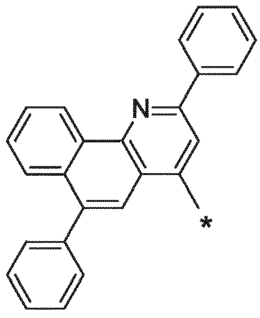 (C37), 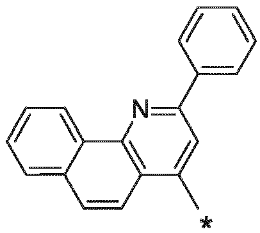 (C38),

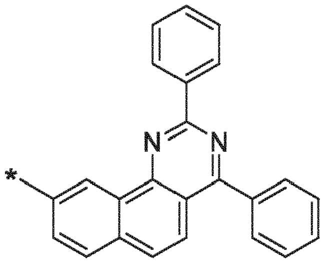 (C39), 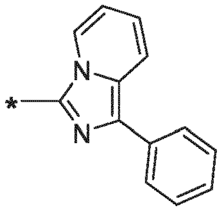 (C40), 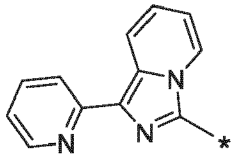 (C41),

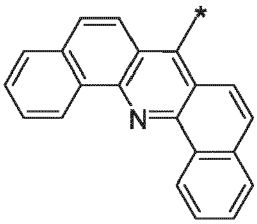 (C42), 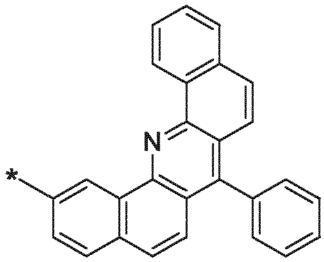 (C43), 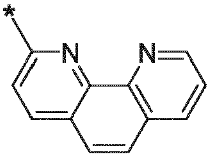 (C44),

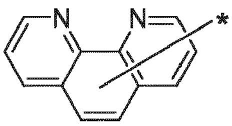 (C45), 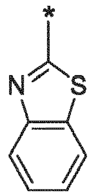 (C46), 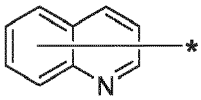 (C47), 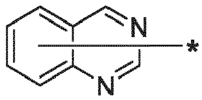 (C48),

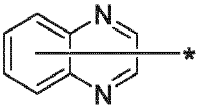 (C49), 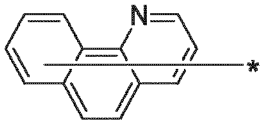 (C50), 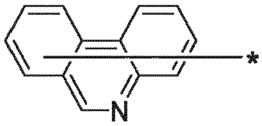 (C51),

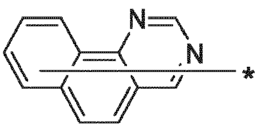 (C52), 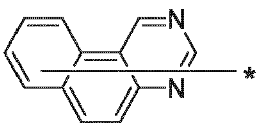 (C53), 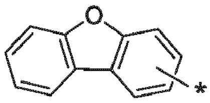 (C54),

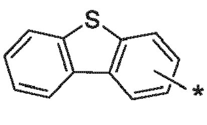 (C55), 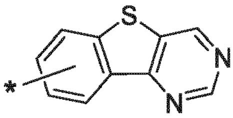 (C56), 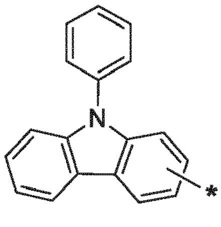 (C57),

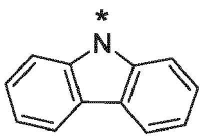 (C58);

wherein the asterix "*" denotes the binding position; and preferably $Ar^{21}$ is selected from (C2) to (C56), more preferred from (C2) to (C6), (C14) to (C45) and (C47) to (C56).

**15.** The organic electroluminescent device according to claims 13 or 14, wherein $Ar^{23}$ is selected from formulae D1 to D43:

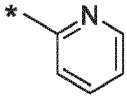 (D1), 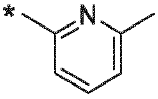 (D2), 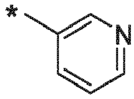 (D3), 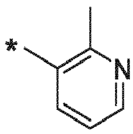 (D4), 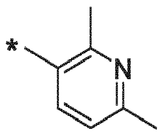 (D5),

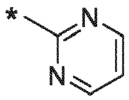 (D6), 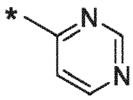 (D7), 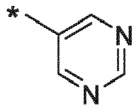 (D8), 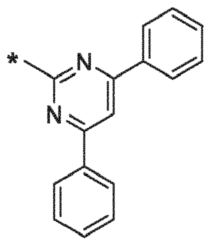 (D9), 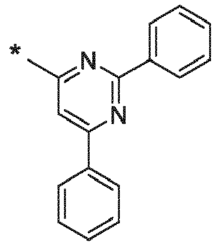 (D10),

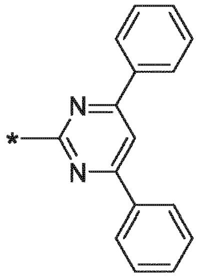 (D11), 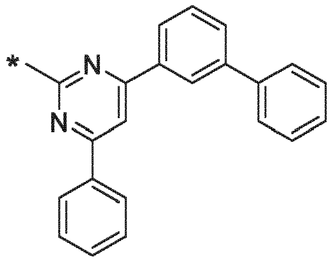 (D12), 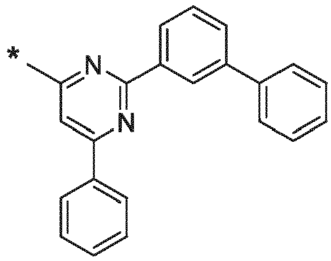 (D13),

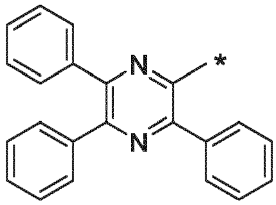 (D14), 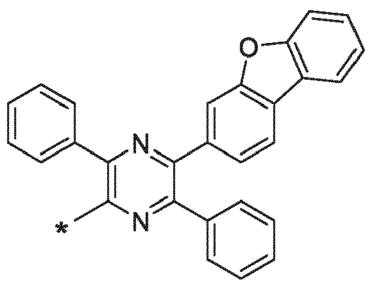 (D15), 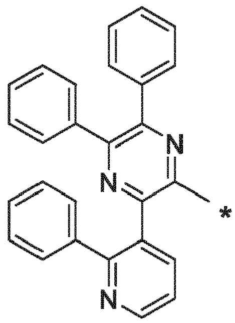 (D16),

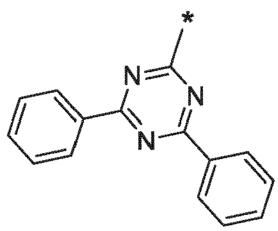 (D17), 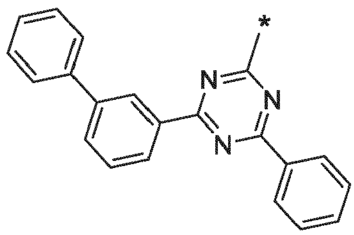 (D18),

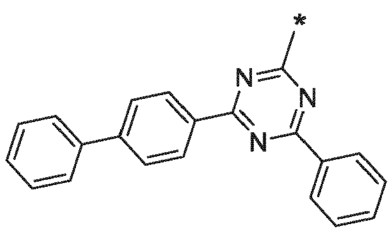 (D19), 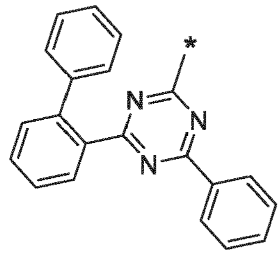 (D20),

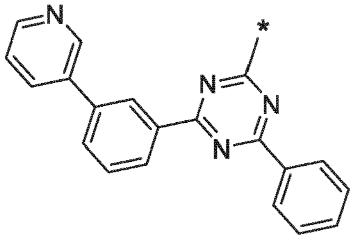 (D21), 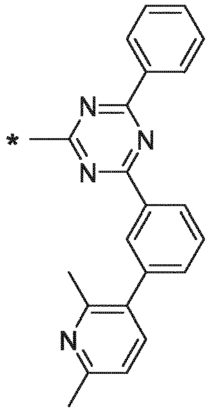 (D22),

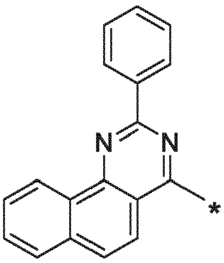 (D23), 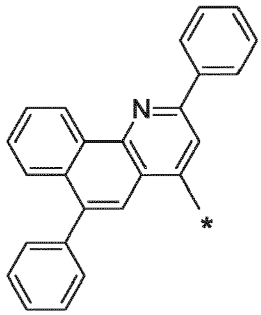 (D24), 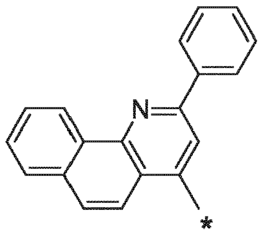 (D25),

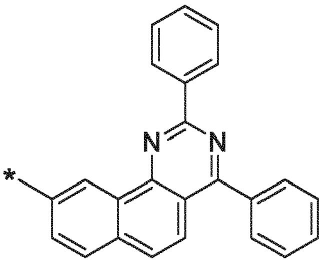 (D26), 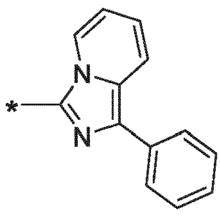 (D27), 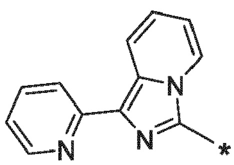 (D28),

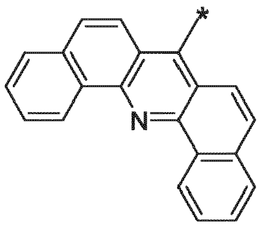 (D29), 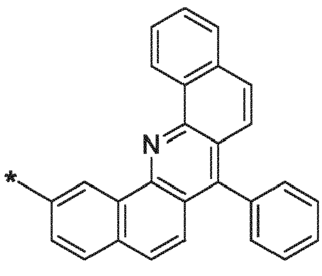 (D30), 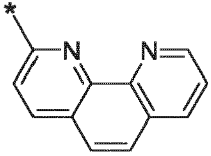 (D31),

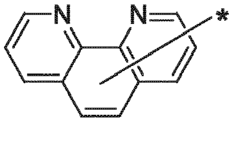 (D32), 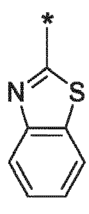 (D33), 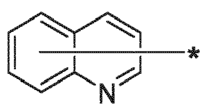 (D34), 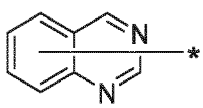 (D35),

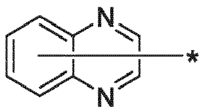 (D36), 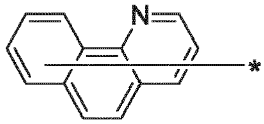 (D37), 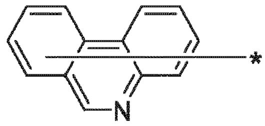 (D38),

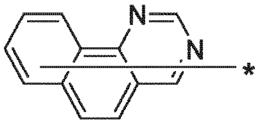 (D39), 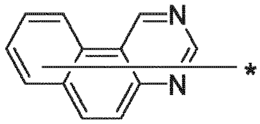 (D40), 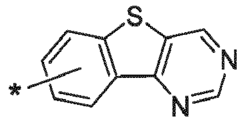 (D41),

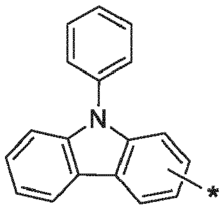 (D42), 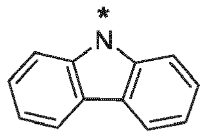 (D43);

wherein the asterix "*" denotes the binding position, preferably, $A^{23}$ is selected from formulae (D1) to (D40), and more preferred (D1) to (D32).

**16.** The organic electroluminescent device according to any of the preceding claims 1 to 15, wherein the second organic compound of the hole injection layer is selected from formulae E1 to E13:

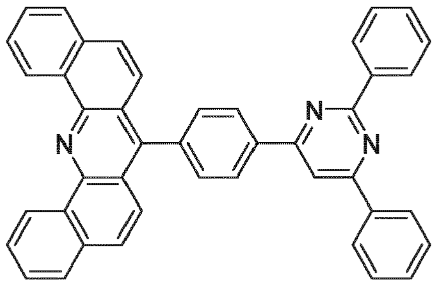 (E1), 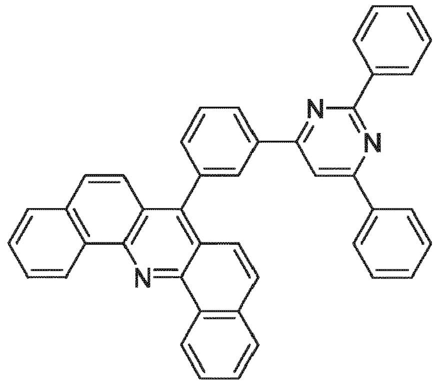 (E2),

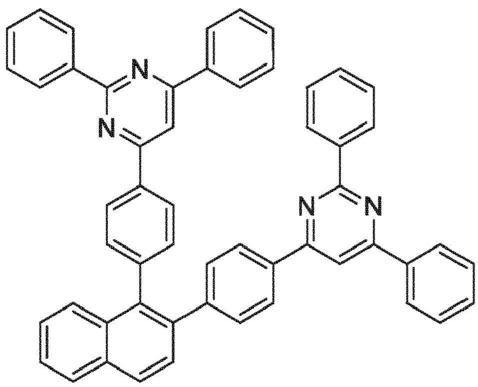 (E3), 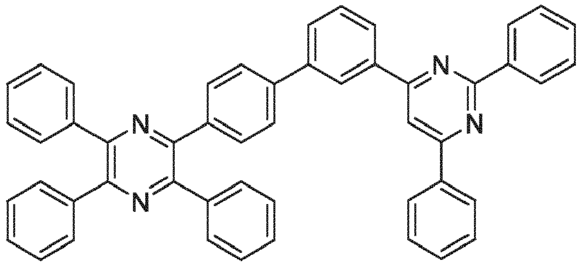 (E4),

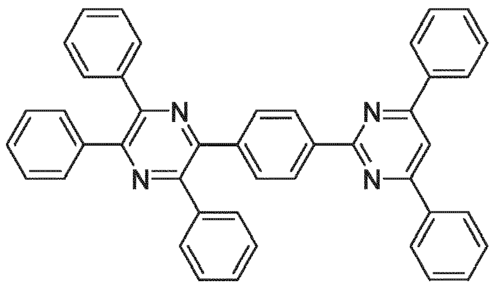 (E5),

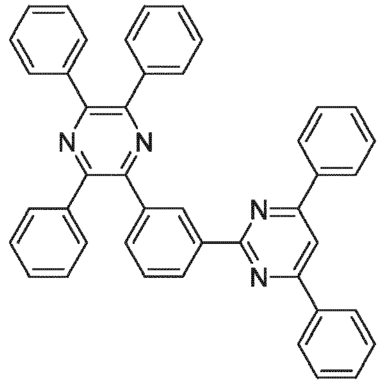 (E6),

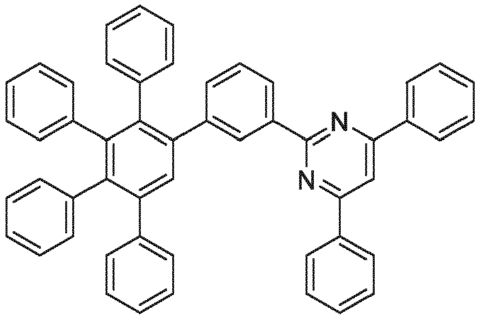 (E7),

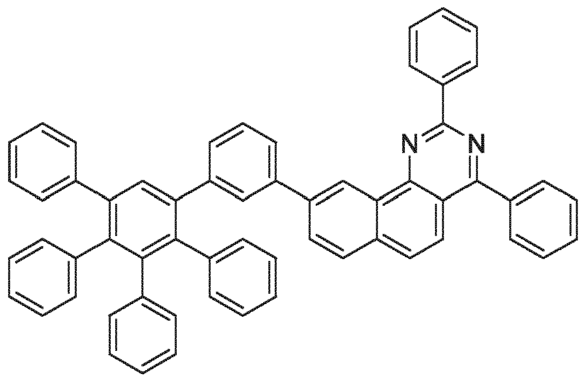 (E8),

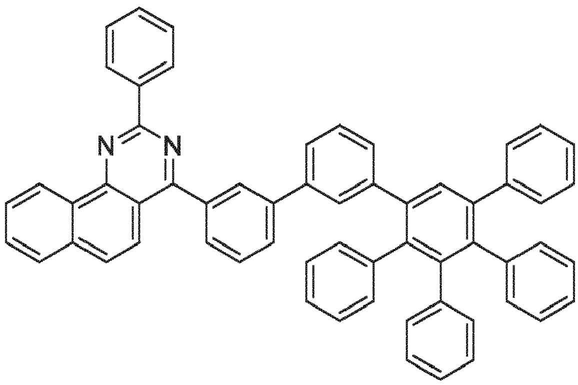 (E9),

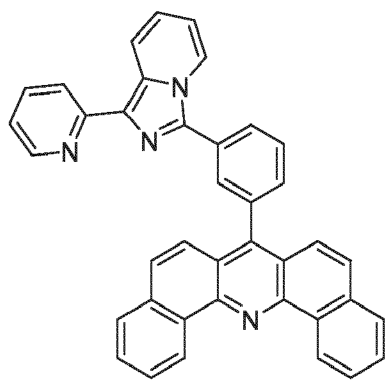 (E10),

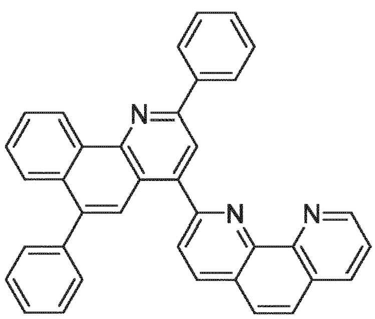 (E11),

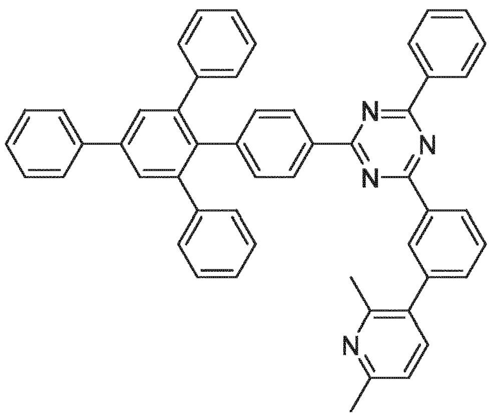 (E12),

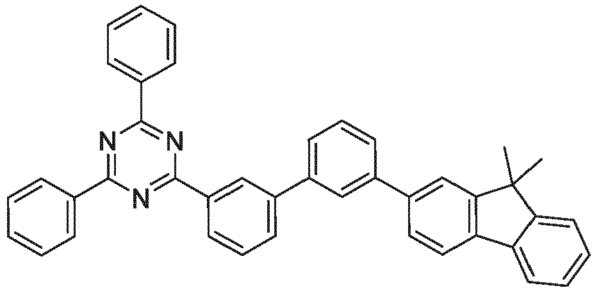
(E13);

preferably the second organic compound of the hole injection layer is selected from (E1) to (E9), also preferred from (E1) to (E6) or (E7) to (E9).

**17.** The organic electroluminescent device according to any of the preceding claims 1 to 16, wherein the composition of the hole injection layer comprises:
$\leq$ 90 wt.-% first organic compound, $\geq$ 5 wt.-% second organic compound, and $\geq$ 1 wt.-% first organic p-dopant, preferably $\leq$ 85 wt.-% first organic compound, $\geq$ 10 wt.-% second organic compound, and $\geq$ 1 wt.-% first organic p-dopant; more preferred $\leq$ 88 wt.-% first organic compound, $\geq$ 10 wt.-% second organic compound, and $\geq$ 2 wt.-% first organic p-dopant; or $\geq$ 55 to $\leq$ 90 wt.-% first organic compound, $\geq$ 10 to $\leq$ 35 wt.-% second organic compound and $\geq$ 1 to $\leq$ 10 wt.-% first organic p-dopant, preferably $\geq$ 60 to $\leq$ 90 wt.-% first organic compound, $\geq$ 10 to $\leq$ 30 wt.-% second organic compound and $\geq$ 1 to $\leq$ 10 wt.-% first organic p-dopant.

**18.** The organic electroluminescent device according to any of the preceding claims 1 to 17, wherein the HOMO energy level of the first organic p-dopant is selected in the range of $\geq$ -8.5 eV to $\leq$ -6.8 eV, preferably in the range of $\geq$ -8.2 eV to $\leq$ -7 eV.

**19.** The organic electroluminescent device according to any of the preceding claims 1 to 18, wherein the first organic p-dopant comprises at least two groups selected independently from $C_6$ to $C_{19}$ aryl group or $C_3$ to $C_{12}$ heteroaryl group, wherein each of the $C_6$ to $C_{19}$ aryl group or $C_3$ to $C_{12}$ heteroaryl group is substituted,
wherein the one or more substituents are independently of each other selected from halogen, F, CN, partially perfluorinated $C_1$ to $C_{12}$ alkyl, perfluorinated $C_1$ to $C_{12}$ alkyl, $CF_3$.

**20.** The organic electroluminescent device according to any of the preceding claims 1 to 19, wherein the first organic p-dopant is selected from a compound of formula (III):

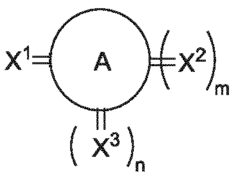
(III),

wherein

n is an integer including 0, 1, 2, 3, 4, 5 or 6, preferably 0, 2, or 4;
m is an integer selected from 0 or 1;
$X^1$, $X^2$ and $X^3$ are independently selected from O, S, $CR^{1a}R^{2a}$, $CR^{1b}R^{2b}$, $NR^{3a}$, $NR^{3b}$ or at least one of $X^1$, $X^2$, and $X^3$ form a fused ring with A, and wherein each $X^3$ is selected the same or different, preferably the same,
$R^{1a}$, $R^{2a}$, $R^{1b}$, and $R^{2b}$ are independently selected from an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted aryl, substituted or unsubstituted heteroaryl,

wherein
the one or more substituents on $R^{1a}$, $R^{2a}$, $R^{1b}$, and $R^{2b}$ are independently selected from D, an electron-withdrawing

group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to C alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl;
wherein
the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, -$NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

$R^{3a}$ and $R^{3b}$ is selected from an electron-withdrawing group, CN, partially fluorinated $C_1$ to $C_6$ alkyl, perfluorinated $C_1$ to $C_6$ alkyl, $CF_3$, substituted or unsubstituted $C_6$ to $C_{30}$ aryl, or substituted or unsubstituted $C_3$ to $C_{30}$ heteroaryl,

wherein
the one or more substituents on $R^{3a}$ and $R^{3b}$ are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl;
wherein
the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, -$NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

A is selected from substituted or unsubstituted $C_3$ to $C_{40}$ cyclohydrocarbon group, substituted or unsubstituted $C_3$ to $C_{40}$ cycloalkane group, substituted or unsubstituted $C_3$ to $C_{40}$ cycloalkane group containing one or more double-bonds, substituted or unsubstituted $C_3$ to $C_{40}$ cycloalkene group, substituted or unsubstituted $C_2$ to $C_{40}$ heterocycloalkane group, substituted or unsubstituted $C_2$ to $C_{40}$ heterocycloalkane group containing one or more double-bonds, substituted or unsubstituted $C_2$ to $C_{40}$ heterocycloalkene group, substituted or unsubstituted $C_6$ to $C_{40}$ aromatic group, substituted or unsubstituted $C_2$ to $C_{40}$ heteroaromatic group,

wherein
the one or more substituents on A are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted $C_6$ to $C_{30}$ aryl, substituted or unsubstituted $C_2$ to $C_{30}$ heteroaryl,
wherein
the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, -$NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
and wherein
preferably the compound of formula (III) comprises at least two groups selected from substituted $C_6$ to $C_{19}$ aryl group or substituted $C_3$ to $C_{12}$ heteroaryl group,
wherein
each of the substituents of $C_6$ to $C_{19}$ aryl group or $C_3$ to $C_{12}$ heteroaryl group are independently of each other selected from halogen, F, CN, partially perfluorinated $C_1$ to $C_{12}$ alkyl, perfluorinated $C_1$ to $C_{12}$ alkyl, or $CF_3$.

**21.** The organic electroluminescent device according to claim 20, wherein in formula (III) the $X^1$, $X^2$, and $X^3$ are independently selected from $CR^{1a}R^{2a}$, $CR^{1b}R^{2b}$, $NR^{3a}$, $NR^{3b}$; and wherein each $X^3$ is selected the same or is selected different.

**22.** The organic electroluminescent device according to claims 20 or 21, wherein A of formula (III) is selected from a group of G1 to G72:

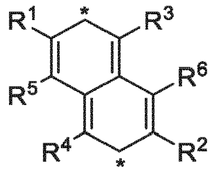 (G1), 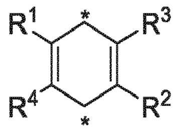 (G2), 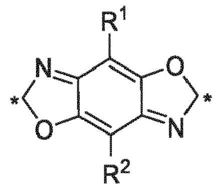 (G3),

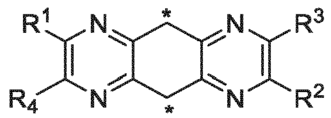 (G4), 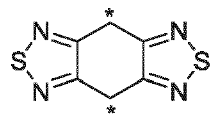 (G5), 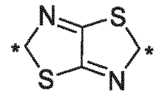 (G6), 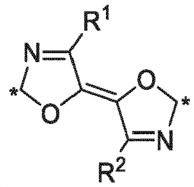 (G7),

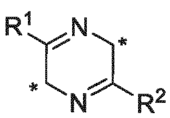 (G8), 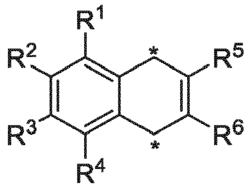 (G9), 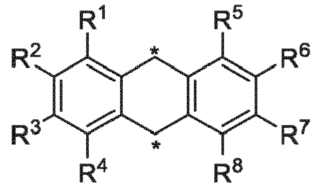 (G10),

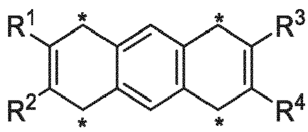 (G11), 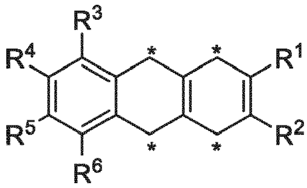 (G12), 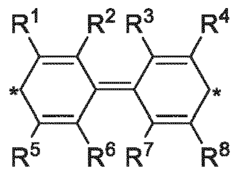 (G13),

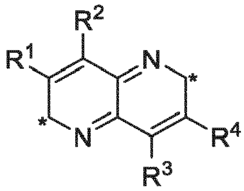 (G14), 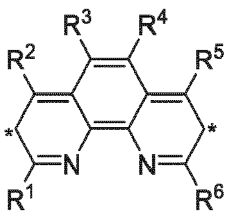 (G15), 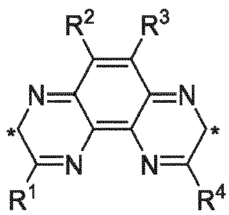 (G16),

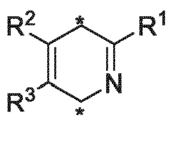 (G17), 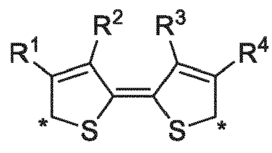 (G18), 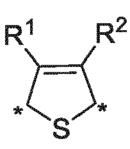 (G19),

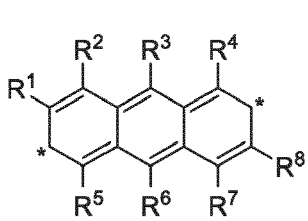 (G20), 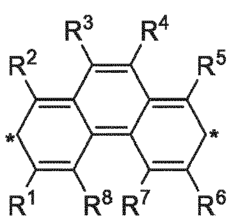 (G21), 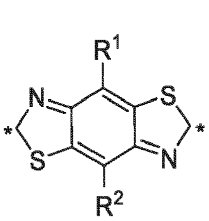 (G22),

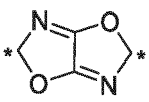 (G23), 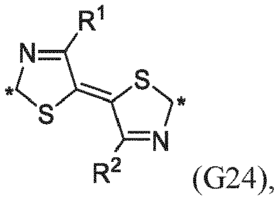 (G24), 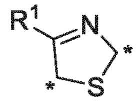 (G25), 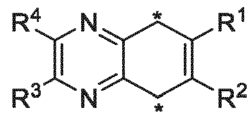 (G26),

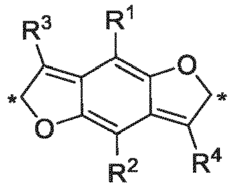 (G27), 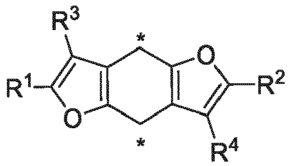 (G28), 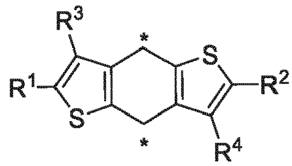 (G29),

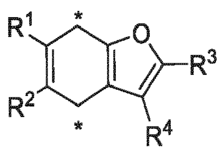 (G30), 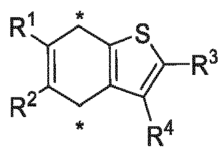 (G31), 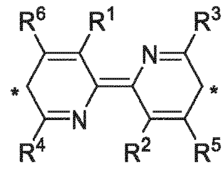 (G32), 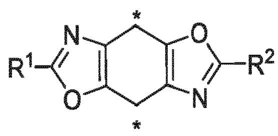

(G33), 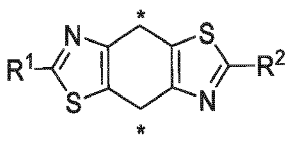 (G34), 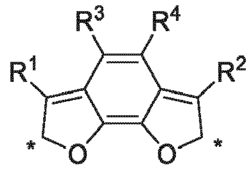 (G35),

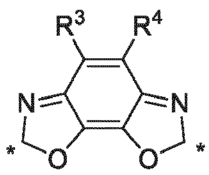 (G36), 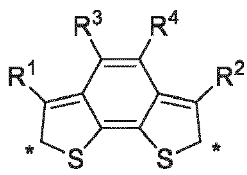 (G37), 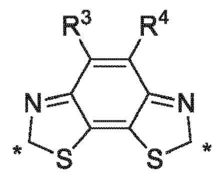 (G38),

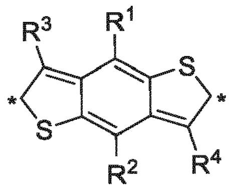 (G39), 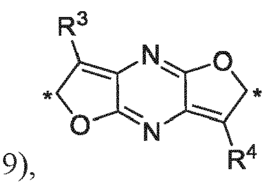 (G40), 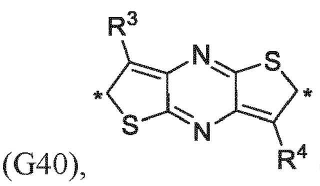 (G41),

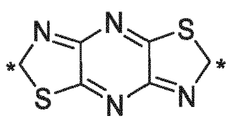 (G42), 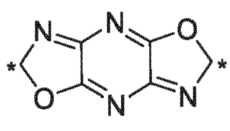 (G43), 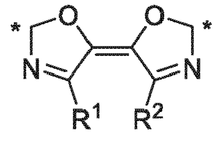 (G44),

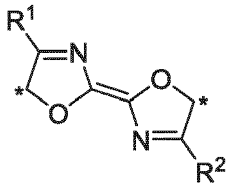 (G45), 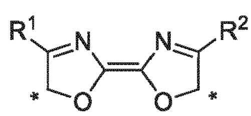 (G46), 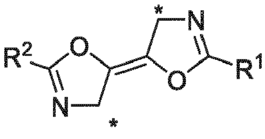 (G47),

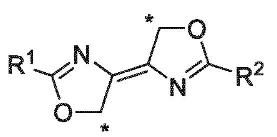 (G48), 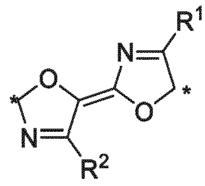 (G49), 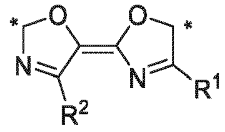 (G50), 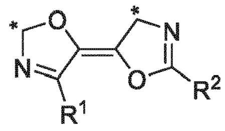

(G51), 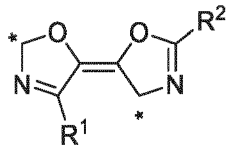 (G52), 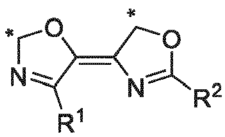 (G53), 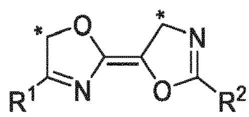 (G54),

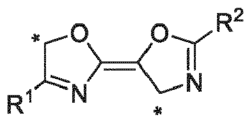 (G55), 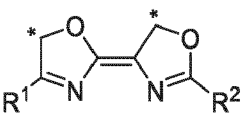 (G56), 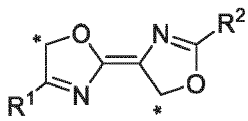 (G57),

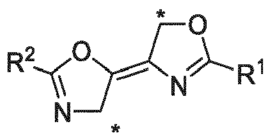 (G58), 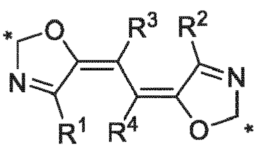 (G59), 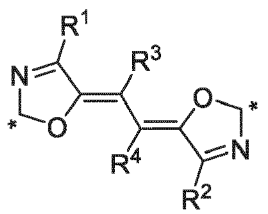 (G60),

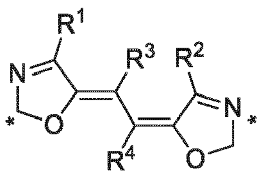 (G61), 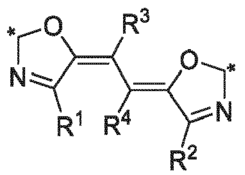 (G62), 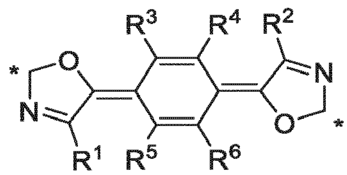 (G63),

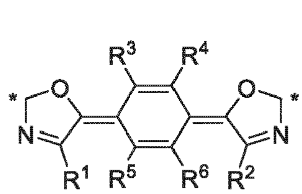 (G64), 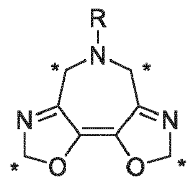 (G65), 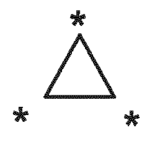 (G66), 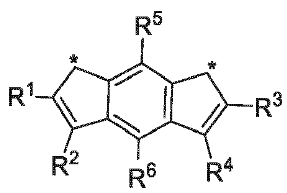

(G67), 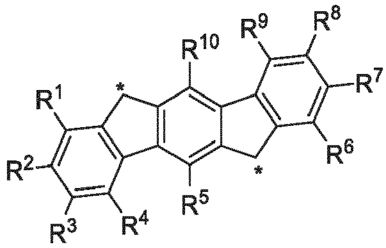 (G68), 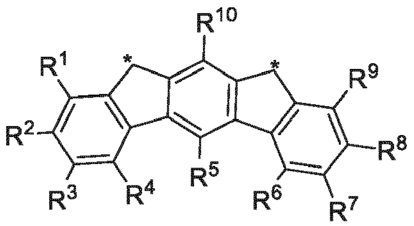 (G69),

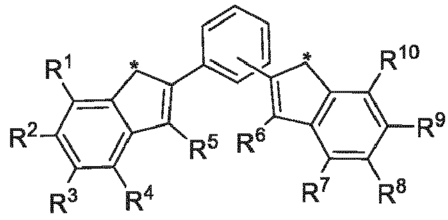

(G70),

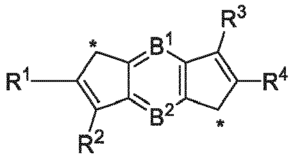

(G71),

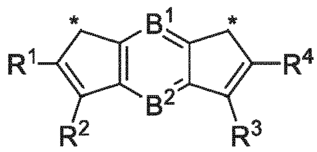

(G72),

wherein the asterisk "*" denotes the binding position;

$R^1$, $R^2$, $R^3$, $R^4$, $R^5$, $R^6$, $R^7$ and $R^8$ are independently selected from H, D, halogen, Cl, F, substituted or unsubstituted $C_1$ to $C_6$ alkyl, partially fluorinated $C_1$ to $C_6$ alkyl, perfluorinated $C_1$ to $C_6$ alkyl, $CF_3$, substituted or unsubstituted $C_1$ to $C_6$ alkoxy, partially fluorinated $C_1$ to $C_6$ alkoxy, perfluorinated $C_1$ to $C_6$ alkoxy, $OCF_3$, substituted or unsubstituted $C_6$ to $C_{30}$ aryloxy, partially fluorinated $C_6$ to $C_{30}$ aryloxy, perfluorinated $C_6$ to $C_{30}$ aryloxy, substituted or unsubstituted $C_6$ to $C_{30}$ aryl, substituted or unsubstituted $C_3$ to $C_{30}$ heteroaryl, CN, isocyano, SCN, OCN, $NO_2$, $SF_5$, wherein the substituents are selected from D, halogen, Cl, F, partially fluorinated $C_1$ to $C_6$ alkyl, perfluorinated $C_1$ to $C_6$ alkyl, $CF_3$, partially fluorinated $C_1$ to $C_6$ alkoxy, perfluorinated $C_1$ to $C_6$ alkoxy, $OCF_3$, CN, isocyano, SCN, OCN, $NO_2$, $SF_5$,
$B^1$ and $B^2$ are independently of each other selected from N, $CR^{5A'}$, or $CR^{6A'}$, wherein
$CR^{5A'}$ or $CR^{6A'}$ are each independently selected from other from H, D, F, a substituted or unsubstituted $C_6$ to $C_{12}$ aryl, a substituted or unsubstituted $C_1$ to $C_{12}$ heteroaryl with 1 to 4 heteroatoms one among O, N, S and Si, a substituted or unsubstituted $C_1$ to $C_{12}$ alkyl, a substituted or unsubstituted $C_1$ to $C_{12}$ alkoxy, a substituted or unsubstituted $C_1$ to $C_{12}$ ether group, CN, $CF_3$, $OCF_3$, halogen, Cl, F, $Si(CH_3)_3$, preferably at least one among $R^1$ to $R^6$ comprises CN,

wherein
the one or more substituents on $CR^{5A'}$, or $CR^{6A'}$ are independently selected from each other from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to C alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl,
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from each other from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy.

**23.** The organic electroluminescent device according to any of the preceding claims 1 to 22, wherein the first organic p-dopant is selected from a radialene compound of formula (IV):

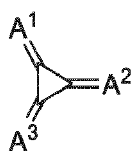

(IV),

wherein in formula (IV)

- $A^1$ is independently selected from a group of formula (IVa):

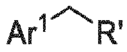 (IVa),

wherein

Ar[1] is independently selected from substituted or unsubstituted aryl and substituted or unsubstituted heteroaryl, wherein for the case that Ar[1] is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl, and
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;

- $A^2$ is independently selected from a group of formula (IVb):

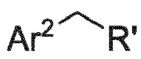 (IVb),

wherein

Ar[2] is independently selected from substituted or unsubstituted aryl and substituted or unsubstituted heteroaryl, wherein for the case that Ar[2] is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl, and
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy,

- $A^3$ is independently selected from a group of formula (IVc)

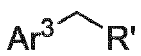 (IVc),

wherein
Ar[3] is independently selected from substituted or unsubstituted aryl and substituted or unsubstituted heteroaryl, wherein for the case that Ar[3] is substituted, one or more of the substituents are independently selected from the group consisting of D, an electron-withdrawing group, halogen, Cl, F, CN, $-NO_2$, substituted or unsubstituted $C_1$ to $C_8$ alkyl, partially fluorinated $C_1$ to $C_8$ alkyl, perfluorinated $C_1$ to $C_8$ alkyl, substituted or unsubstituted $C_1$ to $C_8$ alkoxy, partially fluorinated $C_1$ to $C_8$ alkoxy, perfluorinated $C_1$ to $C_8$ alkoxy, substituted or unsubstituted $C_6$ to $C_{30}$ aryl, and substituted or unsubstituted $C_6$ to $C_{30}$ heteroaryl, and
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
wherein
in $A^1$, $A^2$, $A^3$ each R' is independently selected from substituted or unsubstituted $C_6$ to $C_{18}$ aryl, $C_3$ to $C_{18}$ heteroaryl, electron-withdrawing group, substituted or unsubstituted $C_1$ to $C_8$ alkyl, partially fluorinated $C_1$ to $C_8$ alkyl, perfluorinated $C_1$ to $C_8$ alkyl, halogen, F and CN; and
wherein

preferably the compound of formula (IV) comprises at least two groups selected from aryl $C_6$ to $C_{19}$ aryl groups, or $C_3$ to $C_{12}$ heteroaryl group, wherein each of the $C_6$ to $C_{19}$ aryl group or $C_3$ to $C_{12}$ heteroaryl group is substituted,

wherein the one or more substituents are independently of each other selected from halogen, F, CN, partially perfluorinated $C_1$ to $C_{12}$ alkyl, perfluorinated $C_1$ to $C_{12}$ alkyl, $CF_3$.

**24.** The organic electroluminescent device according to any of the preceding claims 1 to 23, wherein the first organic p-dopant has a quinoid structure.

**25.** The organic electroluminescent device according to any of the preceding claims 1 to 24, wherein the first organic p-dopant comprises a quinoid structure, an indacenedione structure or is selected from a compound of formula (V):

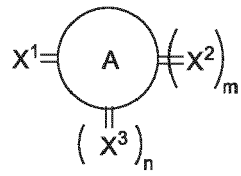

(V),

n is an integer including 0, 1, 2, 3, 4, 5 or 6, preferably 0, 2, or 4;
m is an integer selected from 0 or 1;
$X^1$, $X^2$ and $X^3$ are independently selected from O, S, $CR^{1a}R^{2a}$, $CR^{1b}R^{2b}$, $NR^{3a}$, $NR^{3b}$ or at least one of $X^1$, $X^2$, and $X^3$ form a fused ring with A, and wherein each $X^3$ is selected the same or different, preferably the same,
$R^{1a}$, $R^{2a}$, $R^{1b}$, and $R^{2b}$ are independently selected from an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted aryl, substituted or unsubstituted heteroaryl,
wherein the one or more substituents on $R^{1a}$, $R^{2a}$, $R^{1b}$, and $R^{2b}$ are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to C alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl;
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy,
$R^{3a}$ and $R^{3b}$ is selected from an electron-withdrawing group, CN, partially fluorinated $C_1$ to $C_6$ alkyl, perfluorinated $C_1$ to $C_6$ alkyl, $CF_3$, substituted or unsubstituted $C_6$ to $C_{30}$ aryl, or substituted or unsubstituted $C_3$ to $C_{30}$ heteroaryl,
wherein the one or more substituents on $R^{3a}$ and $R^{3b}$ are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl;
wherein the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
A is selected from substituted or unsubstituted $C_3$ to $C_{40}$ cycloalkane group containing at least one or more double-bonds, substituted or unsubstituted $C_3$ to $C_{40}$ cycloalkene group, substituted or unsubstituted $C_2$ to $C_{40}$ heterocycloalkane group, substituted or unsubstituted $C_2$ to $C_{40}$ heterocycloalkane group containing one or more double-bonds, substituted or unsubstituted $C_2$ to $C_{40}$ heterocycloalkene group, substituted or unsubstituted $C_6$ to $C_{40}$ aromatic group, substituted or unsubstituted $C_2$ to $C_{40}$ heteroaromatic group, wherein $X^1$, $X^2$, and/or $X^3$ are conjugated to each other via a double-bond in A;
wherein the substituents on A, when present, are independently selected from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to $C_8$ alkoxy, $OCF_3$, CN, isocyano, SCN, OCN, $NO_2$, $SF_5$, substituted or unsubstituted $C_6$ to $C_{30}$ aryl, substituted or unsubstituted $C_2$ to $C_{30}$ heteroaryl,
wherein the substituent of $C_6$ to $C_{30}$ aryl, $C_6$ to $C_{30}$ heteroaryl, $C_1$ to $C_8$ alkyl, $C_1$ to $C_8$ alkoxy are independently

selected from D, an electron-withdrawing group, halogen, Cl, F, CN, $-NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
and wherein
preferably the compound of formula (V) comprises at least two groups selected from substituted $C_6$ to $C_{19}$ aryl group or substituted $C_3$ to $C_{12}$ heteroaryl group,
wherein each of the substituted $C_6$ to $C_{19}$ aryl group or substituted $C_3$ to $C_{12}$ heteroaryl group is substituted with a substituent independently selected from halogen, F, CN, partially perfluorinated $C_1$ to $C_{12}$ alkyl, perfluorinated $C_1$ to $C_{12}$ alkyl, or $CF_3$.

**26.** The organic electroluminescent device according to any of the preceding claims 1 to 25, wherein the first organic p-dopant is selected from a compound comprising a indacenedione structure, a radialene compound (IV), or a compound of formula (VIa) or (VIb):

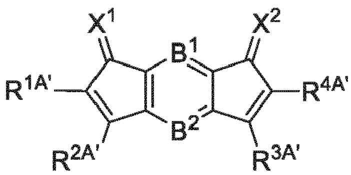 (VIa), 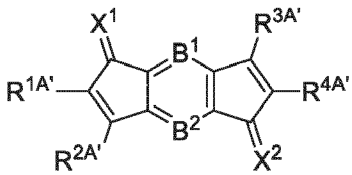 (VIb),

wherein

$B^1$ and $B^2$ are independently of each other selected from N, $CR^{5A'}$ or $CR^{6A'}$,
$R^{1A'}$, $R^{2A'}$, $R^{3A'}$, $R^{4A'}$, $R^{5A'}$, and $R^{6A'}$ are independently selected from each other from H, D, F, a substituted or unsubstituted $C_6$ to $C_{12}$ aryl, a substituted or unsubstituted $C_1$ to $C_{12}$ heteroaryl with 1 to 4 heteroatoms one among O, N, S and Si, a substituted or unsubstituted $C_1$ to $C_{12}$ alkyl, a substituted or unsubstituted $C_1$ to $C_{12}$ alkoxy, a substituted or unsubstituted $C_1$ to $C_{12}$ ether group, CN, $CF_3$, $OCF_3$, halogen, Cl, F, $Si(CH_3)_3$, preferably at least one among $R^1$ to $R^6$ comprises CN, wherein
the one or more substituents on $CR^{5A'}$, or $CR^{6A'}$ are independently selected from each other from D, an electron-withdrawing group, halogen, Cl, F, substituted or unsubstituted $C_1$ to $C_8$ alkyl, partially fluorinated $C_1$ to $C_8$ alkyl, perfluorinated $C_1$ to $C_8$ alkyl, $CF_3$, substituted or unsubstituted $C_1$ to $C_8$ alkoxy, partially fluorinated $C_1$ to $C_8$ alkoxy, perfluorinated $C_1$ to C alkoxy, $OCF_3$, CN, isocyano, SCN, OCN, $NO_2$, $SF_5$, substituted or unsubstituted $C_6$ to $C_{30}$ aryl, and substituted or unsubstituted $C_6$ to $C_{30}$ heteroaryl, wherein
the one or more substituents of $C_6$ to $C_{30}$ aryl, $C_6$ to $C_{30}$ heteroaryl, $C_1$ to $C_8$ alkyl, $C_1$ to $C_8$ alkoxy are independently selected from each other from D, an electron-withdrawing group, halogen, Cl, F, CN, - $NO_2$, isocyano, SCN, OCN, $SF_5$, partially fluorinated $C_1$ to $C_8$ alkyl, perfluorinated $C_1$ to $C_8$ alkyl, partially fluorinated $C_1$ to $C_8$ alkoxy, perfluorinated $C_1$ to $C_8$ alkoxy;
$X^1$ and $X^2$ are independently of each other selected from formula (VIc):

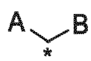 (VIc),

wherein

A and B are independently of each other is selected from H, D, a substituted or unsubstituted $C_6$ to $C_{12}$ aryl, a substituted or unsubstituted $C_1$ to $C_{12}$ heteroaryl with 1 to 4 heteroatoms one among O, N, S and Si, a substituted or unsubstituted $C_1$ to $C_{12}$ alkyl, a substituted or unsubstituted $C_1$ to $C_{12}$ alkoxy, a substituted or unsubstituted $C_1$ to $C_{12}$ ether group, CN, $CF_3$, $OCF_3$, halogen, Cl, F, $Si(CH_3)_3$, preferably the compound of formula (VIa) or (VIb) comprises at least two groups selected from $C_6$ to $C_{19}$ aryl group or $C_3$ to $C_{12}$ heteroaryl group, wherein each of the $C_6$ to $C_{19}$ aryl group or $C_3$ to $C_{12}$ heteroaryl group is substituted, wherein
the one or more substituents are independently of each other selected from halogen, F, CN, partially perfluorinated $C_1$ to $C_{12}$ alkyl, perfluorinated $C_1$ to $C_{12}$ alkyl, $CF_3$.

**27.** The organic electroluminescent device according to any of the preceding claims 1 to 26, wherein the first organic p-dopant is selected from formulae K 1 to K26:

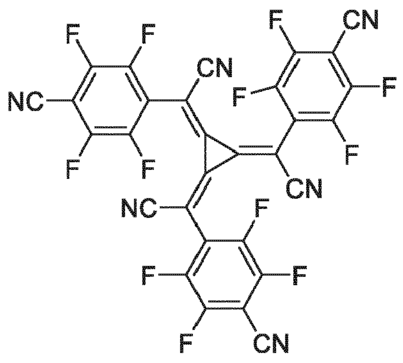 (K1), 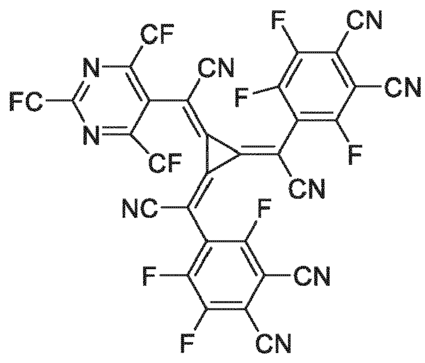 (K2),

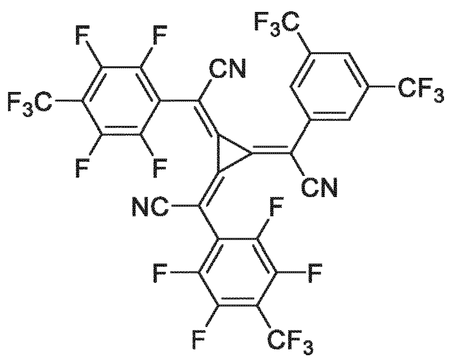 (K3), 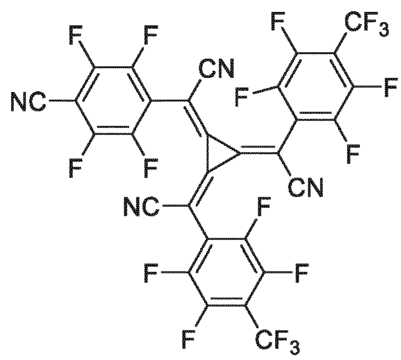 (K4),

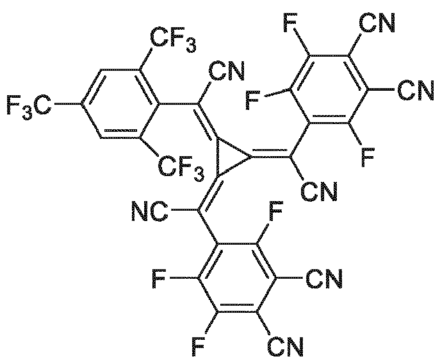 (K5), 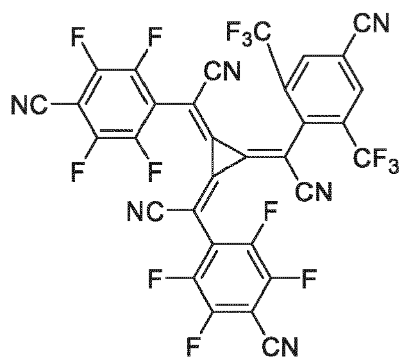 (K6),

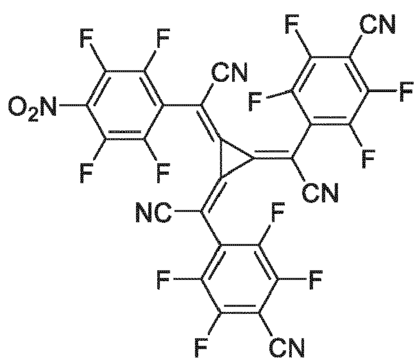 (K7), 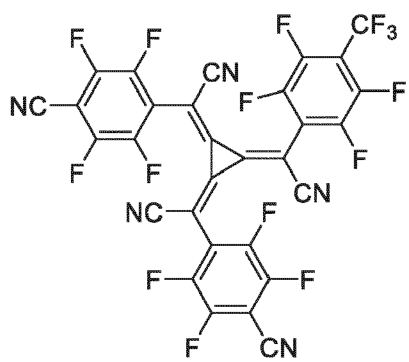 (K8),

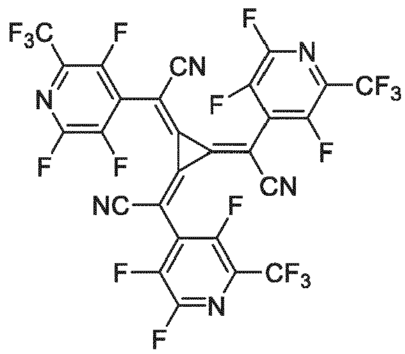
(K9),
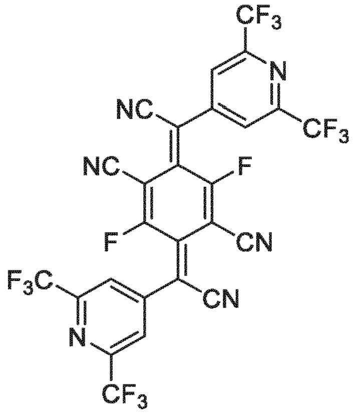
(K10),

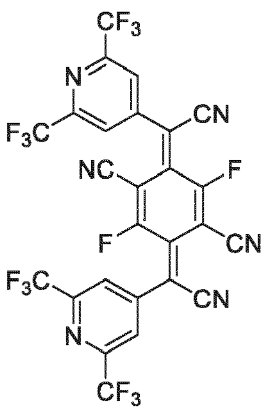
(K11),
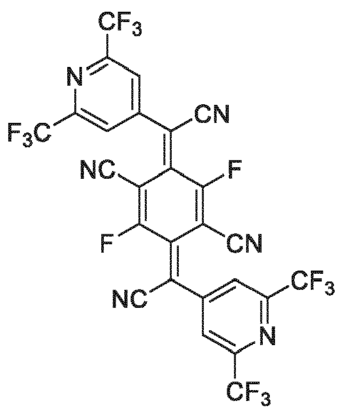
(K12),
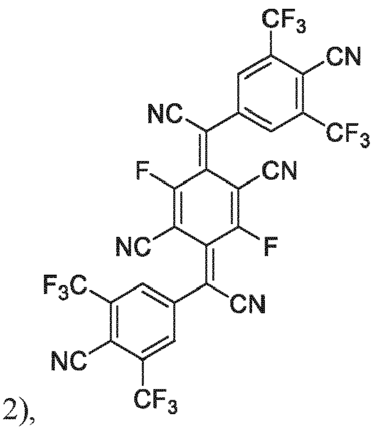
(K13),

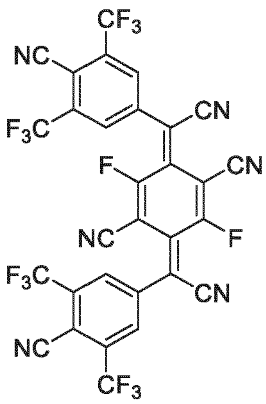
(K14),
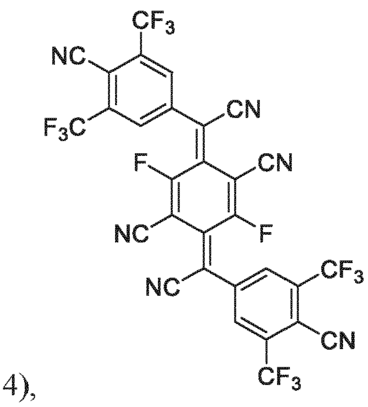
(K15),
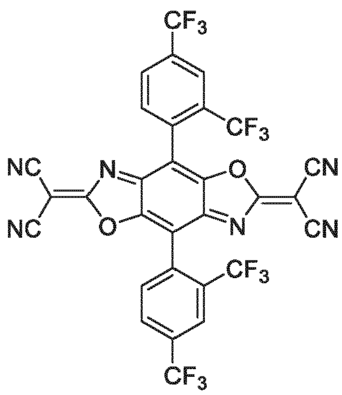
(K16),

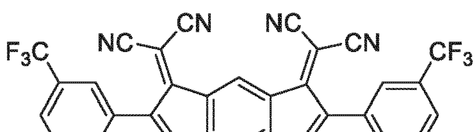
(K17),
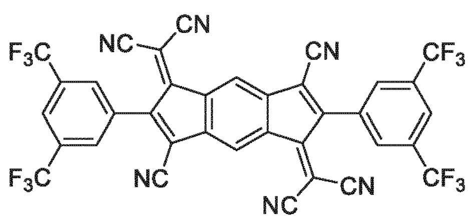
(K18),

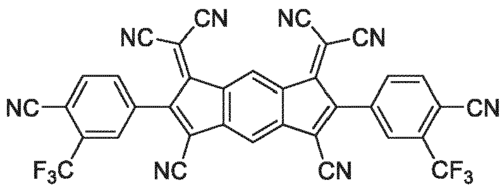 (K19), 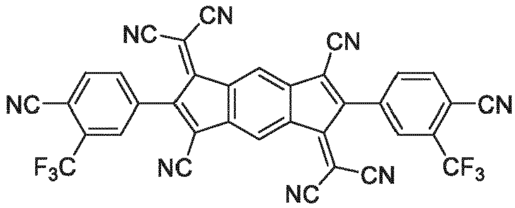 (K20),

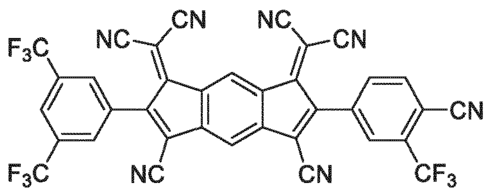 (K21), 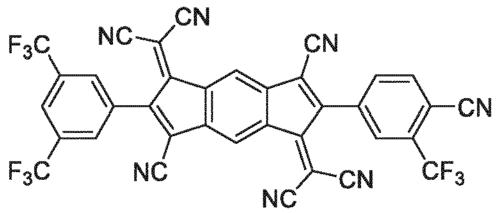 (K22),

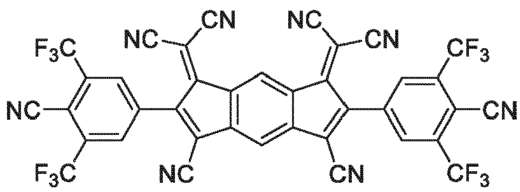 (K23), 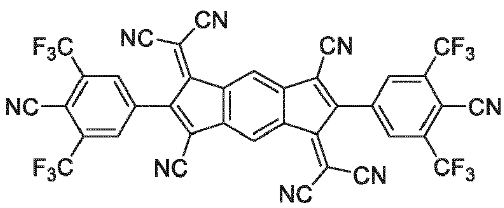 (K24),

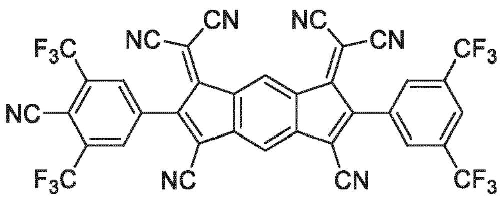 (K25), 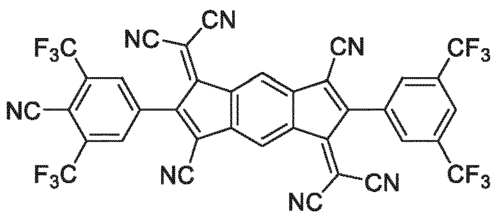 (K26).

**28.** The organic electroluminescent device according to any of the preceding claims 1 to 27, wherein the first emission layer comprises an organic emitter host compound and a light-emitting compound.

**29.** The organic electroluminescent device according to any of the preceding claims 1 to 28, wherein the first emission layer comprises a light-emitting compound, wherein the light-emitting compound is selected from a compound of formula (X):

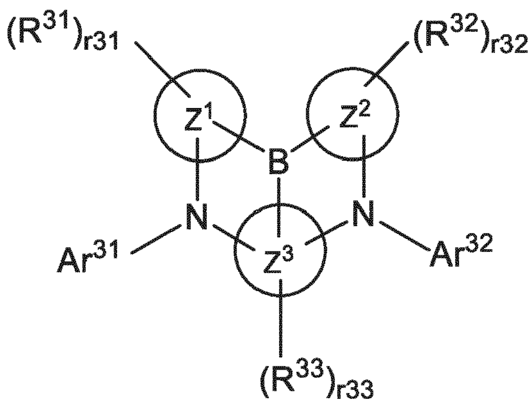 (X),

wherein

$Z^1$, $Z^2$ and $Z^3$ are the same as or different from each other, and are each independently selected from the group

comprising a monocyclic to polycyclic aromatic hydrocarbon ring or monocyclic to polycyclic aromatic hetero ring; $Ar^{31}$ and $Ar^{32}$ are the same as or selected different from each other, and are each independently a substituted or unsubstituted alkyl group, a substituted or unsubstituted aryl group, or a substituted or unsubstituted heteroaryl group, or are bonded to an adjacent substituent to form a substituted or unsubstituted aromatic ring or a substituted or unsubstituted aliphatic ring;

$R^{31}$, $R^{32}$ and $R^{33}$ are the same as or different from each other, and are each independently selected from the group comprising hydrogen, deuterium, a substituted or unsubstituted alkyl group, a substituted or unsubstituted silyl group, a substituted or unsubstituted amine group, a substituted or unsubstituted aryl group, or a substituted or unsubstituted heteroaryl group, or adjacent substituents are bonded to each other to form a substituted or unsubstituted aromatic ring or a substituted or unsubstituted aliphatic ring,

wherein one or more substituents selected from the group consisting of deuterium, an alkyl group having 1 to 6 carbon atoms, an alkyl silyl group having 1 to 30 carbon atoms, an aryl silyl group having 6 to 50 carbon atoms, an alkylamine group having 1 to 30 carbon atoms, an alkylarylamine group having 1 to 50 carbon atoms, an arylamine group having 6 to 50 carbon atoms, an aryl group having 6 to 30 carbon atoms, and a heteroaryl group having 2 to 30 carbon atoms, or a substituent to which two or more substituents selected from the group are linked, or adjacent substituents are bonded to each other to form an aliphatic hydrocarbon ring having 3 to 60 carbon atoms, which is unsubstituted or substituted with the substituent;

$r^{31}$, $r^{32}$ and $r^{33}$ are each an integer from 0, 1, 2, 3 or 4, and when $r^{31}$ to $r^{33}$ are 2 or higher, substituents in the parenthesis are the same as or different from each other.

**30.** The organic electroluminescent device according to any of the preceding claims 1 to 29, wherein the first emission layer comprises an organic emitter host compound, wherein the organic emitter host compound comprises:

- at least one condensed aromatic ring system consisting of 3 to 5 rings, and
- 3 to 7 aromatic or heteroaromatic rings, wherein one or more sub-groups of the aromatic and/or heteroaromatic rings is condensed to form fused aromatic or heteroaromatic ring systems;

wherein the molecular weight Mw of the organic emitter host compound is in the range of ≥ 400 to ≤ 2000 g/mol.

**31.** The organic electroluminescent device according to any of the preceding claims 1 to 30, wherein the first emission layer comprises an organic emitter host compound, wherein the organic emitter host compound is selected from a compound of formula (XI):

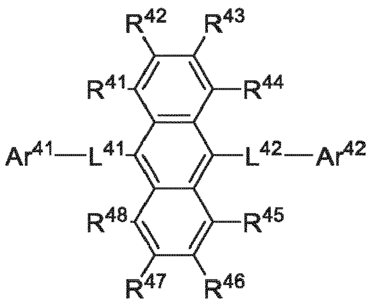

(XI),

wherein

$Ar^{41}$ and $Ar^{42}$ are independently selected from substituted or unsubstituted $C_6$ to $C_{24}$ aryl, substituted or unsubstituted $C_3$ to $C_{24}$ heteroaryl;

$L^{41}$ and $L^{42}$ are independently selected from a direct bond or substituted or unsubstituted $C_6$ to $C_{24}$ arylene, substituted or unsubstituted $C_3$ to $C_{24}$ heteroarylene;

$R^{41}$ to $R^{41}$ are independently selected from H, D, substituted or unsubstituted $C_1$ to $C_{12}$ alkyl, substituted or unsubstituted $C_6$ to $C_{19}$ aryl, substituted or unsubstituted $C_3$ to $C_{12}$ heteroaryl;

wherein
the substituents on $Ar^{41}$, $Ar^{42}$, $L^{41}$, $L^{42}$, $R^{41}$ to $R^{48}$ are independently selected from D, $C_6$ to $C_{10}$ aryl, $C_3$ to $C_9$ heteroaryl, $C_1$ to $C_6$ alkyl, $C_1$ to $C_6$ alkoxy, $C_3$ to $C_6$ branched alkyl, $C_3$ to $C_6$ cyclic alkyl, $C_3$ to $C_6$ branched alkoxy, $C_3$ to $C_6$ cyclic alkoxy, partially or perfluorinated $C_1$ to $C_{16}$ alkyl, partially or perfluorinated $C_1$ to $C_{16}$ alkoxy, partially or perdeuterated $C_1$ to $C_6$ alkyl, partially or perdeuterated $C_1$ to $C_6$ alkoxy, halogen, F or CN.

**32.** A display device comprising the organic electroluminescent device of any of the preceding claims 1 to 31, and preferably a display device comprising a substrate and several organic electroluminescent devices according to any of preceding claims 1 to 31, wherein the organic electroluminescent devices are formed on the substrate as adjacent pixels, wherein the hole injection layer is formed as a common hole injection layer on the adjacent pixels.

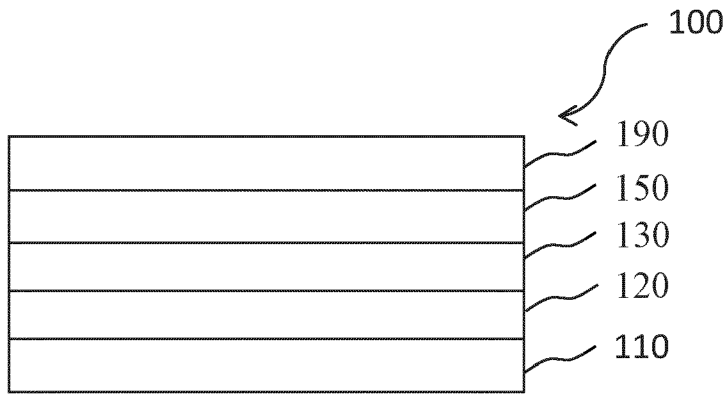


FIG. 1

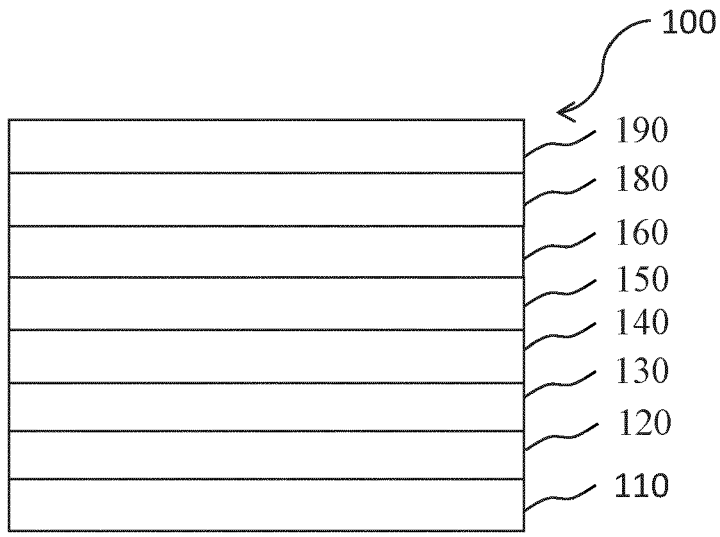


FIG. 2

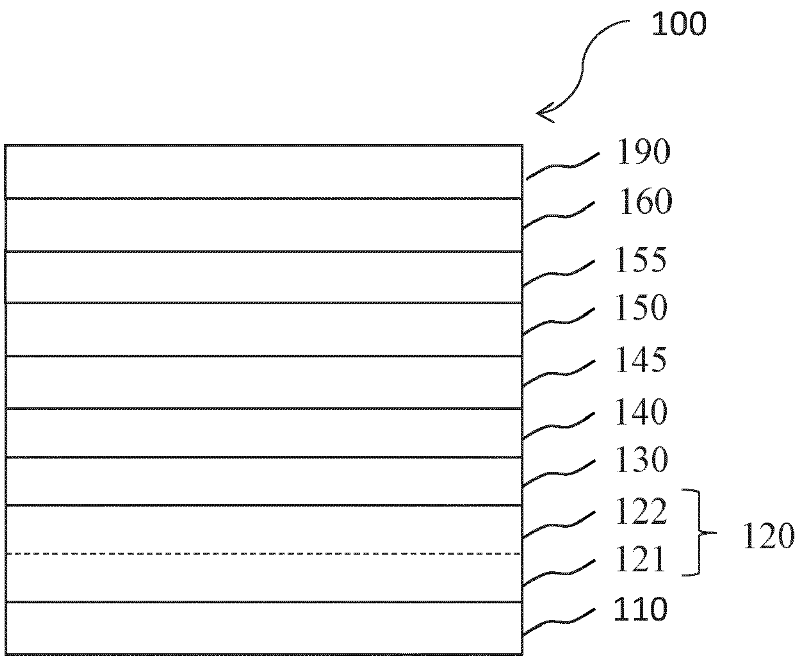


FIG. 3

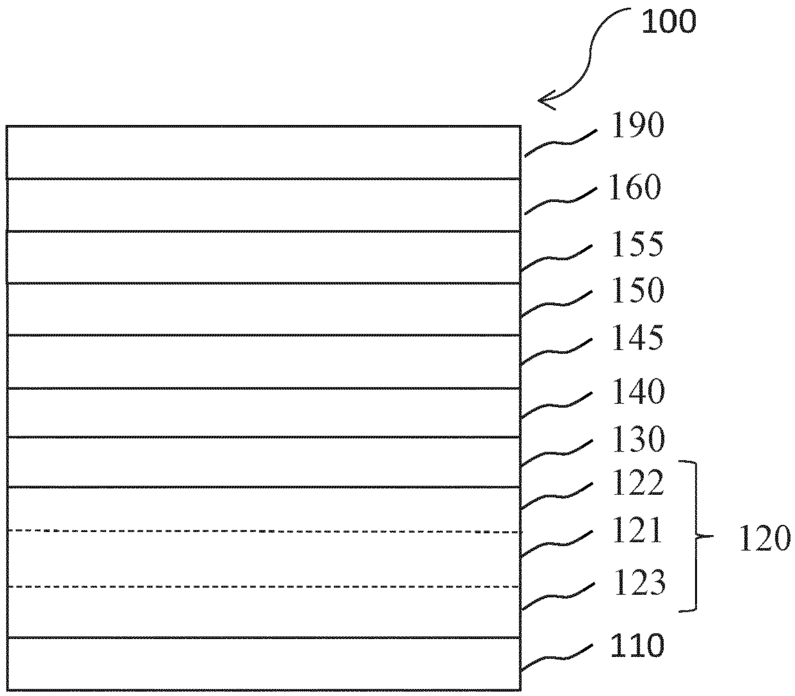
100
190
160
155
150
145
140
130
122
121
123
120
110

FIG. 4

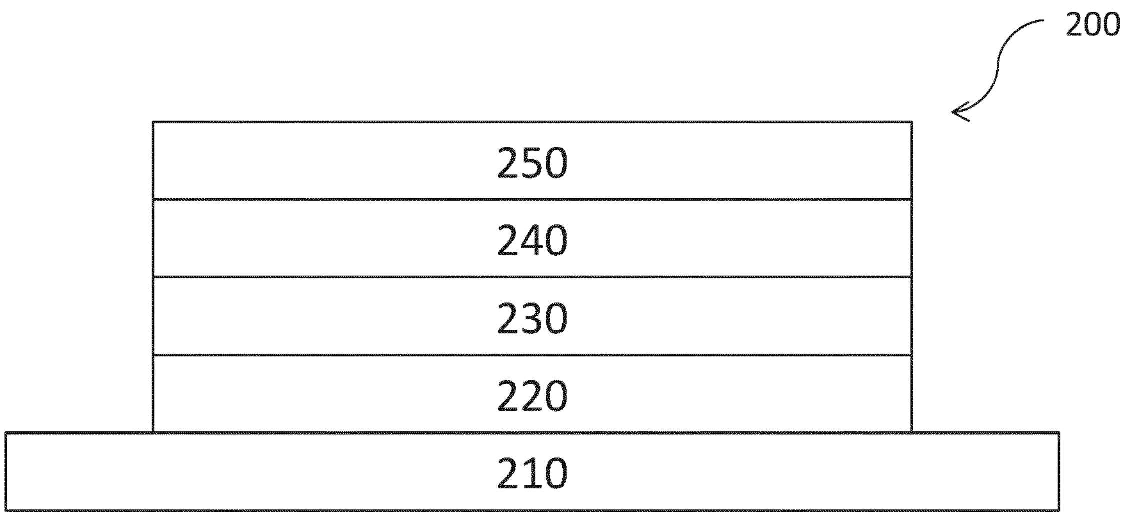
200
250
240
230
220
210

FIG. 5

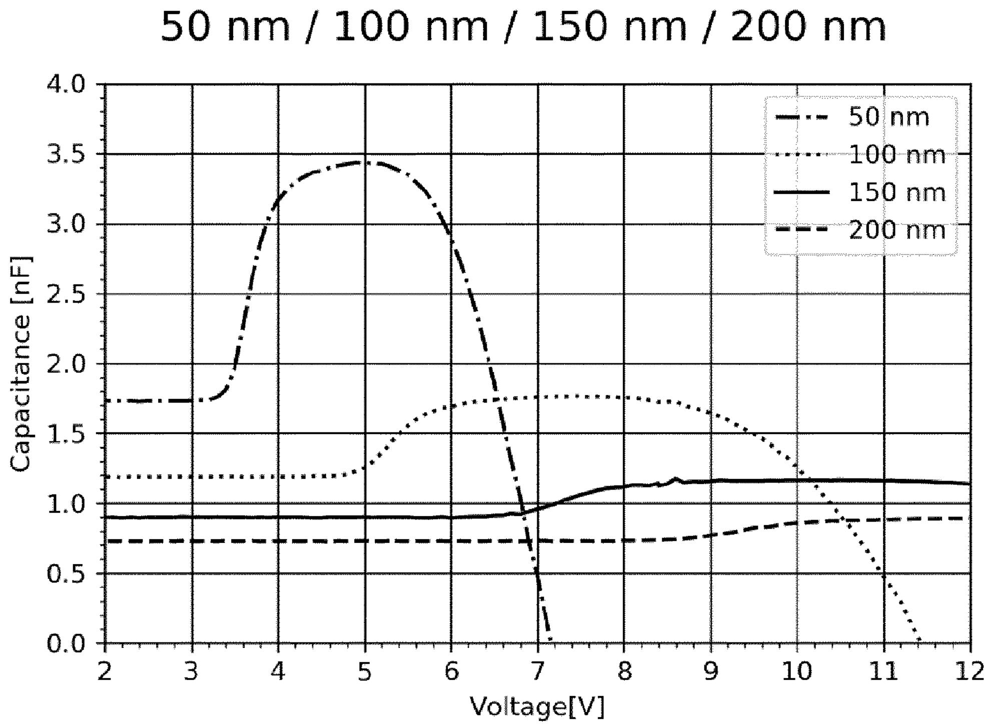
50 nm / 100 nm / 150 nm / 200 nm
50 nm
100 nm
150 nm
200 nm
Capacitance [nF]
Voltage[V]
4.0
3.5
3.0
2.5
2.0
1.5
1.0
0.5
0.0
2
3
4
5
6
7
8
9
10
11
12

FIG. 6

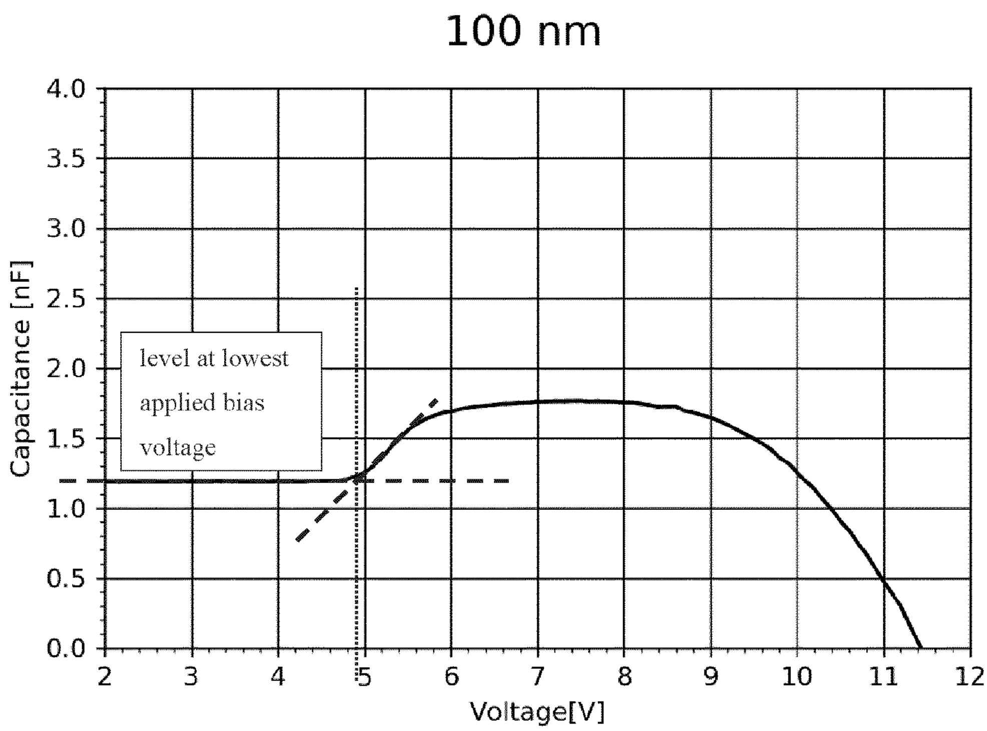
100 nm
level at lowest
applied bias
voltage
Capacitance [nF]
Voltage[V]
4.0
3.5
3.0
2.5
2.0
1.5
1.0
0.5
0.0
2
3
4
5
6
7
8
9
10
11
12

FIG. 7

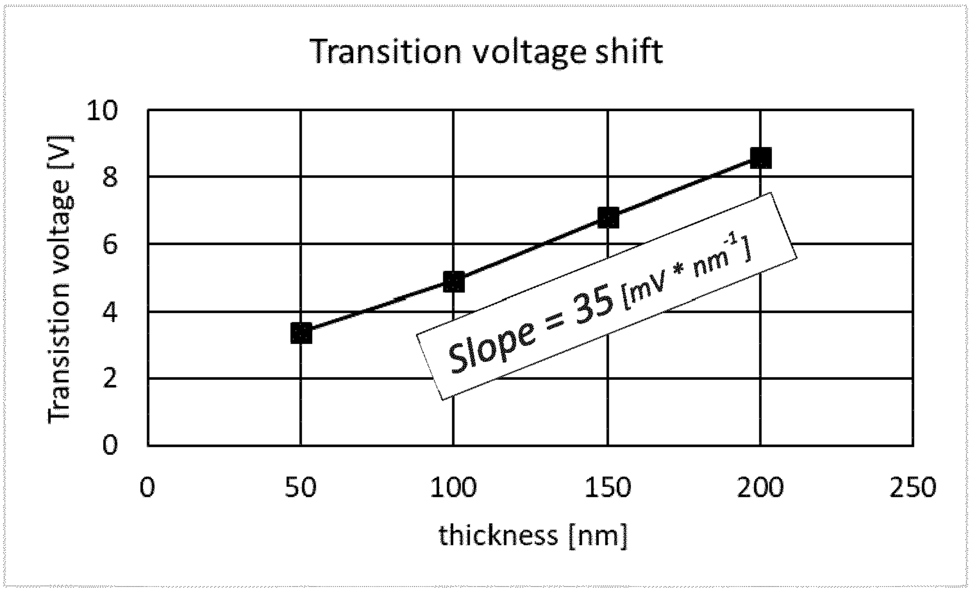
Transition voltage shift
Transistion voltage [V]
10
8
6
4
2
0
0
50
100
150
200
250
thickness [nm]
Slope = 35 [mV * nm-1]

FIG. 8

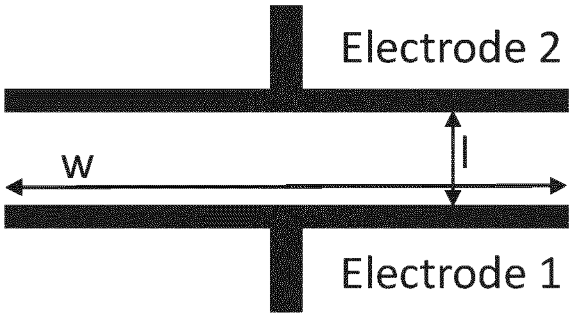


FIG. 9

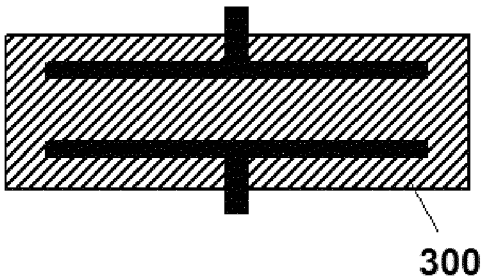


FIG. 10

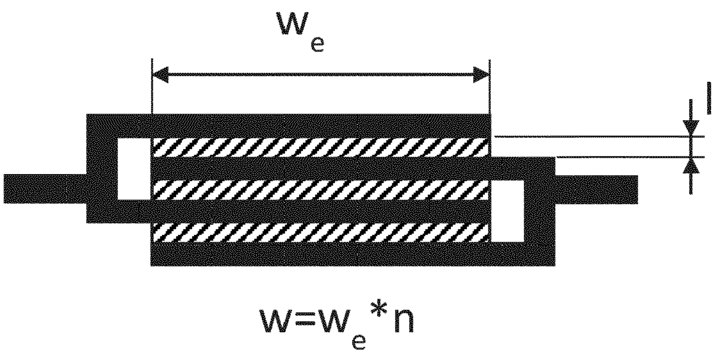


FIG. 11

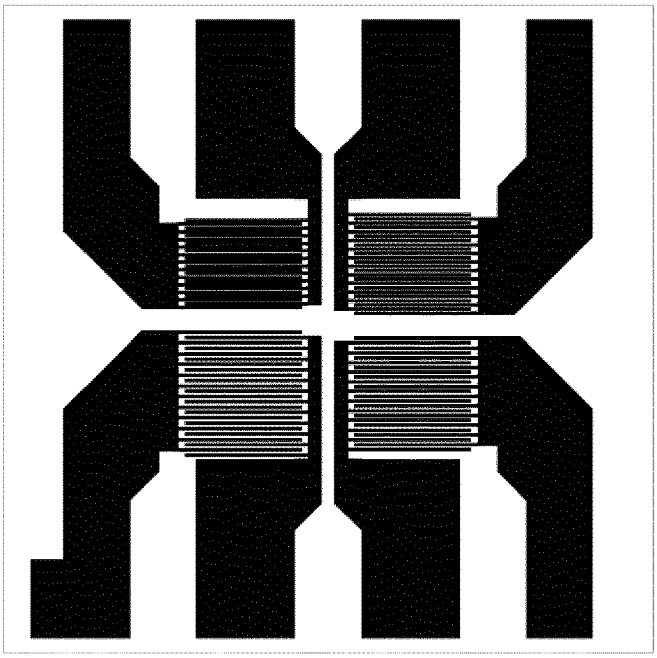

FIG. 12

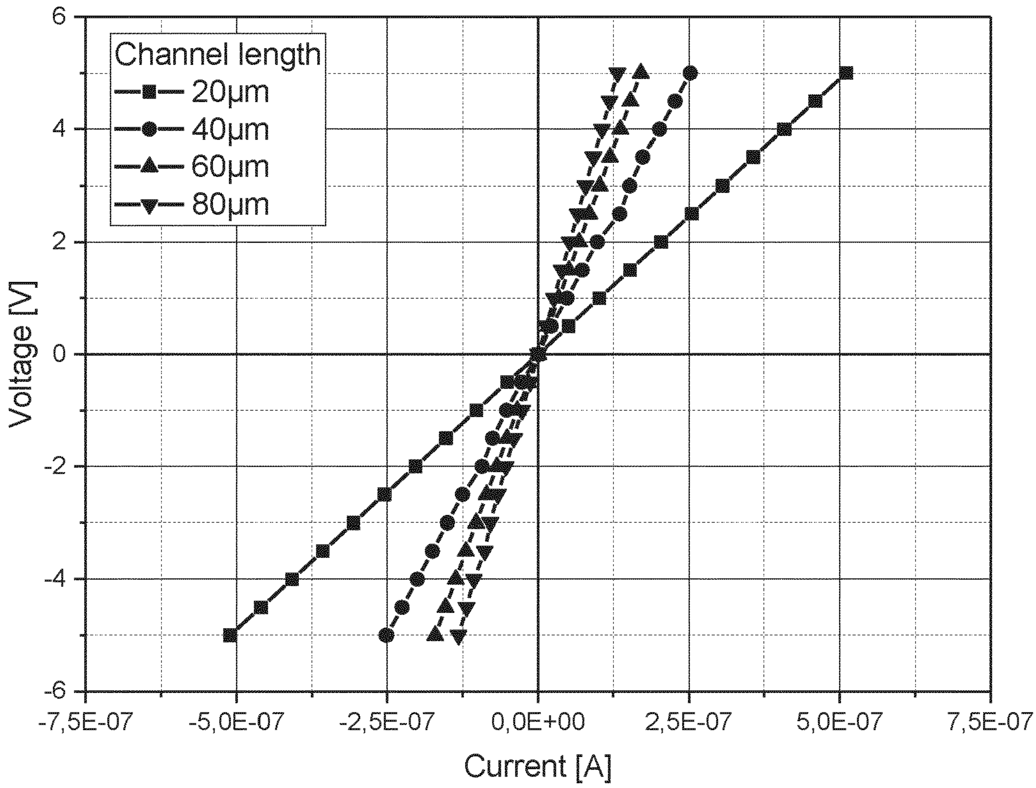
Channel length
20µm
40µm
60µm
80µm
Voltage [V]
6
4
2
0
-2
-4
-6
-7,5E-07
-5,0E-07
-2,5E-07
0,0E+00
2,5E-07
5,0E-07
7,5E-07
Current [A]

FIG. 13

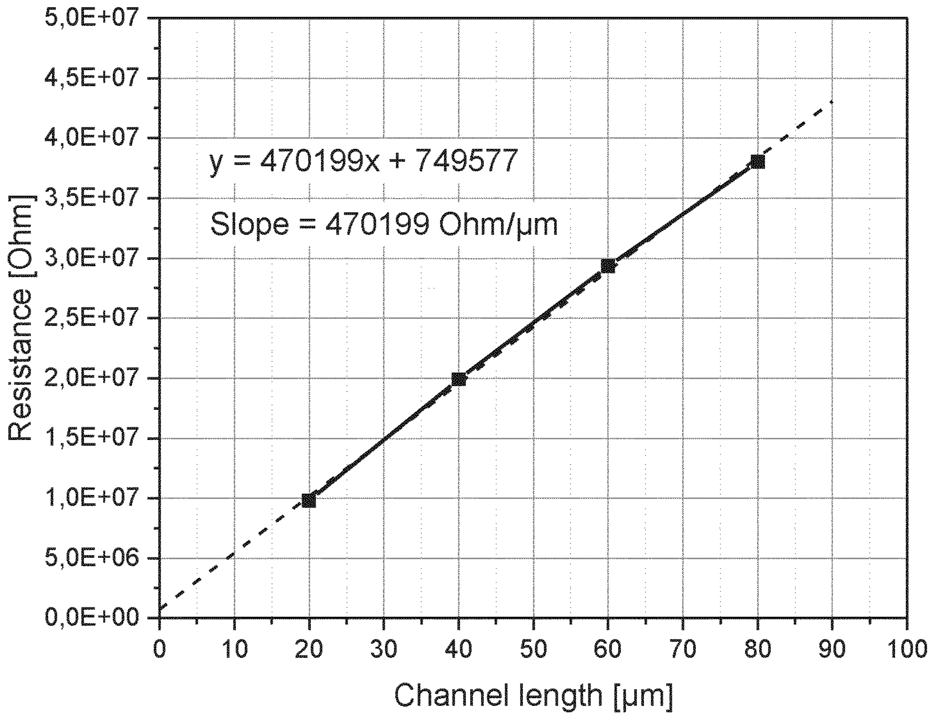
y = 470199x + 749577
Slope = 470199 Ohm/µm
Resistance [Ohm]
5,0E+07
4,5E+07
4,0E+07
3,5E+07
3,0E+07
2,5E+07
2,0E+07
1,5E+07
1,0E+07
5,0E+06
0,0E+00
0 10 20 30 40 50 60 70 80 90 100
Channel length [µm]

FIG. 14

Europäisches Patentamt
European Patent Office
Office européen des brevets

# EUROPEAN SEARCH REPORT

Application Number
EP 23 21 5922

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| T | KROGER M ET AL: "P-type doping of organic wide band gap materials by transition metal oxides: A case-study on Molybdenum trioxide", ORGANIC ELECTRONICS, ELSEVIER, AMSTERDAM, NL, vol. 10, no. 5, 1 August 2009 (2009-08-01), pages 932-938, XP026235906, ISSN: 1566-1199, DOI: 10.1016/J.ORGEL.2009.05.007 [retrieved on 2009-05-10] * the whole document * ----- | | INV. H10K85/60 |
| T | MARKUS GANTENBEIN ET AL: "New 4,4'-Bis(9-carbazolyl)-Biphenyl Derivatives with Locked Carbazole-Biphenyl Junctions: High-Triplet State Energy Materials", CHEMISTRY OF MATERIALS, vol. 27, no. 5, 10 March 2015 (2015-03-10), pages 1772-1779, XP055191916, ISSN: 0897-4756, DOI: 10.1021/cm5045754 * the whole document * ----- | | TECHNICAL FIELDS SEARCHED (IPC) H10K |
| T | TING ZHANG ET AL: "A CBP derivative as bipolar host for performance enhancement in phosphorescent organic light-emitting diodes", JOURNAL OF MATERIALS CHEMISTRY C, vol. 1, no. 4, 1 January 2013 (2013-01-01), pages 757-764, XP055191881, ISSN: 2050-7526, DOI: 10.1039/C2TC00305H * the whole document * ----- -/-- | | |

The present search report has been drawn up for all claims

1

| Place of search | Date of completion of the search | Examiner |
|---|---|---|
| The Hague | 19 June 2024 | Konrádsson, Ásgeir |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

page 1 of 2

Europäisches Patentamt
European Patent Office
Office européen des brevets

# EUROPEAN SEARCH REPORT

Application Number
EP 23 21 5922

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| T | JUNG-HWAN PARK ET AL: "New Bipolar Green Host Materials Containing Benzimidazole-Carbazole Moiety in Phosphorescent OLEDs", BULLETIN OF THE KOREAN CHEMICAL SOCIETY, vol. 32, no. 3, 20 March 2011 (2011-03-20), pages 841-846, XP055191890, ISSN: 0253-2964, DOI: 10.5012/bkcs.2011.32.3.841<br>* the whole document *<br>----- | | |
| T | NAMDAS EBINAZAR ET AL: "Simple color tuning of phosphorescent dendrimer light emitting diodes", APPLIED PHYSICS LETTERS, AMERICAN INSTITUTE OF PHYSICS, 2 HUNTINGTON QUADRANGLE, MELVILLE, NY 11747, vol. 86, no. 16, 11 April 2005 (2005-04-11), pages 161104-161104, XP012065079, ISSN: 0003-6951, DOI: 10.1063/1.1899256<br>* the whole document *<br>----- | | TECHNICAL FIELDS SEARCHED (IPC) |
| A | WO 2023/232972 A1 (NOVALED GMBH [DE]) 7 December 2023 (2023-12-07)<br>* page 70 - page 115; claims 1-15; tables 1-3 *<br>----- | 1-32 | |
| A | WO 2021/259789 A1 (NOVALED GMBH [DE]) 30 December 2021 (2021-12-30)<br>* page 6 - page 44; claims 1-15; tables 1,2 *<br>----- | 1-32 | |

The present search report has been drawn up for all claims

1

| Place of search | Date of completion of the search | Examiner |
|---|---|---|
| The Hague | 19 June 2024 | Konrádsson, Ásgeir |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

page 2 of 2

## ANNEX TO THE EUROPEAN SEARCH REPORT ON EUROPEAN PATENT APPLICATION NO. EP 23 21 5922

This annex lists the patent family members relating to the patent documents cited in the above-mentioned European search report. The members are as contained in the European Patent Office EDP file on
The European Patent Office is in no way liable for these particulars which are merely given for the purpose of information.

19-06-2024

| Patent document cited in search report | Publication date | Patent family member(s) | Publication date |
|---|---|---|---|
| WO 2023232972 A1 | 07-12-2023 | KR 20230168204 A | 12-12-2023 |
| | | WO 2023232972 A1 | 07-12-2023 |
| WO 2021259789 A1 | 30-12-2021 | CN 115804267 A | 14-03-2023 |
| | | CN 115867531 A | 28-03-2023 |
| | | CN 115885598 A | 31-03-2023 |
| | | CN 115918299 A | 04-04-2023 |
| | | CN 115918300 A | 04-04-2023 |
| | | CN 115943757 A | 07-04-2023 |
| | | CN 115943758 A | 07-04-2023 |
| | | CN 115943759 A | 07-04-2023 |
| | | CN 116058109 A | 02-05-2023 |
| | | CN 116076169 A | 05-05-2023 |
| | | EP 4168379 A2 | 26-04-2023 |
| | | EP 4168380 A2 | 26-04-2023 |
| | | EP 4169084 A1 | 26-04-2023 |
| | | EP 4169085 A1 | 26-04-2023 |
| | | EP 4169086 A1 | 26-04-2023 |
| | | EP 4169087 A1 | 26-04-2023 |
| | | EP 4169088 A1 | 26-04-2023 |
| | | EP 4169089 A1 | 26-04-2023 |
| | | EP 4169090 A1 | 26-04-2023 |
| | | EP 4169091 A1 | 26-04-2023 |
| | | EP 4169092 A1 | 26-04-2023 |
| | | JP 2023530520 A | 18-07-2023 |
| | | JP 2023531688 A | 25-07-2023 |
| | | JP 2023531956 A | 26-07-2023 |
| | | JP 2023532855 A | 01-08-2023 |
| | | JP 2023532856 A | 01-08-2023 |
| | | KR 20230027216 A | 27-02-2023 |
| | | KR 20230028424 A | 28-02-2023 |
| | | KR 20230028427 A | 28-02-2023 |
| | | KR 20230028767 A | 02-03-2023 |
| | | KR 20230028768 A | 02-03-2023 |
| | | KR 20230028769 A | 02-03-2023 |
| | | KR 20230028770 A | 02-03-2023 |
| | | KR 20230028771 A | 02-03-2023 |
| | | KR 20230028772 A | 02-03-2023 |
| | | KR 20230028773 A | 02-03-2023 |
| | | KR 20230028774 A | 02-03-2023 |
| | | TW 202208329 A | 01-03-2022 |
| | | TW 202210607 A | 16-03-2022 |
| | | TW 202210608 A | 16-03-2022 |
| | | TW 202210609 A | 16-03-2022 |
| | | TW 202210610 A | 16-03-2022 |
| | | TW 202210611 A | 16-03-2022 |

EPO FORM P0459

For more details about this annex : see Official Journal of the European Patent Office, No. 12/82

## ANNEX TO THE EUROPEAN SEARCH REPORT ON EUROPEAN PATENT APPLICATION NO. EP 23 21 5922

This annex lists the patent family members relating to the patent documents cited in the above-mentioned European search report. The members are as contained in the European Patent Office EDP file on
The European Patent Office is in no way liable for these particulars which are merely given for the purpose of information.

19-06-2024

| Patent document cited in search report | Publication date | Patent family member(s) | Publication date |
|---|---|---|---|
| | | TW 202210612 A | 16-03-2022 |
| | | TW 202210613 A | 16-03-2022 |
| | | TW 202222779 A | 16-06-2022 |
| | | TW 202231624 A | 16-08-2022 |
| | | TW 202231625 A | 16-08-2022 |
| | | US 2023225141 A1 | 13-07-2023 |
| | | US 2023227401 A1 | 20-07-2023 |
| | | US 2023232710 A1 | 20-07-2023 |
| | | US 2023232711 A1 | 20-07-2023 |
| | | US 2023232712 A1 | 20-07-2023 |
| | | US 2023240132 A1 | 27-07-2023 |
| | | US 2023240137 A1 | 27-07-2023 |
| | | US 2023240138 A1 | 27-07-2023 |
| | | US 2023240139 A1 | 27-07-2023 |
| | | US 2023247900 A1 | 03-08-2023 |
| | | US 2023247901 A1 | 03-08-2023 |
| | | WO 2021259782 A2 | 30-12-2021 |
| | | WO 2021259784 A2 | 30-12-2021 |
| | | WO 2021259785 A1 | 30-12-2021 |
| | | WO 2021259786 A1 | 30-12-2021 |
| | | WO 2021259787 A1 | 30-12-2021 |
| | | WO 2021259788 A1 | 30-12-2021 |
| | | WO 2021259789 A1 | 30-12-2021 |
| | | WO 2021259790 A1 | 30-12-2021 |
| | | WO 2021259791 A1 | 30-12-2021 |
| | | WO 2021259792 A1 | 30-12-2021 |
| | | WO 2021259793 A1 | 30-12-2021 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 2722908 A1

### Non-patent literature cited in the description

- *CHEMICAL ABSTRACTS*, 192198-85-9
- *CHEMICAL ABSTRACTS*, 1242056-42-3
- *CHEMICAL ABSTRACTS*, 207739-72-8
- **YASUHIKO SHIROTA** ; **HIROSHI KAGEYAMA**. *Chem. Rev.*, 2007, vol. 107, 953-1010
- **NOGUCHI et al.** *J. Soc. Inf. Display*, 2021, vol. 29, 29-37
- *CHEMICAL ABSTRACTS*, 105598-27-4